# EUROPEAN PATENT APPLICATION

(11) **EP 4 836 620 A1**
(43) Date of publication of application: **04.11.2026**
(21) Application number: 26177260.2
(22) Date of filing: 30.10.2023
(51) Int. Cl.: H05K 7/20

(54) **SYSTEMS AND METHODS FOR COOLING HEAT GENERATING ELECTRONIC COMPONENTS**

(30) Priority: 28.10.2022 US 202263420196 P
(62) Document number(s) of the earlier application(s) in accordance with Art. 76 EPC: 23882090.6 / 4 609 139
(71) Applicant: Zutacore Ltd., 7916700 Hof Ashkelon (IL); Eadelson, Nahshon, 8548000 Moshav Sdei-Avraham (IL)
(72) Inventor: Eadelson, Nahshon, 8548000 Moshav Sdei-Avraham (IL)
(74) Representative: Finnegan Europe LLP

(57) **Abstract**

A cooling device comprising a chamber for containing a liquid coolant, the chamber having a heat transfer surface. The cooling device further comprising an inlet for the liquid coolant, an outlet for vaporized liquid coolant, a plurality of fins within the chamber and extending from the heat transfer surface, the fins being arranged in the chamber for submersion in the liquid coolant, and a plurality of porous units disposed between the plurality of fins such that the fins and the porous units alternate, and wherein the porous units are configured to wick coolant along the fins.

## Description

### CROSS REFERENCE TO RELATED APPLICATIONS

This application claims the benefit of priority of U.S. Provisional Application No. 63/420,196, filed on October 28, 2022, which is incorporated herein by reference in its entirety.

### TECHNICAL FIELD

This disclosure relates to systems and methods to facilitate cooling of electronic components.

### BACKGROUND

As market demand for high-performance, multi-core computing continues to grow, the need for efficient solutions to handle heat generated by servers increases accordingly. Currently available cooling techniques may be inadequate to address the intense workload environments of modern data centers having processors and other electronic components that generate heat while maximizing system performance. For instance, older cooling technologies may be designed for lower powered components and may not be suitable for the intense heat loads of newer chip sets. Cooling techniques that locate data centers in cool climates, or adjacent to bodies of water may introduce large distances between supply and demand for computing services, imposing communication latencies that may hamper performance. Traditional water-based cooling techniques risk short-circuiting of electronic components and may promote corrosion, erosion, fouling, and residue. Installing air conditioning units inside data centers may impose significant costs.

Therefore, there is a need for unconventional, innovative technologies to cool servers effectively in a cost efficient and safe manner. While the cooling of server components is provided as an example, the inventions described herein are not so limited, and can be used for cooling a wide variety of electronic components.

### SUMMARY

Disclosed embodiments provide systems and methods related to cooling heat-generating electronic components. The disclosed systems and methods may be implemented using specialized combinations of hardware and software, including specialized hardware and software as well as conventional hardware and software.

### BRIEF DESCRIPTION OF THE DRAWINGS

The description that follows may be understood in the context of the figures.
Fig. 1A illustrates an exemplary two-phase cooling system including multiple Enhanced Nucleation Evaporators (ENEs), each thermally coupled to a heat-generating electronic component, a heat rejection unit (HRU), and a Refrigerant Distribution Unit (RDU), consistent with disclosed embodiments.
Figs. 1B-1F illustrate differing exemplary views of an ENE configured for mounting on a heat-generating electronic component, consistent with some disclosed embodiments.
Fig. 1G illustrates a perspective view of a cooling device, consistent with some disclosed embodiments.
Figs. 2A-2C illustrate differing exemplary views of a float valve configure to regulate an inflow of liquid coolant to an ENE, consistent with some disclosed embodiments.
Fig. 2D illustrates an underside of a cover of the ENE of Figs. 1B-1F, consistent with some disclosed embodiments.
Fig. 3A illustrates an exemplary array of fins positioned on an inner surface of a heat conductive wall of an ENE, consistent with some disclosed embodiments.
Fig. 3B illustrates exemplary wicks introduced between fins (e.g., interposed between each fin) in an ENE to enhance cooling, consistent with some disclosed embodiments.
Fig. 3C illustrates an example of a wick interposed between two fins, consistent with some disclosed embodiments.
Fig. 3D is a perspective view of an exemplary arrangement of fins and wicks that are sandwiched between graphite sheets, consistent with some disclosed embodiments.
Fig. 3E is a side view of an exemplary graphite sheet with notches, consistent with some disclosed embodiments.
Fig. 3F is a top view of an exemplary cross section of a graphite sheet with notches, consistent with some disclosed embodiments.
Figs. 4A-4E are exemplary cross-sectional views of an exemplary ENE having a vapor pass-through conduit, consistent with some disclosed embodiments.
Fig. 4F illustrates an exemplary diameter or circumference of a tube carrying vaporized coolant larger than a diameter or circumference of a tube carrying liquid coolant, consistent with some disclosed embodiments.
Fig. 5A illustrates an exemplary chimney for breaking up a bubble field and inducing internal counterflow in an ENE, consistent with some disclosed embodiments.
Fig. 5B illustrates multiple exemplary chimneys with multiple bubble channels (conduits) for breaking up a bubble field of a pool in an ENE, consistent with some disclosed embodiments.
Fig. 5C illustrates a cross-sectional schematic view of a two-phase evaporator with a chimney for breaking up a bubble field, consistent with some disclosed embodiments.
Fig. 6 illustrates multiple exemplary ENEs fluidly connected to a common vapor line via a vaporized coolant conduit, consistent with some disclosed embodiments.
Fig. 7 illustrates an exemplary HRU of two-phase cooling system (e.g., for controlling a coolant loop) thermally coupled to a facility water system (e.g., a water loop), consistent with some disclosed embodiments.
Fig. 8A illustrates an exemplary HRU occupying multiple slots of a server rack, consistent with some disclosed embodiments.
Figs. 8B-8C illustrate an exemplary HRU including a condenser collocated with a reservoir and a plurality of pumps at a same level of a server rack, thereby occupying fewer slots than the HRU of Fig. 8A, consistent with some disclosed embodiments.
Figs. 9A-9C are screenshots of an exemplary GUI displaying measurements received via one or more sensors configured with a two-phase cooling system for electronic components, consistent with some disclosed embodiments.
Fig. 9D is a flow chart of an exemplary method for controlling electronics operating frequencies to regulate heat generation, consistent with disclosed embodiments.
Figs. 10A-10E illustrate one or more condensers of an HRU located in a door of a server rack, consistent with some disclosed embodiments.
Fig. 11A is a schematic block diagram of a system for achieving a target water temperature in a facility where water is used as part of a process for electronic cooling, consistent with some disclosed embodiments.
Fig. 11B is a flowchart of an exemplary process for controlling a temperature of the water in the output water line, consistent with embodiments of the present disclosure.
Fig. 12 illustrates an exemplary central HRU configured to be located external to a server farm (e.g., outdoors) while being flow connected to multiple server racks containing multiple ENEs thermally coupled to multiple heat-generating electronic components, internal to the server farm, consistent with some disclosed embodiments.
Fig. 13A is a schematic diagram of a hybrid cooling system for a server rack including a dual-purpose single phase water loop, consistent with some disclosed embodiments.
Fig. 13B is a more detailed view of the hybrid cooling system of Fig. 13A, consistent with some disclosed embodiments.
Fig. 13C illustrates a cabinet for containing two side-by-side server racks, consistent with some disclosed embodiments.
Fig. 13D is an illustration of an exemplary server cabinet interior, consistent with some disclosed embodiments.
Fig. 14A is a schematic diagram of a system for cooling electronic components when bubble formation inhibits cooling, consistent with some disclosed embodiments.
Figs. 14B to 14D are cross-sectional schematic views of three valve positions in a two-phase pulse evaporator for cooling electronic components when bubble formation inhibits cooling, consistent with some disclosed embodiments.
Fig. 14E is another schematic block diagrams of a two-phase pulse evaporator for cooling electronic components when bubble formation inhibits cooling, consistent with some disclosed embodiments.
Fig. 14F is a flowchart of an exemplary process for cooling electronic components when bubble formation inhibits cooling, consistent with embodiments of the present disclosure.

### DETAILED DESCRIPTION

Systems and methods are disclosed for unconventional innovative cooling solutions for heat-generating servers. The disclosed systems and methods may be used to provide direct-on-chip, two-phase, cooling (e.g., waterless cooling) to large server farms, as well as to smaller data centers, or even a single server rack, for example located in an office, hospital, or school. Approaches of the disclosed embodiments may be used to install a cooling system on a server, on a server rack (e.g., including server racks originally designed for air cooling), and/or in a server farm including many server racks. Moreover, in some implementations, some disclosed embodiments may preclude a need for specialized air-conditioning or cooling water and may eliminate hot spots resulting from insufficient air flow.

The disclosed embodiments may refer to one or more technical terms, which may be understood as follows:

Some embodiments involve coolant. A coolant is a substance used for reducing or regulating the temperature of a system. Heat reduction and regulation is achieved by transferring heat from a heat source to the coolant, carrying the absorbed heat to a different location, and releasing the carried heat into another medium such as a gas, liquid, or solid. Consistent with some disclosed embodiments, a coolant may be a non-aqueous, dielectric, non-electrically conductive, non-toxic, and/or non-explosive material, to prevent damage to computer components being cooled using the coolant. Non-limiting examples of coolants may include Coolant HFE7000 (generic), OptoneMZ (Dupont), R1233ZD (Honeywell), R1336mzz(Z), R514A, or any other material having a boiling point between about 10 and 40 degrees Celsius at atmospheric pressure. In some embodiments, different types of coolants may be used with higher or lower boiling point temperatures, depending on the design and needs of the system.

Some embodiments involve a two-phase cooling system. A two-phase cooling system provides thermal management in which a coolant transitions between two phases, such as between liquid and gas or vapor. Such a system is also referred to herein as a "dual-phase cooling system." Consistent with some disclosed embodiments, a two-phase cooling system may stream a coolant in a first phase such as a liquid directly to at least one heat-generating electronic component for on-site cooling. Heat from the at least one electronic component may convert a portion or all of the liquid coolant to a second phase such as vaporized coolant. The vaporized coolant may be collected from the at least one electronic component and streamed to a condenser. A condenser is a device that transfers heat from the vaporized coolant to convert it back into a liquid, to convert a portion or all of the vaporized coolant back to liquid form. In some embodiments, the condenser may use facility water to convert vaporized coolant to liquid. The liquified coolant may be stored in a buffer, or reservoir, from where it may be pumped back to the at least one heat-generating electronic component, in a cyclic manner for repeated cooling. In some embodiments, a two-phase cooling system may include one or more Enhanced Nucleation Evaporators (ENEs), at least one heat rejection unit (HRU), and/or at least one Refrigerant Distribution Unit (RDU).

Some embodiments include at least one Enhanced Nucleation Evaporator (ENE). An ENE is a heat exchanger for controlling a phase change from liquid into vapor. More particularly, ENEs control a nucleation process of evaporating liquid to vapor. Nucleation refers to a process in which a new phase or structure, form as small particles or clusters of particles within a different phase or medium. In the context of the disclosed embodiments, nucleation relates to the formation of gas bubbles as a liquid phase transitions to a gaseous phase. An ENE may include one or more structures for regulating and/or cooperating with other structures to regulate nucleation. For example, an ENE may include one or more structures for handling a coolant in a liquid phase, and may include one or more structures for handling coolant that has transitioned to vapor in a gaseous phase. Depending on the specific implementation, ENEs may include surface treatments, microchannels, varying geometries, or any other technique or technology that for controlling and/or aiding in a nucleation process. Consistent with some disclosed embodiments, an ENE may be thermally coupled directly onto each heat-generating electronic component (e.g., CPU, GPU, FPGA) in one or more computers. The ENE may be coupled by being physically attached to the heat-generating electronic component. Each ENE may include a heat conducting base plate defining a wall of a chamber, and the base plate may be directly attached to the heat-generating electronic component or thermally coupled to it via one or more intermediate components. The chamber of each ENE may include a region for containing liquid coolant and another region for containing vaporized coolant.

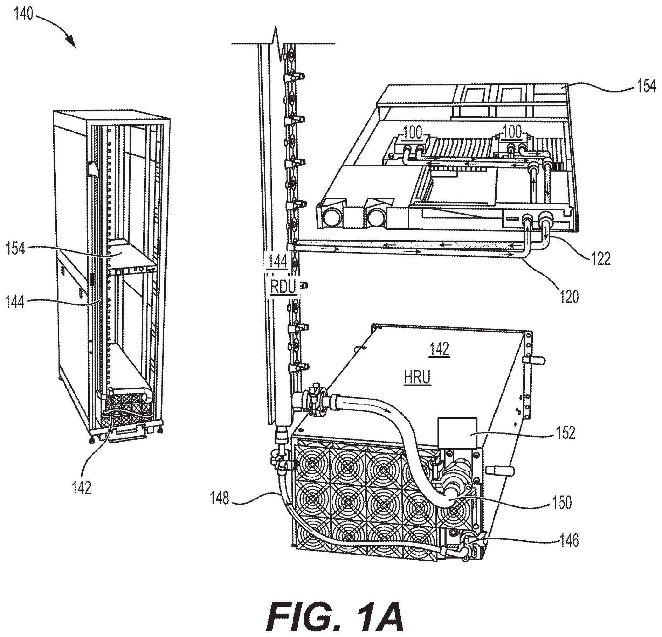

By way of non-limiting example, many of the figures illustrate an exemplary ENE 100. As illustrated in Fig. 1A, one or more ENEs 100 may be attached to one or more components in a server rack shelf 154. A liquid coolant line 120 carries coolant that is at a first, lower temperature to each of the ENEs 100. A vapor line 122 carries vaporized coolant that is at a second, higher temperature from the ENEs 100 to a heat transfer device such as a Heat Rejection Unit. In some embodiments, such as the illustration in Fig. 1A, lines 120 and 122 may be connected to a refrigerant distribution unit (RDU), described in further detail below.

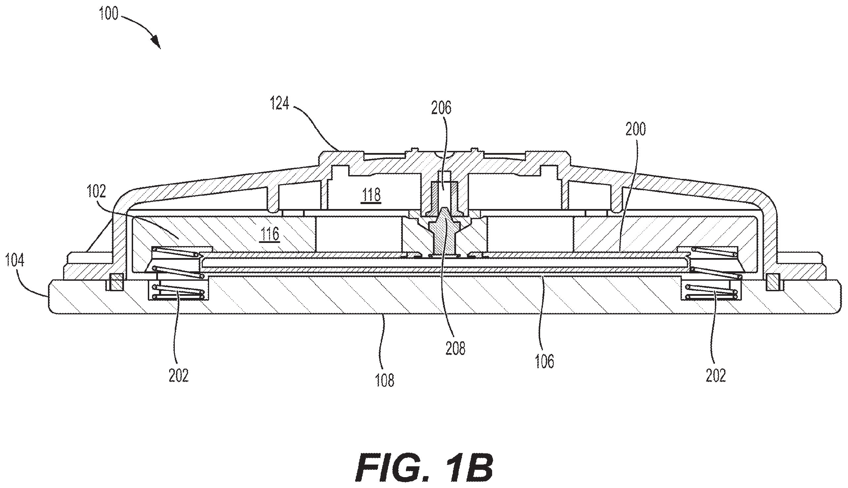

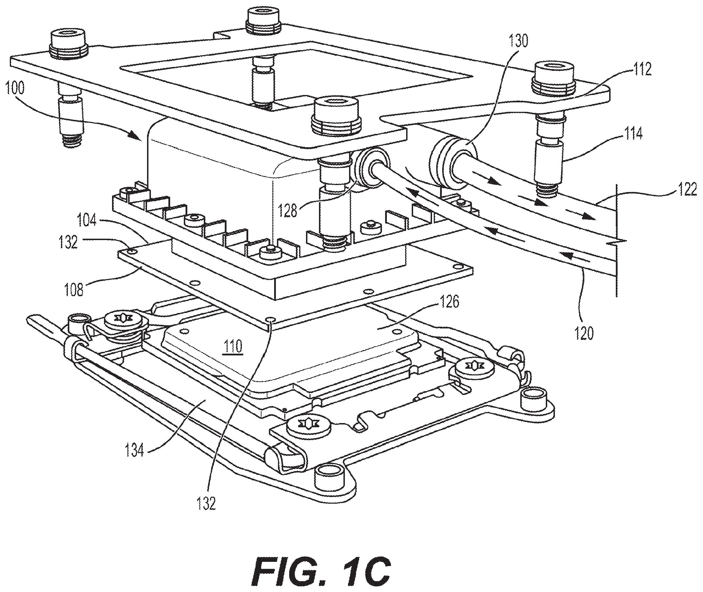

A non-limiting example of a configuration of an ENE 100 is illustrated in Fig. 1B. Fig. 1B shows a cross-sectional view of an ENE 100. Consistent with some disclosed embodiments, ENE 100 is a heat exchanger device with at least one chamber 102 for containing a liquid coolant. In some embodiments, chamber 102 may be configured for thermal contact with the solid-state electrical component (such as electronic component 110 shown in Fig. 1C). For example, chamber 102 may have at least one heat conductive wall 104 that is a first heat transfer wall. Heat conductive wall 104 is configured for thermal contact with the heat generating element (such as electronic component 110 shown in Fig. 1C). In some embodiments, ENE 100 includes a second heat transfer wall formed as an outer surface 124 of the ENE 100. The first and second heat transfer walls may be separated by one or more cavities of chamber 102. Potential configurations of ENE 100 are discussed further below.

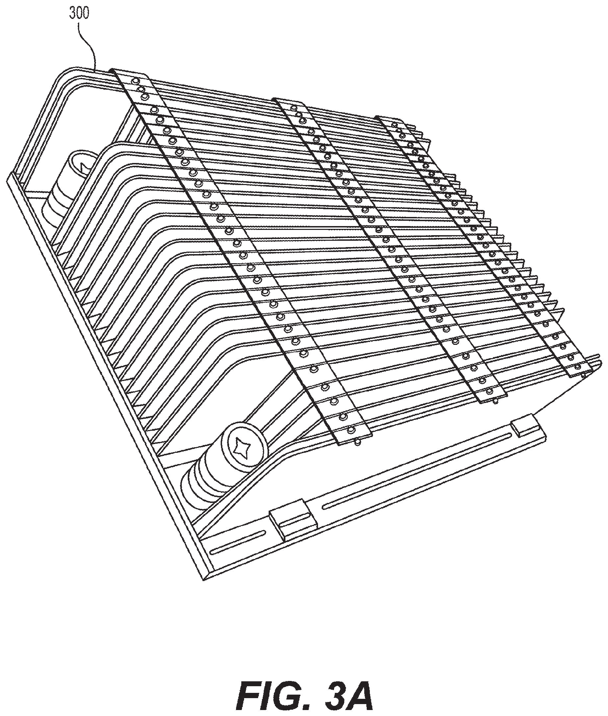

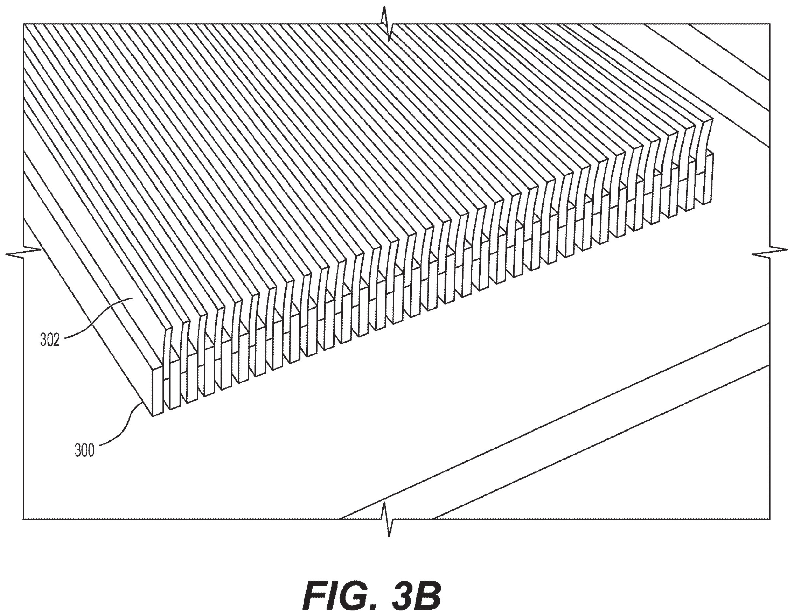

In some disclosed embodiments, and as illustrated in Figs. 3A and 3B, ENE 100 may include one or more heat exchanging components such as fins 300 extending from the first heat transfer wall 104 into the chamber 102, for transferring heat from the heat transfer wall 104 to the liquid coolant in the cavity of chamber 102, thereby providing a cooling effect for an electronic component 110 associated with the ENE 100.

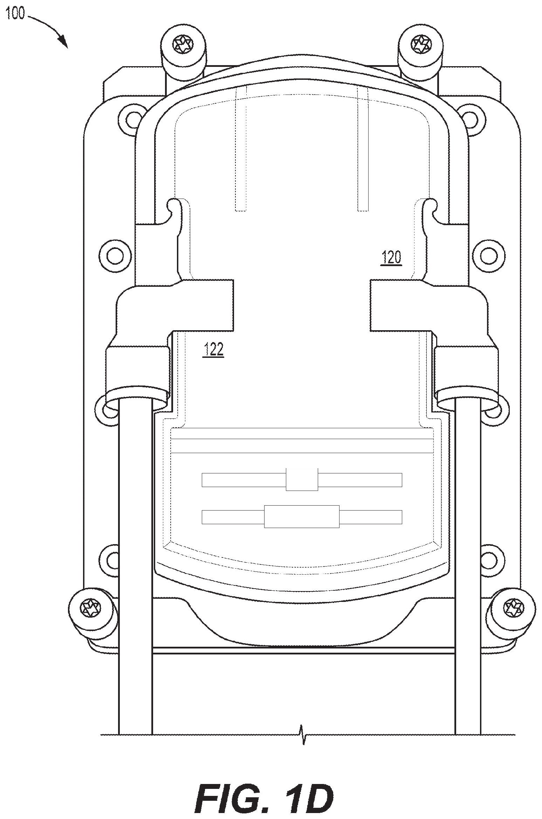

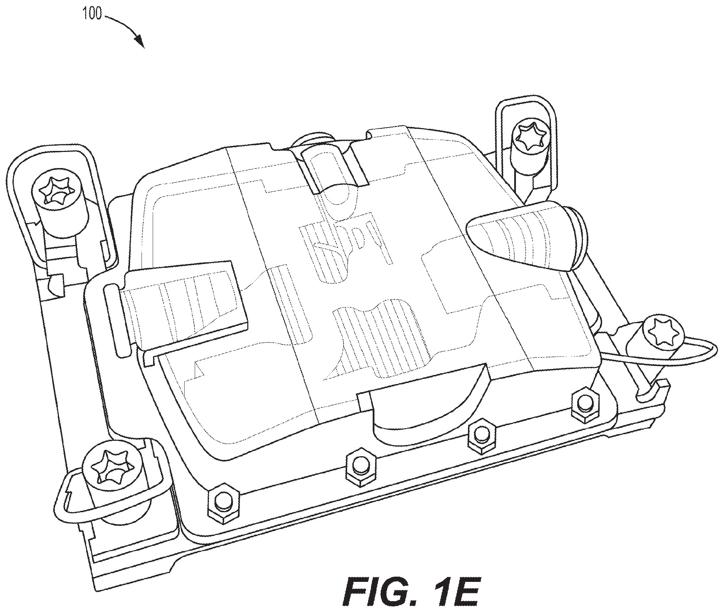

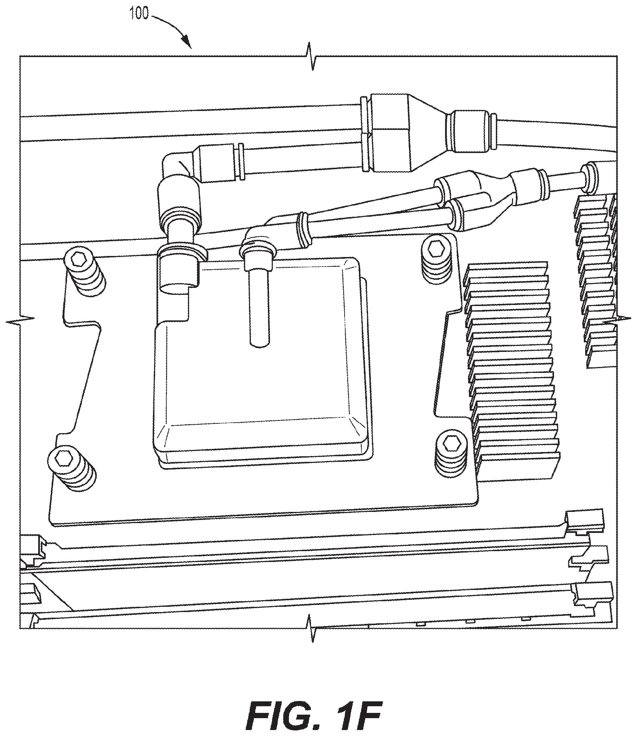

Figs. 1D, 1E, and 1F illustrate additional examples of ENEs, consistent with disclosed embodiments. As shown in Figs. 1D-1F, ENE 100 may have a variety of shapes, form factors, and dimensions, depending on the system design requirements. Each ENE 100 includes connections for a vapor line that carries vaporized coolant, and a liquid coolant line that carries coolant in liquid form, such as vapor line 122 and liquid coolant line 120, respectively, labeled in Fig. 1D.

Some embodiments may involve a Heat Rejection Unit (HRU). An HRU refers to a structure that transfers or dissipates heat generated within a system to a surrounding environment. Heat may be dissipated using one or more mechanisms such as conduction, convection, or radiation, from the vaporized coolant to the environment. Consistent with some disclosed embodiments, an HRU enables vaporized coolant to transfer heat to a heat sink, allowing the vaporized coolant to transition to liquid coolant, thereby enabling two-phase cooling. In some embodiments, the heat sink may transfer heat to another liquid such as facility water, or to gas such as air. Depending on implementation, an HRU may include or may be associated with at least one condenser, a reservoir, a controller (e.g., at least one processor), and at least one pump. The condenser may collect vaporized coolant from each ENE via a vapor line. The condenser may be thermally coupled to a heat sink, such as cool facility water. The heat sink may cause the vaporized coolant introduced into the condenser inlet to liquify to liquid coolant. The liquid coolant may be channeled to a reservoir. The at least one pump may pump the liquid coolant to the ENEs in a cyclical manner for continued cooling. The controller may regulate the pump revolutions per minute (RPM) to ensure consistent and reliable cooling. In some embodiments, a single HRU may be provided to cool heat-generating components of an entire server rack. A non-limiting example of an HRU 142 is illustrated in Fig. 1A.

Some embodiments may involve a Refrigerant Distribution Unit (RDU). An RDU refers to a component or system that manages coolant distribution. Refrigerant is synonymous with coolant, as described and exemplified herein. Distribution refers to moving or spreading coolant throughout a system, such as throughout a system of tubing to various components in the system. The coolant may be spread evenly throughout a system or may be spread unevenly, if a system is designed for uneven distribution. In some embodiments, coolant flows through one or more pipes, channels, or trenches of the RDU to move between components of the system. Consistent with some disclosed embodiments, an RDU may fluidly couple an HRU to at least one ENE, each of which are coupled to at least one heat-generating electronic components of one or more servers. In some embodiments, a single RDU may couple one or more HRUs to each heat-generating electronic component in a server rack. The RDU may include two separate tubing systems, one tubing system for delivering liquid coolant from the reservoir of the HRU to each ENE, and another tubing system for collecting vaporized coolant from each ENE and delivering the vaporized coolant to the condenser of the HRU. In some embodiments, an RDU may be mounted along the height of a server rack, fluidly coupling the HRU to each shelf of the server rack. In some embodiments, an RDU may be integrated with a server rack (e.g., one or more of the tubing systems may be located inside one or more supports of the server rack). A non-limiting example of an RDU 144 is illustrated in Fig. 1A.

In some embodiments, liquid coolant may be delivered to each ENE via a liquid coolant line flow connected to a reservoir of an HRU, e.g., using one or more pumps of the HRU. Heat from the heat-generating electronic component may flow through the heat conducting base plate of each ENE and may be absorbed by the liquid coolant in the chamber, causing the liquid coolant to boil and form vaporized coolant. The vaporized coolant may exit the chamber to a vapor line flow connected to the condenser of the HRU.

For example, Fig. 1A illustrates an exemplary two-phase cooling system 140 including multiple ENEs 100, each ENE 100 thermally coupled to a heat-generating electronic component 110, an HRU 142, and an RDU 144, consistent with disclosed embodiments. HRU 142 may include at least one condenser, a reservoir, and at least one pump 146. In some embodiments, each server rack of a server farm may include a single HRU 142. A pump 146 may push liquid coolant from the reservoir via a main liquid line 148 to a liquid tubing system of RDU 144. The liquid tubing system of RDU 144 may convey the liquid coolant to a liquid coolant line 120 (e.g., configured to deliver liquid coolant to a shelf of a server rack), which may deliver the liquid coolant to each ENE 100 coupled to heat-generating electronic components 110. Heat from heat-generating electronic components 110 may flow into each thermally coupled ENE 100, where the heat may be absorbed by the liquid coolant, causing the liquid coolant to boil and form vaporized coolant. The vaporized coolant may be collected from the multiple ENEs 100 and delivered via a vapor line 122 (e.g., configured to evacuate vaporized coolant from shelf of a server rack). Vapor line 122 may convey the vaporized coolant via a vapor tubing system of RDU 144 to the condenser of HRU 142. Facility water delivered to HRU 142 may cool the vaporized coolant and convert the coolant to liquid form. The liquefied coolant may flow to the reservoir of HRU 142, and the one or more pumps 146 may push the liquid coolant back to ENEs 100 in a cyclical manner for repeated cooling of electronic components 110.

Consistent with disclosed embodiments, a "processor" or "at least one processor" may include any physical device or group of devices having electric circuitry that performs a logic operation on an input or inputs. For example, a processor or at least one processor may include one or more integrated circuits (IC), including an application-specific integrated circuit (ASIC), a microchip, a microcontroller, a microprocessor, all or part of a central processing unit (CPU), a graphics processing unit (GPU), a digital signal processor (DSP), a field-programmable gate array (FPGA), a server, a virtual server, a virtual computing instance (e.g., a virtual machine or a container), or other circuits suitable for executing instructions or performing logic operations. The instructions executed by at least one processor may, for example, be preloaded into a memory integrated with or embedded into the controller or may be stored in a separate memory. The memory may include a Random Access Memory (RAM), a Read-Only Memory (ROM), a hard disk, an optical disk, a magnetic medium, a flash memory, other permanent, fixed, or volatile memory, or any other mechanism capable of storing instructions. In some embodiments, the at least one processor may include more than one processor. Each processor may have a similar construction, or the processors may be of differing constructions that are electrically connected or disconnected from each other. For example, the processors may be separate circuits or integrated in a single circuit. When more than one processor is used, the processors may be configured to operate independently or collaboratively and may be co-located or located remotely from each other. The processors may be coupled electrically, magnetically, optically, acoustically, mechanically or by other means that permit them to interact. Some disclosed embodiments may be software-based and may not require any specified hardware support.

Consistent with some embodiments, in Fig. 1A at least one processor 152 may control one or more aspects of two-phase cooling system 140 based on one or more signals received from one or more sensors. For instance, sensors may be provided to measure pump speed (e.g., RPM) of at least one pump 146, liquid pressure in a liquid coolant line (e.g., liquid coolant lines 120 and/or 148), vapor pressure in a vapor coolant line (e.g., vapor coolant lines 122 and/or 150), a state of one or more controllable valves (e.g., in vapor coolant line 122), temperature (e.g., of electronic component 110 and/or of coolant, such as in ENE 100 and/or in the condenser of HRU 142), or any other measure relevant to controlling two-phase cooling system 140. For example, processor 152 may use one or more of the signals to control a pump speed (e.g., RPM, stop time, start time, or idle time), thereby controlling an amount and/or rate of liquid coolant delivered to ENEs 100. As another example, processor 152 may use the signals to control one or more controllable valves (e.g., by controlling a current or voltage signal delivered to a solenoid controlling the valve) in vapor line 122, thereby controlling vapor coolant flow from ENEs 100 to the condenser of HRU 142. Additionally, or alternatively, processor 152 may use one or more signals to determine leakage (e.g., vapor and/or liquid coolant leakage) in system 140, and/or a clock speed for one or more heat-generating electronic components 110.

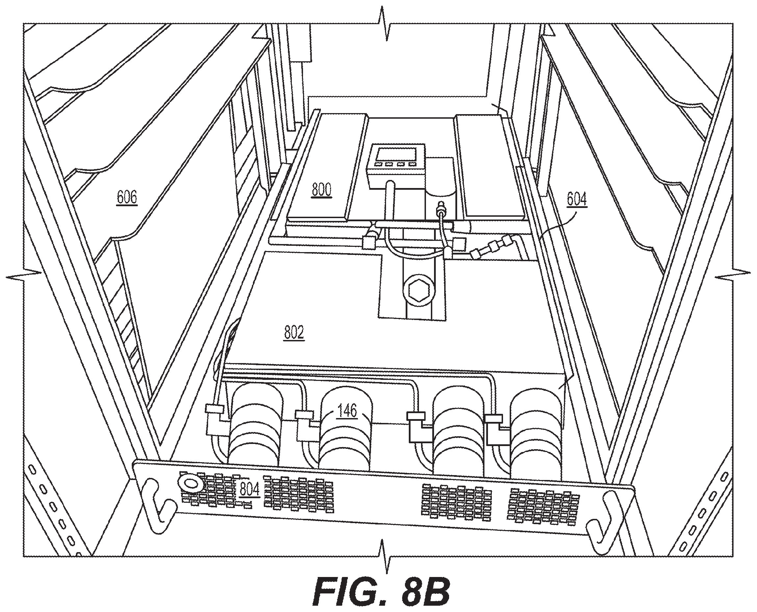

Consistent with disclosed embodiments, in Fig. 1A, HRU 142 may include a condenser flow connected to a reservoir (e.g., condenser 800 and reservoir 802 shown in Fig. 8B), at least one pump 146, and at least one processor 152. At least one pump 146 may pump liquid coolant stored in the reservoir via main liquid coolant line 148. Main liquid coolant line 148 may deliver the liquid coolant, via a liquid tubing system of RDU 144, to liquid coolant line 120 (e.g., one per server slot), which may deliver liquid coolant to multiple ENEs 100 on a server in a server rack. Vaporized coolant line 122 (e.g., one per server slot) may collect vaporized coolant from each ENE 100 on a server and stream the vaporized coolant to a vapor tubing system of RDU 144, which may deliver the vaporized coolant to the condenser of HRU 142 via a main liquid line 150. In some embodiments, vaporized coolant line 122 may include a valve controllable by processor 152 (e.g., a solenoid valve), allowing processor 152 to control pressure in vaporized coolant line 122 and/or ENEs 100. The condenser may convert the coolant to liquid form. The liquefied coolant may flow to the reservoir, from where it may be pumped back to ENEs 100. A processor 152 may control one or more aspects of two-phase cooling system 140, as described in greater detail herein below.

Some disclosed embodiments involve one or more chambers. A chamber refers to an enclosed space. The chamber may take the form of a compartment or cavity within a device, the chamber being generally distinct from or partitioned from other compartments or cavities in the device, and may be partially or totally enclosed. A chamber may further be configured to contain a coolant and/or to enable coolant flow therethrough. A chamber may be structurally connected to a heat-generating component and may include or be associated with a heat conducting wall to facilitate the transfer of thermal energy (e.g., heat) from the heat-generating component through the heat conducting wall to coolant inside the chamber. A chamber may be designed to house components that contribute structurally and/or functionally to a cooling process. For example, in some embodiments, fins and/or wicks may be contained within the chamber. A chamber may further involve a liquid inlet, a vapor outlet, and a valve to facilitate and control the flow of coolant into and out of the chamber. Further, a chamber may involve fins structurally attached to an outside the chamber.

Consistent with disclosed embodiments, a heat-generating component is a component that generates thermal energy (heat). The heat-generating component may generate heat intentionally as a primary function of the component, accidentally due to malfunction or unintended use of the component, and/or as a byproduct of a primary function of the component. A heat-generating component may further involve an electrical component. An electrical component may be a solid-state electrical component. A solid-state electrical component may involve a processor. A solid-state electrical component may involve a microchip. An electrical component such as a microchip generates an amount of heat due to one or more characteristics or operational parameters of the electrical component. For example, a microprocessor generates an amount of heat that is generally inversely proportional to an efficiency of the microprocessor. As another example, a microprocessor generates heat as a byproduct of performing computing operations.

Consistent with disclosed embodiments, a heat conducting wall (also referred to as a heat conductive wall) is a structure designed to efficiently conduct heat therethrough. A wall is a barrier that separates or encloses one space or component from another. The wall conducts heat by transferring heat through materials that are in direct contact with one another, such as transferring heat from a heat-generating component that is in physical or thermal contact with the heat generating wall. A heat conducting wall may conduct thermal energy (e.g., heat) from a region of higher temperature to a region of lower temperature. Further, a heat conducting wall may not permit the movement of coolant from one side to another side. A heat conducting wall may spread concentrated heat generated by a heat-generating electronic component over a larger surface area. Further, a heat conducting wall may facilitate temperature control and/or management. A heat conducting wall may be made of a thermally-conductive material. In some embodiments, materials with high thermal conductivity may be used to maximize a volume and/or efficiency of heat transfer from the heat-generating component. The materials may include metals such as copper, iron, steel, aluminum, and any other metal with high thermal conductivity. Further, the materials may include ceramics such as alumina, silicon carbide, boron nitride, silicon nitride, titanium diboride, aluminum nitride, and any other ceramic with high thermal conductivity.

Some disclosed embodiments include one or more fins. A fin is a structural component that transfers heat from a heat sink to an environment surrounding the fin. A fin may have a wide range of geometries depending on the material of the fin and desired heat transfer properties. In some embodiments a fin is a thin, flat, and/or elongated component. The fin is structurally attached to one or more surfaces that conduct heat to the fin. A fin may be designed to increase surface area available for heat dissipation and/or absorption. For example, a fin may be structurally attached to the heat transfer wall of a chamber such that heat may also be transferred through the heat conducting wall to the fins. Further, a fin may be structurally attached to the outer surface of a chamber to facilitate the transfer of thermal energy from within the chamber to an outside environment.

In some embodiments, one or more sets of heat conductive fins may be employed to cool an ENE. An internal set of fins may be located within the heat exchanger cavity of an ENE, and an external set of fins may be located external (e.g., on a surface) of the ENE. For example, each ENE may have a heat conductive case. Liquid (e.g., coolant) may cool the internal fins (e.g., submerged inside a pool of liquid coolant contained in the chamber of the ENE) and air may cool the external fins (e.g., supported by an external housing of the ENE and exposed to ambient air). For example, one or more fans (e.g., configured with a server rack and/or a server) may blow ambient air over the surface an ENE, allowing the external fins to radiate heat from the ENE to the ambient air.

In some embodiments, the heat exchanger may further include a heat conduit extending from the base to an area adjacent the second plurality of fins. A heat conduit may include a component or structure that facilitates the transfer of thermal energy from one location to another. Further, a heat conduit may be designed to efficiently conduct heat from a heat source to a heat sink or cooling medium, thereby helping to maintain the temperature of a system.

Some disclosed embodiments include one or more wicks. A wick facilitates the movement or transfer of a substance (e.g., liquid, vapor) from one location to another. In some embodiments, a wick is a piece of material or a structural arrangement of one or more materials that conveys or draws other material such as a liquid or gas. In some embodiments, at least one wick is structurally attached to a fin and/or sandwiched between opposing fins. Further, a wick may be designed to facilitate the movement of vaporized coolant bubbles through gaps between adjacent fins away from a heat transfer wall.

Some disclosed embodiments include a liquid inlet. An inlet is a passage, opening, or entrance. In some embodiments, a liquid inlet allows a liquid to enter a specific area, container, system, or device. A liquid may include liquid coolant, as discussed herein. In some embodiments, the liquid inlet may be configured to allow for entry or introduction of the liquid coolant into one or more chambers.

Some disclosed embodiments involve a vapor outlet. A vapor outlet refers to a passage, opening, or egress that allows vapor to exit a specific area, system, or device. Vapor may include a vaporized liquid coolant. A vapor outlet may be configured to allow for the passage of vaporized liquid coolant out of a chamber. In some embodiments, the outlet may be further configured to evacuate vaporized liquid coolant from the chamber. In some embodiments, the outlet may be configured to additionally evacuate heated liquid coolant.

Some disclosed embodiments involve a float. A float refers to a buoyant component (e.g., float valve, flow restrictor, or restrainer) for regulating a fluid level. For example, due to buoyancy, a float's position may change depending on a liquid level within a chamber containing the float. As a fluid level in a chamber rises, the fluid may exert a buoyancy force causing a float valve to elevate and engage with an inlet port, thereby blocking further inflow of liquid coolant into the chamber until the level of the fluid decreases sufficiently to disengage the float valve from the inlet port.

Consistent with some embodiments, Fig. 1A shows an exemplary system 140. System 140 may include HRU 142 flow-connected via RDU 144 to at least one ENE 100 (e.g., a two-phase cooling chamber) on a server rack shelf 154. System 140 also includes at least one pump 146 for circulating liquid and/or vaporized coolant through one or more components of system 140. The design and operation of system 140 components is described and exemplified in further detail below.

System 140 may include at least one processor 152 configured to monitor and/or control pump 146. Processor 152 may receive multiple signals from pump 146, such as an outlet liquid pressure, an RPM, and liquid availability to a pump suction port. In some embodiments, processor 152 may detects that liquid is available at the suction port, determine that an increase in pump RPM does not result in an increase in outlet liquid pressure, and to prevent pump burnout, processor 152 may output a signal to decrease the pump RPM. For example, processor 152 may cause pump 146 to idle, e.g., in a gradual transition and/or one or more step functions. Following causing the pump RPM to decrease, processor 152 (e.g., based on receiving additional signals) may cause the pump RPM to increase (e.g., gradually). In some cases, HRU 142 may include multiple pumps 146, and processor 152 may control the multiple pumps (e.g., to reduce and/or increase the pump RPM) in a staggered manner (e.g., round robin).

In some embodiments, processor 152 may receive a measure of power drawn by electronic components 110 cooled by ENEs 100 over a time period, as well as a measure of liquid coolant flowing through ENEs 100 during the same time period (e.g., based on an RPM of pump 146).

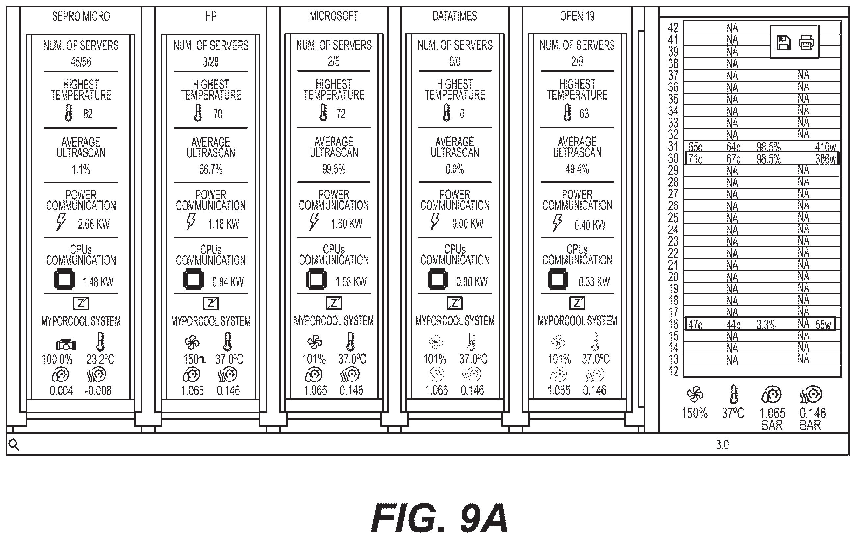

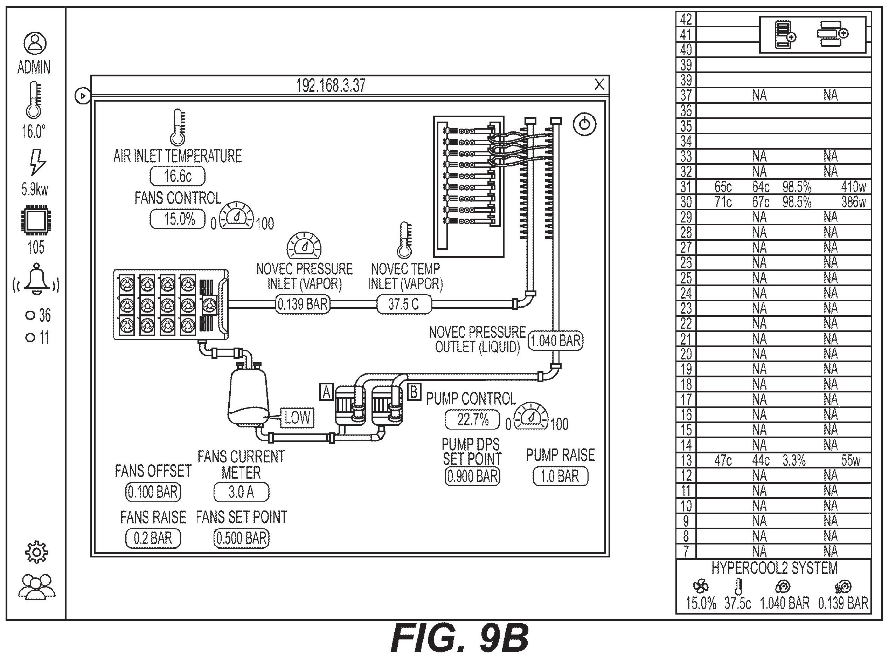

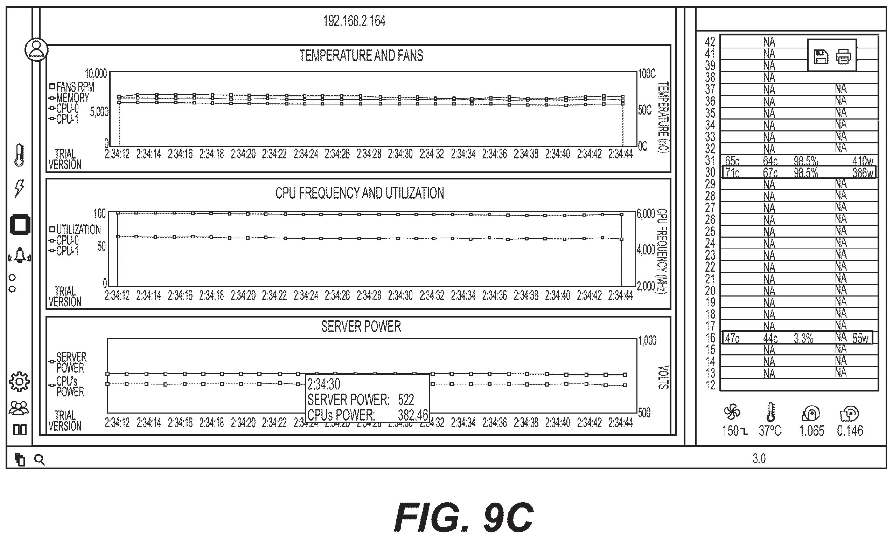

Consistent with disclosed embodiments, Figs. 9A-9C illustrate some exemplary measurements received via one or more sensors configured with system 140. In some embodiments, processor 152 may obtain a reference correlating a predefined power output versus liquid coolant flow to determine leakage, for example if a ratio between the measured power versus the measured liquid flow differs from the reference correlation. Processor 152 may use one or more of the measurements to determine leakage (e.g., liquid and/or vapor leakage).

Referring again to Fig. 1A, processor 152 may receive a measure of power drawn by electronic components 110 cooled by ENEs 100 over a time period. ENEs 100 may be flow connected to vapor line 150 conveying vaporized coolant from ENEs 100 to HRU 142. Vapor line 150 may include a one-way valve to prevent backflow of vapor towards ENEs 100. Processor 152 may additionally receive a measure of temperature associated with electronic components 110 during the time period. If the temperature drops during the time period while the measure of power drawn indicates no substantial change, processor 152 may determine vapor leakage and invoke a remedial action (e.g., a warning).

ENE 100 may include heat conductive wall 104 (e.g., a plate) for mounting on heat generating electronic component 110 to cool electronic component 110 (shown in Fig. 1B). HRU 142 may be configured with a pump 146. Pump 146 may be fluidly connected to a liquid coolant port of ENE 100 via liquid coolant lines 120 and 148 (e.g., and the liquid tubing system of RDU 144), allowing pump 146 to push liquid coolant from the condenser of HRU 142 to each ENE 100. System 140 may additionally include vapor coolant lines 122 and 150 for conveying vaporized coolant from ENE 100 (e.g., via the vapor tubing system of RDU 144) to the condenser of HRU 142. ENE 100 may be configured with a self-regulating float valve 200, as described earlier, to adjust an inflow of liquid coolant.

With reference to Figs. 1B-1C and 3A-3B, a first set of fins 300 (e.g., with interleaving wicks 302) may be located on inner surface 106 of heat conductive wall 104 (e.g., a first heat transfer wall), extending into chamber 102 and submerged inside pool 116. The first set of fins 300 may allow heat conveyed from electronic component 110 to radiate into liquid coolant contained in pool 116. In some embodiments, the heat exchanger may include a second plurality of fins extending from a second heat transfer wall external to the cavity, the second plurality of fins being configured for flow communication with ambient airflow external to the cavity. For example, a second set of fins 300 may be located on outer surface 124 (e.g., a second heat transfer wall) of ENE 100, extending outwards from ENE 100 into the surrounding environment (e.g., a room housing a server rack). The second set of fins 300 may allow some of the heat (e.g., from electronic component 110) to radiate from chamber 102 (e.g., via the liquid coolant contained in pool 116 and the vaporized coolant contained in the second portion 118 of chamber 102) to the ambient air. In some embodiments, a heat conduit may extend from inner surface 106 of heat conductive wall 104 (e.g., a base) to an outer surface of ENE 100, adjacent to the second set of fins 300, e.g., allowing some heat to flow through chamber 102 into the ambient air.

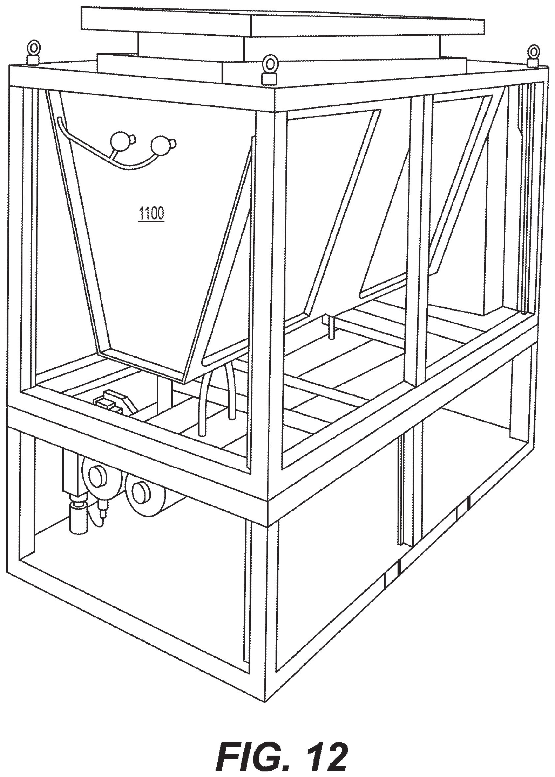

Fig. 12 illustrates an exemplary central heat rejection unit (HRU) 1100, consistent with some embodiments. Rather than associating a large number of indoor condensers with many server racks, a single large (HRU) may be employed for cooling the ENEs in an entire server farm, or a large portion thereof. HRU 1100 may be configured to be located external to a server farm (e.g., outside) while being flow connected to multiple server racks containing multiple ENEs 100 thermally coupled to multiple heat-generating electronic components 110 internal to the server farm. Such a configuration may enable collecting heat generated by multiple heat-generating electronic components 110 inside a server farm and evacuate the collected heat external to the server farm.

Regulating an inflow of liquid coolant to a cooling device for an individual solid state component may enable simultaneously cooling of different electronic components generating different quantities of heat. For example, at any given time, different electronic components may execute different workloads causing different levels of heat to be generated. Some disclosed embodiments include a self-regulating valve for a dual phase on-chip cooling device that may regulate coolant inflow based on an amount of heat generated by an electronic component thermally coupled thereto.

Some disclosed embodiments involve a cooling device for a solid-state electronics component with a component surface that heats during operation. Heat refers to thermal energy and may be measured in Joules or calories. Heat may be transferred between systems due to a temperature difference therebetween. For example, an electronic device may generate heat internally during operation. The heat may radiate outwards to a cooler surrounding environment, causing an increase in temperature of the surrounding environment and a decrease in temperature inside the electronic device. However, if sufficient heat is released by the device such that the surrounding environment reaches the temperature of the device, heat transfer may cease. Such a situation may cause the electronic device to overheat and/or fail. A cooling device refers to an apparatus configured to remove or expel heat. For instance, a cooling device may draw heat away from a heat-generating device. Examples of cooling devices may include a fan, an air conditioner, a refrigerator, a heat pump, and/or a coolant bath and/or pool. A component refers to a unit and/or an element. A solid-state electronics component refers to a device made of a semiconductor material through which electricity may flow. Examples of semiconductor materials may include silicon, gallium arsenide, germanium, and/or any other material that has electrical conductivity between that of a conductor and an insulator. Some examples of solid-state electronics components may include microprocessors, microcontrollers, application specific integrated chips (ASICs), memory chips, and/or system-on-a-chip devices (SoCs). A solid-state electronics component may include a plurality of switches configured to perform logical and/or arithmetic operations within an operating temperature range. Such operations may generate heat which must be evacuated to maintain operation of the component within the operating temperature range. A component surface refers to an exterior and/or outermost layer of a component. A component surface may be exposed to a surrounding environment, and may enable heat transfer between the solid-state electronics component and the environment. Heats during operation refers to an increase or generation of thermal energy while performing one or more tasks and/or processes. For example, a microprocessor may generate heat during performance of one or more computations. A surface that heats during operation may be part of, attached to, or proximate the operating device.

For instance, an individual cooling device may be provided for an individual solid-state electronic component to evacuate heat from the component and maintain the component within an operating temperature range. In some embodiments, a plurality of individual cooling devices may be provided for a plurality of individual solid-state electronic components, allowing each individual solid-state electronic component to be cooled separately. This may allow simultaneous cooling of differing solid-state electronic components operating at differing workloads and generating differing amounts of heat. For example, each individual cooling device may evacuate an amount of heat substantially corresponding to an amount of heat generated by the associated solid-state electronic component, allowing to simultaneously cool differing components operating at differing workloads and generating differing amounts of heat to a substantially uniform temperature.

By way of a non-limiting example, Figs. 1B-1C show a cooling device (e.g., ENE 100) for a solid-state electronics component 110 with a component surface 126 that heats during operation. Mounting ENE 100 on surface 126 may allow heat to flow from solid-state electronics component 110 to ENE 100.

Some disclosed embodiments involve a chamber having a first region defining a pool with a heat conducting wall. A chamber refers to an at least partially enclosed compartment and/or cavity, as described and exemplified elsewhere herein. In some embodiments, a chamber may include one or more openings to enable fluid to enter and/or exit the chamber. A pool refers to a fully or partially enclosed area or reservoir for containing liquid. For example, a chamber may include a pool for holding a volume of liquid. In some instances, a pool may lack an opening to allow liquid to escape, such that when an inflow of liquid is restricted, liquid in the pool may become stagnant. A heat conducting wall refers to a barrier and/or partition capable of heat transfer, as described and exemplified elsewhere herein. In some instances, a heat conducting wall may be made of a material conductive for transferring heat, such as metal (e.g., aluminum, copper, silver, gold, molybdenum, zinc, and/or tungsten), semiconductor (e.g., silicon carbide), graphite, and/or other materials that facilitate the transfer of heat energy from one side of the wall to the other side. A chamber having a first region defining a pool with a heat conducting wall refers to an enclosure having a section configured for containing a liquid. For example, the section may be a bottom portion of the chamber where liquid may accumulate.

Some embodiments involve a heat conducting wall having an inner surface constituting a wall of a pool. An inner surface refers to an interior and/or internal side. For example, an inner surface of a wall of a chamber may be located inside the chamber. A heat conducting wall having an inner surface constituting a wall of the pool refers to a side of a heat conducting wall located inside a chamber, and defining at least part of a volume configured for containing a liquid.

Some disclosed embodiments involve a heat conducting wall having an outer surface, opposite the inner surface for thermal contact with a component surface and for conducting heat therefrom into a pool. An outer surface refers to an external side. For example, an external surface of a wall of a chamber may be located external to the chamber. An outer surface, opposite the inner surface of a wall refers to an external side of the wall facing contrary to an inner side of the wall. For example, an inner surface of a heat conducting wall of a chamber may be exposed to a pool of liquid inside the chamber, and an outer surface of the heat conducting wall, opposite the inner surface, may be exposed to an environment external to the chamber. Thermal contact refers a thermal junction or interface between two surfaces or elements for facilitating an exchange of heat. For example, if a hot element at a first temperature is in thermal contact with a cold element at a second temperature lower than the first temperature, heat may transfer from the hot element to the cold element, toward equilibrium between the first temperature and the second temperature. In some instances, thermal contact may include physical contact (e.g., touching), thereby enabling heat transfer therebetween. Conducting heat refers to a conveyance and/or transfer of heat. For example, a material capable of conducting heat may include particles arranged sufficiently close together to allow thermal energy to be exchanged between the particles, and flow, on average, from a higher temperature region to a lower temperature region. In some embodiments, heat is conducted by flowing from a region of higher temperature to a region of lower temperature within a material or between materials that are in physical contact. Conducting heat therefrom into the pool refers to conveying heat through a heat conducting wall to allow the heat to dissipate into a liquid contained in the pool. For example, heat may transfer from a component surface, through the heat conducting wall, into the inner surface of the heat conducting wall to the liquid contained in the pool.

For example, a cooling device may include a capsule containing a chamber. For instance, the top of the capsule may be made of reinforced polymer. The chamber may have a heat conducting base, or wall. For instance, the heat conducting base or wall may be made of metal. Liquid coolant may flow into the chamber and collect to form a pool on an inner surface of the heat conducting wall. Heat may pass from an outer surface of the heat conducting wall (e.g., from the bottom of the base of the capsule), through the heat conducting wall to the inner surface, and transfer to the pool of liquid coolant inside the chamber.

By way of a non-limiting example, in Fig. 1B, ENE 100 may include chamber 102 having a first region defining a pool 116 with heat conducting wall 104. Heat conducting wall 104 may have inner surface 106 constituting a wall of pool 116. Heat conducting wall 104 may have an outer surface 108, opposite inner surface 106 for thermal contact with component surface 126 (see Fig. 1C). Heat conducting wall 104 may permit conduction of heat from solid-state electronics component 110 into pool 116. For instance, the heat may transfer from component surface 126 to outer surface 108, to inner surface 106, and into liquid coolant collected in pool 116.

Some disclosed embodiments involve a liquid coolant inlet integrated with a chamber. Liquid coolant refers to a substance used to remove or transfer heat, as described and exemplified elsewhere herein, while in a liquid state. For example, vaporized coolant may undergo condensation to transform to liquid coolant. A liquid coolant inlet may be understood similar to a liquid inlet, as described, and exemplified elsewhere herein. For example, a liquid coolant inlet may be fluidly coupled to a reservoir containing liquefied coolant and an associated pump configured to deliver liquid coolant thereto. In some embodiments, a liquid coolant inlet may be associated with one or more devices preventing liquid coolant from exiting via the inlet. For example, a pump maintaining a pressure differential and/or a valve may prevent a reverse flow of liquid coolant. Integrated with the chamber refers to unified and/or joined with the chamber. In some embodiments, a port (e.g., an inlet and/or an outlet) may be manufactured with a chamber as a single, integral piece made of molded material, such as plastic. Alternatively, in some embodiments, a port may be connected to a chamber mechanically or through bonding, where the connection may be scaled (e.g., using a sealant) to prevent leakage. For example, liquid coolant may be delivered from a reservoir to an interior of a chamber via a liquid coolant inlet integrated therewith, and vaporized coolant may exit the interior of the chamber via a vaporized coolant outlet integrated therewith.

Some disclosed embodiments involve a liquid coolant inlet for supplying liquid coolant to a pool to thereby enable pool boiling of a liquid coolant and conversion of the liquid coolant into vaporized coolant. Supplying liquid coolant to a pool refers to delivery of liquid coolant to a region of the chamber defining the pool. For example, a region defining a pool in a chamber may be located in a bottom region of the chamber. In some instances, supplying liquid coolant to a pool may include delivering liquid coolant in a manner enabling the liquid coolant to reach the bottom region of the chamber where a pool is located. For instance, the chamber may include one or more channels delivering liquid coolant from the inlet to the pool region. Boiling refers to a phase transition from a liquid state to a gaseous or vapor state. Boiling may occur by heating a liquid to reach a boiling temperature of the liquid, at which point the liquid may transition to a gaseous state, such as to vapor. The boiling temperature of a liquid may depend on ambient pressure, such that adjusting the ambient pressure may cause a corresponding adjustment to the boiling temperature. Pool boiling refers to causing at least some liquid in a volume to boil by subjecting the volume to a heat source. For example, locating a heat conducting wall in thermal contact with a heat generating component inside a pool of liquid coolant may cause heat to flow from the heat generating component through the heat conducting wall to the liquid coolant. The inflow of heat may increase the temperature of at least some of the liquid coolant to reach the boiling temperature, causing the at least some of the coolant to transition to vapor. In some embodiments, a liquid used for pool boiling may be stagnant, e.g., neither flowing in nor flowing out. In some embodiments, a chamber used for pool boiling may allow liquid coolant to flow into the chamber, but may not allow coolant to flow out of the chamber in liquid form, such that restricting an inflow may cause liquid contained therein to become stagnant. Vaporized coolant may refer to a gaseous state for a coolant substance. For example, liquid coolant undergoing boiling may transform to vaporized coolant. Conversion of liquid coolant into vaporized coolant refers to a state transition of coolant from a liquid phase to a gaseous phase. For example, an inflow of thermal energy (e.g., heat) to a volume of liquid coolant may cause at least some molecular bonds associated with a liquid phase of the coolant to break, which may cause at least some of the liquid coolant to transform to vaporized coolant. In some disclosed embodiments, the liquid coolant is a non-electrically conductive material. A non-electrically conductive material refers to a material such as an insulating substance that blocks or prevents electricity from travelling therethrough. For example, a leak in a tube and/or connection may expose one or more electronic components to liquid coolant. Ensuring that the liquid coolant is non-electrically conductive material may prevent a short circuit in the one or more electronic components in the event of a leak.

For example, a cooling device may include a liquid coolant inlet permitting liquid coolant to flow into a chamber therein, but may not include a liquid coolant outlet thereby preventing liquid coolant from exiting the chamber. The cooling device may additionally include a vapor outlet permitting evacuation of vaporized coolant. During a first time period, liquid coolant may flow into the chamber via the liquid coolant inlet and collect inside to form a pool. During a second time period, the inflow of liquid coolant may be restricted, such that the liquid coolant collected in the pool may become stagnant. Heat may radiate from an electronics component into the pool of stagnant liquid coolant to cause pool boiling of the liquid coolant. The boiling liquid coolant may be converted to vaporized coolant, which may exit the chamber via the vapor outlet. In this manner, at least some heat generated by the electronics component may be removed by the vaporized coolant.

By way of a non-limiting example, in Fig. 1C, ENE 100 includes liquid coolant inlet 128 integrated with chamber 102 (see Fig. 1B). Liquid coolant inlet 128 may supply liquid coolant to pool 116 to thereby enable pool boiling of the liquid coolant and conversion of the liquid coolant into vaporized coolant. For instance, one or more pumps associated with a reservoir storing cool liquid coolant may supply cool liquid coolant to ENE 100 via liquid coolant line 120. The cool liquid coolant may flow through liquid coolant line 120 via liquid coolant inlet 128 into chamber 102, where the liquid coolant may collect in pool 116. Heat generated by solid-state electronics component 110 may radiate through heat conducting wall 104 of ENE 100 where the heat may be absorbed by liquid coolant contained in pool 116. The heat may raise the temperature of the liquid coolant in pool 116 to reach boiling, causing pool boiling of the liquid coolant, and transformation thereof to vaporized coolant. In some embodiments, liquid coolant line 120 may be a polyurethan tube with a diameter of approximately 4mm, and a minimum bend radius of 9.5mm, and liquid coolant inlet 128 may have a diameter of approximately 4mm, to accommodate liquid coolant line 120. In some embodiments, the temperature at which the liquid coolant reaches its boiling point and vapor bubbles form (e.g., the boiling incipient temperature) inside chamber 102 of ENE 100 may be lower than the boiling incipient temperature for the liquid coolant external to ENE 100, subject to ambient pressure. For example, the pressure inside chamber 102 may be higher than ambient pressure. In some embodiments, vapor line 122 may be associated with a controllable valve, permitting at least one processor to control the pressure inside chamber 102, and thereby control the boiling temperature of the coolant. In some embodiments, the liquid coolant may be a non-electrically conductive material, e.g., to prevent contact with solid-state electronics component 110 from causing a short circuit.

Some disclosed embodiments involve a vapor outlet integrated with a chamber for evacuating vaporized coolant from the chamber. A vapor outlet refers to any egress for vapor, as described and exemplified elsewhere herein. For example, a vapor outlet may be fluidly coupled to a condenser configured to convert vaporized coolant to liquid coolant. In some embodiments, a vapor outlet may be associated with one or more devices preventing liquid coolant from entering a vapor line, such as one or more valves. Integrated with the chamber may be understood as described earlier relating to a liquid coolant inlet. Evacuating refers to removing, expelling, and/or drawing and/or siphoning away. Evacuating vaporized coolant from an enclosure refers to causing vaporized coolant to leave an enclosure. For example, a pressure differential between an average pressure inside a chamber versus an average pressure outside the chamber may cause vaporized coolant to exit the chamber via a vaporized coolant outlet. Such a pressure differential may be induced, for instance, due to pool boiling of liquid coolant within the chamber causing liquid coolant to transition to vaporized coolant and accumulate inside the chamber.

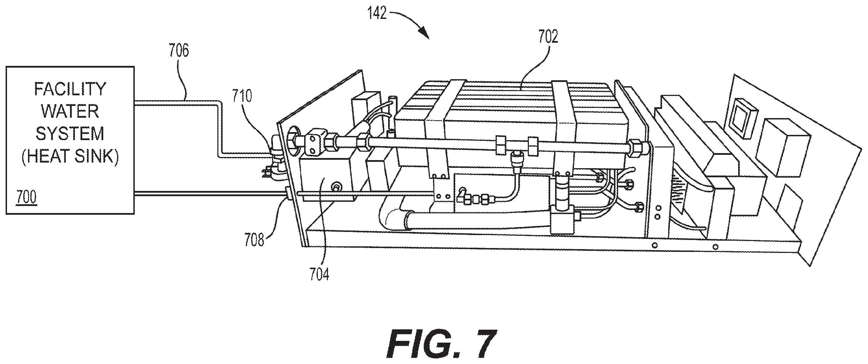

By way of a non-limiting example, in Fig. 1C, vapor outlet 130 may be integrated with chamber 102 for evacuating vaporized coolant from chamber 102. For example, vapor line 122 may connect vapor outlet 130 to condenser 702 of HRU 124 (see Fig. 7). In some embodiments, vapor outlet 130 and/or vapor line 122 may be associated with a controllable valve, allowing to control pressure within vapor line 122 and/or chamber 102. For example, at least one processor may be provided to control the controllable valve and thereby regulate pressure within vapor line 130 and/or chamber 102. In some embodiments, vapor coolant line 122 may be a polyurethan tube with a diameter of approximately 6 mm, and a minimum bend radius of 12.7 mm, and vapor coolant outlet 130 may have a diameter of approximately 6mm, to accommodate vapor line 122.

Some disclosed embodiments involve a valve configured to restrict flow of the liquid coolant when the liquid coolant in the chamber surpasses a threshold. A flow (e.g., a fluid flow) refers to movement of a liquid or gas from one place to another. Such movement may occur as a result of continual deformation of a fluid under an applied force. For example, a temperature gradient in a fluid may cause warmer fluid to rise and cooler fluid to sink, e.g., in a cyclical flow motion. Similarly, exposing a fluid to a pressure gradient may cause the fluid to move from a region of higher pressure to a region of lower pressure. A valve refers to a mechanism for regulating flow. For example, a valve may regulate a direction of flow, a magnitude of flow, and/or may be used to stop and/or start a flow. Restrict flow refers to limiting, constraining, and/or stopping a flow. For example, a valve may be used to restrict a fluid from flowing that would otherwise flow due to a pressure and/or temperature gradient. A threshold refers to a boundary and/or limit. In some embodiments, a threshold may be an upper threshold restricting exceeding of the upper threshold. In some embodiments, a threshold may be a lower threshold restricting falling below the lower threshold. In some embodiments, a threshold may include an upper threshold and a lower threshold. In some embodiments, a threshold may be associated with a tolerance permitting minor aberrations to the threshold. Surpasses a threshold refers crossing a limit or level. For example, if sufficient liquid coolant fills a chamber to reach a threshold, a valve may block the liquid coolant inlet to prevent additional liquid coolant from entering the chamber. In some embodiments, a threshold may be associated with a level of liquid coolant that would permit liquid coolant to enter a vapor line, such that restricting an inflow of liquid coolant into the chamber when the level surpasses the threshold may prevent liquid coolant from entering the vapor line.

In some embodiments, the valve may be a self-regulating valve. For instance, the level of liquid coolant in the chamber may activate the valve, causing the valve to block the liquid coolant and restrict a further inflow of liquid coolant via into the chamber. This may cause liquid coolant to collect inside the chamber and form a pool of stagnant liquid coolant, which may enable pool boiling within the chamber. Thus, the self-regulating valve may permit the level of liquid inside the chamber to control whether or not additional liquid coolant may enter the chamber. As the liquid coolant boils and exits the chamber as vaporized coolant, the level of liquid coolant in the chamber may drop. This may cause the valve to release and enable an inflow of liquid coolant into the chamber to resume.

For example, a first solid-state electronics component may execute a first workload and a second solid-state electronics component may execute a second workload. The first workload may be greater than the second workload, such that the first solid-state electronics component may generate more heat than the second solid-state electronics component. A first cooling device may be thermally coupled to the first solid-state electronics component and a second cooling device may be thermally coupled to the second solid-state electronics component. During a first time instant, the self-regulating valve of the first and second cooling devices may permit liquid coolant to enter and form pools therein. During a second time instant, a level of liquid coolant in the first and second cooling devices may surpass the threshold causing inflow of liquid coolant into the first and second cooling devices to cease, and pool boiling therein to commence. Due to the greater heat generated by the first solid-state electronics component than the second solid-state electronics component, more liquid coolant may reach boiling in the first cooling device than in the second cooling device. Consequently, vaporized coolant may exit from the first cooling device at a higher rate than from the second cooling device, leading to different in levels of liquid coolant inside the first and second cooling devices. In a third time instant, the level of liquid coolant in the first cooling device may drop below the threshold, whereas the level of liquid coolant in the second cooling device may still be above the threshold, due to the slower rate of boiling in the second cooling device. This may cause the self-regulating valve of the first cooling device to release and permit inflow of liquid coolant into the chamber to resume, whereas the self-regulating valve of the second cooling device may continue to restrict inflow of liquid coolant into the chamber. In this manner, the self-regulating valves of the first and second cooling devices may enable liquid coolant to be supplied to cool the first and second solid-state electronics components based on an amount of heat generated by each.

By way of a non-limiting example, in Fig. 1B, chamber 102 may include float valve 200 configured to restrict flow of liquid coolant when the liquid coolant in chamber 102 surpasses a threshold. Float valve 200 may rise and fall relative to inner surface 106 of heat conducting wall 104 as a level of fluid in chamber 102 rises and falls.

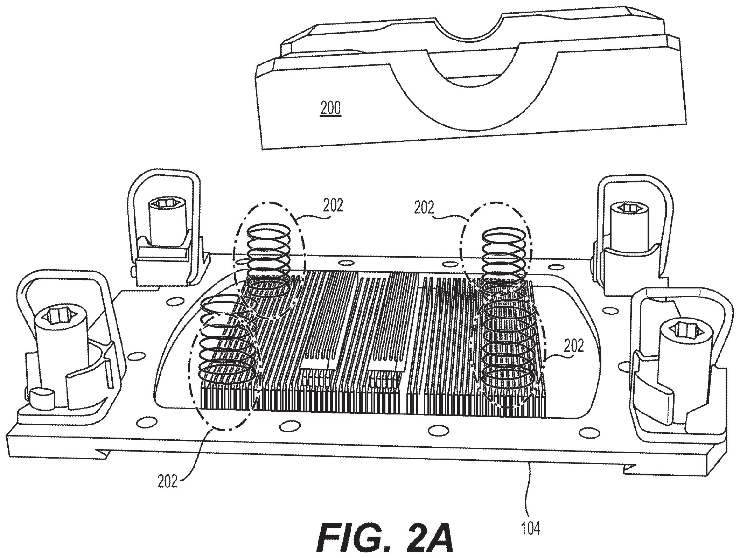

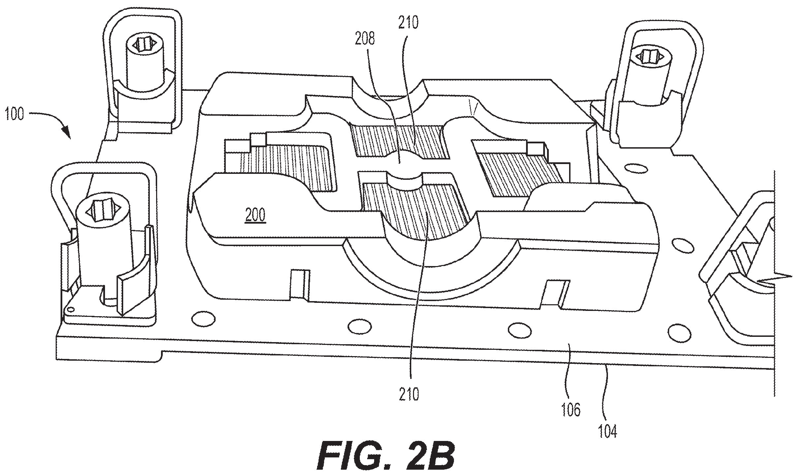

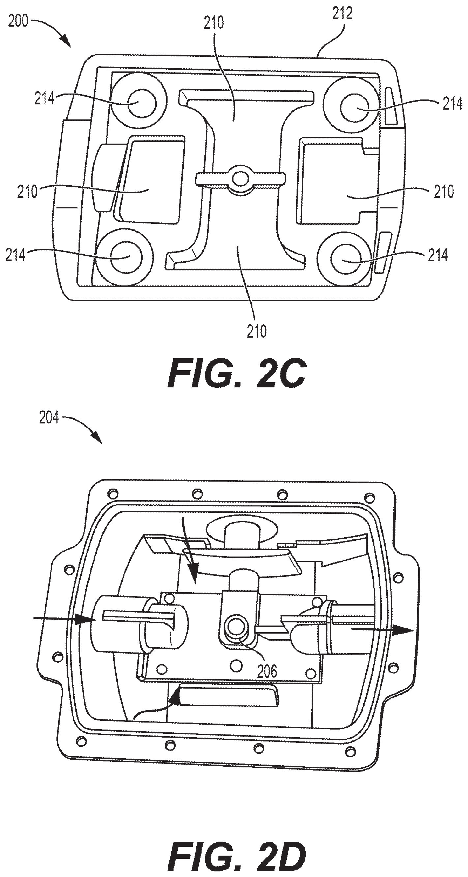

By way of another non-limiting example, reference is made to Figures 2A-2C, which illustrate differing exemplary views of float valve 200 configure to regulate an inflow of liquid coolant to ENE 100, consistent with some disclosed embodiments. In Fig.2A, float valve 200 is shown hovering above heat conducting wall 104 of ENE 100, illustrated without a cover. In Fig. 2B, float valve 200 is shown resting on inner surface 106 of heat conducting wall 104 of ENE 100, illustrated without a cover. In Fig. 2C, an underside of float valve 200 is shown. The underside of float valve 200 may face inner surface 106 of heat conducting wall 104 of ENE 100 when float valve 200 is inserted into chamber 102 of ENE 100.

By way of a further non-limiting example, reference is made to Fig. 2D illustrating an underside of a cover 204 of ENE 100, consistent with some disclosed embodiments. Cover 204 may be mounted overheat conducting wall 104 to form chamber 102 in a manner to prevent liquid and/or vapor coolant from escaping chamber 102. For example, cover 204 may be scaled overheat conducting wall 104. The upper side of float valve 200, shown in Fig. 2B, may face the underside of cover 204 when float valve 200 is located inside chamber 102.

In Fig. 1B, float valve 200 may be located inside chamber 102, and may be configured to restrict flow of liquid coolant when the liquid coolant in chamber 102 surpasses a threshold. For example, the threshold may be associated with a level permitting liquid coolant to enter vapor line 122 (see Fig. 1C). As liquid coolant flows into chamber 102 via liquid coolant inlet 128, float valve 200 may rise with the level of the liquid coolant inside chamber 102. Upon reaching the threshold level, float valve 200 may be at a height permitting engagement with cover 204, thereby preventing addition inflow of liquid coolant into chamber 102 via liquid coolant inlet 128. As the liquid coolant in chamber 102 boils and transitions to vaporized coolant exiting chamber 102 via vapor outlet 130, the level of liquid coolant in chamber 102 to drop, causing float valve 200 to descend accordingly. The descent of float valve 200 may cause disengagement of float valve 200 with cover 204, permitting an inflow of liquid coolant into chamber 102 via liquid coolant inlet 128 to resume.

In some disclosed embodiments, the liquid coolant inlet includes an inlet orifice and the valve includes a float with a portion for blocking the inlet orifice. An inlet orifice refers to an opening, hole and/or aperture configured for permitting fluid entry. A float may be understood as described and exemplified elsewhere herein. A float may be configured to rest on a surface of a pool of liquid coolant, to rise as the volume of coolant in the pool increases and to fall as the volume of coolant in the pool decreases. Blocking refers to obstructing, restricting, and/or preventing a flow therethrough. A portion for blocking an inlet orifice refers to a part, section, or appendage configured to obstruct, restrict, and/or prevent flow through the inlet orifice. For instance, a float may include a mechanism for sealing, covering, enclosing, and/or otherwise blocking an inlet orifice. In some disclosed embodiments, the float has at least one opening therein for enabling the liquid coolant to pass therethrough. A float having an opening therein for enabling liquid coolant to pass therethrough refers to at least one hole, an aperture, and/or a gap permitting liquid coolant to flow therethrough. In some embodiments, the float includes a plurality of openings surrounding the blocking portion, permitting liquid coolant to pass therethrough.

For example, when a level of liquid coolant is below a threshold level, the float, resting on the surface of the pool of liquid coolant, may drop with the level of the liquid coolant. In such a case, the blocking portion of the float may disengage from the inlet orifice, leaving the inlet orifice unblocked. This may allow liquid coolant to enter the chamber via the inlet orifice and pass through the at least one opening in the float and reach the pool. When a level of liquid coolant is above the threshold level, the float may rise with the level of the liquid coolant. In such a case, the blocking portion of the float may engage with the inlet orifice, preventing liquid coolant from entering the chamber.

By way of a non-limiting example, in Figs. 1C and 2D, liquid coolant inlet 128 of ENE 100 may include an inlet orifice 206. For example, liquid coolant inlet 128 may be flow-connected to inlet orifice 206 via a liquid coolant path integrated within cover 220. Cool liquid coolant may flow from a reservoir through liquid coolant line 120 and liquid coolant inlet 128 and enter chamber 102 of ENE 100 through inlet orifice 206.

By way of another non-limiting example, in Fig. 2B, valve 200 may be a float valve with a portion 208 for blocking inlet orifice 206. For example, portion 208 may be configured to engage with inlet orifice 206 to cause an obstruction preventing liquid coolant from passing through. In some embodiments, float valve 200 may have at least one opening 210 therein for enabling the liquid coolant to pass therethrough. For example, when float valve 200 is not blocking inlet orifice 206, liquid coolant may flow into chamber through inlet orifice 206 and pass through openings 210 to reach pool 116.

In some disclosed embodiments, the blocking portion includes a pin and the inlet orifice is configured to receive the pin. A pin refers to a narrow, elongated structure. For example, a pin may include a dowel, a shaft, a spike, and/or any other narrow, elongated object. A blocking portion including a pin refers to a pin protruding and/or extending from the float in a manner configured to block flow. An inlet configured to receive a pin refers to an inlet capable of accommodating a least a portion of the pin. For example, the orifice of the inlet may be sized to accommodate an at least partial insertion of the pin. Additionally, the location and/or orientation of the inlet orifice and the location and/or orientation of the pin on the float may be aligned to permit engagement of the pin with the orifice. For instance, when the level of liquid coolant rises, the float and pin thereon may rise accordingly. Upon reaching or exceeding the threshold level, the float may rise sufficiently to cause the pin of the float to at least partially penetrate the orifice of the inlet aligned therewith. Upon entering the orifice, the pin may block a flow of coolant into the chamber. The pin may remain inside the orifice during the time period that the level of coolant in the chamber is at or above the threshold level. Once the level of liquid coolant drops, the float and pin thereon may drop as well. This may cause the pin of the float to withdraw from the orifice, allowing liquid coolant to flow into the chamber via the inlet and the opening in the float.

By way of a non-limiting example, in Fig. 1B, blocking portion 208 of float valve 200 includes a pin 216 for engaging with inlet orifice 206. Float valve 200 may rest above the liquid coolant in pool 116. When a level of liquid coolant in pool 116 reaches the threshold, float valve 200 may rise with the level of the liquid coolant, raising pin 216 accordingly, until pin 216 engages with and obstructs inlet orifice 206, thereby preventing additional liquid coolant from entering pool 116. In some embodiments, the pin of blocking portion 208 may be beveled and/or slanted to facilitate entry into inlet orifice 206 and achieve blockage.

In some disclosed embodiments, the blocking portion is located in a central area of the float. A central area of a float refers to a middle region of the float. For example, a central area may be located substantially symmetrically relative to any edge of the float. Some disclosed embodiments involve at least one spring for biasing the float toward the inlet orifice. A spring refers to a component having elastic characteristics permitting repeatable transformations from a neutral state to an expanded and/or compressed state and back to a neutral state. A spring may store potential energy in an expanded and/or compressed state, and may release the potential energy as kinetic energy when reverting to the neutral state. Biasing refers to a tendency to favor one state over another. For example, a compression spring may be biased to a compressed state associated with a shorter length, such that applying a force to expand a compression spring to increase a length thereof induces the spring to compress and revert to the compressed state with the shorter length. Similarly, an extension or expansion spring may be biased to an extended state associated with a longer length, such that applying a force to compress the extension spring to decrease a length thereof induces the spring to extend and revert to the extended state with the longer length. A spring for biasing the float toward the inlet orifice refers to a spring tending to push the float in the direction of the inlet orifice. For example, such a spring may be an extension spring tending to extend from a compressed state and thereby push the float towards the inlet orifice.

By way of a non-limiting example, in Figs. 2B-2C, blocking portion 208 may be located in a central area of float valve 200. By way of another non-limiting example, in Fig. 2A, in some embodiments, ENE 100 may include at least one spring 202 for biasing float valve 200 toward inlet orifice 206. For example, in Fig. 1B, springs 202 may bias blocking portion 208 of float valve 200 towards inlet orifice 206, permitting blockage of inlet orifice 206 to prevent liquid coolant from entering chamber 102. This may cause the liquid coolant in pool 116 to become stagnant (e.g., void of inflow and/or outflow of liquid coolant) and enable pool boiling within chamber 102.

In some disclosed embodiments, the at least one spring is configured to counterbalance a weight of the float. A weight of a float refers to a gravitational force acting on the float. A weight of a float may be measured in Newtons. To counterbalance refers to neutralize by exerting an opposing influence. For example, a gravitational force acting on the float to pull the float downwards may be counterbalanced by one or more extension springs pushing the float upwards, such that the effect of gravity on the float may be substantially neutralized, and the weight of the float may be substantially zero. For instance, resting a float on at least one spring may compress the at least one spring, causing storage of potential energy therein. The spring may tend to release the potential energy by expanding to the neutral state, thereby exerting a counterforce on the float that may counterbalance the gravitational force. Neutralizing a gravitational force on the float may enable to float to rise and fall with the level of liquid coolant in the pool, absent a downwards pull on the float that may affect the position of the float independent of the level of coolant. This may maintain a correspondence between the position of the float in the chamber with the level of liquid coolant. For example, a downwards gravitational force may inhibit the float valve from rising with the level of liquid coolant sufficiently to block the input orifice when the liquid coolant in the chamber surpasses the threshold. This may allow liquid coolant to enter the pool when the liquid coolant in the chamber surpasses the threshold, causing liquid coolant to enter the vapor line. Additionally or alternatively, a downwards gravitational force may cause the float valve to disengage from the input orifice while the liquid coolant in the chamber surpasses the threshold. This may also permit liquid coolant to enter the chamber when the liquid coolant in the chamber surpasses the threshold, causing liquid coolant to enter the vapor line. Thus, neutralizing the gravitational force on the float valve may allow the position of the float valve in the chamber to correspond with the level of liquid coolant, thereby enabling the float valve to be a self-regulating valve.

By way of a non-limiting example, in Fig. 2A, springs 202 may counterbalance a weight of float valve 200. For example, this may enable the position of float valve 200 to correspond to the level of liquid coolant in pool 116 absent a gravitational force that would pull float valve 200 downwards, independent of the level of coolant in the pool. Consequently, springs 202 may permit float valve 200 to restrict a flow of liquid coolant through inlet orifice 206 when the level of liquid coolant surpasses the threshold, and allow an inflow of liquid coolant through inlet orifice 206 when the level of liquid coolant is below the threshold, absent interference from gravity pulling down on float valve 200.

In some disclosed embodiments, the at least one spring includes a plurality of springs. A plurality of springs refers to multiple springs, e.g., at least two springs. In some embodiments, the cooling device may include at least three springs, at least four springs, and/or any other number of springs.

In some disclosed embodiments, an aggregate of the expansion forces of the plurality of springs are substantially equal to a weight of the float. An expansion force of a spring refers to a force exerted by a spring to revert to an extended state in response to being compressed An aggregate of the expansion forces refers to a net and/or accumulated force exerted collectively by the plurality of springs. For example, the sum of the expansion forces of the plurality of springs may be substantially equal to the weight of the float (e.g., measured in Newtons), causing the plurality of springs to lift the float sufficiently to be substantially weightless.

In some disclosed embodiments, the expansion forces of the plurality of springs are substantially equal. Equal refers to equivalent and/or the same. Substantially equal means that even if there are some differences, those differences are inconsequential from an operational standpoint. Thus, expansion forces of the plurality of springs are substantially equal when each spring has a substantially similar tendency to expand by a substantially similar length in response to a substantially similar compression force applied thereto. A spring may be associated with a k constant characterizing an amount of force needed to extend or compress a spring by a unit distance. Thus, in some embodiments, each of the springs may have a substantially similar k constant. Extension springs with matching k constants may decrease in length by a substantially similar amount in response to a force imposed thereon, and may exert substantially similar expansion forces in response. Consequently, each spring may shorten by a substantially similar distance in response to the weight of the float exerting a downwards force thereon and may exert a substantially similar upwards force to counterbalance the weight of the float. This may maintain the float at a substantially level orientation, preventing the float from tilting, twisting, and/or flipping and maintain alignment of the blocking portion with the inlet orifice. The alignment may permit repeated engagement and/or disengagement of the blocking portion with the inlet orifice as the level of liquid coolant in the chamber rises and falls.

In some disclosed embodiments, the float has a periphery area and the plurality of springs are distributed in the periphery area. A periphery area refers to a region surrounding a reference location or being near or bounded by an edge, perimeter, and/or rim. For example, one or more periphery areas may surround a central area of a float valve. A float valve may be round, oval, square, rectangular, triangular, and/or any other shape, and a periphery area may differ accordingly. A plurality of springs distributed in the periphery area refers to multiple springs arranged along a perimeter of an object. For example, the springs may be evenly spread out around the edges of a float valve. This may cause the expansion forces counterbalancing the weight of the float valve to be evenly spread around the edges of the float valve as well. Distributing the expansion forces thus may prevent the float valve from tilting, twisting, and/or flipping (e.g., due to turbulence caused by pool boiling), thereby preventing misalignment of the blocking portion with the inlet orifice.

In some disclosed embodiments, the float includes a central area in which the blocking portion is located, and wherein the blocking portion is substantially equidistant from each spring. A central area refers to a middle and/or center region. For example, a central area may be surrounded by one or more periphery areas. Equidistant refers to located midway between two points. A blocking portion substantially equidistant from each spring refers to positioning the blocking portion symmetrically (or roughly symmetrical) relative the plurality of springs. For instance, positioning the blocking portion substantially equidistant from the springs may ensure that the blocking portion is maintained level and aligned with the inlet orifice when the liquid coolant in the chamber surpasses the threshold.

By way of a non-limiting example, in Fig. 2A, an aggregate of the expansion forces of plurality of springs 202 may be substantially equal to a weight of float valve 200. Consequently, float valve 200 may be substantially weightless and may rise and fall with the level of liquid coolant in pool 116, unaffected by gravity. In some embodiments, the expansion forces of plurality of springs 202 may be substantially equal. For example, this may cause each of springs 202 located in a different corner of float valve 200 to push float valve 200 by a substantially similar distance, causing float valve 200 to remain substantial level during pool boiling. This may enable blocking portion 208 to remain aligned with input orifice 206, allowing blocking portion 208 to repeatedly engage with input orifice 206 to restrict an inflow of liquid coolant when the level of coolant surpasses the threshold, and disengage from input orifice 206 to permit an inflow of liquid coolant when the level of coolant is below the threshold. In some embodiments, float valve 200 has a periphery area 212 and plurality of springs 202 are distributed in the periphery area 212.

In some disclosed embodiments, the float has a generally rectangular periphery area. A rectangular peripheral area refers to a region along an edge of an object having four sides, each side perpendicular to two other sides. In some instances, a rectangular peripheral area may include a region along an edge of a square and/or an oblong. In some disclosed embodiments, each of the plurality of springs is located in a differing corner of the generally rectangular periphery area. A differing corner refers to a region near a distinct meeting point of two adjacent edges. For example, a rectangle may have four differing corners, each corresponding to a meeting point of two adjacent edges thereof. A different spring may be associated with a different corner of the float, such that four springs may support the float at the four corners. This may prevent the float from tilting, flipping, and/or turning during pool boiling, to maintain the float a substantially level orientation. Maintaining the float level may ensure alignment between the blocking portion and the inlet orifice.

By way of a non-limiting example, in Figs. 2A and 2C, float valve 200 has a substantially rectangular periphery area 212. In some embodiments, each of springs 202 may be located in a differing corner of the generally rectangular periphery area 212 of float valve 200. In some embodiments, float valve 200 may include a plurality of indentations 214. Each of indentations 214 may engage with a different one of springs 202 to prevent slippage of float valve 200 from one or more of springs 202. This may help maintain float valve 200 substantially level above pool 116.

In some disclosed embodiments, the float is configured to block the inlet orifice in a manner promoting pool boiling. To block an inlet orifice refers to obstructing and/or plugging the inlet orifice. For example, blocking the inlet orifice may prevent liquid coolant from entering the chamber via the inlet orifice. To promote pool boiling refers to encouraging and/or facilitating pool boiling. For instance, maintaining a stagnant pool of liquid coolant in the chamber may promote pool boiling. Thus, by blocking the inlet orifice to prevent additional cool liquid coolant from entering the chamber, the liquid coolant contained inside the chamber may remain stagnant. The liquid coolant may absorb sufficient heat through the heat conducting wall to reach boiling. Conversely, lack of blockage of the inlet orifice via the float may permit additional cool liquid to continually enter the chamber. The continual introduction of cool liquid into the chamber may prevent the liquid coolant contained in the chamber from reaching the boiling point.

By way of a non-limiting example, in Fig. 1B, float valve 200 (e.g., and/or blocking portion 208 thereof) may block inlet orifice 206 in a manner promoting pool boiling. For example, preventing an inflow of liquid coolant into chamber 102 may cause liquid coolant collecting in pool 116 to be substantially stagnant and accumulate heat to reach a boiling point.

In some disclosed embodiments, the heat conducting wall is a cooling plate having screw holes therein adapted for screw connection to a semiconductor board. A cooling plate refers to a flat surface configured to channel and/or draw away heat. A screw refers to a threaded fastener containing a helical groove. A screw hole adapted for screw connection refers to an aperture and/or hollow configured to receive a screw, and thereby join two elements. For example, a screw hole may include a spiraling groove configured to engage with a spiraling ridge of a screw. A semiconductor board refers to a base on which electronic components may be mounted. In some embodiments, a semiconductor board may include a printed circuit board (PCB) having at least one microprocessor and/or a memory chip mounted thereon. For example, a cooling device may be mounted on an electronic component of a semiconductor board by positioning the heat conducting wall of the cooling device on the surface of the electronic component. The heat conducting wall of the cooling device may be secured to the surface of the electronic component using a plurality of screws. In some embodiments, the outer surface of the heat conducting wall of the cooling device may additionally be secured to the surface of the electronic component using a thermally conductive adhesive. Cool liquid coolant entering the chamber of the cooling device via the inlet orifice may absorb heat from the inner surface of the heat conducting wall, thereby cooling the heat conducting wall such that the external surface thereof may serve as a cooling plate to cool the microprocessor.

By way of a non-limiting example, in Fig. 1C, heat conducting wall 104 may be a cooling plate having screw holes 132 therein adapted for screw connection to a semiconductor board 134. For example, solid-state electronics component 110 may be mounted on semiconductor board 134. ENE 100 may be mounted on component surface 126 of solid-state electronics component 110 by screwing heat conducting wall 104 onto semiconductor board 134 using a plurality of screws. Each screw may pass through a different one of screw holes 132. Additionally or alternatively, in some embodiments, outer surface 108 of heat conducting wall 104 may be secured to surface 126 of solid-state electronics component 110 using a thermally conductive adhesive.

In some disclosed embodiments, the chamber includes a plurality of fins on an outer surface thereof. A plurality of fins on an outer surface thereof refers to a plurality of fins, as described and exemplified elsewhere herein, positioned on an outside surface of the chamber. For example, a plurality of fins may be positioned on an outer surface of a cooling device and exposed to ambient air. The plurality of fins may function as a radiator for releasing heat contained inside the chamber of the cooling device to ambient air of an environment surrounding the cooling device.

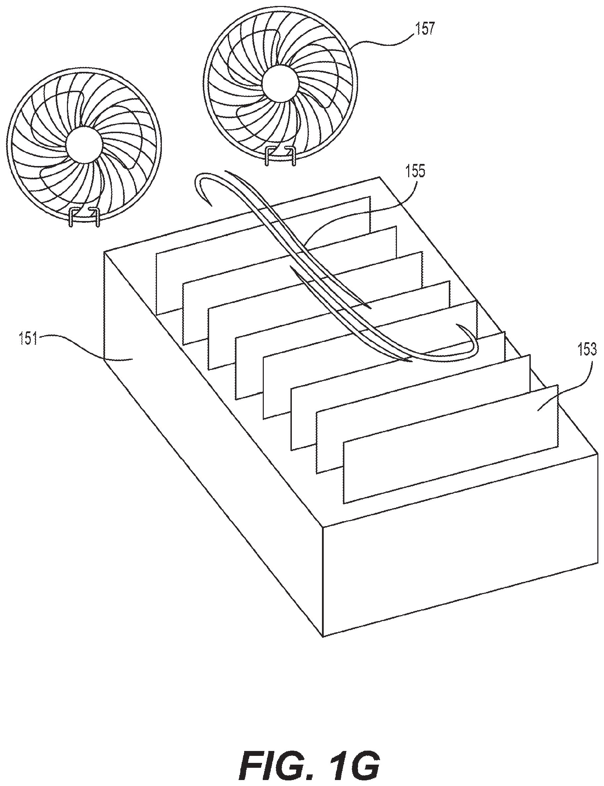

By way of a non-limiting example, Fig. 1G illustrates a perspective view of a cooling device 151, consistent with disclosed embodiments. Cooling device 151 may be substantially similar to ENE 100 with the noted addition of a plurality of fins 153 provided on an outer surface thereof. Fins 153 may radiate heat accumulated inside cooling device 151 to an ambient environment surrounding cooling device 151. In some embodiments, one or more fans 157 may be provided to facilitate an air flow 155 above cooling device 151, allowing fins 153 to release heat accumulated inside cooling device 151 to air flow 155.

In some disclosed embodiments, the chamber includes a plurality of fins therein. A chamber including a plurality of fins therein refers to a plurality of fins, as described and exemplified elsewhere herein, positioned internal to the chamber. For example, a plurality of fins may be located on the inner surface of the heat conducting wall of the chamber, and may be immersed in a pool of liquid coolant. In some embodiments, the plurality of fins may be heat conductive and may function as a radiator releasing heat received through the heat conducting wall to the pool of liquid coolant, thereby promoting pool boiling within the chamber.

In some disclosed embodiments, wicks are disposed between the plurality of fins. Wicks disposed between a plurality of fins may be understood as described and exemplified elsewhere herein. For example, wicks may draw away bubbles generated by pool boiling within the chamber, allowing cool liquid coolant to replace hot vaporized coolant in the region of the heat conducting wall.

By way of a non-limiting example, in Figs. 3A-3B, chamber 102 (see Fig. 1B) may include a plurality of fins 300 therein. For example, fins 300 may conduct heat from inner surface 106 of heat conducting wall 104 into liquid coolant stored in pool 116 to facilitate pool boiling therein. By way of another non-limiting example, in Fig. 3B, wicks 302 may be disposed between plurality of fins 300. For example, wicks 302 may guide bubbles formed in between wicks 302 during pool boiling away from pool 116 to enable the bubbles to escape via vapor outlet 130. This may prevent entrapment of bubbles and facilitate circulation of liquid coolant within chamber 102.

In some disclosed embodiments, the liquid coolant inlet and the vapor outlet are configured for flow-connection to a condenser. A condenser refers to a heat exchanger that transforms a substance in a gaseous state to a liquid state, thereby releasing latent heat stored therein. For example, a condenser may compress a vapor until the vapor transforms to liquid form. A flow-connection refers to a path enabling fluid to travel between two points. For example, one or more liquid lines may flow-connect an output of a condenser to a liquid coolant inlet of a cooling device, and one or more vapor lines may flow-connect a vapor outlet of the cooling device to an input of the condenser. In this manner, the condenser may provide cool liquid coolant to the liquid coolant inlet of the cooling device, receive hot vaporized coolant from the vapor outlet of the cooling device, and convert the hot vaporized coolant to cool liquid coolant for providing to the cooling device in a cyclical manner for continual cooling of a solid-state electronics component connected thereto.

Some disclosed embodiments involve a condenser configured to receive vaporized coolant evacuated from a plurality of cooling devices, convert the vaporized coolant to liquid coolant, and supply the liquid coolant to a plurality of cooling devices. Evacuated refers to removed, expelled, and/or withdrawn from. For example, a plurality of cooling devices for cooling a plurality of solid-state electronics components may be flow-connected to a common condenser via a network of tubes. The condenser may supply each cooling device with cool liquid coolant via an associated liquid coolant inlet, collect hot vaporized coolant exiting each cooling device via an associated vapor outlet, and convert the hot vaporized coolant to cool liquid coolant for supplying to the plurality of cooling devices in a cyclical manner. In some embodiments, one or more pumps may pump the cool liquid coolant from a reservoir associated with a condenser to the plurality of cooling devices.

By way of a non-limiting example, in Figs. 1C and 7, liquid coolant inlet 128 and vapor outlet 130 may be flow-connected to a condenser 702 of HRU 142. For example, hot vaporized coolant may flow out of ENE 100 via vapor outlet 130 and vapor line 122 to condenser 702, which may condense the vaporized coolant to a liquid state. One or more pumps associated with condenser 702 may pump the liquified coolant to ENE 100 via liquid coolant line 120 and liquid coolant inlet 128, allowing the coolant to circulate through ENE 100 for continual cooling of solid-state electronics component 110. By way of another non-limiting example, in Fig. 1A, condenser 702 of HRU 142 may receive vaporized coolant evacuated from a plurality of ENEs 100 via vapor coolant line 150. Vapor coolant line 150 may collect vaporized coolant from multiple ENEs 100 and deliver the accumulated vaporized coolant to condenser 702. Condenser 702 may convert the vaporized coolant to liquid coolant, and supply the liquid coolant to plurality of ENEs 100. This may be performed repeatedly, allowing coolant to circulate continually through a plurality of ENEs 100 to continually cool a plurality of solid-state electronics component 110.

Some disclosed embodiments include an array of fins. Fins are surfaces extending outwards to conduct or radiate heat, as described and exemplified elsewhere herein. The array of fins may be provided inside each ENE to facilitate heat transfer for on-chip cooling by increasing the surface area between a heat source (the electronic component) and a heat sink (e.g., liquid coolant). For instance, the fins may be made of a heat conducting material, such as metal (e.g., iron, steel, and aluminum, or copper) or non-metal (e.g., graphite). The fins may be shaped as elongated rectangular sheets stacked side by side with a long side of each fin affixed to a base, forming gaps between each pair of fins.

Some disclosed embodiments involve a cooling device having a chamber for containing a liquid coolant. A cooling device refers to an apparatus configured to lower a temperature, such as by expelling heat. For instance, a cooling device may draw heat away from a heat-generating device. Examples of cooling devices include heat exchangers, evaporators, and/or any other structure capable of temperature reduction. Heat refers to thermal energy and may be measured in Joules or calories. Heat may be transferred between systems due to a temperature difference therebetween. For example, an electronic device may generate heat internally during operation. The heat may conduct outwards to a cooler surrounding environment, causing an increase in temperature of the surrounding environment and a decrease in temperature inside the electronic device. A chamber refers to an at least partially enclosed compartment and/or cavity, as described and exemplified elsewhere herein. Liquid coolant refers to coolant, as described and exemplified elsewhere herein, while in a liquid state. For example, vaporized coolant may undergo condensation to transform to liquid coolant. Containing a liquid refers to holding or enclosing a liquid substance within a confined space of a container, preventing it from escaping. A chamber for containing a liquid coolant thus refers to an at least partially enclosed compartment that holds or encloses a coolant in a liquid state. In some embodiments, a chamber may include one or more openings to enable fluid to enter and/or exit the chamber.

In some embodiments, the chamber is configured for location on a computer chip to cool the computer chip. A computer chip refers to an integrated circuit that functions to perform logic operations, control operations, store information, and/or electrically perform other tasks. Non-limiting examples of a computer chip include processors as disclosed or exemplified elsewhere herein. In some embodiments, computer chips can include CPUs, microprocessors, and memory chips. Cooling a computer chip refers to removing thermal energy from the computer chip to maintain, reduce, or minimize an increase in temperature of the computer chip. In some embodiments, the chamber has a heat transfer surface. A heat transfer surface refers to an exterior and/or outermost layer or layers of a component which permit thermal energy to be exchanged between particles. For example, the heat transfer surface (i.e., heat conducting wall) may be made of a material capable of conducting heat and allowing heat to flow, on average, from a higher temperature region to a lower temperature region. The heat transfer surface (i.e., heat conducting wall) may be made from heat conducting material, such as metal (e.g., iron, steel, and aluminum, or copper) or non-metal (e.g., graphite).

Some disclosed embodiments include an inlet for the liquid coolant and an outlet for the vaporized liquid coolant. An inlet for the liquid coolant may be understood similar to a liquid inlet, as described and exemplified elsewhere herein. For example, a liquid coolant inlet may be fluidly couplable to a reservoir containing liquefied coolant and an associated pump configured to deliver liquid coolant thereto. In some embodiments, a liquid coolant inlet may be associated with one or more devices preventing liquid coolant from exiting via the inlet. For example, a pump maintaining a pressure differential and/or a valve may prevent a reverse flow of liquid coolant. An outlet for the vaporized liquid coolant may be understood similar to a vapor outlet, as described and exemplified elsewhere herein.

A heat conducting wall refers to a barrier and/or partition capable of heat transfer, as described and exemplified elsewhere herein. In some instances, a heat conducting wall may be made of a material conducive for transferring heat, such as metal (e.g., aluminum, copper, silver, gold, molybdenum, zinc, and/or tungsten), semiconductor (e.g., silicon carbide), and/or graphite.

By way of non-limiting example, in Fig. 1B, ENE 100 may include chamber 102 having a first region defining a pool 116 with heat conducting wall 104. Chamber may include a pool for holding a volume of liquid. In some instances, a pool may lack an opening to allow liquid to escape, such that when an inflow of liquid is restricted, liquid in the pool may become stagnant. Heat conducting wall 104 may have inner surface 106 constituting a wall of pool 116. Heat conducting wall 104 may have an outer surface 108, opposite inner surface 106 for thermal contact with component surface 126 (see Fig. 1B). Heat conducting wall 104 may permit conduction of heat from solid-state electronics component 110 into pool 116. For instance, the heat may transfer from component surface 126 to outer surface 108, to inner surface 106, and into liquid coolant collected in pool 116.

By way of non-limiting example, in Fig. 1C, ENE 100 includes liquid coolant inlet 128 integrated with chamber 102 (see Fig. 1B). Liquid coolant inlet 128 may supply liquid coolant to pool 116 to thereby enable pool boiling of the liquid coolant and conversion of the liquid coolant into vaporized coolant. For instance, one or more pumps associated with a reservoir storing cool liquid coolant may supply cool liquid coolant to ENE 100 via liquid coolant line 120. The cool liquid coolant may flow through liquid coolant line 120 via liquid coolant inlet 128 into chamber 102, where the liquid coolant may collect in pool 116. Heat generated by solid-state electronics component 110 may conduct through heat conducting wall 104 of ENE 100 where the heat may be absorbed by liquid coolant contained in pool 116. The heat may raise the temperature of the liquid coolant in pool 116 to reach boiling, causing pool boiling of the liquid coolant, and transformation thereof to vaporized coolant. In some embodiments, liquid coolant line 120 may be a polyurethan tube with a diameter of approximately 4mm, and a minimum bend radius of 9.5mm, and liquid coolant inlet 128 may have a diameter of approximately 4mm, to accommodate liquid coolant line 120. In some embodiments, the temperature at which the liquid coolant reaches boiling and vapor bubbles form (e.g., the boiling incipient temperature) inside chamber 102 of ENE 100 may be lower than the boiling incipient temperature for the liquid coolant external to ENE 100, subject to ambient pressure. For example, the pressure inside chamber 102 may be higher than ambient pressure. In some embodiments, vapor line 122 may be associated with a controllable valve, permitting at least one processor to control the pressure inside chamber 102, and thereby control the boiling temperature of the coolant. In some embodiments, the liquid coolant may be a non-electrically conductive material, e.g., to prevent contact with solid-state electronics component 110 from causing a short circuit.

Some disclosed embodiments may involve a plurality of fins within the chamber and extending from the heat transfer surface. A plurality of fins within the chamber refers to thin, flat, elongated components structurally attached to a surface, as described, and exemplified elsewhere herein. Fins may be positioned on the inner surface of the heat transfer surface (i.e., heat conducting wall) to facilitate pool boiling. Fins extending from the heat transfer surface refers to fins structurally attached and protruding from, spreading out from, and/or reaching out from the heat transfer surface. For example, the fins may be positioned on the heat transfer surface in the chamber and extend outward for submersion in the liquid coolant. Submersion in the liquid coolant allows heat from the heat transfer surface (i.e., heat conducting wall) to conduct into the chamber via fins.

In some embodiments, the fins are be made of heat conductive material. Heat-conductive material refers to a substance that conveys and/or transfers heat. For example, a material capable of conducting heat may include vibration of atoms that exchange energy with each other., and flow, on average, from a higher temperature region to a lower temperature region. In some embodiments, the heat conductive material is chosen from a group consisting of copper, iron, steel, and aluminum. Non-limiting examples of heat-conductive material may further include graphite, silver, or gold.

In some embodiments, the fins are made of a non-metal. Non-metal refers to an element and/or material that is not classified as a metal, such as materials having high electronegativity that are poor conductors of electricity. In some embodiments, non-metals may include materials that are not malleable or ductile. Non-limiting examples of non-metal include iodine, carbon, phosphorous, sulfur, and selenium. In some embodiments, the non-metal is graphite, which is a form of the element carbon.

In some disclosed embodiments, the fins may be arranged in the chamber for submersion in the liquid coolant. Submersion in the liquid coolant refers to the act or process of going or being partially or wholly covered, surrounded, or immersed in the liquid coolant. For example, the fins may be arranged so that they within the liquid coolant such that heat carried through the fins dissipates in the liquid coolant. Submersion in the liquid coolant may occur for a short or long duration, or until an event happens.

By way of a non-limiting example, in Figs. 2A-2B, chamber 102 (see Fig. 1B) may include a plurality of fins 204 therein. For example, fins 204 may conduct heat from inner surface 106 of heat conducting wall 104 into liquid coolant stored in pool 116 to facilitate pool boiling therein.

By way of non-limiting example, in Fig. 3A, an array of fins 300 may be positioned on inner surface 106 of heat conductive wall 104 of an ENE 100. Fins 300 may be positioned inside pool 116 of chamber 102, extending outwards from inner surface 106 of heat conductive wall 104 for submersion in the liquid coolant to allow heat from heat generating component 110 to conduct into chamber 102 via fins 300. As liquid coolant boils inside chamber 102, bubbles (e.g., containing vaporized coolant) may form and collect on fins 300.

Some disclosed embodiments involve a plurality of porous units disposed between the plurality of fins such that the fins and the porous units alternate, and wherein the porous units are configured to wick coolant along the fins. A porous unit may include a single or individual cell or quantity of medium or material that has voids or pores therein. The voids or pores may permit, for permitting air or fluid to pass therethrough. For example, porous units may be filters, absorbents, nanostructured material, or any other similar units. In some examples, the porous units are wicks. Wicks disposed between a plurality of fins may be understood as components designed to facilitate the movement or transfer of a substance (e.g., liquid, vapor) from one location to another, described and exemplified elsewhere herein. To wick means to draw or transport from one area to another. For example, each of the porous units may draw away bubbles generated by pool boiling within the chamber, allowing cool liquid coolant to replace hot vaporized coolant in the region of the heat conducting wall. To wick coolant along the fins refers to drawing or transporting coolant located near or adjacent a surface of a fin. Disposed refers to arranging in a particular position. For example, porous units (e.g., wicks) may be positioned between the fins according to a predetermined pattern (e.g., alternating). Alternating refers to occurring in turn repeatedly. For example, alternating can be every other, and/or another pattern. In some examples, porous units may be positioned such that there is a fin, then a porous unit, then a fin, then a porous unit. Similarly, the porous units may be positioned so that porous units follow a different arrangement.

In some embodiments, the porous units include a non-heat conductive fibrous material. Non-heat conductive fibrous material refers to a material not capable of heat transfer and consisting of, characterized by, and/or resembling fibers. A non-heat conductive material refers to an insulating substance that does not allow the passage of heat from travelling therethrough. Fibrous material may include natural fibers, synthetic fibers, and/or a combination of natural fibers and synthetic fibers. Non-limiting examples of non-heat conductive fibrous material include cotton, wool, linen, silk, polyester, and nylon. In some embodiments, the fibrous material may be cellulose. Cellulose refers to a polysaccharide, insoluble substance, consisting of chains of glucose monomers. Cellulose may be natural, manufactured, and/or any combination of natural and manufactured. Non-limiting examples of cellulose include rayon, viscose, or a cellulose polymer such as flax.

In some embodiments, the at least some of the plurality of porous units have a rough surface. A rough surface refers to a surface that is uneven, unregular, not smooth, and/or having a non-level outer or top layer. For example, rough surface may be bumpy, rugged, coarse, dry, and/or ridged. Porous units (e.g., wicks) with a rough surface may cause bubbles to form and release quickly, thereby promoting efficient heat transfer. In further embodiments, each rough surface may be configured to prevent entrapment of boiling coolant bubbles in an associated gap between adjacent fins. Entrapment refers to being caught or trapped in a confined space in a way that at least partially restricts movement or freedom. Entrapment of boiling coolant bubbles refers to bubbles being caught or held between fins and thereby occupying the space between fins. Entrapped bubbles may prevent coolant from entering the space between fins. Further, entrapment may prevent circulation of liquid coolant within the chamber. Preventing entrapment of boiling coolant bubbles refers to stopping or hindering bubbles from being caught or trapped. Adjacent fins refers to two or more fins that are arranged next to one another in a space or along a length. In some embodiments, adjacent fins may be parallel to one another, and may have at least one edge in alignment with other adjacent fins. Boiling coolant bubbles refers to vapor bubbles formed due to boiling of the coolant. Boiling coolant bubbles may occur when heating a liquid to reach a boiling temperature, at which point the liquid may be converted to gas, or vapor and bubbles may form. The boiling temperature of a liquid may depend on ambient pressure, such that adjusting the ambient pressure may cause a corresponding adjustment to the boiling temperature. Boiling coolant bubbles may form inside the chamber. A gap refers to an opening, an aperture, slit, slot, vent, cavity, crack, hole, space, and/or perforation. An associated gap between fins refers to a space between two fins. In some embodiments liquid coolant is permitted to flow through the space of the gap. In some embodiments, each rough surface is configured to facilitate formation of boiling coolant bubbles smaller than would be formed in an absence of each rough surface. Boiling coolant bubbles smaller than would be formed in an absence of each rough surface refers to the area and/or diameter of the bubbles formed with the porous unit (e.g., wick) having a rough surface being smaller than the area and/or diameter of the bubbles formed without the rough surface. If bubbles become trapped within fins (e.g., due to their large size), vaporized coolant may be unable to escape the vapor outlet and thus may hamper heat transfer. Formation of smaller boiling coolant bubbles minimizes risk of entrapment. For example, a rough surface configured to facilitate smaller bubbles reduces the chance of bubbles being caught or held between fins, and thus helps allow coolant to flow between fins. In some embodiments, each rough surface is configured to facilitate formation of boiling coolant bubbles smaller than an associated gap between adjacent fins. Adjacent fins refer to fins that are located next to, alongside, or in close proximity to each other. Bubbles that are smaller than an associated gap between adjacent fins refers to bubbles having a dimension such as a diameter that is smaller than a dimension of an opening of the associated gap between fins that are located next to each other, so that the bubbles can pass through the gap. By facilitating the formation of boiling coolant bubbles that are smaller than an associated gap between adjacent fins, associated disclosed embodiments minimize risk of entrapment and facilitate coolant flowing between fins. In some embodiments, the plurality of porous units are configured to enable the boiling coolant bubbles formed thereon to escape toward the outlet for vaporized liquid coolant. To escape refers to leaving, releasing, or breaking free from a confined space. To enable the boiling coolant bubbles formed thereon to escape refers to facilitating the release of bubbles formed on the porous units. Escape toward the outlet for vaporized liquid coolant refers to bubbles leaving the porous units or being released from the porous units in a direction of the vaporized liquid coolant outlet. In some embodiments, the porous units may be placed between each fin to enhance cooling and guide bubbles during pool boiling away from the pool. For example, wicks may enable the bubbles to escape via the vapor outlet. The enablement of boiling coolant bubbles to escape toward the outlet allows for heat transfer from fins of the ENE using the liquid coolant that becomes vaporized from conducted heat.

In some embodiments, a width of each of the plurality of porous units may be less than or equal to a size of an associated gap between adjacent fins. Width refers to a thickness or side to side dimension. For example, a measurement of the thickness of a porous unit (e.g., wick) may be less than or equal to a dimension of the gap between adjacent fins. Stated in another way, the width of the gap between two fins may be larger than the thickness of the porous unit (e.g., wick). An associated gap refers to a gap, as described and exemplified elsewhere herein, between adjacent fins to which the gap is associated. For example, liquid coolant may flow through a gap between adjacent fins, allowing for heat transfer. In other embodiments, the at least some of the plurality porous units may extend past adjacent fins in at least one of length or height. Height refers to the extent and/or amount of projection of the fin from the heat transfer surface. For example, the height of porous units greater than the height of fins may cause wicks to extend beyond fins. height-wise into the chamber, and into the pool. Length refers to the extent and/or amount of an object from end-to-end. For example, the length of the porous units may be large enough to cause the porous units to extend in a direction beyond fins into the chamber, and into the pool. Porous units may extend past adjacent fins due to both height and length.

In some embodiments, each of the plurality of porous units is in a form of a strip interleaved between adjacent fins. Strip refers to an elongated arrangement or material. In some embodiments, a strip may take the form of an arrangement that has a narrow dimension along one axis, and a long dimension across another axis. Porous units in a form of a strip thus refers to a plurality of porous units arranged together in a long, narrow configuration. Interleaved refers to a pattern or arrangement in which different elements or items are alternated or mixed together in an ordered sequence. In some embodiments, interleaved may refer to layers of one material or device placed between layers of another material or device. For example, an elongated arrangement of porous units (i.e., wicks) may be positioned between fins in an alternating fashion to enhance cooling.

Some disclosed embodiments involve at least one rib in the chamber that maintains the porous units between the fins. A rib refers to a structural element that provides support. A rib may be a raised, linear feature or a beam-like projection on the surface of a structure. A rib that maintains refers to a rib that supports one or more components of a structure by providing stability by distributing a force or load. A rib also adds strength and reinforcement to a structure by helping it to resist deformation. In some embodiments, a rib is an elongated, raised piece of stronger and/or thicker material across a surface or through a structure. For example, a rib may extend from inside the chamber and support the porous units within the chamber.

Some disclosed embodiments involve graphite layers sandwiching at least some of the porous units. Graphite layers refers to sheets and/or surfaces made of graphite, in whole or in part. Sandwiching refers to inserting or place an item between two other items. In some embodiments, sandwiching may involve surrounding an item with other items that exert a squeezing force on the sandwiched item. Graphite layers sandwiching at least one of the porous units refers to at least one porous layer being placed between pieces of graphite, serving as a conductor and promoting heat transfer.

Some disclosed embodiments involve the graphite layers containing a plurality of notches. Notches refer to indentations, recesses, or incisions on an edge or surface of an object. Notches may have a V-shape or a U-shape, or other types of shapes depending on the design requirements of the system. Notches that are repeated along a length of a graphite layer may create a graphite layer that appears folded or corrugated. In some embodiments, one or more graphite layers may include notches that promote bubble formation in the coolant, and promote movement of the bubbles. In some embodiments, notches may promote ventilation by allowing bubbles form and move upward away from the wins and wicks. Some embodiments involve, the notches expose each of the plurality of porous units to an adjacent fin. Expose refers to subjecting, presenting, contacting, interfacing, uncovering, and/or revealing. For example, a first one object may interface with a second object through direct contact or indirect contact via one or more intermediate third objects. Alternatively, a first object may be exposed to a second object by providing a direct line of sight between the two objects. An adjacent fin refers to a fin that is next to, alongside, or in close proximity to an object. Plurality of porous units to an adjacent fin thus refers to a fin being next to, alongside, or in close proximity to the plurality of porous units (e.g., wicks). The notches exposing each of the plurality of porous units to an adjacent fin refers to indentations or recesses in the graphite layer that result in the graphite layer contacting both the plurality of porous units and a fin in close proximity. For example, the notches in the graphite layers may be designed so that there is a pathway along the porous units and fins, to promote bubble formation and movement.

By way of non-limiting example Fig. 3A illustrates an exemplary array of fins positioned on an inner surface of a heat conductive wall of an ENE, consistent with some disclosed embodiments. As shown in Fig. 3A, one or more bubbles may become trapped within fins 300 (e.g., if the bubbles grow too large). This may prevent the bubbles from escaping, thwarting an outflow of vaporized coolant via vapor outlet 122 and hampering heat transfer. Thus, fins 300 alone may be insufficient to cool heat-generating electronic components (e.g., due to non-uniform bubble formation). To address this issue and enhance a cooling effect of the system, and by way of non-limiting example, Fig. 3B illustrates exemplary wicks introduced between fins. As shown in Fig. 3B, wicks 302 may be introduced between fins 300 (e.g., interposed between each fin), as shown in Fig. 3B, in an ENE to enhance cooling. Wicks 302 may guide bubbles during pool boiling away from pool 116 to enable the bubbles to escape via vapor outlet 130.

An arrangement of wicks such as that illustrated in Fig. 3B may prevent entrapment of bubbles and facilitate circulation of liquid coolant within chamber 102. Wicks 302 may be made of a fibrous material, such as paper, cellulose, or fabric (e.g., having a porous or rough surface) that may cause bubbles to form quickly and evenly distributed, and release quickly, thereby promoting efficient heat transfer. In some embodiments, individual wicks 302 may be distributed between fins 300 (e.g., in an alternative arrangement) to cause a wicking motion of the coolant along wicks 302, facilitating bubbles forming on wicks to escape to second portion 118 of chamber 102. In some embodiments, wicks 302 may be long strips for fitting between fins 300 (e.g., interleaved between fins 300, each of which may be shaped as a long rectangle). Each of wicks 302 may be narrower than the gap between each pair of fins 300 to allow fluid flow in and around wicks 302 when interleaved between fins 300.

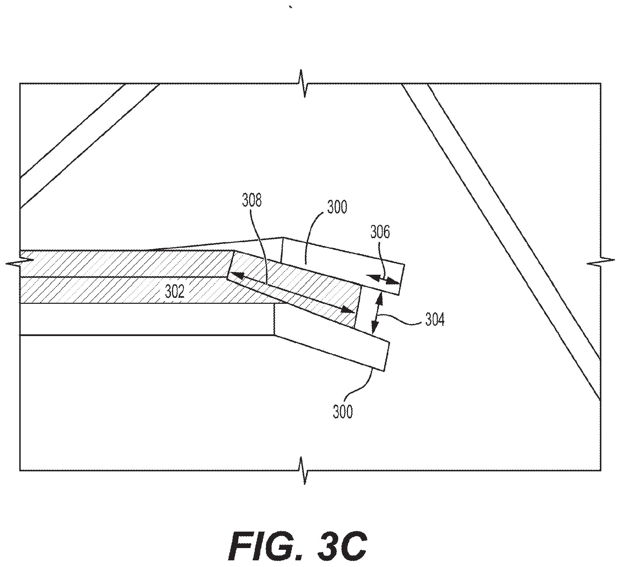

Fig. 3C illustrates a non-limiting example of a wick interposed between two fins. As shown in Fig. 3C, a width 304 of the wicks 302 may be less than the size of an associated gap between adjacent fins 300. In some embodiments, the height 306 of wicks 302 may be greater than the height 306 of fins 300, causing wicks 302 to extend beyond fins 300 height wise into chamber 102 (e.g., into pool 116). In some embodiments, the wicks 302 may extend past the fins 300 in length 308, into chamber 102 (e.g., into pool 116). Further, a combination of height 306 of wicks 302 and length 308 of wicks 302 may cause the wicks 302 to extend into chamber 102 (e.g., into pool 116 of chamber 102, illustrated in Fig. 1B). In some embodiments, A base of chamber 102 (shown in Fig. 1B) may include one or more grooves or ribs (e.g., pairs of ribs forming grooves) to hold the wicks and/or graphite layers between pairs of fins 300. For example, a base plate of the arrangement shown in Fig. 3A may have one or more grooves formed therein, to hold one end of the fins and/or wicks. In some embodiments, ribs (not shown) may be formed on top of the base plate surface, and parallel ribs close to one another may form a groove for holding a fin or wick.

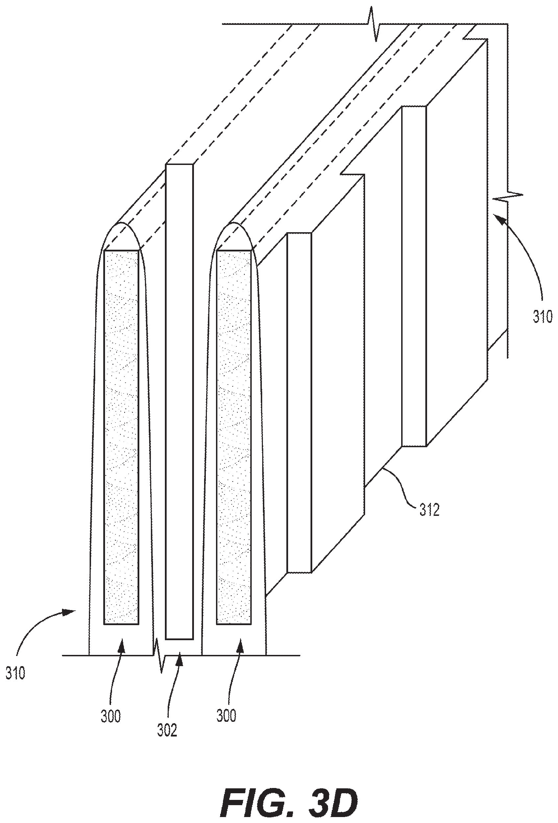

By way of non-limiting example, Fig. 3D illustrates a perspective view of an exemplary arrangement of fins and wicks that are sandwiched between graphite sheets, consistent with some disclosed embodiments. As shown in Fig. 3D, graphite layers 310 (e.g., thin sheets) may be inserted between wicks 302 and/or fins 300. The graphite layers may include notches 312 that may interface between the wicks and the fins (e.g., to promote bubble formation and movement).

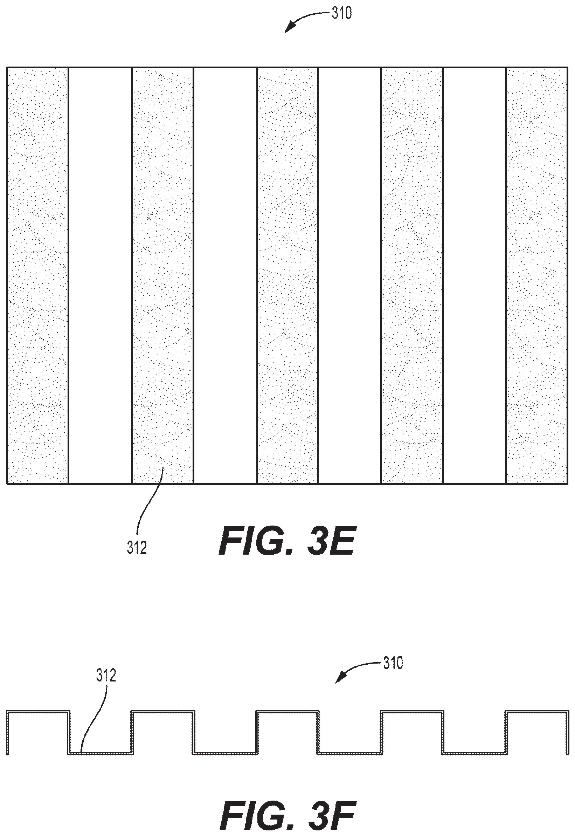

Fig. 3E illustrates a side view of an exemplary graphite sheet with notches, consistent with some disclosed embodiments. As shown, a graphite layer 310 (e.g., a thin sheet), may have notches 312 repeatedly formed in the graphite layer 310, such that the graphite layer 310 may have a corrugated appearance. Fig. 3F illustrates a top view of an exemplary cross section of a graphite sheet with notches, consistent with some disclosed embodiments. The cross-section view shown in Fig. 3F further illustrates an exemplary corrugated arrangement of a graphite sheet 310 with notches 312 formed in the sheet. Notches 312 formed in graphite sheet 310 may promote bubble formation and movement of bubbles of a small size that can move easily upward and away from fins 300, to maximize the cooling effect of the ENE.

To interconnect multiple Enhanced Nucleation Evaporators (ENEs) with minimal tubing and connection complexities, vapor return from multiple ENEs may be aggregated using a vapor passthrough line running through each ENE. The vapor passthrough may flow connect multiple ENEs (e.g., via a vapor port of each ENE), to collect vaporized coolant from each ENE, e.g., for delivery to a main vapor line carrying the vaporized coolant to a condenser.

Some disclosed embodiments involve a two-phase cooling device configured for parallel liquid coolant interconnection and serial vapor return interconnection. A two-phase cooling device refers to a heat exchanger that utilizes phase change of a working fluid for heat transfer purposes, as described and exemplified elsewhere herein. Two-phase cooling device may be configured to allow for parallel liquid coolant interconnection and/or serial vapor return interconnection. Liquid coolant refers to coolant, as described and exemplified elsewhere herein, while in a liquid state. Interconnection refers to a mutual connection between two or more things, substances, and/or devices. For example, multiple ENEs may be interconnected, allowing for vaporized coolant to flow between the ENEs. Parallel liquid coolant interconnection refers to conduits, tubes, pipes, or other channels arranged such that liquid coolant flows therethrough in parallel (e.g., flows to multiple components simultaneously). For example, a parallel liquid coolant interconnection may refer to an arrangement where liquid coolant is enabled to flow through multiple ENEs at the same time (i.e., in parallel). Serial vapor return interconnection refers to an interconnection of vaporized coolant flowing through multiple components in sequence, and therefore accumulating vaporized coolant for delivery to the main vapor line, to be sent to the condenser. For example, serial vapor coolant return interconnection may refer to vaporized coolant flowing through multiple ENEs in sequence (e.g., ENEs arranged along a common vapor return flow path) and accumulating vaporized coolant from each ENE. It is to be appreciated that the direction of the flow of aggregated vaporized coolant may change depending on load and vapor pressure of the ENEs. A two-phase cooling device configured for parallel liquid coolant interconnection and serial vapor return interconnection thus refers to a two-phase cooling device adapted (or arranged) for both parallel liquid coolant interconnections and serial vapor return interconnections.

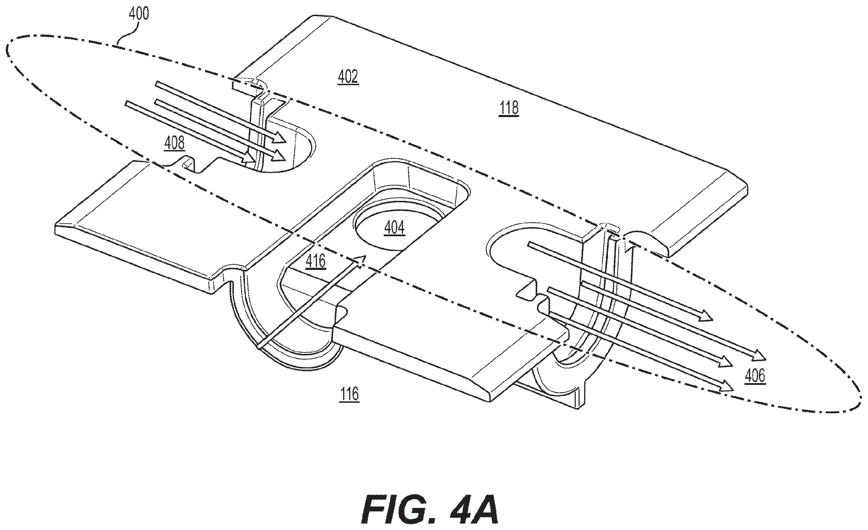

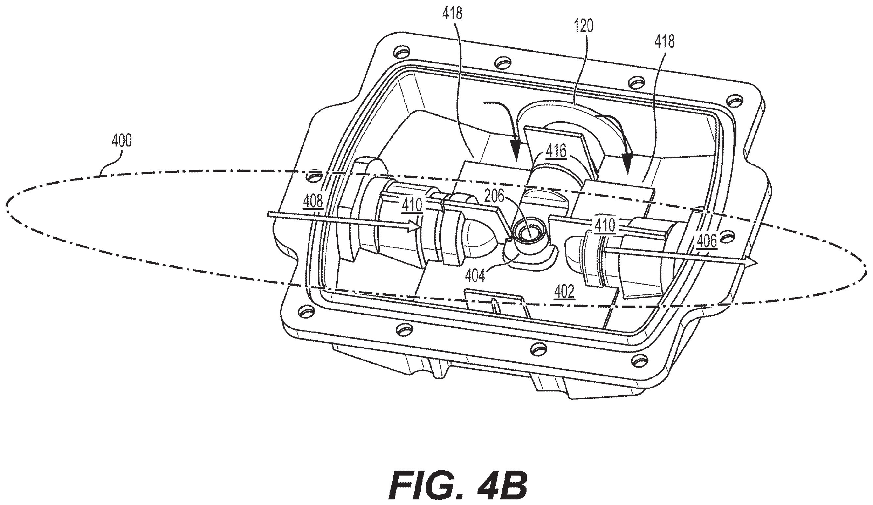

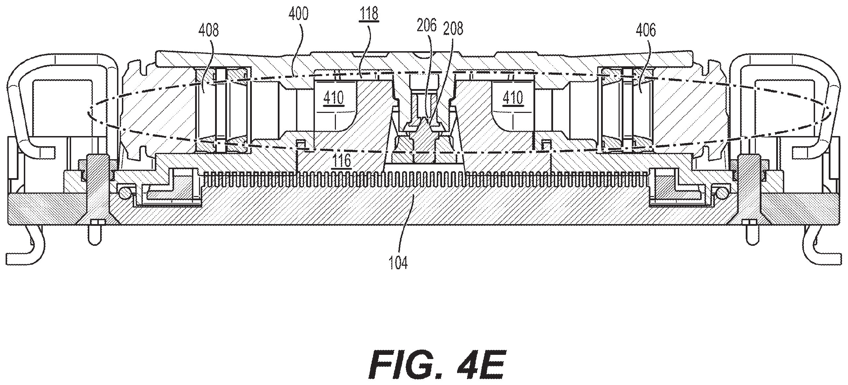

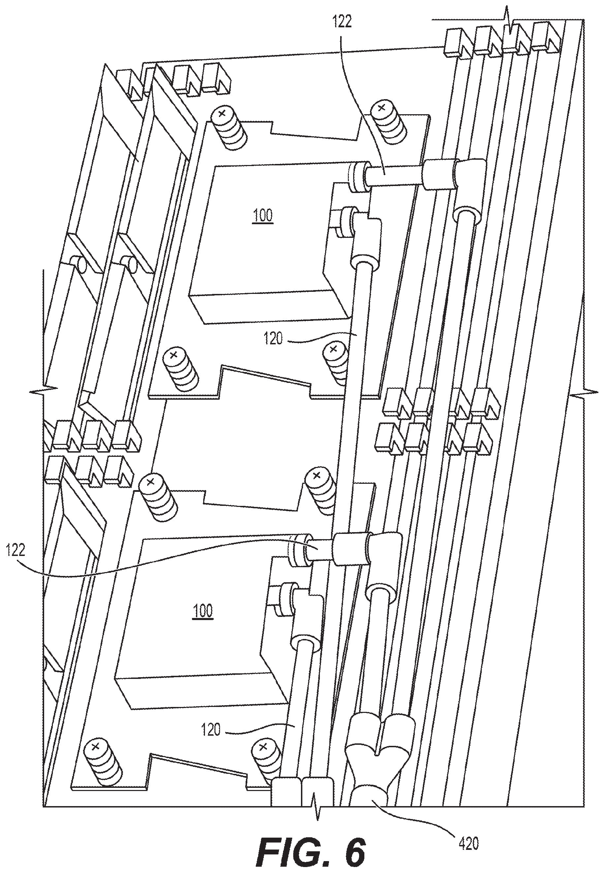

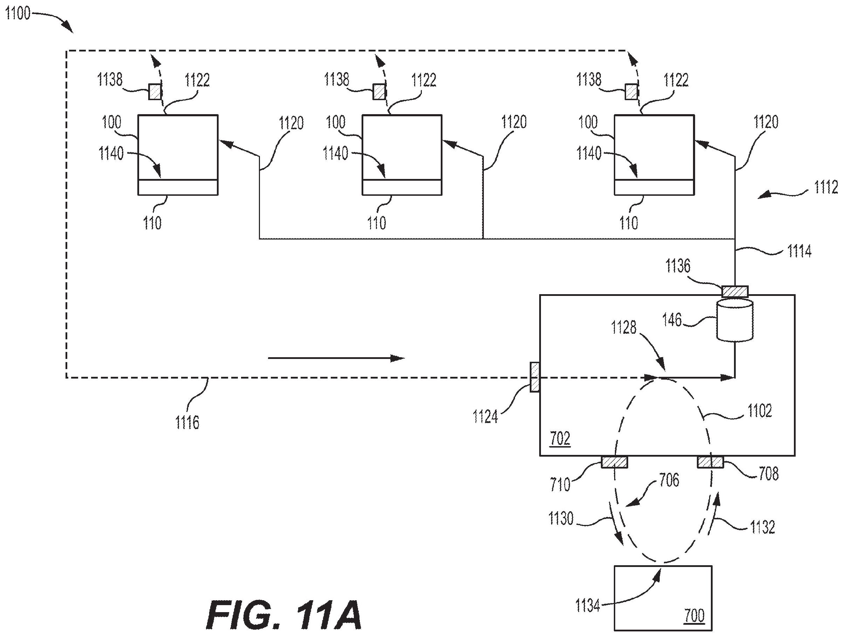

By way of non-limiting example, Fig. 6 illustrates two ENEs 100 (two-phase cooling devices). ENEs 100 are each connected to a liquid coolant line 120, such that the ENEs 100 receive liquid coolant in parallel. In the example shown in Fig. 6, each ENE 100 is also connected in parallel to vaporized coolant return line 122. In some embodiments, the vaporized coolant of a first ENE 100 may flow through a conduit in a second ENE 100 and mix with vaporized coolant from the second ENE 100, so that the vaporized coolant return of the ENEs are connected serially. For example, Fig. 11A shows a block diagram of multiple ENEs 100 connected to a vaporized coolant return line 1100. Line 1100 may connect each of the ENEs 100 serially using a vapor passthrough. Examples of vapor passthrough 400 are illustrated in Figs. 4A, 4B, and 4E, and described and exemplified herein.

In some embodiments, the two-phase cooling device may involve a chamber having a liquid coolant region and a vaporized coolant region. A chamber refers to an at least partially enclosed compartment and/or cavity, as described and exemplified elsewhere herein. In some embodiments, chamber may include one or more openings to enable fluid to enter and/or exit the chamber. Further, a chamber may include multiple regions, having one or more similar or different functions. A region is a defined area or space. A region may be characterized by certain common features, characteristics, or boundaries of the space. A liquid coolant region refers to an area in the chamber configured to hold liquid coolant. Vaporized coolant refers to liquid coolant that has undergone a phase change to a gaseous state, and vaporized coolant may undergo condensation to transform back to liquid coolant. Vaporized coolant region refers to an area in the chamber configured to hold vaporized coolant. Vaporized coolant may be understood as a gaseous state of a liquid coolant substance. For example, liquid coolant undergoing boiling may transform to vaporized coolant. Vaporized coolant region may include an inlet and/or outlet. A chamber having a liquid coolant region and a vaporized coolant region refers to the chamber having and/or being configured to have multiple regions, including a liquid coolant region and a vaporized coolant region as described elsewhere herein.

By way of non-limiting example, Fig. 1B shows a cross sectional view of an ENE 100, having a chamber 102 with a pool 116 (also referred to herein as a liquid coolant portion that serves as a liquid coolant region) and a second portion 118 serving as a vaporized coolant region.

In some embodiments, a float valve in the liquid coolant region may be configured to conditionally restrict inlet flow of liquid coolant into the liquid coolant region. A valve refers to a mechanism for regulating flow, as described and exemplified elsewhere herein. For example, a valve may regulate a direction of flow, a magnitude of flow, and/or may be used to stop and/or start a flow. A float valve, as described and exemplified elsewhere herein, may be located in the liquid coolant region and regulate amount of liquid coolant allowed into the liquid coolant region. Flow (e.g., a fluid flow) may be understood as movement or continual deformation of a fluid under an applied force. Flow may correspond to kinetic energy of particles or molecules of a fluid, where a fluid may include a substance in a liquid and/or gaseous state. For example, a temperature gradient in a fluid may cause warmer fluid to rise and cooler fluid to sink, e.g., in a cyclical flow motion. Similarly, exposing a fluid to a pressure gradient may cause the fluid to move from a region of higher pressure to a region of lower pressure. An inlet is described an exemplified elsewhere herein. To Restrict inlet flow refers to limiting, constraining, and/or stopping flow through an inlet. For example, restrict inlet flow may involve reduced inflow of liquid coolant into a chamber. In some embodiments, a valve may be used to restrict a fluid from flowing that would otherwise flow due to a pressure and/or temperature gradient. Conditionally restrict refers to limiting according to predetermined criteria and/or conditions. In some embodiments, inlet flow may be limited based on one or more measured parameters or upon detection of a condition due to surpassing a threshold. For example, a float valve may be configured to regulate or restrict flow of a liquid coolant when the liquid coolant in the chamber surpasses a threshold. A threshold refers to a boundary and/or limit, as exemplified elsewhere herein. A float valve that is configured to conditionally restrict inlet flow refers to a float valve with the ability to engage with an inlet port and regulate the flow of liquid coolant into the liquid coolant region of the chamber based on a set of conditions. Conditions may include height of liquid, temperature of liquid, and/or flow of liquid in the chamber. Conditions may be predetermined and/or determined in real time by sensors. For example, float valve may block further inflow of liquid coolant into the chamber until the level of liquid coolant decreases sufficiently to disengage the float valve from the inlet port.

By way of non-limiting example, Figs. 1B, 2A and 2C illustrate a float valve 200 of an ENE 100, that is configured to conditionally restrict inlet flow, as further described and exemplified elsewhere herein.

Some disclosed embodiments include a first vapor port in the chamber for evacuating first vaporized coolant from the chamber. A vapor port refers to an opening, aperture, and/or hole in the chamber for vapor movement. For example, vapor port may be an inlet and/or outlet port, as exemplified elsewhere herein. A vapor port may be manufactured with a chamber as a single, integral piece made of molded material, such as plastic. Alternatively, a vapor port may be manufactured as a separate component and attached to a wall of the chamber. For example, a vapor port may be connected to the chamber mechanically, where the connection may be sealed (e.g., using a sealant) to prevent leakage. A first vapor port may be configured to evacuate first vaporized coolant from the chamber. The first vapor port may be configured for flow connection. Flow connection refers to an interconnection enabling substance (e.g., vaporized coolant) to travel between two points. For example, first vapor port may be flow connected to another vapor port (e.g., second vapor port), allowing a first vaporized coolant to travel in a path to the second vapor port. First vaporized coolant refers to vaporized coolant evacuated from the one heat exchanger, such as a chamber of an ENE, via the first vapor port. For example, first vaporized coolant may travel from the chamber of an ENE, through the first vapor port, to a second ENE. Evacuating refers to removing, expelling, and/or drawing and/or siphoning away, as described and exemplified elsewhere herein. Evacuating first vaporized coolant from the chamber refers to removing, expelling, or enabling first vaporized coolant to be removed from the chamber. For example, a pressure differential between an average pressure inside a chamber versus an average pressure outside the chamber may cause vaporized coolant to exit the chamber via first vapor port in the chamber. Such a pressure differential may be induced, for instance, due to pool boiling of liquid coolant within the chamber causing liquid coolant to transition to vaporized coolant and accumulate inside the chamber.

Some disclosed embodiments include a second vapor port in the chamber for receiving second vaporized coolant from at least one other chamber of at least one other two-phased cooling device. Second vapor port refers to a vapor port, as described and exemplified elsewhere herein, configured to receive the second vaporized coolant from another chamber. The second vapor port may be configured for flow connection. Second vaporized coolant refers to vaporized coolant received from at least one other chamber of at least one other two-phase cooling devices. Second vaporized coolant may include an aggregate and/or mixture of vaporized coolant received from one or multiple two-phase cooling devices. The vaporized coolants from at least one other chamber of at least one other two-phase cooling device may be flow connected. In some embodiments, the first vapor port and the second vapor port are at least partially located in the liquid coolant region. Partially located refers to part of a component being situated in a place or position, so there is some extent and/or degree of presence in a specific area. A region may be understood as a defined area, as described and exemplified elsewhere. For example, the first vapor port and second vapor port may extend into the liquid coolant region to a certain degree, but not fully or completely.

In some embodiments, the cross-sectional areas of the first vapor port and the second vapor port are larger than a cross-sectional area of the liquid coolant port. Cross-sectional area refers to an area of a two-dimensional shape obtained when a three-dimensional object is sliced perpendicular to a specified axis. For example, the cross-sectional area of a cylinder may be the area of a circle. If round, a cross-sectional area of a vapor port may be determined using a radius and/or diameter of the vapor port. A cross-sectional area of the second vapor port refers to a cross-sectional area determined with respect to the second vapor port. For example, determining a cross sectional area of the second vapor port may involve determining the radius and/or diameter of the second vapor port. The cross-sectional areas of the first vapor port and the second vapor port being larger than the cross-sectional area of the liquid coolant port refers to a measurement and/or determination that the aggregate of the cross-sectional areas of the first vapor port and the second vapor port is larger than the cross-sectional area of the liquid coolant port. For example, the diameters of the first vapor port and the second vapor port may be larger than the diameter of the liquid coolant port.

Some disclosed embodiments include a vapor passthrough path flow-connecting the first vapor port to the second vapor port, to thereby enable the second vaporized coolant to mix with the first vaporized coolant. A passthrough path refers to a designated route from one place to another. A passthrough path may be understood to provide unimpeded passage, allowing for continuous and unobstructed passage. A vapor passthrough path refers to a designated route for vapor to flow without condensing. A vapor passthrough path may provide a path for vapor to flow without causing condensation or loss of the vapor. By preventing condensation, a vapor passthrough path maximizes heat evacuation from a heat exchanger, such as an ENE, and may optimize heat retention of the vapor until it reaches a heat exchanger to expel heat and condense to liquid vapor, such as in an HRU. A vapor passthrough path may be flow connected between multiple ENEs. For example, a vapor passthrough path may include an accumulation of first vaporized coolant from the first vapor port and second vaporized coolant from the second vapor port. Flow-connecting the first vapor port to the second vapor port refers to a flow connection as exemplified elsewhere herein, where the vapor travels from the first vapor port to the second vapor port. For example, first vaporized coolant may travel through the first vapor port, through a vapor passthrough path, and to the second vapor port. Flow-connecting the first vapor port to the second vapor port allows for mixing of the first and second coolant. To mix refers to combining substances (e.g., vaporized coolant). To mix may be understood as combining substances in a way that they become uniformly distributed or integrated with one another. For example, with a serial vapor return interconnection, liquid coolant from multiple ENEs (e.g., first vaporized coolant and second vaporized coolant) may be mixed. Enabling the second vaporized coolant to mix with the first vaporized coolant refers to the vapor passthrough path allowing for flow connection between the first vapor port and second vapor port such that the second vaporized coolant may mix with the first vaporized coolant. The mixing of the second vaporized coolant with the first vaporized coolant allows for vapor to collect from each ENE, for delivery to a main vapor line carrying the vaporized coolant to a condenser.

In some further embodiments, the first vapor port and second vapor port are flow connected to the vaporized coolant region of the chamber thereby enabling the second vaporized coolant entering the vaporized coolant region to form a mixture with the first vaporized coolant, and enabling the mixture to exit the vaporized coolant region via the first vapor port. A mixture refers to the result of mixing substances (e.g., vaporized coolant). For example, a mixture may be an aggregate and/or combination of first vaporized coolant and second vaporized coolant. Form a mixture refers to creating a combination of two or more substances in such a way that they are physically intermingled but may not be chemically bonded. Enabling the second vaporized coolant entering the vaporized coolant region to form a mixture with the first vaporized coolant refers to the first vapor port and second vapor port being flow connected so that the first vaporized coolant and the second vaporized coolant may mix and create a combination of the first vaporized coolant and the second vaporized coolant. Exit refers to leaving, egressing, and/or escaping. For example, the vaporized coolant mixture may leave the vaporized coolant region through the first vapor port. Enabling the mixture to exit the vaporized coolant region via the first vapor port in the context of a two-phase cooling device refers to being configured so that the mixture of the first vaporized coolant and second vaporized coolant may exit (e.g., leave) the vaporized region via the first vapor port and flow to another location (e.g., the chamber).

By way of non-limiting example, Figs. 4A-4C and 4E show a first vapor port 406 and a second vapor port 408 that may be flow connected to vaporized coolant region in second portion 118 of chamber 102 to enable the vaporized coolant from a downstream ENE 100 entering vaporized coolant region in second portion 118 of the current ENE 100 via second vapor port 408 to mix with the vaporized coolant flowing from pool 116 of the current ENE 100. The mixed vaporized coolant may exit vaporized coolant region 118 via first vapor port 406 (e.g., to a vapor line flow connected to a condenser). As shown in Figs. 4A, 4B, and 4E, a vapor passthrough 400 may provide a path for vapor to flow through vapor return lines connecting ENEs in series, without causing condensation or loss of the vapor.

In some embodiments, the vapor passthrough path is at least partially located in the vaporized coolant region. A vapor passthrough path is described and exemplified above. A vapor passthrough path at least partially located in the vaporized coolant region refers to a vapor passthrough path that flows in part or in whole through the vaporized coolant region. For example, vapor passthrough path may travel from the first vapor port, through the vaporized coolant region of the chamber, and to the second vapor port.

In some embodiments, at least one vaporized coolant conduit is connected to at least one of the first vapor port and the second vapor port, wherein the at least one vaporized coolant conduit at least partially passes through the liquid coolant region. A vaporized coolant conduit refers to a conduit, as described and exemplified elsewhere herein, for facilitating the transfer of vaporized coolant. For example, a vaporized coolant conduit may be configured to move vaporized coolant from one location to another. Connected to refers to being attached, associated with, and/or linked. For example, vaporized coolant conduit may be attached to at least the first vapor port and the second vapor port, such that the conduit may transfer vaporized coolant (e.g., to the chamber). Vaporized coolant conduit may be connected to one or more additional vapor ports, allowing for transfer of additional vaporized coolant (e.g., to the chamber). At least partially passes through the liquid coolant region refers to the vaporized coolant conduit moving though the liquid coolant region to an extent and/or degree. For example, the vaporized coolant conduit may partially and/or fully pass through the vaporized region of the chamber. The vaporized coolant conduit may be at least partially submerged in liquid coolant in the pool.

By way of non-limiting example, Figs. 4A-4E show interior and cross-sectional views of an exemplary ENE 100 (e.g., including a liquid coolant region in pool 116 and vaporized coolant region in second portion 118 inside chamber 102) having a vapor pass-through conduit 400. Liquid coolant may flow into pool 116 of chamber 102 of an ENE 100 from a liquid coolant source (e.g., a condenser) via a liquid port (e.g., orifice 206 flow connected to liquid coolant line 120). Vaporized coolant (e.g., vaporized by heat generated form electronic component 110) may be evacuated from chamber 102 via a vapor port 406 (e.g., first vapor port, flow connected to vaporized coolant conduit 122). Chamber 102 may include at least one other vapor port 408 for receiving vaporized coolant from at least one other chamber 102 of at least one ENE 100 (e.g., Figs. 4A-4B) and thereby enable the vaporized coolants from multiple ENEs to mix.

In some embodiments, vapor pass through 400 may flow connect three or more ENEs 100 serially, e.g., port 406 may convey vaporized coolant (e.g., aggregated from the current ENE and a downstream ENE) to an upstream ENE 100, thereby aggregating vaporized coolant from three ENEs. It is to be noted that the direction of the flow of aggregated vaporized coolant may change depending on load and corresponding vapor pressure among the three ENEs (e.g., they may connect in a loop that connects to a main vapor line).

By way of another non-limiting example, Fig. 6 shows multiple ENEs 100 fluidly connected to a common vapor line 420 via vaporized coolant conduit 122. In some embodiments, each conduit 122 may be connected to a vapor pass-through configured with each ENE, to allow aggregating vaporized coolant from multiple ENEs. In the arrangement shown in Fig. 6, ENEs 100 are connected in parallel to common vapor line 420.

In some embodiments, a liquid coolant conduit within the chamber may have a valve seat, wherein the float valve includes a pin configured to engage the valve seat in order to restrict the inlet flow of liquid coolant through a liquid coolant inlet and into the liquid coolant region. A liquid coolant conduit refers to a conduit, as described and exemplified elsewhere herein, facilitating the transfer of liquid coolant. For example, a liquid coolant conduit may be configured to move liquid coolant from one location to another. A valve seat refers to a surface against which an inlet and/or outlet valve rests when the valve is closed and functions to restrict flow through a valve. For example, a valve seat may make contact with the float valve body and regulate entry of liquid coolant into the chamber. A valve seat may include an opening, hole, aperture, and/or orifice. A pin refers to a narrow, elongated object, as exemplified elsewhere herein. For example, a pin may include a dowel, a shaft, a spike, and/or any other narrow, elongated object. A pin configured to engage the valve seat refers to a pin (or a structure connected thereto) configured to seal against the valve seat. For example, pin of a float valve may engage the valve seat to restrict inlet flow of liquid coolant through a liquid coolant inlet and manage flow. Restrict the inlet flow of the liquid coolant refers to controlling, limiting, blocking, and/or slowing the flow of liquid coolant through a liquid coolant inlet. For example, float valve may block the flow of liquid coolant though the liquid coolant inlet by engaging the valve seat to seal the valve. To engage the valve seat in order to restrict the inlet flow of liquid coolant through a liquid coolant inlet and into the liquid coolant region refers to a structure (such as a pin or portion connected thereto) configured to seal against the valve seat, restricting inlet flow of liquid coolant through the liquid coolant inlet. Some embodiments involve the two-phase cooling device including a liquid coolant conduit for conveying liquid coolant from the liquid coolant port to a liquid coolant inlet in the liquid coolant chamber. A liquid coolant conduit may be understood similar to a vaporized coolant conduit, as described and exemplified elsewhere herein. A liquid coolant conduit may facilitate transfer of liquid coolant. For example, liquid coolant conduit may enable liquid coolant from the liquid coolant port to move to a liquid coolant inlet in the coolant chamber. Conveying liquid coolant from the liquid coolant port to a liquid coolant inlet refers to a structure capable of establishing a path for liquid coolant to move from the liquid coolant port to the liquid coolant inlet. For example, conveying liquid coolant from the liquid coolant port to the liquid coolant inlet may involve a tube fitted inside a conduit for liquid coolant transfer.

Some embodiments involve a liquid coolant conduit that at least partially passes through the vaporized coolant region of the chamber. Partially passes refers to a limited extent and/or degree that the liquid coolant moves through the vaporized region of the chamber. Pass through refers to movement of a substance through an object. For example, liquid coolant may enter, travel through, and exit the liquid coolant region of the chamber (e.g., pool).

By way of non-limiting example, Fig. 4B shows ENE 100 having liquid coolant conduit 416 for conveying liquid coolant (e.g., using a tube fitted inside conduit 416) from the liquid coolant port to a liquid coolant inlet (e.g., orifice 206 flow connected to liquid coolant line 120) in the liquid coolant chamber (e.g., pool 116). Liquid coolant conduit 416 may pass partially through vaporized coolant region 118. ENE 100 may additionally include a float valve (e.g., valve 200 shown in Figs. 1B, 2A, and others) to conditionally restrict inflow of liquid coolant into pool 116 into chamber 102, as described earlier. For example, liquid coolant may enter chamber 102 via a tube (e.g., fitted with conduit 416) and pass through vaporized coolant region 118 to liquid coolant inlet 404. Conduit 416 may include a valve seat (e.g., orifice 206) configured to engage pin 208 to restrict inflow of liquid coolant into pool 116 of chamber 102, as described earlier.

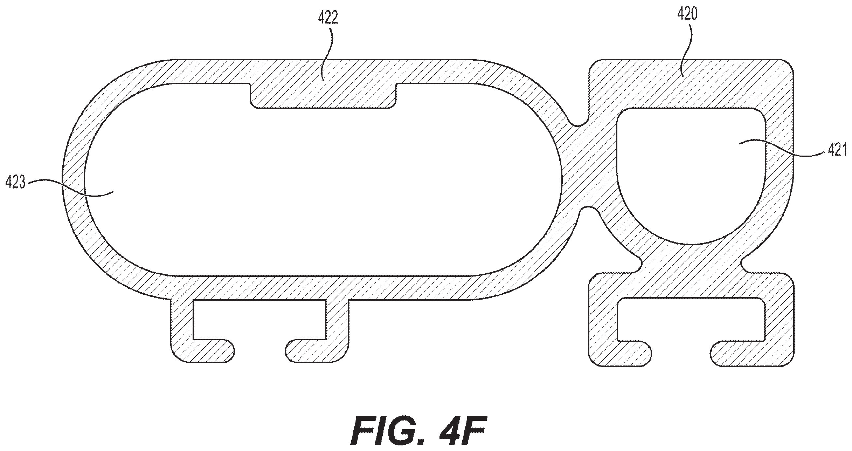

By way of another non-limiting example, as shown in Fig. 4F, a diameter or circumference of a tube carrying vaporized coolant, such as vaporized coolant conduit cross section 422, may have larger than a diameter or circumference, and thus a larger cross-sectional area, than a tube carrying liquid coolant, such as liquid coolant conduit cross section 420. To conserve space in a server rack, vapor ports 406 and/or 408 may be located within liquid coolant region 116. A vaporized coolant conduit 410 (e.g., snorkel) may flow connect vapor region 118 to vapor ports 406 and 408, where vaporized coolant conduit 410 may at least partially submerged in liquid coolant in pool 116.

In further embodiments, the first vapor port is associated with a first controllable valve and the second vapor port is associated with a second controllable valve. A controllable valve refers to a valve configured to regulate and/or control flow therethrough (e.g., liquid coolant, vaporized coolant). This may occur, for example, with a structure that varies the size of a flow passage in the valve. Such control may occur via a signal from a controller, as described and exemplified elsewhere herein. Non-limiting examples of controllable valves include ball valves, manifold valves, and double block valves. The controller may regulate the flow rate, pressure, and/or level of vapor by varying the size of the flow passage. Flow passage refers to the extent and/or degree of which the valve is opened. For example, a larger flow passage may correspond to more vaporized coolant flow. Each vapor port (e.g., first vapor port, second vapor port) in the chamber may include a controllable valve. A first controllable valve may be associated with the first vapor port and function to regulate the inflow and/or outflow of vapor from the first vapor port. A second controllable valve may be connected to the second vapor port and function to regulate the inflow and/or outflow of vapor from the second vapor port. Associated with refers to being connected, related, and/or linked to. For example, the first vapor port may include and/or be connected to the first controllable valve.

In some embodiments, the first controllable valve and the second controllable valve may be regulated by at least one processor to modulate temperature within the chamber. A processor refers to a device or group of devices having electric circuitry that performs a logic operation on an input or inputs, as described and exemplified elsewhere herein. For example, processor may send a signal to the controllable valve to change the size of the valve's flow passage in order to control flow rate, pressure, and/or vapor level. As another example, one or more processors may regulate the opening and/or closing of valves and size of the valve's flow passage. Modulate temperature within the chamber refers to varying, regulating, and/or adjusting the temperature inside of the chamber. For example, processor may be configured to adjust the size of the valve's flow passage in order to control the amount of liquid coolant in the chamber, and therefore temperature inside the chamber. The processor may adjust the size of valve flow passage to maintain a predetermined temperature of vapor in the chamber. To be regulated by at least one processor refers to a signal from the processor to a control valve to vary the size of the flow passage to modulate temperature within the chamber. For example, a signal from the processor may be sent to the first controllable valve to vary the size of the flow passage of the first controllable valve, so that temperature is modulated within the chamber. First controllable valve and second controllable valve may or may not be regulated simultaneously. It is to be appreciated that the first and second controllable valves do not need to be regulated in the same manner. For example, the first controllable valve may be opened to a large flow passage to promote evacuation of first vaporized coolant from the chamber. The second controllable valve may be opened to a smaller flow passage to restrict inflow of liquid coolant from the chamber. Further, the first control valve may be controlled by a separate processor from the second control valve.

In further embodiments, the first controllable valve and the second controllable valve may be solenoid valves. Solenoid valves refer to electromechanically operated valves that when electrically energized or de-energized, either shut off or allow fluid flow. Solenoid valve allows for automatic control of flow (e.g., liquid coolant flow, vaporized coolant flow). Non-limiting examples of solenoid valves include water solenoid valves, solenoid gas valves, hydraulic solenoid valves, and high-pressure solenoid valves. For example, a first controllable solenoid valve and a second controllable solenoid valve may be associated with the first vapor port and second vapor port, respectively, and be used to automatically control pressure, level, and/or flow control. Solenoid valves may be controlled by a processor.

Some disclosed embodiments include a barrier in the chamber dividing the vaporized coolant region from the liquid coolant region. A barrier refers to a separation wall or partition. For example, a barrier may be located in the chamber and divide the vaporized coolant region from the liquid coolant region. Dividing refers to partitioning or separating. Dividing may be understood to involve partitioning something into subparts or portions, which may be equal or unequal in size. For example, a barrier may split a chamber into a vaporized coolant region and a liquid coolant region. In some embodiments, the barrier may expose at least one vent permitting the first vaporized coolant to escape from the liquid coolant region to the vaporized coolant region and mix with the second vaporized coolant in the vaporized coolant region. To expose refers to revealing or containing. A vent refers to an opening that allows a substance (e.g., liquid coolant, vaporized coolant) to pass out of or into a confined space. For example, the vent may allow vaporized coolant to move from the liquid coolant region of the chamber to the vaporized coolant region of the chamber. A vent may be an inlet, outlet, opening, aperture, and/or gap. A vent permitting the first vaporized coolant to escape from the liquid coolant region refers to a vent, as exemplified elsewhere herein, that allows liquid coolant to move from the liquid coolant region to the vaporized coolant region. For example, barrier may include a vent with an opening which allows vaporized coolant to leave the liquid coolant region (e.g., the pool). To mix with the second vaporized coolant refers to combining of the first vaporized coolant and the second vaporized coolant. The first vaporized coolant may leave the liquid coolant region and travel to the vaporized coolant region and mix with the second vaporized coolant. The mixed first vaporized coolant and second vaporized coolant may be collected and delivered to the condenser.

In other embodiments, the first vapor port and the second vapor port may be integrally formed with the barrier. Integrally formed refers to being created or constructed together. An object that is integrally formed may be formed as a single, unified entity with components that are closely connected. Components that are integrally formed may function together as an integral whole. Integrally formed with the barrier refers to unified and/or formed together with the barrier. In some embodiments, the first vapor port and the second vapor port may be manufactured with a barrier as a single, integral piece made of molded material, such as plastic. Alternatively, in some embodiments, the first vapor port and second vapor port may be connected to a chamber mechanically, where the connection may be sealed (e.g., using a sealant) to prevent leakage. For example, vaporized coolant may be delivered from a chamber to the first vapor port, and vaporized coolant may exit the interior of the chamber via a vaporized coolant outlet integrated therewith.

By way of non-limiting example, in Figs. 4A-4D, passthrough 400 may be integrated with a vented barrier 402 in chamber 102 that divides vapor coolant region 118 from liquid coolant region 116. Barrier 402 may provide one or more vents between barrier 402 and an inner surface 412 of an encasement 414 of ENE 100 to allow vaporized coolant (e.g., produced by pool boiling in liquid coolant region 116) to enter a vapor coolant region 118.

In some cmbodiments, the vapor passthrough path is configured for flow connection to a vapor conduit for receiving third vaporized coolant from at least one additional vapor passthrough path of at least one additional two-phase cooling device, to thereby enable the third vaporized coolant to mix with the first vaporized coolant and the second vaporized coolant. A vapor conduit refers to a component or structure that facilitates the transfer of vapor, as described and exemplified elsewhere herein. A flow connection to the vapor conduit for receiving third vaporized coolant from at least one additional vapor passthrough path allows a third vaporized coolant to mix with the second vaporized coolant. Additional vaporized coolant from additional two-phase cooling devices may be flow connected to the vapor passthrough as well. As explained elsewhere herein, the mixing may refer to combining vaporized coolants. For example, the vaporized coolant from each vapor port (e.g., first vapor port, second vapor port, third vapor port) may be collected and delivered to the condenser. For example, the vapor passthrough path may involve mixing first vaporized coolant with second vaporized coolant the third vaporized coolant.

By way of non-limiting example, Fig. 6 illustrates multiple ENEs 100 connected to vaporized coolant lines 122, which may function as vapor conduits. Each vaporized coolant line 122 may connect to a vapor passthrough port of each ENE 100 (such as port 408 illustrated in other figures). In some embodiments, each ENE 100 may be connected in series to one or more other ENEs 100 (not shown) that are connected via "upstream" vaporized coolant line connections to the illustrated ENEs 100. The vaporized coolant conveyed through lines 122 may mix at point 420.

In some embodiments, the liquid coolant conduit may be transverse to the vapor passthrough path. Transverse refers to being oriented or positioned across a particular direction or axis. An object that is transverse may extend across another object (i.e., extending in a non-parallel direction). In some examples, the transverse direction may, but need not be, and be perpendicular. Put another way, a transverse object may be aligned at a right angle or crosswise with reference to another object. Transverse to the vapor passthrough path refers to the liquid coolant conduit being oriented crosswise or crossways with reference to the vapor passthrough path. For example, the liquid coolant conduit may be positioned perpendicular to, and/or crosswise of the vapor passthrough path, forming a substantially right angle between the liquid coolant conduit and the vapor passthrough path.

By way of non-limiting example, Fig. 4A shows a liquid coolant conduit 416 that is transverse to vapor passthrough 400.

Some disclosed embodiments include a liquid coolant port in the chamber for flow connection to a liquid coolant source. A liquid coolant port refers to an opening, aperture, and/or hole in the chamber for liquid coolant movement. For example, a liquid coolant port may be a liquid coolant inlet and/or outlet. A liquid coolant port may be connected to a liquid coolant source via flow connection. A flow connection refers to a path enabling fluid to travel between two points, as exemplified elsewhere herein. For example, one or more liquid lines may flow connect an output of a condenser to a liquid coolant inlet of a cooling device, and one or more vapor lines may flow-connect a vapor outlet of the cooling device to an input of the condenser. In this manner, the condenser may provide cool liquid coolant to the liquid coolant inlet of the cooling device, receive hot vaporized coolant from the vapor outlet of the cooling device, and convert the hot vaporized coolant to cool liquid coolant for providing to the cooling device in a cyclical manner for continual cooling of a solid-state electronics component connected thereto. A liquid coolant source refers to a location and/or component where liquid coolant is stored or held. For example, liquid coolant source may include a portion of a condenser or may be a buffer or reservoir. Flow connection to a liquid coolant source refers to a path enabling liquid coolant to travel from the liquid coolant port in the chamber to the liquid coolant source (e.g., condenser).

In some embodiments, the liquid coolant port is configured for flow connection to the liquid coolant source via a liquid coolant manifold configured for flow connecting a plurality of additional two-phase cooling devices to the liquid coolant source. A manifold refers to a component configured to serve as a distribution or connection point for fluids, gases, or other substances. Further, a manifold may be designed to manage the flow of and/or redirect substances (e.g., liquid coolant, vaporized coolant) to various destinations or components. Manifold may also be designed to evenly distribute substances (e.g., liquid coolant, vaporized coolant) to destinations. A liquid coolant manifold may be designed to route or distribute liquid coolant from a liquid coolant source to a plurality of ENEs. A liquid coolant manifold configured for flow connecting a plurality of additional two-phase cooling devices to the liquid coolant source refers to a distribution component that is fashioned for location between multiple two-phase cooling devices and a liquid coolant source (e.g., a reservoir and/or condenser). For example, the manifold may be designed to distribute liquid coolant from a reservoir or buffer to multiple two-phase cooling devices. The use of a liquid coolant manifold allows for aggregation of liquid coolant from multiple devices and pathways.

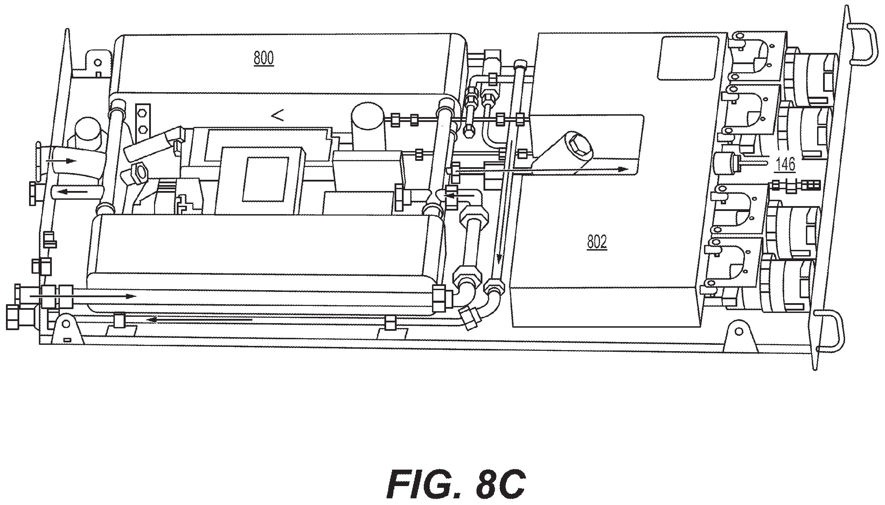

By way of non-limiting example, Fig. 1A shows a system 140 having one or more ENEs 100 that may receive liquid coolant via liquid coolant lines 120. The liquid coolant lines 120 may be connected to each ENE 100 via a liquid coolant port, such as port 128 illustrated in Fig. 1C. Referring again to Fig. 1A, liquid coolant may be conveyed to liquid coolant lines 120 via a liquid coolant manifold such as RDU 144. The manifold (RDU 144) may be flow connected to HRU 142 via line 148, which coveys liquid coolant to RDU 144. In some embodiments, HRU 142 may include a liquid coolant source in the form of a reservoir, such as reservoir 704 shown in Fig. 7 or reservoir 802 shown in Figs. 8B and 8C.

Pool boiling may cause numerous bubbles to form in and on the surface of a pool of liquid contained in an ENE chamber, forming a bubble field. To avoid a situation where the bubble field may block liquid coolant from reaching heat conducting plate and fins conveying heat from a heat-generating processor, a chimney structure may split the bubble field into spaced apart vapor channels, enabling liquid coolant to reach the heat conducting plate and fins via gaps between the spaced apart vapor channels. Some disclosed embodiments include a chimney for a dual-phase on-chip cooling device that may break up bubble fields.

Some disclosed embodiments involve a cooling device configured to induce internal counterflow. A cooling device refers to an apparatus configured to remove or expel heat, as described and exemplified elsewhere herein. For instance, a cooling device may draw heat away from a heat-generating device. Examples of cooling devices may include a fan, an air conditioner, a refrigerator, a heat pump, a coolant bath and/or pool. Heat may be transferred between systems due to a temperature difference therebetween. Internal counterflow may involve flow of a same fluid or different fluids in opposite directions. For instance, internal counterflow may include a medium flowing in the opposite direction of, antiparallel to, adverse to, or against a reference. Thus, for example, in some embodiments of the cooling device, internal counterflow may involve flow of a liquid coolant and vaporized coolant in opposite directions.

In some disclosed embodiments, the cooling device includes a chamber for containing a liquid coolant. A chamber refers to an at least partially enclosed compartment and/or cavity, as described and exemplified elsewhere herein. In some embodiments, a chamber may include one or more openings to enable fluid to enter and/or exit the chamber. A liquid coolant refers to coolant, as described and exemplified elsewhere herein, while in a liquid state. For example, vaporized coolant may undergo condensation to transform to liquid coolant. A chamber for containing a liquid coolant refers to a chamber configured to hold, accommodate, consist of, enclose, and/or encompass liquid coolant. For example, the chamber for containing a liquid coolant may involve a pool. A pool may include a region for holding a volume of liquid coolant. The pool may lack an opening to allow liquid to escape, such that when an inflow of liquid coolant is restricted, liquid in the pool may become stagnant. The chamber may be configured such that liquid coolant may enter and/or exit the chamber. For example, the liquid coolant may flow into the chamber and collect to form a pool. Liquid coolant may also exit the chamber.

Some disclosed embodiments involve a liquid coolant inlet in the chamber. A liquid coolant inlet may be understood similar to a liquid inlet, as described, and exemplified elsewhere herein. For example, a liquid coolant inlet may be fluidly coupled to a reservoir containing liquid coolant and an associated pump configured to deliver liquid coolant thereto. In some embodiments, a liquid coolant inlet may be associated with one or more devices preventing liquid coolant from exiting via the inlet. For example, a pump maintaining a pressure differential and/or a valve may prevent a reverse flow of liquid coolant. In some embodiments, a port (e.g., an inlet and/or an outlet) may be connected to a chamber mechanically, where the connection may be sealed (e.g., using a sealant) to prevent leakage. For example, liquid coolant may be delivered from a reservoir to an interior of a chamber via a liquid coolant inlet integrated therewith, and vaporized coolant may exit the interior of the chamber via a vaporized coolant outlet integrated therewith. Liquid coolant inlet in the chamber refers to a liquid coolant inlet enclosed by, surrounded by, and/or located within the chamber. For example, the liquid coolant inlet may be located entirely inside the chamber region or passing through a wall of the chamber, allowing liquid coolant to enter the chamber. Some disclosed embodiments involve a vapor outlet in a vapor collection region of the chamber for evacuating vaporized liquid coolant from the chamber. A vapor outlet may be understood as described and exemplified elsewhere herein. For example, a vapor outlet may involve an opening fluidly coupled to a condenser configured to convert vaporized coolant to liquid coolant. In some embodiments, a vapor outlet may be associated with one or more devices preventing liquid coolant from entering a vapor line, such as one or more valves. A vapor collection region refers to a region or portion of the chamber in which vapor may be accumulated or stored. For example, the vapor collection region may be at the top of the chamber, above the liquid coolant region (e.g., pool). A vapor outlet in a vapor collection region of the chamber refers to a vapor outlet located inside of, through a wall of, or being encompassed by the vaporized collection region of the chamber. For example, the chamber may include at least one vapor outlet connected to a vapor collection region of chamber for evacuating vaporized coolant from chamber. Evacuating refers to removing, expelling, withdrawing, and/or siphoning away. Evacuating vaporized coolant from the chamber refers to causing vaporized coolant to leave the chamber. For example, a pressure differential between an average pressure inside a chamber versus an average pressure outside the chamber may cause vaporized coolant to exit the chamber via a vaporized coolant outlet. Such a pressure differential may be induced, for instance, due to pool boiling of liquid coolant within the chamber causing liquid coolant to transition to vaporized coolant and accumulate inside the chamber, causing a pressure inside the chamber to rise above a pressure outside the chamber. Vaporized liquid coolant refers to a gaseous state of a coolant substance. For example, liquid coolant undergoing boiling may transform to vaporized liquid coolant. Thus, a vapor outlet may be connected at one end to a portion of the chamber in which vapor generated due to boiling of the liquid coolant may be accumulated. Evacuating vaporized liquid coolant from the chamber refers to removing vaporized liquid coolant from the chamber. For example, the vapor outlet may allow the vapor (or vaporized liquid coolant) to be removed or expelled from the chamber.

In some embodiments, the vapor outlet is configured to evacuate vaporized coolant from the chamber to a condenser. Evacuate refers to remove, expel, withdraw, or siphoning away. For example, vaporized coolant may evacuate a chamber, such that the vaporized coolant leaves the chamber and moves to another location. A condenser refers to a heat exchanger that transforms a substance in a gaseous state to a liquid state, thereby releasing latent heat stored therein. For example, a condenser may compress a vapor until the vapor transforms to liquid form. Evacuate vaporized coolant from the chamber to a condenser refers to removing vaporized coolant from the chamber and moving it to a condenser. For example, the vapor outlet may be integrated with or connected to the chamber for evacuating vaporized liquid coolant. Vapor outlet configured to evacuate vaporized coolant from the chamber to a condenser refers to a vapor outlet designed to or having the ability of evacuating vaporized liquid coolant from the chamber to the condenser. For example, vapor outlet may be connected to the chamber, allowing vapor to evacuate the chamber and move to the condenser.

A non-limiting example of a configuration of an ENE 100 is illustrated in Fig. 1B. Fig. 1B shows a cross-sectional view of an ENE 100. Consistent with some disclosed embodiments, ENE 100 is a heat exchanger device with at least one chamber 102 for containing a liquid coolant. In reference to Fig. 1C, ENE 100 includes liquid coolant inlet 128 integrated with chamber 102 (see Fig. 1B). Liquid coolant inlet in the chamber 128 may supply liquid coolant to pool 116 (see Fig. 1B). to thereby enable pool boiling of the liquid coolant and conversion of the liquid coolant into vaporized coolant. For instance, one or more pumps associated with a reservoir storing cool liquid coolant may supply cool liquid coolant to ENE 100 via liquid coolant line 120. The cool liquid coolant may flow through liquid coolant line 120 via liquid coolant inlet 128 into chamber 102, where the liquid coolant may collect in pool 116. As shown in Fig. 1C, vapor outlet 130 may be integrated with chamber 102 for evacuating vaporized coolant from chamber 102. Vapor outlet 130 may be in a vapor collection region of the chamber 118 (see Fig. 1B). For example, vapor line 122 may connect vapor outlet 130 to condenser 702 of HRU 124 (see Fig. 7).

In some embodiments, the liquid coolant inlet is configured for flow connection to the condenser to thereby enable delivery of the liquid coolant to the coolant pool region via the liquid coolant inlet. A flow-connection in this context refers to a path enabling fluid (e.g., liquid coolant) to travel between two points. For example, one or more liquid lines may have a flow connection to an output of a condenser to a liquid coolant inlet of a cooling device, and one or more vapor lines may have a flow connection to a vapor outlet of the cooling device to an input of the condenser. Flow connection to the condenser refers to a path enabling fluid (e.g., liquid coolant) to travel to the condenser. For example, one or more liquid lines may have a flow connection to an output of a condenser to a liquid coolant inlet of a cooling device, and one or more vapor lines may have a flow connection to a vapor outlet of the cooling device to an input of the condenser. In this manner, the condenser may provide cool liquid coolant to the liquid coolant inlet of the cooling device, receive hot vaporized coolant from the vapor outlet of the cooling device, and convert the hot vaporized coolant to cool liquid coolant for providing to the cooling device in a cyclical manner for continual cooling of a solid-state electronics component connected thereto. Delivery refers to movement of a substance from one location to another location. For example, delivery of the liquid coolant to the pool region involves a transfer of liquid coolant to the pool region. For example, the liquid coolant inlet may be configured for flow connection to the condenser, enabling delivery of the liquid coolant to the coolant pool region. Delivery of the liquid coolant to the coolant pool region refers to the liquid coolant being moved to the coolant pool region by means of or through the liquid coolant inlet. For example, the liquid coolant inlet may be configured so that liquid coolant travels to the condenser (e.g., pool).

By way of a non-limiting example, in Figs. 1C and 7, liquid coolant inlet 128 and vapor outlet 130 may be configured for flow connection to a condenser 702 of HRU 142, to enable delivery of liquid coolant to the coolant pool region 116 via the liquid coolant inlet 128. For example, hot vaporized coolant may flow out of ENE 100 via vapor outlet 130 and vapor line 122 to condenser 702, which may condense the vaporized coolant to a liquid state. One or more pumps associated with condenser 702 may pump the liquified coolant to ENE 100 via liquid coolant line 120 and liquid coolant inlet 128, allowing the coolant to circulate through ENE 100 for continual cooling of solid-state electronics component 110. By way of another non-limiting example, in Fig. 1A, a condenser of HRU 142 (such as condenser 702 shown in Figs. 7 and 11A) may receive vaporized coolant evacuated from a plurality of ENEs 100 via vapor coolant line 150. Vapor coolant line 150 may collect vaporized coolant from multiple ENEs 100 and deliver the accumulated vaporized coolant to condenser 702. Condenser 702 may convert the vaporized coolant to liquid coolant, and supply the liquid coolant to plurality of ENEs 100. This may be performed repeatedly, allowing coolant to circulate continually through a plurality of ENEs 100 to continually cool a plurality of solid-state electronics component 110.

In some disclosed embodiments, the liquid coolant inlet is associated with a valve for conditionally restricting inflow of liquid coolant into the chamber. A valve refers to a mechanism for regulating or controlling one or more characteristics of a flow of a fluid (e.g., liquid or vapor). For example, a valve may regulate a direction of flow, a magnitude of flow, a rate of flow, and/or may be used to stop and/or start a flow. Valve mechanism for regulating or controlling one or more characteristics of a flow of a substance (e.g., liquid coolant or vaporized coolant) may include a mechanical structure or element that fully blocks flow of a substance (e.g., liquid coolant or vaporized coolant) in a conduit or enclosed space. The valve may be controlled by a processor and/or regulator. The valve may control the passage of liquid coolant in one or more directions. The valve may regulate one or more passageways of liquid coolant into the chamber. Further, the valve may be configured to be open, closed, and/or partially opened. Conditionally restricting flow refers to limiting, constraining, and/or stopping a flow according to certain conditions or circumstances. Conditionally restricting flow may refer to adjusting the valve mechanism to close or partially close to maintain a predetermined temperature, pressure, flow rate, viscosity, or similar property into the chamber or within the chamber. For example, conditionally restricting flow may refer to adjusting the valve mechanism to close, or partially close to maintain a particular flow rate, of quantity of fluid (e.g., liquid coolant) that passes into the chamber in a specific period of time. For example, the valve may be partially closed to restrict liquid coolant flow into the chamber and therefore decrease flow rate. By way of another example, under certain conditions (e.g., pressure or temperature within the chamber), the valve may be configured to allow liquid coolant flow to occur, whereas in other conditions, the valve may be configured to prevent liquid coolant flow. Allowing liquid coolant flow to occur involves opening the valve mechanism. Further, under certain conditions of pressure and temperature gradient, the valve may allow liquid coolant to flow, whereas in other conditions the valve may restrict liquid coolant flow. Further, by way of non-limiting example, under certain conditions of a liquid coolant level within the chamber (e.g., below a predetermined level), the valve may allow liquid coolant to enter the chamber. Under other conditions of liquid coolant level within the chamber (e.g., at a predetermined level), the valve may restrict liquid coolant flow into the chamber. Level refers to a height and/or horizontal plane or line with respect to the distance above the bottom or base of the chamber. A valve for conditionally restricting inflow of liquid coolant into the chamber refers to a valve that functions to limit, constrain, or stop a flow of liquid coolant into the chamber under certain conditions. For example, using a valve for conditionally restricting inflow of liquid coolant into the chamber may involve adjusting the valve mechanism to close or partially close to maintain a predetermined temperature, pressure, flow rate, viscosity, or similar property in the chamber. For example, a valve for conditionally restricting inflow of liquid coolant into the chamber may include a float valve. For example, liquid coolant inlet associated with a valve for conditionally restricting inflow of liquid coolant into the chamber refers to an inlet flow-connected to the valve (e.g., either a direct connection or a connection via a conduit). For example, the liquid coolant inlet may be associated with a valve for conditionally restricting inflow of liquid coolant into the chamber, where the valve may partially close when the rate of liquid coolant flow into the chamber exceeds a threshold. By way of non-limiting example, the valve may be restricted when the rate of liquid coolant flow into the chamber exceeds a threshold, to decrease liquid coolant flow rate. Therefore, the liquid coolant inlet may be associated with a valve for conditionally restricting inflow of liquid coolant into the chamber.

By way of a non-limiting example, as shown in Fig. 1C, vapor outlet 130 and/or vapor line 122 may be associated with a controllable valve, for controlling conditions (e.g., pressure, temperature, flow) within vapor line 122 and/or chamber 102. For example, at least one processor may be provided to control the controllable valve and thereby regulate pressure within vapor line 130 and/or chamber 102. In some embodiments, vapor coolant line 122 may be a polyurethan tube with a diameter of approximately 6 mm, and a minimum bend radius of 12.7 mm, and vapor coolant outlet 130 may have a diameter of approximately 6 mm, to accommodate vapor line 122.

By way of a non-limiting example, in Fig. 1B, chamber 102 containing liquid coolant may include float valve 200 configured to restrict flow of liquid coolant when the liquid coolant in chamber 102 meets a certain a certain condition (e.g., pressure or temperature within the chamber) or surpasses a threshold (e.g., liquid coolant level), as described and exemplified elsewhere herein.

By way of another non-limiting example, reference is made to Figures 2A-2C, which illustrate differing exemplary views of float valve 200 configured to regulate an inflow of liquid coolant to ENE 100, consistent with some disclosed embodiments. In Fig. 2A, float valve 200 is shown hovering above heat conducting wall 104 of ENE 100, illustrated without a cover. In Fig. 2B, float valve 200 is shown resting on inner surface 106 of heat conducting wall 104 of ENE 100, illustrated without a cover. In Fig. 2C, an underside of float valve 200 is shown. The underside of float valve 200 may face inner surface 106 of heat conducting wall 104 of ENE 100 when float valve 200 is inserted into chamber 102 of ENE 100.

Some disclosed embodiments involve a heat conducting element in a boiling region of the chamber. Heat conducting refers to a property of a material that allows it to transfer heat efficiently. For example, a material capable of conducting heat may include particles arranged sufficiently close together to allow thermal energy to be exchanged between the particles, and flow, on average, from a higher temperature region to a lower temperature region. A heat conducting element refers to a component capable of heat transfer by conducting heat, as described and exemplified elsewhere herein-. In some instances, a heat conducting element may refer to a heat conducting wall, or barrier and/or partition capable of heat transfer, as described and exemplified elsewhere herein. In some instances, a heat conducting wall may be made of a material conducive for transferring heat, such as metal (e.g., aluminum, copper, silver, gold, molybdenum, zinc, and/or tungsten), semiconductor (e.g., silicon carbide), and/or graphite. Heat conducting element in a boiling region of the chamber refers to a component capable of heat transfer, located within or encompassed by the chamber region. For example, an enclosure inside the boiling region of the chamber may include a heat conducting wall, capable of heat transfer.

In some disclosed embodiments, the heat conducting element includes a plurality of fins configured to cause a bubble field of vaporized coolant to be trapped therebetween, and wherein the at least one conduit is configured to facilitate an evacuation of the trapped bubble field. A fin refers to an elongated component designed to increase surface area available for heat dissipation and/or absorption, as described and exemplified elsewhere herein. For example, a fin may be structurally attached to the heat transfer wall of a chamber so that heat may be transferred through the heat conducting wall to the fins. A plurality of fins refers to more than one fin. For example, a plurality of fins may be structurally attached to the heat transfer wall of a chamber so that heat is transferred through the heat conducting wall to the fins. Trapped refers to an inability to escape, a confinement, and/or restraint. For example, bubble field of vaporized coolant may be trapped between fins, making bubble fields unable to escape a region. and A bubble is a sphere of liquid enclosing a gas such as air or vapor. (e.g., a sphere of liquid coolant enclosing vaporized liquid coolant). For example, when the liquid coolant temperature reaches boiling, a bubble of vaporized liquid coolant may form. A bubble field refers to a plurality of bubbles distributed over an area. For example, when the base plate heats up and the liquid coolant starts to boil, the surface of the coolant pool and/or surface of the base plate may be covered in bubbles (e.g., a field of bubbles). A bubble field of vaporized coolant refers to a plurality of bubbles made of vaporized coolant. For example, bubble field may be a plurality of liquid coolant bubbles distributed on the pool surface. Vaporized coolant refers to a gaseous state for a coolant substance, as described and exemplified elsewhere herein. For example, liquid coolant undergoing boiling may transform to vaporized coolant forming a plurality of bubbles. Movement of the bubbles, however, may be restricted due to the presence of closely spaced fins of the heat conducting element. Thus, the plurality of bubbles formed due to vaporization of the liquid coolant may be restrained or confined between adjacent fins and may be unable to exit or flow out from within the space located between the adjacent fins of the heat conducting element. A plurality of fins configured to cause a bubble field of vaporized coolant to be trapped therebetween refers to multiple fins positioned so that a bubble field of vaporized coolant is confined or retained between the fins. For example, the fins may be positioned close to one another, so that the bubbles become trapped in the space between adjacently located fins. A trapped bubble field refers to the bubble field of vaporized coolant confined or restrained between the fins.

At least one conduit may be configured to facilitate an evacuation of the trapped bubble field. A conduit refers to a component or structure that facilitates the transfer of a substance (e.g., vaporized coolant). For example, a conduit may be a channel or tube for conveying a substance (e.g., liquid coolant, vaporized coolant). As another example, a conduit may allow for vaporized coolant to move from one location to another. To facilitate refers to enabling or assisting an action or process. For example, the conduit may be designed or positioned to cause the trapped bubble field to evacuate the region or plurality of fins it is stuck therebetween. Such a conduit may also be referred to as a chimney that splits the bubble field in two and provide vapor channels on either side for bubbles to rise and exit the chamber. Facilitating an evacuation of the trapped bubble field refers to causing trapped bubble field to leave the region where it is trapped. For example, the plurality of bubbles in the bubble field may flow through the conduit, thereby exiting from the space between adjacent fins of the heat conducting element. Further, by way of non-limiting example, when bubble field forms on the pool surface, it may block the flow of liquid coolant towards the base plate. A base plate may include a foundational component of an evaporator system, designed to facilitate heat exchange. For example, an evaporator base plate may be made of a thermally conductive material, such as heat-conductive metal.

In some disclosed embodiments, the fins are thermally coupled to the heating conducting element. Thermally coupled refers to a direct or indirect connection that allows transfer of heat. Thermally coupled to the heating conducting element refers to a direct or indirect connection between the fins and the heat conducting element to allow for transfer of heat. As explained elsewhere, a direct contact may involve the fins touching the heat conducting element. An indirect contact may involve a thermally conductive material disposed between the fins and the heat conducting element, thereby allowing heat to be conducted from the heat conducting clement through the thermally conductive material to the fins. Thus, for example, fins may be thermally coupled to the heat conducting element causing a transfer of heat between the fins and the heating conducting element (e.g., heat conducting wall or barrier).

Some disclosed embodiments involve a coolant pool region interposed between the vapor collection region and the boiling region. A pool refers to an amount, a volume, or a body of liquid. A coolant pool refers to an amount, a volume, or a body of liquid coolant. A coolant pool region refers to a section, part, or portion of an enclosure in which liquid coolant is accumulated. For example, a section, part, or portion of a chamber may enclose or hold an amount, a volume, or a body of liquid coolant and form a coolant pool region of the chamber. The boiling region of the chamber refers to a section, part, or portion of an enclosure in which the liquid coolant may boil. Boiling refers to a phase transition from a liquid state to a gaseous state, or vapor. Boiling may occur by heating a liquid to reach a boiling temperature, at which point the liquid may be converted to gas, or vapor. The boiling temperature of a liquid may depend on ambient pressure, such that adjusting the ambient pressure may cause a corresponding adjustment to the boiling temperature. Interposed refers to placing or inserting between things or components. For example, the coolant pool region interposed between the vapor collection region and the boiling region refers to the coolant pool region being located between the vapor collection region and the boiling region, such that the vapor collection region and boiling region arc not adjacent or attached to each other.

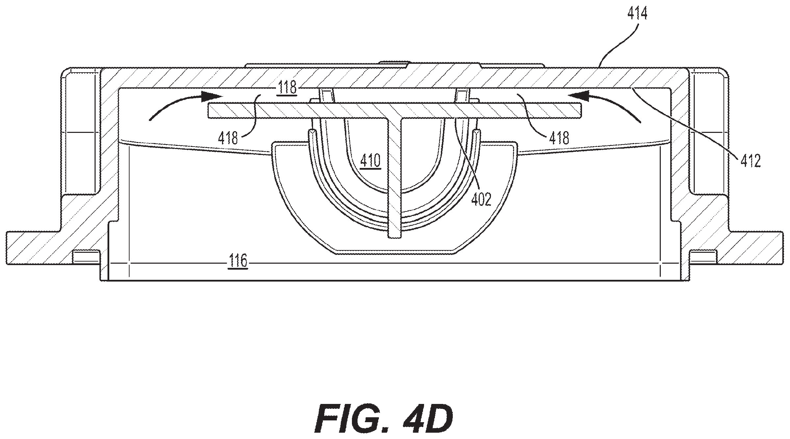

By way of non-limiting example, in Fig. 4D, the boiling region of the chamber may be the pool 116. The vapor region 118 is above barrier 418. The barrier 418 functions to prevent liquid from splashing and entering vapor lines 122 (as shown in Fig. 1A). The vapor region 118 may refer to anything above the pool 116.

By way of non-limiting example, in Fig. 1B, ENE 100 may include chamber 102 with at least one heat conducting element (e.g., conductive wall) 104 that is in the boiling region (e.g., pool 116) of the chamber 102. Chamber 102 may include a liquid coolant inlet 206 (as shown in Fig. 4B) for conveying liquid coolant to pool 116 from a condenser, as well as at least one vapor outlet 406 and/or 408 (as shown in Fig. 4B) flow connected to a vapor region 118 of chamber 102 for evacuating vaporized coolant from chamber 102 of ENE 100 to the condenser. Heat conductive wall 104 may be configured for thermal contact with the heat generating element (such as electronic component 110 shown in Fig. 1C). The heat conducting element (e.g., conductive wall) 104 may include a plurality of fins 300 (as shown in Fig. 3A and 3B) configured to cause a bubble field of vaporized coolant to be trapped therebetween. Further, the plurality of fins 300 (as seen in Fig. 3A) may extend from the first heat transfer wall 104 into the chamber 102, for transferring heat from the heat transfer wall 104 to the liquid coolant in the cavity of chamber 102, thereby providing a cooling effect for an electronic component 110 (as shown in Fig. 1C) associated with the ENE 100. At least one conduit 502 may be configured to facilitate an evacuation of trapped bubble field.

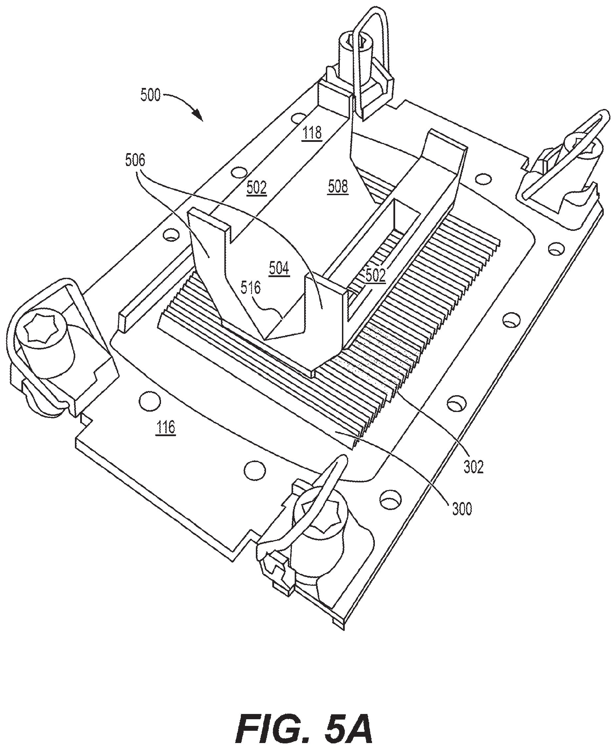

By way of non-limiting example, Fig. 5A shows an exemplary chimney 500 for breaking up a bubble field and inducing internal counterflow in an ENE 100. For example, chimney 500 may fit inside chamber 102 (as shown in Fig. 1B) of ENE 100. In some embodiments, chimney 500 may rest on plurality of fins 300 extending from the base plate of chamber 102. As liquid coolant in pool 116 absorbs heat via heat conductive wall 104, liquid coolant may boil, causing the formation of a plurality of bubbles distributed on and/or near the surface of pool 116. When a bubble field forms on and/or near the pool 116 surface, it may block the flow of liquid coolant towards the base plate (e.g., heat conductive wall 104). The chimney 500 splits the bubble field into two sections, and provides vapor channels through conduits 502. At least some of the bubbles of the bubble field may rise through the vapor channels of chimney and exit chamber 102 via vapor. The gap between the channels lets liquid coolant descend and reach the pool 116.

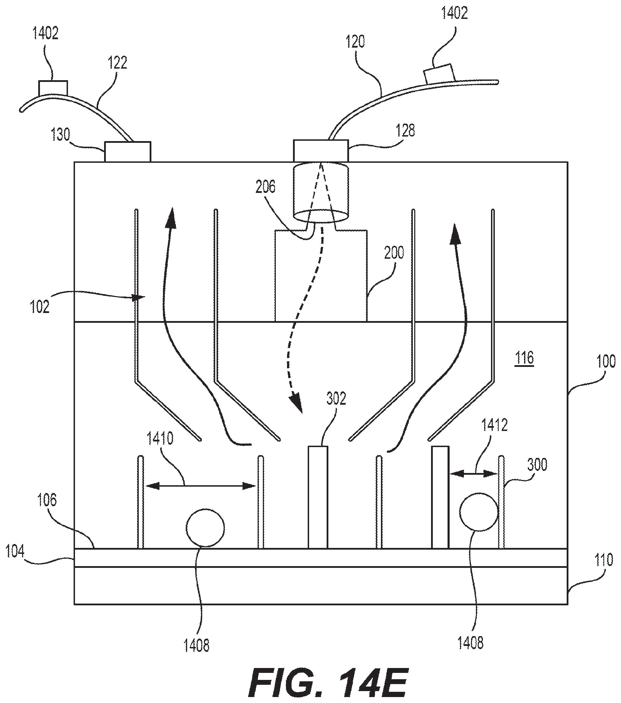

By way of another non-limiting example, reference is made to Fig. 14E. Fig. 14E shows a cross section view of chamber 102. The heat conducting element 104 may be thermally coupled to a plurality of fins 300 configured to cause a bubble field 1408 of vaporized coolant to be trapped therebetween. The gap between the conduits may facilitate an evacuation of the trapped bubble field, allowing liquid coolant to descend and reach the pool above the fins 300 to the upper region of the chamber so they can exit from the vapor line 120.

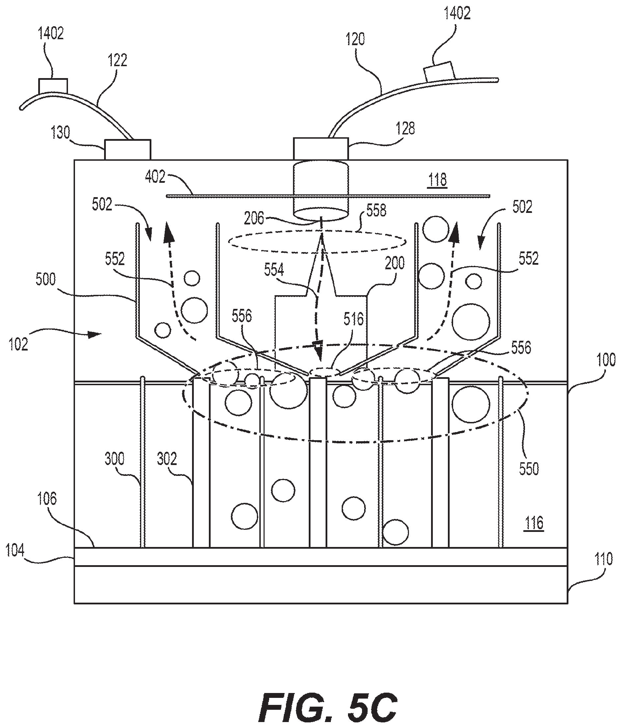

By way of another non-limiting example, reference is made to Fig. 5C illustrating a cross-sectional schematic view of two-phase evaporator 100 with chimney 500 for breaking up a bubble field 550, consistent with some disclosed embodiments. A heat conducting element (e.g., heat conductive wall 104) may include a plurality of fins 300 configured to cause a bubble field 550 of vaporized coolant to be trapped therebetween. For instance, surface tension may cause one or more bubbles of bubble field 550 to stick to one or more of fins 300. The presence of bubble field 550 on and/or near a surface of pool 116 may prevent a flow of liquid coolant from reaching pool 116, which may hinder cooling. At least one conduit 502 of chimney 500 may facilitate an evacuation of one or more bubbles trapped in bubble field 550 For example, at least one conduit 502 may channel one or more bubbles of bubble field 550 towards vapor region 118 above barrier 402 (e.g., see vapor flows 552 in conduits 502 flowing from pool 116 to barrier 402). This may permit vaporized coolant to exit chamber 102 via vapor coolant outlet 130. The removal of at least some bubbles of bubble field 550 away from pool 116 may permit a liquid flow 554 entering chamber 102 via inlet orifice 206 to enter pool 116, thereby facilitating cooling. In some embodiments, the vaporized coolant may exit chamber 102 via a snorkel, as described and exemplified elsewhere herein. In some embodiments, at least one processor (e.g., processor 152 of Fig. 1A) may cause successive pressure fluctuations (e.g., pulses) inside chamber to agitate bubbles in bubble field 550, as described elsewhere herein. This may facilitate one or more bubbles trapped in bubble field 550 to enter at least one conduit 502 and reach vapor region 118.

Some disclosed embodiments involve at least one conduit extending from the boiling region toward the vapor collection region, where the at least one conduit is configured to direct vapor in a first direction toward the vapor collection region thereby facilitating liquid coolant movement toward the boiling region in a second direction counter to the first direction. A conduit refers to a component or structure that facilitates the transfer of a substance (e.g., vaporized coolant), as exemplified elsewhere herein. For example, a conduit may be a channel or tube for conveying a substance (e.g., liquid coolant, vaporized coolant). As another example, a conduit may allow for vaporized coolant to move from one location to another. Extending from refers protruding or projecting from a component, device, and/or location. For example, conduit extending from the boiling region toward the vapor collection region refers to a conduit protruding, projecting, or coming out from the boiling region in the direction of the vapor collection region. The conduit may or may not extend fully into the vapor collection region. Directing vapor refers to guiding, controlling, regulating, extending, or causing the vapor to move from one component, region, or location to another. For example, the conduit may be configured to move vapor from the boiling region to the vapor collection region. A first direction refers to a direction or path towards the vapor collection region. For example, the conduit may be configured to direct vapor in a first direction toward the vapor collection region, to exit an ENE, causing liquid coolant, allow for coolant to flow into the ENE more easily or efficiently. Second direction refers to a direction or path opposite, adverse, antiparallel, contrary, reversed, and/or opposed to the first direction. For example, conduit may be configured to direct liquid coolant in a second direction, toward the boiling region. Facilitating liquid coolant movement toward the boiling region in a second direction counter to the first direction refers enabling or assisting the liquid coolant to move toward the boiling region in a direction opposite of the first direction (e.g., opposite the vapor collection region). For example, liquid coolant and vaporized coolant may move antiparallel from one another. It is to be appreciated facilitating liquid coolant movement toward the boiling region does not necessarily mean liquid coolant arrives at the boiling region, but rather liquid coolant travels in the direction of the boiling region. Stated another way, liquid coolant may or may not arrive at the boiling region.

In some embodiments, the at least one conduit extends from a position adjacent the fins to a position in or adjacent the vapor collection region. Extend refers to protruding, bridging, or being stretched out, in this instance from a position in a vicinity of the fins to a vicinity of the vapor collection region. Adjacent refers to a position in a vicinity of, near to, connected to, close by, neighboring, or bordering a component, device, or region. For example, adjacent the vapor collection region may involve being connected to or next to the vapor collection region. For example, conduit may extend from a position next to the fins to a position neighboring, near to, close by, touching, and/or bordering the vapor collection region. In the vapor collection region refers to being located within and/or contained in an area where vaporized coolant may accumulate. For example, one or more conduits may extend from a position adjacent the fins to a position in the vapor collection region or in proximity to the vapor collection region. In some embodiments, a plurality of conduits may be arranged to deliver vaporized coolant towards one or more vents distributed around a perimeter of a barrier separating the vapor collection region from a pool of liquid coolant.

In some disclosed embodiments, the position adjacent to the fins is in the coolant pool region. Coolant pool region refers to a pool, as described and exemplified elsewhere herein. For example, coolant pool region may hold liquid coolant and be configured so that liquid coolant may enter and/or exit the chamber. In the coolant pool region refers to inside the coolant pool region or encompassed by the coolant pool region. For example, conduit may extend from a position inside the coolant pool region to a position either inside or next to the vapor collection region.

By way of non-limiting example, as shown in Fig. 5A, chimney 500 may include at least one conduit 502 extending from a position adjacent the fins 300 (e.g., pool 116) to a position in or adjacent the vapor region 118. The at least one conduit 502 extending from the boiling region 116 toward the vapor region 118 may be configured to direct vapor in a first direction (e.g., upwards) from the bubble field in boiling region 116 toward vapor region 118, thereby facilitating liquid coolant movement toward the boiling region 116 in a second direction (e.g., downwards) counter to the first direction, and therefore inducing internal counterflow.

By way of another non-limiting example, in Fig. 550, at least one conduit 502 may extend from a position adjacent fins 300 to a position in or adjacent vapor collection region 118. For example, at least one conduit 502 may guide at least some bubbles of bubble field 550 on and/or near the surface of pool 116 towards vented barrier 402, e.g., as vapor flows 552. This may permit liquid flow 554 entering chamber 102 via inlet orifice 206 to enter pool 116. Vapor flows 552 may enter vapor collection region 118 via the one or more vents surrounding barrier 402 and exit chamber 102 via vapor coolant outlet 130. In some embodiments, vaporized coolant collected in vapor region 118 may exit chamber 102 via a snorkel pathway 410, as described and exemplified elsewhere herein. In some embodiments, the position adjacent to fins 300 is in the coolant pool region 116.

Consistent with some disclosed embodiments, the at least one conduit includes at least two conduits with a gap therebetween, and wherein the gap is configured to facilitate liquid coolant flow toward the boiling region in the second direction. A gap refers to the space between two objects. For example, a gap may be an, an aperture, a slit, slot, vent, cavity, crack, hole, and/or perforation. The gap may be designed so that liquid coolant flows opposite the vapor collection region and instead, towards the boiling region. Gap therebetween refers to a gap between two components and/or items. For example, at least two conduits with a gap therebetween, may refer to more than one conduit with a gap between each conduit. For example, liquid coolant may flow in the gap between the conduits. At least one conduit includes at least two conduits with a gap therebetween refers to the conduit extending from the boiling region toward the vapor region, as described and exemplified elsewhere herein. The conduit may include two or more conduits with a gap between adjacent pairs of conduits. Facilitate liquid coolant flow refers to causing, enabling, or allowing liquid coolant to flow. For example, the gap may be configured to facilitate liquid coolant flow in a particular direction or towards a component. Gap configured to facilitate liquid coolant flow toward the boiling region in the second direction refers to the gap between conduits being positioned, shaped, or arranged so that liquid coolant flows toward the boiling region in the second direction, opposite the first direction as described and exemplified elsewhere herein.

In some disclosed embodiments, the gap is configured to facilitate liquid coolant flow toward the boiling region in a cyclical manner for facilitating heat conduction. Liquid coolant flow refers to movement of liquid coolant from one location to another. Liquid coolant flow may be a continuous or intermittent movement of liquid coolant. For example, liquid coolant may flow opposite the vapor collection region and towards the boiling region. Facilitate liquid coolant flow refers to making liquid coolant flow easier, smoother, or more efficiently, as exemplified elsewhere herein. For example, the gap may be configured to facilitate liquid coolant flow toward the boiling region. Cyclical manner refers to occurring in uniform or nonuniform cycles, at regular intervals, or continuously. For example, as vaporized coolant continually rises through the conduits and/or channels of the chimney, liquid coolant continually descends from the inlet orifice (at the top of the ENE) to the pool (at the bottom of the ENE) via the gap in the middle of the chimney. Facilitating liquid coolant flow toward the boiling region in a cyclical manner may create a convection cycle where hot vapor rises and cool vapor falls. Heat conduction refers to the process by which heat is transferred from the hotter end of an object, device, or region to the cooler end of the object, device, or region, as described and exemplified elsewhere herein. For example, heat may be transferred between systems due to a temperature difference therebetween. Facilitating heat conduction refers to making heat conduction easier, smoother, or more efficient. Facilitating may involve enabling, providing assistance, support, or a mechanism to achieve a goal. For example, liquid coolant flow in a cyclical manner may make heat transfer between regions easier or more efficient. For example, the gap between adjacent conduits may facilitate liquid coolant flow toward boiling region in in a cyclical manner for facilitating heat conduction.

In some disclosed embodiments, the gap may be in flow communication with the liquid coolant inlet. Flow communication and liquid coolant inlet are described and exemplified elsewhere herein. For example, liquid coolant entering the chamber via a liquid coolant inlet may flow to the gap, permitting the liquid coolant to enter the pool.

In some disclosed embodiments, the gap includes a first opening at a location adjacent the boiling region, the first opening being narrower than openings of the inlets of the at least two conduits adjacent the boiling region. An opening refers to a separation or space. An opening may be formed between two objects or surfaces. A first opening refers to a separation or space of a gap located adjacent to the boiling region. Adjacent refers to next to or adjoining something. For example, the first opening may be adjoined with the boiling region, allowing a substance (e.g., liquid coolant, vaporized coolant) to flow to and/or from the boiling region. A first opening at a location adjacent the boiling region refers to the beginning of the gap adjacent to the boiling region. For example, the first opening may be in contact with and be connected to the boiling region. Narrower than refers to being limited, restricted, and/or smaller in comparison to a reference. For example, the first opening radius, diameter, or size may be smaller than the openings of the conduits adjoining the boiling region.

In some disclosed embodiments, the gap includes a second opening at a location remote from the fins, the second opening being wider than openings of the at least two conduits adjacent the fins. A second opening refers to an aperture. Wider refers to being broader and/or larger in comparison to a reference. For example, the second opening diameter may be greater than the opening of the conduits adjacent the fins. Remote refers to being situated away or distant from. A remote location may be one that is separated by a distance from a reference point. For example, the gap may include a second opening situated or positioned away from, not connected to, and/or removed from the fins. Adjacent refers to positioning or placing next to or r near a reference. For example, a plurality of conduits may be in a position next to, neighboring, near to, close by, touching, in a vicinity of or bordering the fins. The plurality of conduits may include two or more conduits. Second opening at a location remote from the fins refers a beginning, end, or exterior region of a gap located away from the fins. A second opening being wider than openings of the at least two conduits adjacent the fins refers to the second opening being larger than the opening of the at least two conduits adjacent the fins. For example, the second opening being wider than openings of the at least two conduits adjacent the fins may facilitate liquid coolant flow toward the boiling region in the second direction.

By way of non-limiting example, in Fig. 5A, chimney 500 may include two (or more) conduits 502, with a gap 504 in between. Gap 504 may facilitate liquid coolant flow toward boiling region 116, e.g., in a cyclical manner facilitating heat conduction. Each of conduits 502 may include adjacent inlets 506 configured to divide vapor flow into a plurality of spaced apart vapor pathways with a liquid coolant pathway therebetween. The liquid coolant pathway may include a first opening 516 (e.g., a groove at the bottom of gap 504 of chimney 500) adjacent fins 300. The first opening 516 of the liquid coolant pathway may be narrower than inlets 506 adjacent fins 300 (e.g., to account for vaporized coolant occupying a larger volume than an equivalent amount (e.g., in ml) of liquid coolant). The liquid coolant pathway may lead (and/or include) pool 116. Chimney 500 may include a second opening 508 remote from fins 300. For example, second opening 508 may connect to a tube flow-connected to liquid coolant inlet 404 (as shown in Fig. 4B), for conveying liquid coolant from a condenser 702 (as shown in Fig. 7), through vapor region 118, towards gap 504 and fins 300. In some embodiments, second opening 508 of chimney 500 may be transverse to conduits 502.

By way of another non-limiting example, in Fig. 5C, gap 516 may be in flow communication with a liquid coolant inlet (e.g., inlet orifice 206). In some embodiments, gap 516 includes a first opening at a location adjacent the boiling region (e.g., adjacent to pool 116), the first opening being narrower than openings 556 of inlets of at least two conduits 502 adjacent the boiling region. In some disclosed embodiments, the gap includes a second opening 558 at a location remote from fins 300, the second opening 558 being wider than openings 556 of the at least two conduits adjacent the fins.

Consistent with some disclosed embodiments, the at least two conduits each include an elongated outlet with the gap between outlets of the at least two conduits at a location remote from the fins, and wherein a length of each of the elongated outlets is greater than a width of the gap. Elongated may be understood as described and exemplified elsewhere herein. Elongated may also refer to an extended component and/or element. For example, an elongated outlet may have a larger length dimension than its width. Outlet refers to a passage, opening, or entrance that allows for a substance (e.g., vaporized liquid coolant) to exit a specific area, region, system, or device. An outlet may be configured to allow for the flow of a substance (e.g., vaporized liquid coolant) out of a chamber. Elongated outlet refers to an extended passage that allows a substance (e.g., vaporized liquid coolant) to exit a region. For example, elongated outlet may extend from the chamber and allow vaporized liquid coolant to exit the chamber. The at least two conduits may each include an elongated outlet with the gap between outlets of the at least two conduits at a location remote from the fins. For example, each of the conduits may have an elongated outlet located at a distance from or in a different region from the fins. The elongated outlets of the conduits may be separated or spaced apart by a gap at a location that may be positioned at a distance from or in a different region from the fins. Length refers to a measurement or extent of something from end to end. For example, length of each of the elongated outlets may be a measurement of a longer portion of each outlet. Width refers to a measurement or extent of something from side to side. For example, the width of the outlet may be the smaller measurement of the opening of the gap. A length of each of the elongated outlet, that is a linear measurement of a longer portion of each outlet may be greater than a width or side to side measurement of the gap.

In some disclosed embodiments, the at least two conduits include two conduits joined in a unified structure, and wherein the two conduits converge in the boiling region and diverge as the two conduits approach the vapor collection region. A unified structure refers to parts, devices, or substances that are arranged, organized, or connected together. A unified structure may include a physical structure where conduits are joined or refer to a state of being unified by a particular property. For example, the two conduits may be joined in a unified structure so that they are physically connected to each other and/or collocated on the same structure. Converge refers to meeting at a point, intersecting, coming together, or collecting. For example, the two conduits may converge in the boiling region. Diverge refers to moving, separating, or going in a different direction, or distributing. For example, the two conduits may diverge as the two conduits approach the vapor collection region.

By way of non-limiting example, in Fig. 5A, conduits 502 may be channels having inlets 506 near fins 300 and outlets 130 (as shown in Fig. 1C) remote from fins 300 (e.g., in vapor region 118). The at least two conduits 502 may include an elongated outlet 130 (as shown in Fig. 1C) with the gap 504 between outlets 130 (as shown in Fig. 1C) of the at least two conduits 502 at a location remote from the fins 300, and wherein the length of the elongated outlets 130 (as shown in Fig. 1C) is greater than the width of the gap 504. **In** other embodiments, the second opening 508 may be wider than openings of the at least two conduits 502 adjacent the fins 300. **In** some embodiments, the at least two conduits 502 may include two conduits 502 joined in a unified structure, and wherein the two conduits 502 converge in the boiling region of the chamber 102 and diverge as the two conduits 502 approach the vapor collection region 118 of the chamber.

By way of another non-limiting example, in Fig. 5C, at least two conduits 502 may include two conduits joined in a unified structure (e.g., chimney 500). The two conduits 502 may converge in the boiling region (e.g., pool 116) and diverge as the two conduits 502 approach vapor collection region 118.

In some embodiments, the at least two conduits include inlets adjacent the boiling region, the inlets being configured to divide vapor flow into a plurality of spaced apart vapor pathways with a liquid coolant pathway in the gap therebetween. Adjacent may be understood as described and exemplified elsewhere herein. At least two conduits include inlets adjacent the boiling region refers to two or more conduits next to or connected to the boiling region. For example, inlets may be in contact with the boiling region allowing vapor flow to divide into different pathways. Divide vapor flow refers to separating vapor into different streams and/or courses. Spaced apart vapor pathways refers to vapor pathways spaced apart or arranged with spaces or gaps in between. For example, spaced apart vapor pathways may have gaps between each vapor pathway, allowing for liquid coolant to flow in the gap. For example, inlets of the conduits may be in contact with or located in proximity to the boiling region, allowing vapor flow to enter the different conduits and travel via the different conduits that may be spaced apart from each other. Liquid coolant pathway refers to a route or path for liquid coolant to flow or travel through. Liquid coolant pathway in the gap therebetween refers to a path of liquid coolant between a plurality of spaced apart vapor pathways. For example, liquid coolant may flow between two vapor paths, in particular in the gap between two conduits carrying vapor away from the boiling region. Inlets may be designed or positioned to divide the vapor being generated in the boiling region into more than one spaced apart stream of vapor flowing through the spaced apart conduits. The liquid coolant may flow towards the boiling region in the gaps between the conduits carrying vapor away from the boiling region.

In some disclosed embodiments at least two conduits define two channels, each channel having an inlet opening adjacent the fins and an outlet opening remote from the fins, and the liquid coolant pathway includes the coolant pool region. A channel refers to a conduit, path, or course along which a fluid may flow. For example, a channel may include one or more fluidly coupled tubes, pipes, and/or ducts. In some embodiments, a channel may include a first opening at a first thereof permitting fluid to enter the channel, and a second opening at a second end thereof permitting fluid to exit the channel. A channel having an inlet opening adjacent the fins refers to the channel having an inlet next to, near, or adjoining the fins. Channel having an inlet opening adjacent the fins may function to break up the bubble fields. A channel having an outlet opening remote from the fins refers to the channel having an outlet spaced from or located at a distance from the fins. For example, the channel may have an inlet next to the fins and an outlet away from the fins, allowing liquid coolant to flow away from the fin. A liquid coolant pathway including the coolant pool region refers to liquid coolant flowing through the coolant pool region as part of the liquid coolant path. For example, the liquid coolant may flow in part through the coolant pool region. Thus, in some disclosed embodiments two or more conduits may create two or more channels. Each channel may have an inlet opening next to or adjacent to the fins and an outlet opening away from the fins. The liquid coolant may flow through the coolant pool region. For example, liquid coolant may flow between the channels, away from the fins.

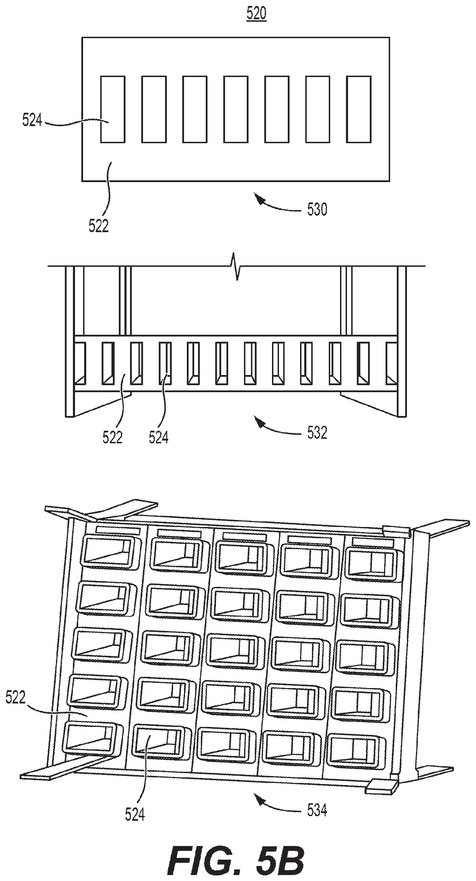

Consistent with some embodiments, Fig. 5B illustrates multiple chimneys 520 with multiple bubble channels (conduits) 522 for breaking up a bubble field of pool 116 in an ENE 100. A side view of outlet bubble channels (conduits) 522 is shown in 530 with gaps 524 in between conduits 522. A side view of inlet liquid channels is shown in 532 with gaps 524 in between the conduits 522. Inlet openings may be adjacent fins 300 and outlets may be remote from fins 300. A top view of outlet bubble channels 534 is shown in 534 with gaps 524 in between the conduits 522.

By way of another non-limiting example, in Fig. 5C, at least two conduits 502 may include inlets 556 adjacent the boiling region (e.g., pool 116). Inlets 556 may divide a vapor flow into a plurality of spaced apart vapor pathways (e.g., vapor flows 552) with a liquid coolant pathway (e.g., liquid flow 554) in the gap therebetween (e.g., between vapor flows 552). For example, conduits 502 may impose a physical barrier between vapor flows 552 and liquid flow 554 to prevent liquid coolant from mixing with and/or entering vapor flows 552.

In some disclosed embodiments, the heat conducting clement includes a plurality of wicks interposed between adjacent fins. A wick refers to a component designed to facilitate fluid movement, as described and exemplified elsewhere herein. Adjacent fins refer to fins, as exemplified elsewhere herein, that are adjoining or located next to each other. For example, adjacent fins may be near each other and may have a gap between each other. Wicks interposed between adjacent fins refers to wicks placed or inserted between fins that are next to each other. For example, a wick may be structurally attached to a fin and designed to facilitate movement of vaporized coolant bubbles through gaps between adjacent fins. A plurality of wicks interposed between adjacent fins refers to wicks placed between adjoining fins. For example, two or more wicks may be located in between adjoining fins, facilitating movement of liquid coolant. Further, a plurality of wicks may be interposed between some adjoining fins, but not all adjoining fins. For example, a plurality of wicks may be placed between alternating adjacent fins or a pattern of adjacent fins. Wicks may draw away bubbles generated by pool boiling within the chamber, allowing cool liquid coolant to replace hot vaporized coolant in the region of the heat conducting wall. In some examples, interposed wicks may refer to an alternating relationship of wick, fin, wick, fin, etc.

In some disclosed embodiments, at least one conduit includes an inlet seated on at least one of the plurality of fins or the plurality of wicks interposed between the plurality of fins. Seated on refers to a positioning or placing of an object or component on another object or component. For example, the inlet may be placed on top of a fin or wick, allowing for substance (e.g., liquid coolant, vaporized coolant) to flow. An inlet seated on at least one of the plurality of fins or the plurality of wicks interposed between the plurality of fins refers to positioning or placing the inlet on top of or in contact with at least one fin. For example, the inlet may contact multiple fins.

By way of non-limiting example, in Fig. 3B, the set of fins 300 may include a plurality of wicks 302 interposed between adjacent fins 300, designed to facilitate the movement or transfer of bubbles through gaps. With reference to Figs. 1B-1C and 3A-3B, a first set of fins 300 (e.g., with interleaving wicks 302) may be located on inner surface 106 of heat conductive wall 104 (e.g., a first heat transfer wall), extending into chamber 102 and submerged inside pool 116.

In some disclosed embodiments, the cooling device is configured for mounting on electronics for cooling the electronics. Mounting refers to attaching, setting, supporting, fixing, standing, or arranging something. For example, mounting may involve positioning, stationing, or arranging on a device, component, item, or region. Electronics may refer to electronic devices, electronic components, or any device made of electronic components that uses electricity or electric energy to operate. Non-limiting examples of electronics include integrated circuits, transistors, processors, or any similar device or component that uses electricity. Mounting on electronics refers to attaching or connecting to one or more electronics. For example, the cooling device may be configured for mounting on electronics Stated another way, the cooling device may be attached to electronic components via fasteners, adhesives, clamps, soldering, brazing, or via any other means of attachment to allow for cooling the electronics.

By way of non-limiting example, Fig. 1C shows an ENE 100 that may include heat conductive wall 104 (e.g., a plate) for mounting on heat generating electronic component 110 to cool electronic component 110.HRU 142 may be configured with a pump 146 (as shown in Fig. 1A). Pump 146 may be fluidly connected to a liquid coolant port of ENE 100 via liquid coolant lines 120 and 148 (e.g., and the liquid tubing system of RDU 144), allowing pump 146 to push liquid coolant from the condenser of HRU 142 to each ENE 100. System 140 may additionally include vapor coolant lines 122 and 150 for conveying vaporized coolant from ENE 100 (e.g., via the vapor tubing system of RDU 144) to the condenser of HRU 142. ENE 100 may be configured with a self-regulating float valve 200, as described earlier, to adjust an inflow of liquid coolant.

Duc to geometry and sizing considerations, tubing for evacuating vaporized liquid coolant in a pool-boiling cooling device may be located below the surface of the liquid coolant pool. A snorkel structure may allow evacuation of vaporized liquid coolant that collects above the surface of the liquid coolant pool to flow through tubing located below the pool.

Some disclosed embodiments involve a two-phase cooling device for enabling vapor outflow from a submerged liquid level location. A two-phase (or dual phase) cooling device broadly refers to a heat exchanger. General description and examples are provided and exemplified elsewhere herein. Vapor refers to a substance or material in its gaseous or gas phase. For example, liquid coolant may be heated to a temperature greater than or equal to its boiling point temperature, causing at least some of the liquid coolant to change to a gaseous phase to form vaporized liquid coolant. Liquid level location refers to the position or depth at which a surface of a liquid is located within a container or vessel. For example, a liquid level location may refer to a surface of liquid coolant located within a chamber. Submerged refers to a position of an object or component that is completely or partially beneath the surface of a liquid. For example, a submerged liquid level location may refer to a location of a component that is partially or totally beneath the surface of the component. Outflow refers to the movement or flow of something, such as a liquid, gas, or other substances, away from a point or source. Vapor outflow refers to the movement or flow of vapor away from a point or source. Enable refers to making something possible, to provide the means or resources for a particular action, or to give something the ability or authority to do something. A two-phase cooling device for enabling vapor outflow from a submerged liquid level location refers to a two-phase cooling device configured such that at least one of its components enables vapor outflow below a surface of a liquid. For example, a cooling device may be configured such that vapor outflow may occur from a location below a surface of a liquid coolant.

Some disclosed embodiments include a chamber having a lower region for containing liquid coolant and an upper region for containing vaporized liquid coolant. A chamber refers to an at least partially enclosed compartment and/or cavity, as described and exemplified elsewhere herein. Containing refers to holding, storing, or enclosing something within a certain space or limits. For example, a chamber containing liquid coolant may refer to a chamber within which liquid coolant is held or stored. Vaporized liquid coolant refers to liquid coolant that has changed phases into a gaseous form, as described and exemplified elsewhere herein. A lower region refers to an area situated at a lower elevation compared to other areas. For example, a lower region may be close to a bottom portion of the chamber relative to a gravitational direction. A lower region for containing liquid coolant of a chamber may refer to a portion located inside the chamber that may be configured to contain liquid coolant. In some embodiments, the lower region of the chamber may be bounded on one or more sides by a heat conducting wall of the chamber. An upper region refers to an area of the chamber situated closer to the top portion or surface of the chamber relative to a gravitational direction. For example, an upper region of a chamber may refer to a portion located inside the chamber that includes a ceiling of the chamber, and that may be configured to contain vaporized liquid coolant. A chamber having a lower region for containing liquid coolant and an upper region for containing vaporized liquid coolant thus refers to a chamber with two areas, each of which may be configured to contain a different phase of matter of a substance. There may or may not be a complete or partial physical boundary between the upper region and the lower region. Some disclosed embodiments involve, the lower region for containing liquid coolant having a volume substantially larger than a volume of the upper region. Volume refers to an amount of space that a three-dimensional object occupies in physical space and may be measured in cubic centimeters, cubic inches, or any other unit typically used to quantify volume. Substantially larger refers to a notable difference in magnitude such that one measurement or quantity is considerably greater than another measurement or quantity. A volume that is substantially larger may be larger by, for example, a threshold amount (e.g., 5%, 10%, or other amounts depending on the design requirements of the system). For example, a lower region for containing liquid coolant may be designed to have a volume substantially larger than a volume of an upper region for containing vaporized liquid coolant because a large quantity or store of liquid coolant may be needed to facilitate cooling or heat transfer from a heat-generating electronic component whereas vaporized liquid coolant generated as a result of the heat transfer may continuously flow out and away from a cooling device, thereby requiring a smaller volume of storage of vaporized liquid coolant in the chamber.

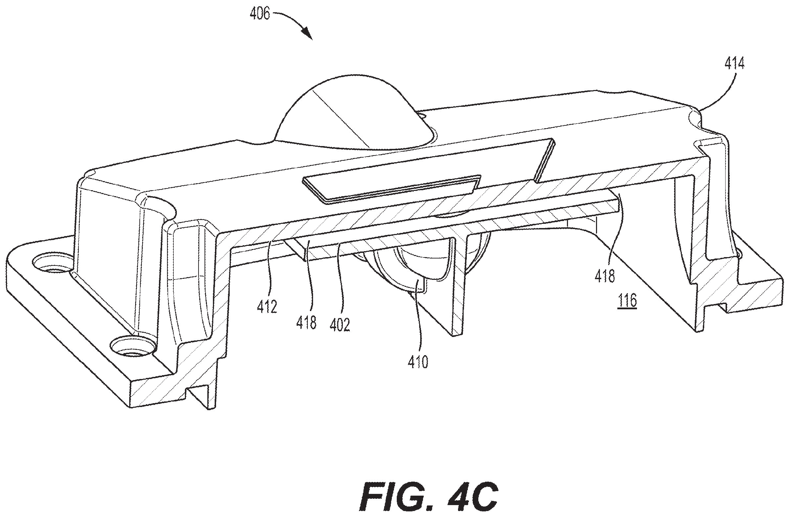

By way of non-limiting example, Figs. 1B, 4C, and 4D show a cooling device (e.g., ENE 100) with a lower liquid coolant region 116 and an upper vaporized liquid coolant region 118. One side of lower liquid coolant region 116 is inner surface 106 of heat conducting wall 104. One side of upper vaporized liquid coolant region 118 is inner surface 412 of ceiling wall 414. With specific reference to Fig. 4D, lower region 116 is depicted to be substantially larger than upper region 118.

Some disclosed embodiments involve a liquid coolant port in the chamber. A port refers to an opening or connection point in a system, as further described and exemplified elsewhere herein. A liquid coolant port in the chamber refers to an opening or connection point in a chamber configured to allow flow of liquid coolant into or out of the chamber. A liquid coolant port may be understood to be similar to a liquid inlet or liquid coolant inlet, as described, and exemplified elsewhere herein. Some disclosed embodiments include a float valve in the lower region, the float valve being configured to conditionally obstruct the coolant inlet. A float valve refers to a component configured to regulate a level of fluid in a chamber, as described and exemplified elsewhere herein. Obstruct refers to blocking, hindering, or impeding the progress or movement of something. Conditionally refers to something that occurs based on satisfaction of a particular rule or criterion, or under a specific circumstance. Conditionally obstruct refers to obstructing based on a particular criterion or circumstance. For example, a float valve may experience a buoyancy force from a level of fluid in a chamber as it rises. Under a certain circumstance, such as when the float valve rises and reaches a level at which the coolant inlet is located, the float valve may block (or obstruct) the inlet port and flow of liquid coolant through the coolant inlet. Thus, in this case, the condition may be when a height of the float valve relative to a reference surface is equal to a height of the coolant inlet relative to that same reference surface. Accordingly, the float valve may conditionally obstruct the coolant inlet based on a height of the float valve relative to the reference surface.

By way of non-limiting example, Figs. 4B shows an interior view of the upper portion of an ENE, inverted. As shown, the ENE includes a liquid coolant port (e.g., orifice 206 and liquid coolant inlet 404), through which liquid coolant may enter chamber. A blocking portion of float valve 200 (such as blocking portion 208 shown in Fig. 4E) may conditionally obstruct orifice 206 and obstruct the flow of liquid coolant into lower region 116. By way of non-limiting example and with reference to Fig. 4E, when float valve 208 is in a lower position, orifice 206 is not blocked, allowing liquid coolant to flow into lower region 116.

Some disclosed embodiments include a heat conducting element in the lower region of the chamber. A heat conducting element, also known as a thermal conductor, is a component that allows the transfer of heat through it. For example, heat conducting wall is one example of a heat conducting clement. In some disclosed embodiments, the heat conducting element is configured for mounting on a heat-generating electrical component for cooling the heat-generating electrical component. When a heat-conducting element is in thermal contact with a heat-generating electrical component (as described and exemplified elsewhere herein) cooling of the heat-generating component may occur. Mounting refers to the process of attaching, securing, or installing an object or device to a support structure or surface of another object or device. Mounting may be accomplished through use of a fixing element, e.g., screws, bolts, brackets, adhesives, clamps, or any other element whose function involves physically attaching at least two other different objects. For example, the heat conducting element may be designed to have screw holes through which a screw can be inserted to mount the heat conducting element onto a heat-generating electrical component. As another example, an adhesive layer may be used to attach the heat conducting element onto a heat-generating electrical component.

In some disclosed embodiments, the chamber is configured for pool boiling. Pool boiling may be understood as described and exemplified elsewhere herein. For example, the chamber may be configured to allow the transfer of thermal energy from a heat-generating electrical component through a heat conducting element into the lower region of a chamber to facilitate the boiling of liquid coolant into vaporized liquid coolant.

By way of non-limiting example, Figs. 1B and 4E show cross section views of a cooling device (e.g., ENE 100 as labeled in Fig. 1B) with a heat conducting wall 104 which defines a side of the lower region of the chamber configured to containing liquid coolant. Thermal energy from a heat-generating clectronic component mounted below the cooling device may transfer to the liquid coolant through a heat conducting element such as heat conducting wall 104. The thermal energy may raise the temperature of the liquid coolant in the lower region to reach boiling, causing pool boiling of the liquid coolant.

Some disclosed embodiments include at least one vapor coolant port located at a level at least partially in the lower region, and at least partially beneath the upper region. Vapor coolant refers to coolant in a vapor or gascous phase of matter. Vapor coolant may be created as a result of vaporizing liquid coolant. Vapor coolant may be understood to be similar to vaporized liquid coolant, as described and exemplified elsewhere herein. A vapor coolant port refers to an opening or connection point in a chamber configured to allow the flow of vapor coolant into or out of the chamber. A vapor coolant port may be understood to be similar to a vaporized liquid coolant port, vapor outlet, or vaporized liquid coolant outlet, as described, and exemplified elsewhere herein. A level is described and exemplified elsewhere herein. In some embodiments, a level refers to a horizontal plane or line with respect to the distance above or below a given point. A level at least partially in the lower region refers to a level, in part or in whole, in the lower region. A level at least partially beneath the upper region refers to a level that is located beneath the upper region in part or in whole. A level at least partially in the lower region and at least partially beneath the upper region refers to a level that spans both the lower region and the upper region. For example, a vapor coolant port may be configured to be partially in the lower region and partially in the upper region of a chamber. In some disclosed embodiments, the at least one vapor port includes two vapor ports. In other embodiments, the at least one vapor port includes more than two ports.

By way of a non-limiting example, Fig. 4B shows an interior view of part of an exemplary cooling device (e.g., ENE 100) with two vaporized liquid coolant ports 406 and 408. Vaporized liquid coolant may flow into vaporized liquid coolant ports 406 and 408, through vaporized liquid coolant conduits 410, and into an upper region for containing vaporized liquid coolant 118. As shown in Fig. 4A, vaporized liquid coolant ports 406 and 408 may be located at a level such that they extend at least partially into lower region for containing liquid coolant 116 and at least partially below upper region for containing vaporized liquid coolant 118.

In some disclosed embodiments, a cross-section of an opening of the at least one vapor port may be larger than a cross-section of an opening of the liquid coolant port. A cross-section is described and exemplified elsewhere herein. In some embodiments, a cross-section refers to a two-dimensional representation or view of a three-dimensional object or structure obtained when a plane cuts an object. For example, a cross-section of a vaporized liquid coolant conduit may be obtained when a plane cuts the conduit in a direction perpendicular to a central axis of the vaporized liquid coolant conduit along which vaporized liquid coolant may flow. A larger cross-section refers to a cross-section with an area that has a greater two-dimensional extent or surface coverage when compared against at least one other object. For example, a cross-section of an opening of a vaporized liquid coolant port may be larger than a cross-section of an opening of a liquid coolant port when the area of the cross-section opening of a vaporized liquid coolant port is greater than the area of the cross-section opening of a liquid coolant port.

By way of non-limiting example, Fig. 4F shows a cross-section of a vaporized liquid coolant port 422 and liquid coolant port 420, with the cross-sectional area 421 of the opening of vaporized liquid coolant port 422 being larger than the cross-sectional area 423 of an opening of the liquid coolant port 420.

Some disclosed embodiments include at least one snorkel pathway fluidly connecting the upper region for containing vaporized liquid coolant with the at least one vaporized liquid coolant port, to thereby enable vaporized liquid coolant to exit the chamber from the submerged level at least partially beneath a level of liquid coolant in the lower region. A pathway refers to a route or track that may provide passage or access for one or more objects or substances to move from one place to another. A snorkel refers to a tubular device or component having one end arranged for submersion beneath a liquid, and the other end configured to extend above the liquid. A snorkel may provide a pathway for gas such as vaporized coolant to rise through a pool of liquid coolant. A snorkel and/or its pathway may have a cross-section that is round or any other shaped cross-section. A snorkel may have a straight and/or curved form. A snorkel pathway refers to hollow passage through the snorkel. Fluidly connecting, or a fluid connection, is described and exemplified elsewhere herein. In some embodiments, a snorkel pathway may be manufactured with a chamber as a single, integral piece made of molded material, such as plastic. Alternatively, in some embodiments, a port may be connected to a chamber mechanically, where the connection may be sealed (e.g., using a sealant) to prevent leakage. At least one snorkel pathway fluidly connecting the upper region for containing vaporized liquid coolant with at least one vaporized liquid coolant port refers to a snorkel pathway that has one end open in the upper region for containing vaporized liquid coolant and the other end connected to the vaporized liquid coolant port. For example, vaporized liquid coolant may be delivered via a snorkel pathway from an upper region of a chamber, through a lower region of a chamber to a vapor port that is at least partially beneath a level of liquid coolant, and vice versa.

By way of non-limiting example, Fig. 4E shows an exemplary cooling device (e.g., ENE 100) with two vaporized liquid coolant conduits 410 acting as snorkel pathways. One vaporized liquid coolant conduit 410 is connected to vaporized liquid coolant port 408, thereby fluidly connecting upper region for containing vaporized liquid coolant 118 with vaporized liquid coolant port 408. Similarly, another vaporized liquid coolant conduit 410 is connected to vaporized liquid coolant port 406, thereby fluidly connecting upper region for containing vaporized liquid coolant 118 with vaporized liquid coolant port 406. As shown in Fig. 4E, vaporized liquid coolant conduits 410 and vaporized liquid coolant ports 406 and 408 are located at least partially in lower region for containing liquid coolant 116. Therefore, vaporized liquid coolant that flows from upper region for containing vaporized liquid coolant 118, through vaporized liquid coolant 410, and to vaporized liquid coolant port 406 or 408 exits the chamber from a level at least partially beneath a level of liquid coolant stored in lower region 116.

In some disclosed embodiments, at least one snorkel pathway includes two snorkel pathways. For example, two pathways may traverse a common snorkel, or two snorkels, each with its own pathway may be employed. In some disclosed embodiments, each of the two snorkel pathways may be in flow communication with the upper region, thereby enabling vapor from one of the two vaporized liquid coolant ports to exit through the other of the two vaporized liquid coolant ports. Flow communication may be understood similarly to a fluid connection, as described, and exemplified elsewhere herein. To exit refers to leaving or escaping. Each of the two snorkel pathways in flow communication with the upper region refers to each of the two snorkel pathways having an end open in the upper region for vaporized liquid coolant and having the other end connected to their own respective vaporized liquid coolant ports, thereby making the two snorkel pathways and the two vaporized liquid coolant ports in flow communication with each other and enabling vaporized liquid coolant to flow from one vaporized liquid coolant port to the other vaporized liquid coolant port. For example, vaporized liquid coolant may flow from one vaporized liquid coolant port, through one snorkel pathway, to an upper region for containing vaporized liquid coolant, through a second snorkel pathway, to a second vaporized liquid coolant port. In some disclosed embodiments, the two snorkel pathways are symmetric. Symmetric refers to a quality or characteristic of being balanced, similar, or identical on either side of a central point, axis, or plane. For example, each of the two snorkel pathways may be similarly shaped and sized on either side of a plane equidistant between the two snorkel pathways.

By way of non-limiting example, Figs. 4A, 4B, and 4E show interior and cross section views of portions of an ENE 100. As shown in Fig. 4B a vapor passthrough 400 may have a first and second vaporized liquid coolant conduits 410. In some embodiments, a vapor passthrough 400 may allow vaporized liquid coolant originating in a first ENE 100 to pass through upper region 118 of a second ENE 100, mix with vaporized liquid coolant originating in the second ENE 100, and the mixed vaporized liquid coolant to flow to a third ENE. For example, vapor passthrough 400 may include vaporized liquid coolant ports 408 and 406 such that vaporized liquid coolant from a first ENE 100 may enter a second ENE 100 through vaporized liquid coolant port 408, mix with vaporized liquid coolant from the second ENE 100, and exit through vaporized liquid coolant 406. Although vaporized liquid coolant is depicted as flowing into ENE 100 via vaporized liquid coolant port 408 and flowing away from ENE 100 via vaporized liquid coolant port 406, it should be understood that the flow of vaporized liquid coolant may occur in the reverse direction. At least one vaporized liquid coolant port 406 (and 408) may be located at a level at least partially in lower region 116 (e.g., containing liquid coolant), beneath upper region 118 (e.g., for containing vaporized liquid coolant). At least one snorkel pathway (e.g., vaporized liquid coolant conduit 410) may fluidly connect upper region 118 containing vaporized liquid coolant with at least one vaporized liquid coolant port 406 (and/or 408), to enable vaporized liquid coolant in upper region 118 to exit chamber 102 from the submerged level at least partially beneath a level of liquid coolant in the lower region 116. Further, as shown in Fig. 4E, the two snorkel pathways 410 may be symmetric such that they have similar or substantially similar shape and size from an equidistant plane or axis of symmetry.

In some disclosed embodiments, the at least one snorkel pathway is S-shaped. S-shaped refers to a shape or form that resembles the letter "S" in its appearance in part or in total. Further, S-shaped may refer to a shape or form that consists of a smooth, curved line that starts with a curve in one direction, then reverses course with another curve in the opposite direction.

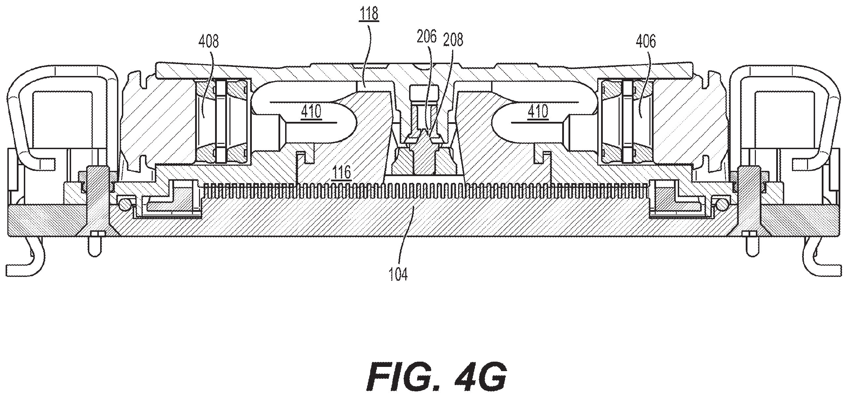

By way of non-limiting example, Fig. 4G shows an exemplary cooling device (e.g., ENE 100) with two vaporized coolant conduits 410. Each vaporized coolant conduit 410 is S-shaped and fluidly connects vaporized coolant port 406 or 408 with upper region for containing vaporized liquid coolant 118, thereby enabling vapor from one of the two vaporized liquid coolant ports 406 or 408 (e.g., flowing from a downstream ENE 100 via port 408) to exit via upper region 118 through the other vaporized liquid coolant port 408 or 406. Further, as shown in Fig. 4G, the two snorkel pathways 410 may also be symmetric such that they have similar or substantially similar shape and size from an equidistant plane or axis of symmetry.

In some disclosed embodiments, the snorkel pathway has a consistent gradient. Consistent refers to a characteristic or quality of being that maintains a steady and unchanging pattern, behavior, or quality over time and/or space. A gradient refers to the rate of change of a particular quantity as it varies along a curve. For example, a gradient may refer to the curvature of a snorkel pathway. A consistent gradient refers to a gradient that is steady and unchanging across a length. For example, a snorkel pathway may be configured to have a consistent gradient to facilitate or ensure the smooth and efficient flow of vaporized liquid coolant from a chamber to a vapor port without pooling or stagnation.

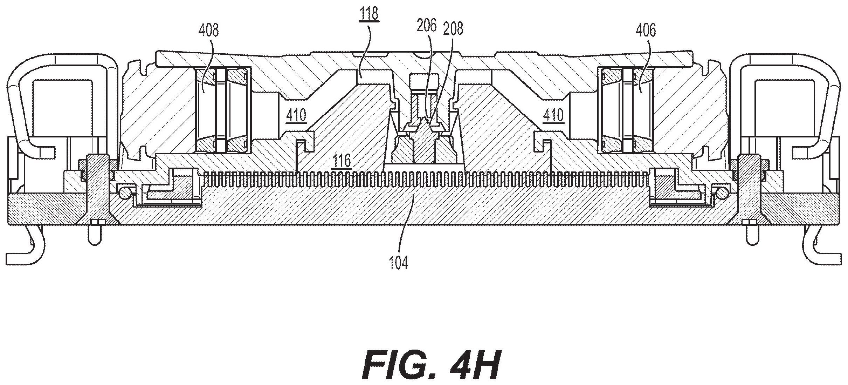

By way of non-limiting example, Fig. 4H shows an exemplary cooling device (e.g., ENE 100) with two vaporized coolant conduits 410. Each vaporized coolant conduit 410 has a consistent (e.g., diagonal) gradient and fluidly connects vaporized coolant port 406 or 408 with upper region for containing vaporized liquid coolant 118, thereby enabling vapor from one of the two vaporized liquid coolant ports 406 or 408 (e.g., flowing from a downstream ENE 100 via port 408) to exit via upper region 118 through the other vaporized liquid coolant port 408 or 406. Further, as shown in Fig. 4H, the two snorkel pathways 410 may also be symmetric such that they have similar or substantially similar shape and size from an equidistant plane or axis of symmetry.

Some disclosed embodiments include a barrier between the lower region and the upper region. A barrier is described and exemplified elsewhere herein. A barrier may also be understood to refer to a physical obstruction that prevents or restricts movement or access between at least two locations. For example, a barrier may be configured to demarcate the boundary between an upper region for containing vaporized liquid coolant and a lower region for containing liquid coolant. In some disclosed embodiments, the barrier is configured to obstruct entry of liquid coolant into the upper region. For example, a barrier may be a wall, an obstruction, a plate, a membrane, a guard, a cover, or any other physical component configured to prevent or limit the movement of liquid coolant from the lower region into the upper region. In some disclosed embodiments, the barrier is plate shaped. A plate refers to a thin, flat, rigid body. The plate may have a uniform thickness, and may be made of plastic, metal, or any other rigid material. Plate shaped refers to an object or component having a shape or form similar or resembling that of a plate. For example, a plate shaped barrier may involve a barrier that is a thin flat, rigid material of generally uniform thickness. The plate may have any shape, for example, circular, elliptical, rectangular, square, polygonal, or any other shape.

By way of non-limiting example, Fig. 4A shows a barrier 402 separating lower region 116 and upper region 118 of an exemplary cooling device (e.g., ENE 100). Barrier 402 may be solid and plate-shaped, which physically obstruct liquid coolant originating in lower region 116 from entering upper region 118. Fig. 4D shows a cross-section of barrier 402 in an exemplary cooling device (e.g., ENE 100) and further illustrates the physical structure that may prevent liquid coolant originating in lower region 116 from entering upper region 118.

In some disclosed embodiments, the barrier has a liquid coolant inlet extending therethrough. Extending therethrough refers to an object, component, or feature that passes completely through a particular area, other object, or structure. For example, a liquid coolant inlet extending therethrough refers to a liquid coolant inlet that has one end located on one side of a barrier, the other end located on the other side of a barrier, and is continuous from the one end to the other end such that liquid coolant may flow uninterrupted. For example, the liquid coolant inlet may be created as part of the barrier, or may be attached to an opening in the barrier. The opening may be created by drilling, punching, cutting, or by any other method of removing material from the barrier to form the opening. For example, a liquid coolant inlet may be manufactured with the barrier as a single, integral piece of molded material. Alternatively, a liquid coolant inlet may be mechanically connected to an opening in a barrier, where the connection may be sealed (e.g., using a sealant) to prevent leakage. For example, liquid coolant may be delivered from a liquid coolant port through a barrier into a lower region of a chamber.

By way of non-limiting example, Fig. 4A shows an exemplary cooling device (e.g., ENE 100) with barrier 402 and liquid coolant inlet 404. Liquid coolant inlet 404 extends through barrier 402 and may allow liquid coolant to enter lower region 116 of the cooling device from liquid coolant conduit 416 as depicted by the single white arrow. Fig. 4B shows an upside-down view of an exemplary cooling device (e.g., ENE 100) with liquid coolant inlet 404 extending through barrier 402.

In some disclosed embodiments, the barrier includes a liquid coolant conduit for conveying liquid coolant through the upper region to the liquid coolant inlet. A liquid coolant conduit is described and exemplified elsewhere herein. Conveying refers to transporting a substance from one location to another location, as described and exemplified elsewhere. For example, conveying liquid coolant may refer to transporting liquid coolant from a liquid coolant port to an upper region of a chamber. In some disclosed embodiments, a cross-section of the liquid coolant conduit is smaller than a cross-section of the at least one snorkel pathway. For example, a cross-section of a liquid coolant conduit may be a section or surface obtained when a plane cuts the conduit in a direction perpendicular to a central axis of the liquid coolant conduit along which liquid coolant may flow. For example, a cross-section of an opening of a liquid coolant conduit may be smaller than a cross-section of an opening of a snorkel pathway when the area of the cross-section opening of a vaporized liquid coolant port is less than the area of the cross-section opening of a liquid coolant port. In some disclosed embodiments, the liquid coolant conduit is transverse to a direction of vaporized liquid coolant flow. Transverse as described and exemplified elsewhere herein, may refer to crossing or extending in a crosswise direction. Transverse may also be understood to refer to a positioning or orientation of one object such that the one object is situated across to another object, direction, or axis. For example, a liquid coolant conduit transverse to a direction of vaporized liquid coolant flow may refer to a liquid coolant conduit configured to be oriented such that it exists along one line perpendicular to another line along which vaporized liquid coolant conduits exist.

By way of non-limiting example, Figs. 4A and 4B show a cooling device (e.g., ENE 100) with vaporized liquid coolant conduits 410 acting as snorkel pathways and liquid coolant conduit 416. As depicted in Fig. 4A, liquid coolant conduit 416 may be incorporated as part of barrier 402. Liquid coolant conduit 416 facilitates the movement of liquid coolant from liquid coolant line 120 to lower region of a chamber 116 through liquid coolant inlet 404 and inlet orifice 206. Liquid coolant conduit 416 is shown to be transverse to the flow of vaporized liquid coolant (arrows) through vaporized liquid coolant conduits 410. As depicted in Fig. 4A, a cross-sectional area associated with liquid coolant conduit 416 is smaller than the cross-sectional area associated of vaporized liquid coolant conduit 410. This difference in cross sectional size is further depicted in Fig. 4B.

In some disclosed embodiments, the barrier exposes at least one vent, permitting vapor of boiling coolant in the lower region to escape to the upper region. A vent refers to an opening or passage that allows the movement of air, gases, vapors, liquids, or other substances. For example, a barrier may expose a vent between the barrier and the side walls of a chamber such that vaporized liquid coolant may flow from the lower region into the upper region. Exposing a vent refers to a vent being accessible or the vent being open. Exposing the vent may involve making a vent accessible or open by providing a space for the vent, or by an absence of an obstruction from the space the vent occupies. In some disclosed embodiments, the at least one vent includes a plurality of vents distributed around a perimeter of the barrier. A perimeter refers to an outer boundary or edge of an object. For example, a perimeter of a barrier may refer to the continuous boundary or outermost parts of the barrier. For example, a barrier may expose a plurality of vents distributed around a perimeter to allow vaporized liquid coolant from the lower region to flow into the upper region in multiple locations and/or at a quicker rate than the capabilities of flow associated with a single vent. The plurality of vents may involve two, three, four, or any number greater than one vents. The vents may be located along a periphery and may be spaced apart from each other at equal or unequal distances. Each vent provides a location through which vaporized liquid coolant may flow, and an increased number or size of vents provides a larger total cross-sectional area through which vaporized coolant may flow. Because flow rate and cross-sectional area through which a gas flows are generally in a positive relationship such that when cross-sectional area increases, flow rate likely increases, the total flow rate of vaporized liquid coolant may be greater or quicker.

By way of non-limiting example, Figs. 4C and 4D show portions of an exemplary cooling device (e.g., ENE 100) including a barrier 402 with vents 418. Barrier 402 may be configured such that it does not extend to completely separate upper region 118 and lower region 116, thereby exposing vents 418 between the barrier 402 and the side walls of the chamber (such as chamber 102 in Fig. 1B). As shown in Fig. 4D, the vapor produced by boiling coolant in pool 116 may flow as depicted by the curved arrows from lower region 116, around barrier 402, through vents 418, to upper region 118. Further, as shown in Fig. 4B, which shows an inside view of an inverted upper portion of an exemplary cooling device (e.g., ENE 100), vaporized liquid coolant originating as a result of pool boiling in lower region 116 may flow as depicted by curved arrows through vents 418 to upper region 118. Barrier 402 with vents 418 may prevent entry of liquid coolant into upper region 118 (e.g., to prevent liquid coolant from entering the vapor line). As described earlier, barrier 402 may be plate shaped and may be configured with a liquid coolant inlet 404, which may be conditionally obstructed by float valve 200.

Some disclosed embodiments involve the upper region enabling boiling coolant originating in the lower region to mix with coolant vapor entering through the at least one vapor port. To mix refers to combining or blending substances, elements, or components, as described and exemplified elsewhere herein. For example, vaporized liquid coolant formed through pool boiling liquid coolant in the lower region in one chamber may mix with vaporized liquid coolant entering through a vapor port and originating from a chamber from another cooling device, as described elsewhere herein with respect to a vapor passthrough. In this way, vaporized liquid coolant may flow continuously from the chamber of a cooling device, through vapor lines, through other chambers of other cooling devices, to an HRU where vaporized liquid coolant may transition into liquid coolant, and/or an RDU, from where liquid coolant may be distributed to cooling devices, as described and exemplified elsewhere herein.

By way of non-limiting example, Figs. 4B-4D show portions of a cooling device (e.g., ENE 100) with a barrier 402 separating lower region 116 and upper region 118. Vents 418 may permit vapor produced by boiling coolant in pool 116 to escape to upper vapor region 118 following a path depicted by curved flow arrows through vents 418 and mix with vaporized liquid coolant entering through vaporized liquid coolant port 406 or 408, e.g., from a downstream ENE 100. The mixed vaporized liquid coolant may then exit through the other vaporized liquid coolant port 408 or 406 to an upstream ENE 100.
[1] As operating frequencies of electronic components increase, so does heat flux, creating a larger difference in temperature (or delta temperature) between the case and junction. The case temperatures may be balanced by controlling the workload among electronic components to cause a more even distribution of workload, to maximize the total heat output temperature of the cooling media. To increase case temperature, it is beneficial to reduce the delta temperature between the junction and the case. Lowering the frequency of the chip may cause the chip case to become hotter.
[2] For example, CPUs that work at 100% frequency can use four times more power than CPUs operating at 50% frequency (e.g., power intake may be double the processing speed). Consequently, in a distributed computing environment (e.g., multiple CPUs operating cooperatively to accomplish a shared workload) a CPU may operate at 100% operating speed and complete its task early, causing the CPU to idle until the next task is scheduled. Therefore, it may be efficient to cap an operating frequency of a CPU, e.g., to 90%, thereby reducing the power drawn and the idle time. For example, if a server requires less than 70% of its utilization load, the operating frequency of the server's processors may be capped.
[3] Some disclosed embodiments include a system for controlling electronics operating frequencies for regulating heat generation. Controlling electronics refers to managing, directing, or regulating one or more electronic components, as previously described and exemplified. For example, a system may control the operating frequencies of electronics, to manage excess heat generation. Operating frequencies refers to an intended, designed, and/or actual frequency or range of frequencies at which a device or system functions. For example, a device or system may have a range of operational frequencies, with a lower and upper limit. If the device is pushed to operate outside the range of operating frequencies, it may not work properly. Further, a higher operating frequency may be associated with higher power consumption, but more computational power. Additionally, a higher power consumption may be associated with more heat generation. Thus, at higher operating frequencies, the system may generate more heat. In a system, each heat-generating electronic component may have a different operating frequency due to differences in the purposes, functions, and/or properties of the heat-generating electronic components. Regulating heat generation refers to the process of managing and controlling the amount of heat produced. It may refer to controlling the conversion of one form of energy into thermal energy. An electronic device may generate heat internally during operation, and that heat may conduct outwards to a cooler surrounding environment, causing an increase in temperature of the surrounding environment and a decrease in temperature inside the electronic device. However, if sufficient heat is released by the device such that the surrounding environment reaches the temperature of the device, heat transfer may cease. Such a situation may cause the electronic device to overheat and/or fail. Regulating heat generation may prevent electronic device overheat and/or fail. Electronic components may have an associated operating frequency. Controlling electronics operating frequencies for regulating heat generation refers to managing, directing, or regulating electronics operating frequencies to control heat generation, such that the electronics operate properly. For example, operating frequency may be lowered to reduce excess heat generation of the electronics. It is to be appreciated that at higher operating frequencies, the heat-generating electrical components may generate excess heat. Thus, controlling electronics operating frequencies for regulating heat generation is beneficial from an efficiency standpoint.
[4] Some disclosed embodiments involve at least one processor configured to monitor utilization of a plurality of heat-generating electronic components, each having an associated operating frequency. The term "processor," as previously defined and exemplified, is used to refer to a single processor and multiple processors operating together to accomplish a task. Utilization refers to, how often, the purpose of, by what, or how much a device or component is used. For example, utilization of a heat-generating electronic component may indicate how often or how much a heat-generating electronic component is used. Utilization of a device or component may be determined by monitoring the output of a device or component, such as the output heat of a heat-generating electronic component. Utilization may also be measured by monitoring or determining voltage or current consumption of a device (e.g., heat-generating electronic component). Utilization may also be measured or controlled by a processor. Monitor utilization refers to observing, checking, determining, sampling, and/or keeping a record (e.g., a continuous record in some cases) of utilization. For example, a processor may check heat-generating electronic component usage and store the information in a database. For example, processor may monitor properties of a heat-generating electronic component (e.g., voltage consumption or current consumption) to continuously keep track of (e.g., monitor) utilization. Non-limiting examples of heat-generating electronic components include CPUs, GPUs, and FPGAs. Electronic components each having an associated operating frequency indicates that each electronic component may have an operating frequency associated with it. Heat-generating electronic components may have different operating frequencies due to their different operations or functions. For example, an associated operating frequency of one heat-generating electronic component may be different than the operating frequency of another heat-generating electronic component. A processor configured to monitor utilization of a plurality of heat-generating electronic components, each having a different operating frequency refers to a processor (as previously defined) configured to observe, supervise, or keep track over time of an extent to which electronic components are being operated. Utilization monitoring may occur on a component-by-component basis, or on a group basis (more than one) The monitoring of utilization of the electronic components may be done in any manner. For example, processor may monitor utilization of heat-generating electronic devices by determining the voltage and/or current consumption of the heat-generating electronic components. In some embodiments, software in the system (such as, for example, the operating system) may include a built-in task manager that displays real-time information regarding the utilization of the electronic components of the system. A processor may monitor utilization of heat-generating electronic components continuously, randomly, or at predetermined time intervals.
[5] In some disclosed embodiments, the heat generated by each electronic component is a function of the associated operating frequency. For example, one electronic component may generate more heat (e.g., thermal energy), the same heat, or less heat than another component, depending upon the operating frequency of the component. It is to be appreciated that electronic component and heat-generating electronic component are used synonymously in the forgoing disclosure. When there is a relationship between the operating frequency and the amount of heat generated, it is to be understood that heat generated is a "function of" operating frequency. For example, A is a function of B means that the value or behavior of A changes with or is determined by the value or behavior of B. Heat is considered a function of operating frequency if an increase in operating frequency causes an increase in heat, regardless of whether a specific mathematical relationship exists between frequency and heat output. In some cases, the heat generated may be proportional to the associated operating frequency. Stated another way, as operating frequency increases, the amount of heat generated from a heat-generating component may increase. As the operating frequency of an electronic component increases, the number of operations it performs per unit time may also increase, and consequently, its power consumption and heat generation may increase.
[6] Some disclosed embodiments involve determining that the associated operating frequency of at least one of the plurality of heat-generating electronic components cooperating to accomplish a shared workload is greater than necessary to accomplish the shared workload within a predefined timeframe, and therefore generating unnecessary heat. Cooperating refers to working together or jointly for a particular purpose. For example, cooperating may refer to heat-generating electronic components collaborating or working together to achieve a particular task (e.g., accomplish a workload). For example, the electronic components may share data, and one electronic component may perform a portion of a task and another electronic component may perform another portion of the task. Shared workload refers to a division of work and/or division of computing resources to accomplish a task and/or generate an outcome. This may refer to the distribution of computational tasks or processes across multiple electronic components, such as processors, servers, or nodes of the system to enhance overall system performance and/or efficiency by utilizing the available resources in a collaborative manner. For example, a shared workload between heat-generating electronic components may refer to multiple electronic components working together and sharing computing resources to accomplish a task or generate an outcome. The workload may or may not be split or shared evenly between electronic components. Any operating frequency larger than the minimum frequency needed, required, or essential to accomplish the workload may be considered an operating frequency greater than that necessary to accomplish the workload. A predefined timeframe refers to a set amount of time that has been established and may be e a duration of time or a number of clock cycles. For example, a predefined timeframe may refer to a fixed duration of time required for the heat-generating electronic components to accomplish an operation. Unnecessary heat refers to undesirable and/or excess heat. For example, unnecessary heat may refer to the excess heat generated from electronic components running at higher operating frequency than required to accomplish a task, operation, or outcome. Unnecessary heat is inefficient and undesirable. In some embodiments, the processor may determine that the operating frequency of the electronic component cooperating to accomplish a shared workload is greater than necessary to accomplish the shared workload within a predefined timeframe, and thus generating unnecessary heat. This may be determined in any manner. In some exemplary embodiments, a database or data stored in (or accessible to) the system may include the typical operating frequencies (or range of operating frequencies) of different electronic components to perform different tasks in different times, and by referencing the database, a processor (e.g., processor 152 of Fig. 1A) may determine that a particular component is operating at an operating frequency greater than needed to finish the task within the predefined time, and therefore generating unnecessary heat. The processor may, for example, be configured to estimate the amount of energy required to complete a task in a predefined time period, and may then throttle a component to work a lower frequency if that lower frequency would be sufficient to accomplish the task in the predefined time period. Similarly, the at least one processor may perform load balancing, shifting workload between components in order to reduce or minimize overall heat generated by a system.
[7] In some disclosed embodiments, determining that the associated operating frequency of the at least one of the plurality of heat-generating electronic components is greater than necessary includes identifying idle usage periods associated with the heat-generating electronic components. Idle usage periods refer to portions of time where the electronic component is not actively processing instructions or tasks. While in an idle usage period, the electronic component may consume minimal power and wait for tasks to be scheduled. For example, idle usage periods may refer to the clock cycles where the electronic component is not being used by any program tasks. Idle usage periods may save power because the device is not running at full operation. Identifying idle periods refers to at least one of detecting, receiving a signal containing an indication, and/or recognizing an idle period. For example, a processor and/or sensors may identify idle usage periods by either sensing when a component is not operating or by estimating that a component will be idle. Peak usage periods refer to portions of time where the electronic component (e.g., electronic component 110 in Fig. 1C) is operating at or near an upper workload limit. For example, if an exemplary electronic component (e.g., electronic component 110 in Fig. 1C), reaches 4 GHz at 100% (full) capacity, peak usage periods may refer to the clock cycles where the CPU is operating at or near 4 GHz. In some embodiments, determining that the associated operating frequency of the electronic component is greater than necessary includes identifying idle usage periods associated with the electronic component (e.g., electronic component 110 in Fig. 1C). In some exemplary embodiments, sensors may identify idle usage periods associated with the electronic components (e.g., electronic component 110 in Fig. 1C) and send idle usage period information to processor (e.g., processor 152 of Fig. 1A). In other embodiments, expected idle usage periods may be calculated. Processor (e.g., processor 152 in Fig. 1A) may determine that a particular electronic component (e.g., electronic component 110 in Fig. 1C) is operating at an operating frequency greater than necessary and therefore generating unnecessary heat.
[8] Some disclosed embodiments involve determining at least one operating frequency cap for the at least one of the plurality of heat-generating electronic components. An operating frequency cap refers to an upper limit on the operating frequency of an electronic component. A frequency cap may be measured in clock cycles per second, where each clock cycle may represent an execution of an operation. For example, an operating frequency cap may refer to a restriction or a limitation imposed on the rate or speed at which a particular process can occur in an electronic component. It may be a parameter that sets an upper limit on how often, or how quick, a specific process or operation can be processed by the electronic component. The frequency cap may function to reduce the workload of the electronic component (e.g., CPU) or any other electronic component of the system), thereby avoiding an inefficient operating range for the electronic component where disproportional heat is generated. In some exemplary embodiments, sensors may be connected to the at least one of the electronic components (e.g., electronic component 110 in Fig. 1C), and by communicating with the sensor, a processor (e.g., processor 152 of Fig. 1A) may receive electronic component data and determine the operating frequency cap for the electronic components.
[9] By way of another non-limiting example, electronic component (e.g., CPU) may reach 4 GHz at 100% (full) capacity. However, the amount of heat generated by the CPU may not be linear, increasing steeply from 80% capacity (3.2 GHz) and above. For example, the CPU may generate 1.5x heat operating at 90% capacity (3.6 GHz) than it may generate operating at 80% capacity (3.2 GHz). In this instance, the (e.g., processor 152 of Fig. 1A) may determine the frequency cap should be set at 80% capacity (3.2 GHz), in an effort to avoid entering an inefficient CPU operating zone.
[10] Consistent with some disclosed embodiments, the at least one operating frequency cap is determined to enable the plurality of heat-generating electronic components to accomplish the workload while controlling aggregate heat output of the plurality of heat-generating electronic components. Aggregate heat output of heat-generating electronic components refers to total, combined, or accumulated heat output of those components. For example, the heat output (e.g., Joules, calories, or another unit indicative of heat) of each electronic component may be summed or totaled, generating one aggregate heat output of the plurality of heat-generating electronic components. Controlling aggregate heat output of the plurality of heat-generating components refers to regulating or managing the total heat output for the heat-generating electronic components. For example, at least one processor may determine an operating frequency cap for a group of electronic components so that the task is completed (or the workload is accomplished) while controlling the total heat output of the group. In some embodiments therefore, the operating frequency or clock speed of one or more electronic components (e.g., a CPU) may be dynamically set based on the workload. A CPU's clock speed determines how many instructions it can execute per second. When the workload is light, the CPU's clock speed may be set lower to reduce heat generation. Conversely, during heavy workloads, the clock speed may be set higher for higher performance. By way of non-limiting example, a CPU may operate at 90% capacity and complete its workload in 0.5 seconds, idling for another second. During the first 0.5 second, the CPU working at 90% capacity may have generated 1.5x the amount of heat than it would have when operating at 80% capacity and then idled. In this instance, the processor (e.g., processor 152 of Fig. 1A) may set the frequency cap of the CPU at 80%.
[11] Consistent with some disclosed embodiments, determining at least one operating frequency cap includes shifting workload from peak usage periods to idle usage periods. Shifting refers to moving, transferring, conveying, adjusting, changing, or adapting. For example, shifting workload from peak usage periods to idle usage periods refers to transferring some of the workload for a specific component from what would be a peak usage period to a projected idle usage period. Alternatively or additionally, transfer of workload may occur between electrical components in order to balance the loads with a goal of reducing heat generation while at the same time completing the workload in a timely manner, such as within or near a prescribed time. For example, shifting workload from expected peak usage periods to expected idle usage periods may prevent excess heat generation and improve efficiency. Similarly, on the fly, as one component operates at or near capacity (or operates harder than needed) some of that work may be shifted to a component that is either idle or working at significantly below an acceptable capacity. Determining an operating frequency cap to shift workload from a peak usage period to an idle usage period may be useful from a power management perspective, due to a reduced burden and increased efficiency. Further, shifting workload from peak usage periods to idle usage periods may reduce heat output. The processor of the system may determine that the operating frequency of an electronic component is greater than necessary by identifying idle usage periods of the electronic component and may determine an operating frequency cap for the electronic components by shifting workload from the peak usage periods to the idle usage periods. Shifting the workload from the peak usage periods to the idle usage periods may help control excess heat generation. In some exemplary embodiments, sensors or software tools (e.g., task manager) may identify idle usage periods associated with the electronic components (e.g., electronic component 110 in Fig. 1C) and send idle usage period information to processor (e.g., processor 152 of Fig. 1A). Processor (e.g., processor 152 in Fig. 1A) may determine that a frequency cap by shifting workload from peak usage periods to idle usage periods. In some disclosed embodiments, the at least one operating frequency cap is further based on an amount of time taken to shift from the peak usage periods to the idle usage periods. For example, processor may shift workload from peak usage periods to idle usage periods. An amount of time taken to shift from the peak usage periods to the idle usage periods may refer to the amount of time or clock cycles required to shift from the peak usage period to the idle usage period. For example, if the amount of time taken to shift from the peak usage period to the idle usage period is large, a frequency cap may be increased. The processor of the system may determine the frequency cap based on the amount of time taken to shift the workload from the peak usage periods to the idle usage periods. In some exemplary embodiments, processor (e.g., processor 152 of Fig. 1A) may determine amount of time taken to shift from the peak usage periods to the idle usage periods associated with the electronic component (e.g., 110 in Fig. 1C) and determine the operating frequency accordingly. By way of non-limiting example, the processor (e.g., processor 152 of Fig. 1A) may determine the operating frequency cap to have a shorter amount of time to shift from the peak usage period to the idle usage period.
[12] Some disclosed embodiments involve the at least one operating frequency cap that is a single common operating frequency cap applied to each of the plurality of heat-generating electronic components. A single common operating frequency cap refers to one frequency cap of a same value for each heat-generating electronic component. Rather than multiple frequency caps, a single operating frequency cap may be calculated based on the aggregate heat output of the plurality of heat-generating electronic components. For example, in a multi-heat-generating electronic component system (e.g., multiple CPUs), the processor (e.g., processor 152 of Fig. 1A) may set every heat-generating electronic component (e.g., electronic component 110 in Fig. 1C) at the same frequency cap (e.g., 80% of 4 GHz or 3.2 GHz). Alternatively, in some disclosed embodiments, the at least one operating frequency cap may include a plurality of different operating frequency caps for application to differing ones of the plurality of heat-generating electronic components. A plurality of different operating frequency caps for application to differing ones of the plurality of heat-generating electronic components refers to frequency caps of different values applied to different heat-generating electronic components. By determining different frequency caps targeted towards different electronic components, excess heat generated by the system may decrease because the frequency cap is individualized to each electronic component. For example, in a multi-heat-generating electronic component system (e.g. multiple CPUs), the processor (e.g., processor 152 of Fig. 1A) may set every heat-generating electronic component (e.g., electronic component 110 in Fig. 1C) at a different frequency cap (e.g. electronic component A at 80%, electronic component B at 90%, electronic component C at 85%). In some embodiments, the different frequency cap may be set based on the operation that an electronic component is performing at a time. In some embodiments, the different frequency cap may be set based on time to completion of a task. For example, electronic components A and B may be sharing workload and the processor may determine that component A has almost completed its share of the task while component B is only halfway done, and based on this information may apply different frequency caps on components A and B, for example, so that both component finish their tasks at about the same time.
[13] In some disclosed embodiments, the at least one processor is further configured to change the plurality of operating frequency caps dynamically over time. Changing refers to altering or modifying. For example, the processor may change the frequency caps depending on properties (e.g., idle time, utilization) of the system or heat-generating components (e.g., voltage consumed, current consumed). Dynamically refers to continuously, actively, or progressively. Dynamically may refer to a process that occurs or changes in real-time, for example, in response to immediate conditions or external stimuli. Dynamic changes may relate to adaptability, flexibility, and the ability to modify or adjust actions, settings, or parameters on the fly, rather than relying on pre-defined or static configurations. In some embodiments, a dynamic change may be characterized by continuous movement, evolution, or adjustment in a manner that is not fixed or predetermined. For example, the processor may dynamically change the frequency cap to adapt to changing system properties (e.g., idle time, utilization) or heat-generating component properties (e.g., voltage consumed, current consumed). Change the plurality of operating frequency caps dynamically over time involves adapting the frequency caps to properties (e.g., idle time, utilization) as the system runs, with respect to time. For example, frequency caps may be variable, such that they are not fixed to a particular value. Frequency caps may be changed dynamically over time, over a time duration or along with clock cycles. By way of non-limiting example, a CPU may operate at 90% capacity and complete its workload in 0.5 seconds, idling for another second. During the first 0.5 second, the CPU working at 90% capacity may have generated 1.5x the amount of heat than it would have when operating at 80% capacity and then idled. In this instance, the processor (e.g., processor 152 of Fig. 1A) may set the frequency cap of the CPU at 80%. However, in later clock cycles, the CPU may operate at 85% capacity and complete its workload in 0.5 seconds, idling for another second. During the first 0.5 second, the CPU working at 85% capacity may have generated 1.5x the amount of heat than it would have when operating at 70% capacity and then idled. In this instance, the processor (e.g., processor 152 of Fig. 1A) may change the frequency cap of the CPU to 70%. By dynamically changing the frequency caps with time, excess heat generated by the system may decrease because the frequency cap adjusts to the conditions of the system.
[14] In some disclosed embodiments the values of the differing operating frequency caps depend on heat-generating electronic component type. Heat-generating electronic component type refers to the kind, classification, variety, class, or model of the heat-generating electronic component. Each type may have its own heat and operational profiles, and the caps may therefore vary based on type. Electronic components perform a wide range of functions within the system, such as, for example, computing, graphics processing, memory, power delivery, amplification, switching, filtering, and signal processing. In some embodiments, the electronic components that perform a particular function may be classified as one type, and electronic components that perform another function may be classified as another type. Non-limiting examples of heat-generating electronic component types include integrated circuit, microchip, or semiconductors, as described and exemplified elsewhere. Type may alternatively or additionally refer to assigned tasks. Two instances of the same model CPU, for example, may be classified differently if one is assigned a highly processor intensive task (such as graphics processing) while the task of the other is less processor intensive. Values of the differing operating frequency caps refers to a measure of extent of operation. For example, the values may correspond to the frequency of or percentage of the maximum frequency the frequency caps. For example, the value of an operating frequency cap may be 3.6 GHz or 90% the frequency capacity (e.g., 90% of 4.0 GHz). As various electronic component types serve different roles and functions, the heat-generating electronic components may have different properties (e.g., idle time, utilization), thus requiring different operating frequency caps to optimize efficiency. In some exemplary embodiments, the processor (e.g., processor 152 of Fig. 1A) may determine the frequency caps based on the electronic component (electronic component 110 as in Fig. 1C) type (e.g., CPU). For example, a CPU may handle tasks required for software on the server to run correctly, while a GPU may support the CPU to perform concurrent calculations. Accordingly, the GPU may be able to complete simple and repetitive tasks faster than the CPU. Depend on refers to contingent, determined, or decided by. For example, to maximize efficiency, the values of differing frequency caps depend on heat-generating electronic component type. Since, for example, a CPU and GPU serve different functions and require different workloads, frequency caps may depend on properties (e.g., voltage consumed, current consumed) of the electronic component type (e.g., CPU). Determining the operating frequency cap based on the electronic component type may allow for greater efficiency and less unnecessary heat. In an exemplary embodiment, the processor (e.g., processor 152 of Fig. 1A) may determine the electronic component type (e.g., CPU or GPU) and determine the frequency caps based on the electronic component type (e.g., CPU or GPU). By way of non-limiting example, the processor (e.g., processor 152 of Fig. 1A) may set the frequency cap of a CPU at 3.6 GHz and the frequency cap of a GPU at 3.4 GHz, to account for the differing functions and properties of the CPU and GPU.
[15] In some disclosed embodiments, the at least one operating frequency cap is determined based on heat-generating electronic component idle time and utilization. As described and exemplified previously, idle time refers to a time or amount of time that a device or component is not being used despite being available to be used. For example, idle time of a heat-generating electronic device may be when the device has performed a task and is waiting to receive another order to perform another task. Utilization, as described and exemplified elsewhere herein, refers to how often, the purpose of, by what, and how much a device or component is used. The frequency cap may be determined based on heat-generating electronic component idle time and utilization to reduce workload of the processor (e.g., CPU) thereby avoiding an inefficient operating range for the CPU where disproportional heat is generated. In some exemplary embodiments, a processor (e.g., processor 152 of Fig. 1A) may determine the idle time and utilization of the electronic components (e.g., electronic component 110 in Fig. 1C). The processor (e.g., processor 152 of Fig. 1A) may determine the operating frequency cap based on idle time and utilization information of the electronic component (e.g., electronic component 110 in Fig. 1C). By way of non-limiting example, a CPU may operate at 90% capacity and complete its workload in 0.5 seconds, idling for another second. During the first 0.5 second, the CPU working at 90% capacity may have generated 1.5x the amount of heat than it would have when operating at 80% capacity and then idled. In this instance, the processor (e.g., processor 152 of Fig. 1A) may set the frequency cap of the CPU at 80%.
[16] In some disclosed embodiments, the at least one operating frequency cap is based on an amount of idle time for a particular one of the plurality of heat-generating electronic components. Amount of idle time for a particular one of the plurality of heat-generating electronic components refers to a quantity of time a single heat-generating electronic component is idle (e.g., amount of time a device is not being used despite being available to be used). For example, frequency caps may be based on an amount of idle time of an electronic component. In some exemplary embodiments, a processor (e.g., processor 152 of Fig. 1A) may determine the idle time for a particular electronic component (e.g., electronic component 110 in Fig. 1C). The processor (e.g., processor 152 of Fig. 1A) may determine the operating frequency cap based on the idle time of the electronic component (e.g., electronic component 110 in Fig. 1C). By way of non-limiting example, a CPU may complete its workload in 0.5 seconds, idling for another second. In this instance, the processor (e.g., processor 152 of Fig. 1A) may lower the frequency cap of the CPU to reduce excess heat generation.
[17] In some disclosed embodiments, when the utilization exceeds a threshold, the at least one processor is configured to increase the at least one operating frequency cap. A threshold refers to a boundary and/or limit. In some embodiments, a threshold may be an upper threshold restricting exceeding of the upper threshold. In some embodiments, a threshold may be a lower threshold restricting decreasing below the lower threshold. In some embodiments, a threshold may refer to a range and include an upper threshold and a lower threshold. In some embodiments, a threshold may be associated with a tolerance permitting minor aberrations to the threshold. Exceeding a threshold refers to surpassing and/or breaking through a threshold. For example, if utilization reaches an upper threshold, the frequency cap may be increased to compensate for the high usage. Utilization exceeds a threshold refers to utilization, as described and exemplified elsewhere herein, exceeding a threshold. For example, if heat-generating component usage is greater than a predetermined threshold, the processor may be configured to increase the at least one operating frequency cap. Stated another way, when the utilization exceeds a threshold (e.g., voltage consumption, current consumption), the processor may be configured to increase the operating frequency cap (e.g., upper limit on the workload of the processor). Increasing the at least one operating frequency cap may avoid operating at an inefficient operating range for the processor where disproportional heat is generated. In an exemplary embodiment, the processor (e.g., processor 152 of Fig. 1A) may determine that the utilization of the electrical component (e.g., electrical component 110 of Fig. 1C) exceeds a threshold and the processor (e.g., processor 152 of Fig. 1A) may increase the operating cap accordingly. For example, the current consumption of the electrical component (e.g., electrical component 110) may be greater than an upper limit and the processor may increase the operating frequency cap to compensate.
[18] Disclosed embodiments involve outputting at least one cap signal to the at least one of the plurality of heat-generating electronic components, wherein the at least one cap signal is configured to limit the associated operating frequency of the at least one of the plurality of electronic components to the operating frequency cap. A cap signal refers to an instruction or a signal from an electronic component (e.g., the processor or a controller) to another electronic component. For example, a cap signal may be sent from a processor to an electronic component to change or adjust its frequency cap. For example, the cap signal may be an instruction from a processor to change cap frequency from one value (e.g., 3.6 GHz (90%) capacity) to another value (e.g., 3.2 GHz (80% capacity)). Outputting at least one cap signal to the at least one of the plurality of heat-generating electronic components refers to the processor sending at least one cap signal to one or more electronic components. One cap signal may be sent to one, a group of, or all heat-generating electronic components. Further, different cap signals may be sent to different electronic components. Limit refers to restricting, regulating, controlling, or restraining. For example, the at least one cap signal may be configured to regulate or restrict the operating frequency of at least one electronic component. Limit the associated operating frequency of the at least one of the plurality of electronic components may involve sending a cap signal to a =electronic component to lower or regulate the operating frequency of at least one of the electronic components. For example, the cap frequency of a heat-generating electronic device may be changed from 3.6 GHz (90%) capacity to 3.2 GHz (80% capacity). It is to be appreciated the cap signal may be sent to each of, a group of, or all heat-generating electronic components to change the frequency cap. In some exemplary embodiments, the processor (e.g., processor 152 of Fig. 1A) may output a cap signal to the electronic components (e.g., electronic component 110 of Fig. 1C) to limit the operating frequency of at least one electronic component. By way of non-limiting example, the cap signal sent by the processor (e.g., processor 152 of Fig. 1A) may be configured to limit the operating frequency cap of the electronic components (e.g., electronic component 110 of Fig. 1C), such as changing the cap frequency from 3.6 GHz (90% capacity) to 3.2 GHz (80% capacity).
[19] In some disclosed embodiments, a plurality of cooling devices are associated with each of the plurality of heat-generating electronic components, and the at least one processor is configured to simultaneously control the plurality of cooling devices. A cooling device refers to an apparatus configured to expel heat. For instance, a cooling device may draw heat away from an electronic component. Further, a cooling device may evacuate heat from the electronic components and maintain an operating temperature range. Non-limiting examples of cooling devices may include a fan, a heat exchanger, an air conditioner, a refrigerator, a heat pump, and/or a coolant bath and/or pool. Another example of a cooling device is an ENE, as described and exemplified elsewhere herein. Cooling devices associated with each of the plurality of heat-generating electronic components refer to cooling devices that are configured to cool the plurality of electronic components. For example, cooling devices associated with electronic components may refer to one or more components or a system that is configured to dissipate the heat generated by the electronic components during operation. These associated cooling devices may be positioned near, coupled to, or positioned far from the electronic components. In some embodiments, a single cooling device or a plurality of cooling devices may be configured to cool multiple electronic components. In some embodiments, separate cooling devices may be applied to each electronic component, allowing each component to be cooled separately. In some embodiments, a single cooling device may cool multiple electronic components Non limiting examples of a cooling device include a heat sink, a fan, a liquid cooling system, thermal paste, thermal interface material, heat pipe, a Peltier cooler, a vapor chamber, a phase change cooler, and an air duct. Control refers to controlling, as described and exemplified elsewhere herein. For example, a system may control the operating frequencies of electronics, thereby managing excess heat generation. Simultaneously control refers to controlling at the same time. For example, processor may control multiple cooling devices at the same time. For example, cooling devices associated with each electronic component may allow for simultaneous cooling of different components operating at differing working loads and generating different amounts of heat. For example, each individual cooling device may evacuate an amount of heat substantially corresponding to an amount of heat generated by the associated solid-state electronic component, allowing to simultaneously cool differing components operating with differing workloads and generating differing amounts of heat to a substantially uniform temperature. Processor may be configured to control the plurality of cooling devices associated with the heat-generating electronic components, where at least one processor is configured to simultaneously control the plurality of cooling devices.
[20] By way of non-limiting example, Fig. 1A shows an exemplary system 140. System 140 may comprise a plurality of heat-generating electronic components 110 (as seen in Fig. 1C). A plurality of cooling devices (e.g., pool 116) may be associated with each heat-generating electronic component 110. As described and exemplified elsewhere herein, pool 116 may include a region for holding a volume of liquid coolant. Processor 152 may be configured to simultaneously control the plurality of cooling devices (e.g., pool 116). In some cases, HRU 142 may include multiple pumps 146, and processor 152 may control the multiple pumps (e.g., to reduce and/or increase the pump RPM) in a staggered manner (e.g., round robin). For example, the processor 152 may increase or decrease the pump 146 speed (e.g., RPM, stop time, start time, idle time), controlling an amount or rate of liquid coolant delivered to ENEs 100,
[21] In some disclosed embodiments, the plurality of cooling devices is configured for two-phase cooling using a coolant. Coolant refers to a substance used for reducing or regulating the temperature of a system, as exemplified elsewhere herein. For example, coolant may be a non-aqueous non-electrically conductive material to prevent damage to computer components being cooled using the coolant. used to reduce or regulate the temperature of a system. Two-phase cooling refers to coolant transitioning between two phases (e.g., liquid and vapor), as exemplified elsewhere herein. For example, two-phase cooling may involve streaming liquid, non-aqueous coolant directly to at least one heat-generating electronic component for on-site cooling. Heat from the at least one electronic component may convert a portion or all of the liquid coolant to vaporized coolant. In some embodiments, the coolant is a dielectric coolant. Dielectric coolant refers to coolant, as described and exemplified elsewhere herein, that is insulating and does not conduct electricity or electrical current. For example, dielectric coolant may help reduce or regulate temperature of the system by transferring heat from the heat source to the coolant, carrying the heat to a different location, and releasing the carried heat into another medium. In some embodiments, the cooling devices may be configured for two-phase cooling using a dielectric coolant.
[22] By way of non-limiting example, in Fig. 1A, system 140 may include HRU 142 flow-connected via RDU 144 to at least one ENE 100 (e.g., a two-phase cooling chamber) on a server rack shelf 154. Plurality of cooling devices (e.g., pool 116) may be configured for two-phase cooling using a coolant. System 140 may stream a coolant in a first phase such as a liquid directly to at least one electronic component (e.g., electronic component 110 in Fig. 1C) for on-site cooling. Heat from at least one electronic component (e.g., electronic component 110 in Fig. 1C) may convert a portion or all of the liquid coolant to a second phase such as vaporized coolant. As described above. system 140 may include at least one pump 146 for circulating liquid and/or coolant (e.g., dielectric coolant) through one or more components of system 140.
[23] In reference to Fig. 1C, ENE 100 includes liquid coolant inlet 128 integrated with chamber 102 (see Fig. 1B). Liquid coolant inlet in the chamber 128 may supply liquid coolant to pool 116 (see Fig. 1B). to thereby enable pool boiling of the liquid coolant and conversion of the liquid coolant into vaporized coolant. For instance, one or more pumps associated with a reservoir storing cool liquid coolant may supply cool liquid coolant to ENE 100 via liquid coolant line 120. The cool liquid coolant may flow through liquid coolant line 120 via liquid coolant inlet 128 into chamber 102, where the liquid coolant may collect in pool 116. As shown in Fig. 1C, vapor outlet 130 may be integrated with chamber 102 for evacuating vaporized coolant from chamber 102. In some disclosed embodiments, the at least one processor is further configured to control a pump delivering the coolant to the plurality of cooling devices. A pump refers to an electro-mechanical device, as described and exemplified elsewhere herein. In some embodiments, the pump may use suction and/or pressure to deliver a liquid coolant. For example, one or more pumps may move the liquid coolant from a reservoir associated with a condenser to the plurality of cooling devices. Further, a pump may be used to maintain a pressure differential and be used in conjunction with a valve for preventing reverse flow of liquid coolant. Processor may be configured to control a pump refers to the processor having the ability to send a signal or command the pump to perform a task or operation. For example, processor may receive information from a pump or pumps, such as an outlet liquid pressure, an RPM, and liquid availability to a pump suction port, and send a command back to the pump to increase or decrease outlet liquid pressure or RPM. In some cases, system may include multiple pumps, and processor may control the multiple pumps (e.g., to reduce and/or increase the pump RPM). In an exemplary embodiment, sensors may receive information from a pump configured to deliver coolant, and the processor (e.g., processor 152 in Fig. 1A) may be configured to control a pump (e.g., pump 146 in Fig. 1A) delivering the coolant to the cooling devices.
[24] By way of non-limiting example, in Fig. 1A, system 140 may include at least one processor 152 configured to monitor and/or control pump (e.g., pump 146) delivering coolant to the cooling devices (e.g., pool 116 in Fig. 1B). Processor 152 may receive multiple signals from pump 146, such as an outlet liquid pressure, an RPM, and liquid availability to a pump suction port. In some embodiments, processor 152 may detect that liquid is available at the suction port, determine that an increase in pump RPM does not result in an increase in outlet liquid pressure, and to prevent pump burnout, processor 152 may output a signal to decrease the pump RPM. For example, processor 152 may cause pump 146 to idle, e.g., in a gradual transition and/or one or more step functions. Following causing the pump RPM to decrease, processor 152 (e.g., based on receiving additional signals) may cause the pump RPM to increase (e.g., gradually). In some cases, HRU 142 may include multiple pumps 146, and processor 152 may control the multiple pumps (e.g., to reduce and/or increase the pump RPM) in a staggered manner (e.g., round robin). In some embodiments, processor 152 may receive a measure of power drawn by electronic components 110 cooled by ENEs 100 over a time period, as well as a measure of liquid coolant flowing through ENEs 100 during the same time period (e.g., based on an RPM of pump 146).
[25] Consistent with some embodiments, Fig. 9A illustrates exemplary measurements obtained by one or more sensors configured with two-phase cooling system 140, and which may be used by processor 152 to dynamically control (e.g., a frequency cap) of one or more heat-generating electronic components 110.
[26] In some disclosed embodiments, each of the plurality of cooling devices includes a valve for controlling an output vapor flow, and wherein the at least one processor is further configured to control each valve, thereby controlling vaporized coolant exiting each of the plurality of cooling devices. A valve refers to a mechanical (or electro-mechanical) device for controlling passage of gas and/or liquid. In some examples, a valve may be an automatic device allowing for movement only in one direction, such as output vapor flow from the chamber. For example, a controllable valve may be associated with a vapor line, permitting a processor to control the pressure inside the chamber and thereby controlling the boiling temperature of the coolant. Vapor flow refers to movement of stream of vapor. For example, vapor flow may refer to vapor traveling from one location to the next with an associated flow rate or pressure. Output vapor flow refers to vapor flow leaving a location, region, or device. For example, cooling devices may have an output vapor flow. Controlling an output vapor flow refers to controlling, as described and exemplified elsewhere herein, the output vapor flow. For example, valve may be configured to restrict vapor flow when the chamber surpasses a threshold and/or limit, such as a chamber temperature or level. Each cooling device may include a valve for controlling an output vapor flow and the processor may be configured to control each valve, thus controlling vaporized coolant exiting of the cooling devices.
[27] By way of non-limiting example, in Fig. 14E shows a cross-section of ENE 100 (as shown in Fig. 1B). Liquid coolant may enter the chamber 102 via liquid coolant inlet line 120 and liquid coolant port 120. Liquid coolant may enter the chamber 102 and accumulate in pool 116. Valve 1402 may be configured with vapor outlets of ENEs 100, thereby controlling vaporized coolant exiting the cooling device (e.g., pool 116). Processor (e.g., processor 152 in Fig. 1A) may transmit one or more cap signals to valve 1402 thereby controlling vaporized coolant exiting the cooling device (e.g., pool 116). Processor (e.g., processor 152 in Fig. 1A) may send signals for valve to open or close based on sensor information (e.g., RPM, flow rate).
[28] In some disclosed embodiments, the at least one processor is further configured to control an inflow of water for cooling the vaporized coolant, thereby controlling a heat transfer rate between the vaporized coolant and the water. Inflow refers to arrival of, flowing in, or amount or rate of flowing in. For example, a cooling device may have an inflow of water for cooling the vaporized coolant. Controlling an inflow of water refers to controlling the flow of water from a reservoir and/or facility water supply. For example, water inflow may be controlled via a valve. Heat transfer rate refers to the rate of the movement of heat from one substance to another. Heat transfer rate is proportional to the temperature difference between two substances and total thermal resistance between two substances. For example, the higher the heat transfer rate, the easier heat is transferred between two substances. By controlling the inflow of water for cooling the vaporized coolant, a heat transfer rate may be maintained between vaporized coolant and water. The processor may control an inflow of water for cooling the vaporized coolant, thereby controlling a heat transfer rate between the vaporized coolant and the water. By controlling the inflow of water for cooling the vaporized coolant, the heat transfer rate between the vaporized coolant and water may be controlled. For example, with reference to Fig. 14E, processor (e.g., processor 152 in Fig. 1A) may transmit one or more signals to a controllable valve (e.g., valve 1402 in Fig. 14E) located on a liquid coolant inlet line 120 supplying liquid coolant to a two-phase pulse evaporator enclosure causing the controllable valve 1402 to open, close, and/or partially obstruct, thereby regulating liquid coolant flow into the enclosure and to the inner surface of the base plate therein. As another example, at least one processor may transmit one or more signals to a controllable valve (e.g., valve 1402 in Fig. 14E) located on a vapor outlet line of a two-phase pulse evaporator enclosure causing the controllable valve (e.g., valve 1402 in Fig. 14E) to open, close, and/or partially obstruct, thereby regulating a vapor outflow from the two-phase pulse evaporator enclosure. This may affect vapor pressure and/or temperature inside the two-phase pulse evaporator enclosure, which may affect a heat transfer rate and the level of coolant in a pool 116 therein.
[29] In some disclosed embodiments, a load balancer is configured to allocate the workload amongst the plurality of heat-generating electronic components. A load balancer refers to a device, an electronic component, or a software module that manages and/or distributes workload between the heat-generating electronic components. For example, the frequency cap may involve load balancing and operation scheduling, preventing the processor (e.g., CPU) from working at full capacity and then idling. Allocating the workload refers to distributing or assigning the workload. For example, the processor may allocate the workload to the heat-generating electronic components, such that each heat-generating electronic component shares the total workload. Workload may or may not be allocated evenly between heat-generating electronic components. The load balancer may allocate or divide the workload amongst the electronic components. In an exemplary embodiment, an individual CPU may reach 4 GHz at 100% (full) capacity. The load balancer may distribute a task among three processors, with two CPUs operating at 60% capacity (2.4 GHz), taking one second to complete their portion of the workload. The third CPU may operate at 90% capacity (3.6 GHz), and complete its workload in only 0.5 second, idling for another 0.5 second. In this instance, during the first 0.5 second, the CPU working at 90% capacity (3.6 GHz) may have generated 1.5x the amount of heat than it would have when operating at 80% capacity (3.2 GHz), and then idled-which is inefficient and generates unnecessary heat. Therefore, the processor (e.g., processor 152 in Fig. 1A) may set frequency cap of the third CPU should be set at 80% (3.2 GHz), the upper limit of the workload limit. In this instance, the CPU may take longer to complete an operation, but generates less heat.
[30] In some embodiments, for the operating frequencies above which each electronic component experiences a heat-related degradation, the at least one processor is configured to impose an operational limit on an associated operating frequency. Heat-related degradation refers to a process where heat or elevated temperature on material causes a loss of physical, mechanical, or electrical properties. Heat-related degradation may refer to a decrease in performance (e.g., speed), lifetime, or reliability of an electronic component. Heat-related degradation may occur at an ineffective range of operating frequencies. For example, CPUs that work at 100% frequency can use more than 4x more power than CPUs operating at 50% frequency and may accordingly generate 4x more heat. The generation of extra heat may cause a loss of physical, mechanical, or electrical properties of the electronic component. Operational limit refers to the extent and/or boundaries the electronic component can operate and/or work. For example, CPU operational limit may be set at the maximum frequency before heat-related degradation occurs, limiting the frequencies to an effective range. Imposing an operational limit refers to forcing, inflicting, or causing an operational limit. For example, the processor may impose an operational limit on an associated operating frequency to prevent heat-related degradation. For operating frequencies above which each clectronic component experiences a heat-related degradation, the processor may be configured to impose an operational limit on a heat-generated electronic component's associated operating frequency. For example, processor may be configured to determine operating frequencies above which an electronic component (e.g., electronic component 110 in Fig. 1C) experiences a heat-related degradation and impose an operational limit accordingly. In some exemplary embodiments, processor (e.g., processor 152 in Fig. 1A) may be configured to impose an operational limit on an associated operating frequency according to the operating frequency above which each electronic component (e.g., electronic component 110 in Fig. 1C) experiences a heat-related degradation. If the processor 152 determines pool 116 experiences a heat-related degradation at 3.6 GHz, the processor 152 may impose an operational limit of 3.6 GHz.
[31] In some disclosed embodiments, the at least one operating frequency cap is associated with the operating limit. Being associated with the operating limit refers to depending on or correlated with the operational limit. For example, the frequency cap may be set at the operational limit to limit frequencies to an effective range. The at least one operating frequency cap may be associated with the operating limit. In other embodiments, the at least one operating frequency cap is less than the operational limit. Less than the operational limit refers to a frequency less than the maximum operational limit. For example, processor (e.g., processor 152 in Fig. 1A) may determine operating limit of electronic component (e.g., electronic component 110 of Fig. 1C). If the electronic component 110 maximum operational limit is 4.0 GHz, the frequency cap may be less than the maximum operational limit value (e.g., set at 3.6 GHz). Setting the operating frequency cap less than the operational limit helps avoid operating at an inefficient operating range where disproportionate heat is generated.

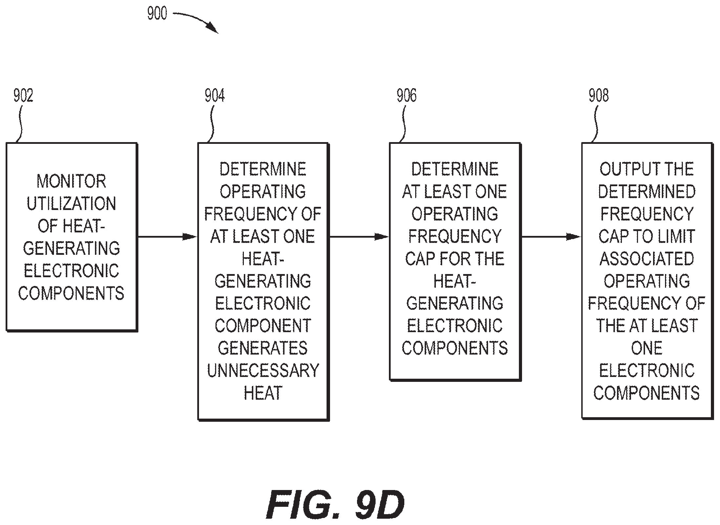

By way of non-limiting example, Fig. 9D is a flow chart of an exemplary method 900 for controlling electronics operating frequencies for regulating heat generation, according to disclosed embodiments. Method 900 may monitor utilization of heat-generating electronic components 902. Method 900 may determine that the determine that the associated operating frequency of at least one of the plurality of heat-generating electronic components cooperating to accomplish a shared workload, is greater than necessary to accomplish the shared workload within a predefined timeframe, and therefore generating unnecessary heat 904. Method 900 may determine at least one operating frequency cap for the at least one of the plurality of heat-generating electronic components, wherein the at least one operating frequency cap is determined to enable the plurality of heat-generating electronic components to accomplish the workload while controlling aggregate heat output of the plurality of heat-generating electronic components 906. Method 900 may output at least one cap signal to the at least one of the plurality of heat-generating electronic components, wherein the at least one cap signal is configured to limit the associated operating frequency of the at least one of the plurality of electronic components to the operating frequency cap 908.

In some disclosed embodiments, heat generated by a plurality of heat-generating electronic components may be used by a facility, such as an office (e.g., for a server farm) and/or institution. For example, the heat may be transferred to water, which may flow to a facility in a closed water loop. However, for efficient heat reuse capability, the water may need to reach a minimal temperature threshold. Systems and methods are disclosed for achieving a high degree of control over a cooling system for a plurality of heat-generating electronic components. This may permit use of the heat to precisely control water temperature in an associated facility's water supply, and may permit achieving a minimal water temperature threshold associated with efficient heat reuse.

Some disclosed embodiments involve a system for achieving a target water temperature in a facility where water is used as part of a process for electronics cooling. Water refers to a substance composed of the chemical elements hydrogen and oxygen. In some embodiments, water may include additional minerals, such as but not limited to, calcium, magnesium, sodium, fluoride, potassium, and/or chlorine. Water may exist in gaseous, liquid, and/or solid states. Temperature refers to an indication of hotness or coldness and may be measured in degrees (e.g., Celsius, C, Fahrenheit, F, or Kelvin, K). A difference in temperature (e.g., a temperature gradient) may indicate a direction of heat flow from a hotter body thermally coupled to a colder body. Water temperature refers to a physical property indicating how much kinetic energy is contained in a volume and/or flow of water, and may indicate relative hotness or coldness of a volume of water. A target water temperature refers to an intended, desired, recommended, and/or advised water temperature. For example, a target water temperature may correspond to energy needed to provide heat to a facility. Providing water below a target water temperature may be associated with an inefficient heat reuse capability, whereas providing water at or above the target water temperature may improve efficiency for the heat reuse capability. A process for electronics cooling refers to a method and/or technique for removing and/or conveying heat away from one or more electronic components. A facility where water is used as part of a process for electronics cooling refers to an area and/or site where water may be thermally coupled to a plurality of heat-generating electronic components to remove heat therefrom. For example, a plurality of heat-generating electronic components may generate a significant quantity of heat. Failure to remove this heat from the electronic components may result in overheating and/or break-down of the electronic components, leading to performance degradation, and/or risks to safety. Including water in a process for electronics cooling may enable transferring at least some of the heat to the water, thereby cooling the heat-generating electronic components to ensure operation within a safe and/or efficient operating range.

Some disclosed embodiments involve a primary water loop including an output water line and an associated control valve. A water loop refers to one or more conduits for enabling liquid water to circulate therein. The conduits may include hollow structures such as pipes and/or tubes that are arranged to circulate water. For example, a water loop may include one or more pipes connected in a manner to enable a fixed volume of water to continually flow therethrough. Primary is understood to be distinct from secondary. For example, a primary water loop may include one or more distinct conduits, different than conduits included in a secondary two-phase loop. A control valve refers to a device configured to regulate, and/or control a fluid flow. For example, a control valve may open, close, and/or partially obstruct a passageway, to thereby control a fluid flow therein. Fully closing a control valve may cause a flow rate to become zero (e.g., no flow), fully opening a control valve may cause a flow rate to reach a maximum flow rate, and partially opening a control valve may cause a flow rate to range between zero and a maximum flow rate. A control valve of a primary water loop may permit regulating a flow of water therethrough. A primary water loop including an output water line refers to a portion within a water loop configured to convey water flow. For instance, an output water line of a primary water loop may deliver heat to a heat exchanger by conveying a flow of heated water. Upon transferal of heat from the water to the heat exchanger, the (e.g., cooled) water may circulate back through the water loop, for example, to absorb additional heat for continual heat transfer. In some embodiments, a first section of an output water line may deliver a flow of relatively cool water for thermal coupling to a heat source. The cool water may absorb heat from the heat source, exit from a second section of the output water line and flow to a location thermally coupled to a heat exchanger. Heat may transfer from the heated water to the heat exchanger, to produce a flow of relatively cool water. The relatively cooler water may circulate back to the first section of the output water line to enable a continual transfer of heat from the heat source to the heat exchanger using a fixed volume of water circulating through the water loop. A control valve associated with the output water line may regulate a flow rate of water therein to enable controlling a rate of heat transfer from the heat source to the heat exchanger. In some embodiments, a water loop may be additionally associated with one or more pumps for controlling a water flow (e.g., on/off) and/or flow rate and/or flow volume in the water loop.

By way of a non-limiting example, reference is made to Fig. 7, showing exemplary HRU 142 of two-phase cooling system 1100 thermally coupled to facility water system 700, consistent with some disclosed embodiments. HRU 142 may house a condenser 702. A primary water loop 712 may circulate water between condenser 702 and facility water system 700. Primary water loop 712 may include an output water line 706 and an associated control valve 704. For example, output water line 706 of primary water loop 712 may contain relatively hot water flowing from condenser 702 to facility water system 700 to permit heat transfer from the hot water to the facility water system 700. Relatively cool water may return to condenser 702 via a return line 714 of primary water loop 712. Control valve 704 may control a flow of relatively cool facility water towards condenser 702 via return line 714, thereby regulating a flow of relatively hot water flowing in output water line 706.

By way of another non-limiting example, reference is made to Fig. 11A, which is a schematic block diagram of a system 1100 for achieving a target water temperature in a facility where water is used as part of a process for electronic cooling, consistent with some disclosed embodiments. System 1100 may include primary water loop 712, indicated with a dashed line. Primary water loop 712 may circulate a flow of water between condenser 702 (e.g., included inside HRU 142) and facility water system 700. For example, relatively hot water may flow from condenser 702 to facility water system 700 via output water line 706. Upon arrival at facility water system 700, heat may flow from the relatively hot water to a heat exchange, causing the water in primary water loop 712 to cool. The relatively cool water may circulate back from facility water system 700 to condenser 702 via return line 714 of water loop 712, where the relatively cool water may absorb heat via condenser 702 for continual heat transfer.

Some disclosed embodiments involve a secondary two-phase loop. A phase refers to a state of a substance. For example, a substance may be in a solid, liquid, or gaseous phase. Absorption and/or removal of heat may cause a change of phase in a substance. For instance, removing latent heat from a substance in a gaseous phase (e.g., by condensing the substance) may cause the substance to transform to a liquid phase, and adding latent heat to a substance in a liquid phase may cause the substance to transform to a gaseous phase. A two-phase loop refers to one or more conduits configured to enable a fluid to circulate therethrough in a liquid phase, a gaseous phase, and/or a mixture of the liquid and gaseous phases. For example, a first section of a two-phase loop may be configured for a flow of liquid coolant and a second section of the two-phase loop may be configured for a flow of vaporized coolant. The first section may supply relatively cool liquid coolant for thermal coupling to a plurality of heat-generating electronic components. The relatively cool liquid coolant may absorb heat from the plurality of heat-generating electronic components (e.g., in a pool boiling process within chambers of a plurality of two-phase evaporators), causing the liquid coolant to boil and convert to a gaseous phase (e.g., as relatively hot vaporized coolant). The second section of the two-phase loop may convey the relatively hot vaporized coolant to a location thermally coupled to relatively cool water flowing in a water loop. Heat may transfer from the relatively hot vaporized coolant to the relatively cooler water, to produce heated water, as described earlier. This may cause condensation of the vaporized coolant to relatively cool liquid coolant. The relatively cool liquid coolant may circulate back through the first section of the two-phase loop to enable circulating coolant through the two-phase loop in both liquid and gaseous phases, and thereby continually cool the plurality of heat-generating electronic components.

In some embodiments, a two-phase loop may include different types of tubing for different sections thereof. For example, the first section of a two-phase loop configured for liquid coolant flow may include tubing designed and/or sized to accommodate coolant in liquid form, and the second section configured for vaporized coolant flow may include tubing designed and/or sized to accommodate coolant in vapor form. For instance, a cross section of tubing in the first section may be smaller than a cross section of tubing in the second section to accommodate the greater volume occupied by vaporized coolant than occupied by liquid coolant.

Some disclosed embodiments involve a plurality of two-phase evaporators, each two-phase evaporator configured for thermal contact with an associated one of a plurality of heat-generating electronic components. A two-phase evaporator refers a heat exchanger configured to absorb heat from a substance, typically a liquid, and evaporate it into a vapor. The term "two-phase" refers to the fact that the fluid undergoes both liquid and vapor phases during the heat transfer process. One example of a two-phase evaporator is an Enhanced Nucleation Evaporator (ENE), as described and exemplified elsewhere herein. Thermal contact refers to an arrangement and/or configuration enabling an exchange of energy through heat transfer. For example, placing a hot object in thermal contact with a cool object may allow thermal energy (e.g., heat) to transfer from the hot object to the cool object. In some embodiments, thermal contact may include physical contact (e.g., touching) between two objects. In some embodiments, two objects in thermal contact may be physically separated (e.g., non-touching). For example, the two objects may be sufficiently close to allow heat to transfer from a hotter body to a cooler body. A heat-generating electronic component refers to an electrical device that produces heat when operating. For example, a microprocessor, a graphics processor, and/or a memory chip may produce heat during operation. In some instances, a heat-generating electronics component may be associated with an operating temperature range. Maintaining an environment within an operating temperature range for a plurality of electronic components may allow the electronic component to operate safely and meet one or more efficiency standards. Conversely, allowing the temperature of the environment to exceed the operating temperature range may lead to safety hazards (e.g., fire, smoke, explosion), degraded performance, and/or failure of the heat-generating electronic components. A two-phase evaporator configured for thermal contact with a heat-generating electronic component refers to a heat exchanger configured to be positioned in proximity to a heat-generating electronic component in a manner enabling heat transfer therebetween. For example, a two-phase evaporator may include a heat-conducting plate, base, and/or wall configured for mounting on a surface of an electronic component (e.g., using one or more screws and/or a heat conductive adhesive). Heat generated by the electronic component may be conducted through the heat-conducting wall of the two-phase evaporator and transfer to liquid coolant contained in a pool therein, to cool the electronic component and ensure operation within an operating temperature range. A plurality of two-phase evaporators, each two-phase evaporator configured for thermal contact with an associated one of a plurality of heat-generating electronic components refers to multiple two-phase evaporators, each thermally coupled to a different electronic component (or to a different group of electronic components) to enable concurrent transfer of heat from the plurality of electronic components to liquid coolant contained in each of the two-phase evaporators. The heat transfer may cause the liquid coolant to boil and convert to vaporized coolant.

For example, a server farm may include a plurality of heat-generating electronic components. Each heat-generating electronics component may be thermally coupled to a heat conducting wall of a different two-phase evaporator. One or more pumps may deliver cool liquid coolant into a chamber of each of the two-phase evaporators via a plurality of liquid coolant inlet lines. The liquid coolant in each chamber may absorb heat generated by an associated electronic component and conducted via the heat conducting wall, which may convert the coolant to relatively hot vaporized coolant. The vaporized coolant may be evacuated away from each two-phase evaporator via a plurality of vapor coolant outlet lines, to thereby cool the plurality of electronic components.

By way of a non-limiting example, in Fig. 11A, system 1100 may include a secondary two-phase loop 1112. Secondary two-phase loop 1112 may include a liquid coolant portion 1114, indicated with a solid line, and a vapor coolant portion 1116, indicated with a dotted line. Secondary two-phase loop 1112 may include a plurality of two-phase evaporators (e.g., ENEs 100). Each two-phase evaporator may be configured for thermal contact with an associated heat-generating electronic component 110. For example, each ENE 100 may be attached to heat-generating electronic component 1118 using one or more screws and/or heat-conductive adhesive, as shown in Fig. 1C. Liquid coolant portion 1114 of two-phase loop 1112 may convey a flow of liquid coolant from condenser 702 to each ENE 100 and vapor coolant portion 1116 of two-phase loop 1112 may convey a flow of vaporized coolant from each ENE 100 to condenser 702.

Some disclosed embodiments involve a plurality of liquid coolant inlet lines for delivering liquid coolant to the plurality of two-phase evaporators. Liquid coolant refers to coolant, as described and exemplified elsewhere herein, in a liquid phase. For example, a condenser may convert coolant in a gaseous phase to a liquid phase, and boiling may convert coolant in a liquid phase to a gaseous phase. Delivering refers to conveying, transporting, and/or providing. A liquid coolant inlet line refers to a channel, tube, and/or conduit for conveying coolant in a liquid phase. For example, each two-phase evaporator may be associated with a liquid coolant inlet line fluidly coupling the respective two-phase evaporator to a reservoir storing a volume of liquid coolant. One or more pumps may propel liquid coolant from the reservoir through each liquid coolant line to supply a flow of liquid coolant to each of the two-phase evaporators.

Some disclosed embodiments involve a plurality of vapor coolant outlet lines for evacuating vaporized coolant from the plurality of two-phase evaporators. Vapor coolant refers to coolant, as described and exemplified elsewhere herein, in a gaseous phase. Evacuating refers to removing, expelling, and/or transferring. A vapor coolant outlet line refers to a channel, tube, and/or conduit for conveying coolant in a gaseous phase. For example, each two-phase evaporator may include a chamber, and may be associated with a vapor coolant outlet line fluidly coupling the chamber to a condenser. As liquid coolant boils inside the chamber and becomes vaporized coolant, the vapor pressure inside the chamber may increase, causing at least some of the vaporized coolant to exit via the associated vapor coolant outlet line. In some embodiments, one or more valves may be provided to regulate one or more of a flow, pressure, and/or temperature of vaporized coolant flowing through each vapor coolant outlet line.

By way of a non-limiting example, in Fig. 11A, secondary two-phase loop 1112 may include a plurality of liquid coolant inlet lines 1120. For example, liquid coolant inlet lines 1120 may be included in liquid coolant portion 1114 of secondary two-phase loop 1112. Liquid coolant inlet lines 1120 may deliver liquid coolant to the plurality of two-phase evaporators (e.g., ENEs 100). In some embodiments, each liquid coolant inlet line 1120 may deliver liquid coolant to each ENE 100 via an associated liquid coolant inlet 128 (see Fig. 1C). Secondary two-phase loop 1112 may include a plurality of vapor coolant outlet lines 1122 for evacuating vaporized coolant from the plurality of two-phase evaporators. For example, vapor coolant outlet lines 1122 may be included in vapor coolant portion 1116 of secondary two-phase loop 1112. In some embodiments, each of vapor coolant outlet lines 1122 may connect to each ENE 100 via vapor outlet 130 (see Fig. 1C).

Some disclosed embodiments involve a condenser having a condenser inlet for flow connection to the plurality of vapor coolant outlet lines and being configured to convert the vaporized coolant into the liquid coolant. A condenser refers to a heat exchanger configured to transform a substance in a gaseous phase to a liquid phase, thereby extracting heat from the substance. In some embodiments, a condenser may remove heat from vaporized coolant in a first heat transfer stage, and convert (e.g., condense) the vaporized coolant to liquid coolant to release latent heat in a second heat transfer stage. At least some of the released heat may be transferred to a volume and/or flow of air and/or water. Convert refers to transform and/or change. A condenser configured to convert the vaporized coolant into the liquid coolant refers to a condenser configured to receive vaporized coolant and extract a sufficient amount of heat to transform the coolant to a liquid phase. For example, a condenser may thermally couple relatively hot vaporized coolant flowing in a two-phase loop to relatively cool water flowing in an output water line of a water loop. The relatively cool water may absorb heat from the relatively hot vaporized coolant, causing the vaporized coolant to condense and cool to produce relatively cool liquid coolant. A condenser inlet refers to an opening, passage, and/or conduit configured to permit a fluid to enter a condenser. For example, a condenser inlet may permit hot vaporized coolant to enter a condenser. Flow connected refers to coupled and/or joined in a manner to enable a substance to be conveyed between two locations. For example, flow connecting a first location to a second location may enable fluid to flow between the first and second locations. In some embodiments, a flow connection may include one or more scaled tubes and/or channels preventing a fluid from flowing anywhere other than via the flow connection. In some embodiments, a flow connection may be associated with a flow direction and/or one or more valves permitting a one-way flow direction from a first location to a second location and preventing flow from the second location to the first location. A condenser inlet for flow connection to a plurality of vapor coolant outlet lines refers to a (e.g., single) condenser inlet fluidly coupled to a plurality of vapor coolant outlet lines, permitting vaporized coolant flowing through the plurality of vapor coolant outlet lines to enter the condenser. In some embodiments, vaporized coolant flowing through a plurality of vapor coolant outlet lines may be combined and channeled into a single aggregated vaporized coolant line which may be flow connected to a condenser via a condenser inlet.

As an example, a plurality of vapor coolant outlet lines may flow connect chambers of a plurality of two-phase evaporators with a condenser inlet. Pool boiling due to heat absorption from a plurality of heat-generating electronic components may cause vaporized coolant to accumulate in each chamber. The accumulation of vaporized coolant may increase vapor pressure within each chamber, leading to a pressure differential relative to the condenser inlet. Thus, may cause vaporized coolant to exit from each of the chambers and flow to the condenser via the plurality of vapor coolant outlet lines. In some embodiments, one or more valves associated with the plurality of vapor coolant outlet lines may prevent a backwards vapor flow to the associated two-phase evaporator. In some embodiments, a plurality of two-phase evaporators may be flow-connected via one or more bi-directional flow connections to allow aggregating vapor outputted from each two-phase evaporator at differing pressures that may vary over time. The aggregated vapor may be conveyed to the condenser via one or more vapor coolant outlet lines (e.g., via a one-way flow connection).

Some disclosed embodiments involve a vapor manifold for collecting vapor from the plurality of outlet lines and for delivering the collected vapor to the condenser. Collecting vapor refers to combining and/or aggregating vapor from a plurality of sources. A manifold refers to a structure that collects flow from multiple sources. For example, a group of smaller pipes and/or tubes may be connected to a larger pipe, tube, or chamber which serves as a manifold. A vapor manifold refers to a manifold configured to receive vapor from a plurality of smaller vapor lines to a single larger vapor line, pipe, conduit, or chamber. For example, a vapor manifold may permit aggregating vaporized coolant flowing in a plurality of smaller individual vapor coolant output lines to a larger (e.g., main) vapor line fluidly connected to a condenser, thereby delivering vaporized coolant collected from a plurality of two-phase evaporators to the condenser.

By way of a non-limiting example, in Fig. 11A, condenser 702 may have a condenser inlet 1124 for flow connection to plurality of vapor coolant outlet lines 1122. Condenser 702 may convert the vaporized coolant (e.g., transported through vapor coolant portion 1116 of secondary two-phase loop 1112) into liquid coolant (e.g., for conveying through liquid coolant portion 1114 of secondary two-phase loop 1112).

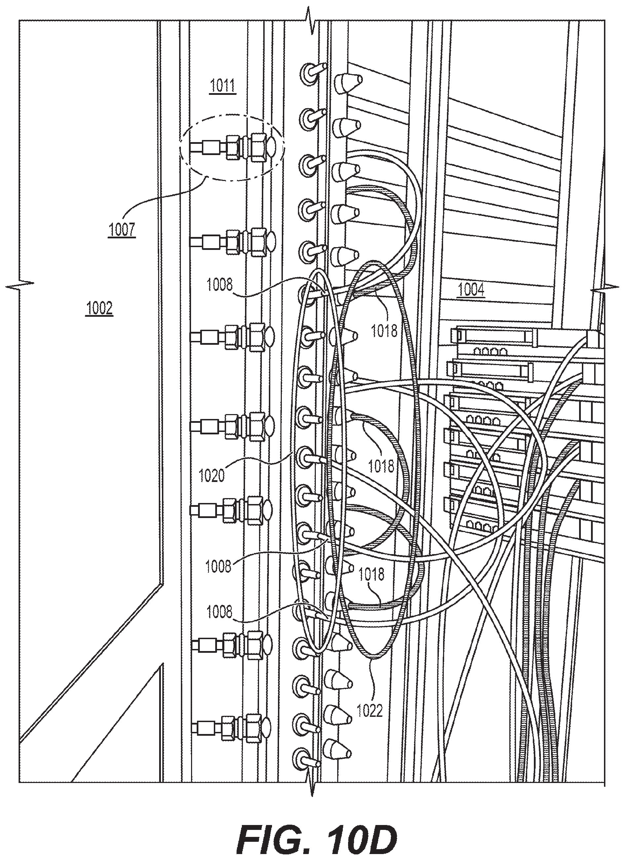

By way of another non-limiting example, reference is made to Fig. 10D, illustrating a plurality of vapor lines 1008 of a vapor manifold 1020, and a plurality of liquid lines 1018 of a liquid manifold 1022 mounted on a server rack door 1002, consistent with some disclosed embodiments. For example, each vapor line 1008 may transport vaporized coolant from a different shelf of a server rack. Vapor manifold 1020 may combine the vaporized coolant flowing in each of vapor lines 1008 for delivery to condenser 702 via condenser inlet 1124 (Fig. 11A). Similarly, liquid manifold 1022 may distribute liquid coolant from condenser 702 to each liquid line 1018. Each liquid line 1018 may be fluidly coupled to condenser outlet 1136 for supplying liquid coolant from condenser 702 to a different shelf of the server rack. In some embodiments, each shelf of the server rack may include a plurality of heat-generating electronic components and associated two-phase evaporators 100. Thus, each vapor line 1008 may collect vaporized coolant from a plurality of two-phase evaporators 100 located on a particular shelf and each liquid line 1018 may deliver liquid coolant to a plurality of two-phase evaporators 100 located on a particular shelf. Vapor lines 1008 and vapor manifold 1020 may be included in vapor coolant portion 1116 of secondary two-phase loop 1112 (Fig. 11A), and liquid lines 1018 and liquid manifold 1022 may be included in liquid coolant portion 1114 of secondary two-phase loop 1112.

In some disclosed embodiments a condenser includes an outlet for flow connection to the plurality of liquid coolant inlet lines. A condenser outlet refers to an opening, passage, and/or conduit configured to permit a fluid to exit a condenser. For example, a condenser outlet may permit cooled liquid coolant to exit a condenser. A condenser outlet for flow connection to a plurality of liquid coolant inlet line refers to a flow connection permitting liquid coolant to flow from an (e.g., single) condenser outlet to multiple liquid coolant inlet lines. For example, a flow of liquid coolant exiting a condenser outlet may be split to branch out and flow through a plurality of liquid coolant inlet lines, cach delivering liquid coolant to a different two-phase evaporator.

Some disclosed embodiments involve a liquid coolant manifold for delivering the condensed liquid coolant to the plurality of liquid coolant inlet lines. Delivering refers to supplying, conveying, and/or distributing. A liquid coolant manifold refers to a structure that collects liquid coolant from multiple sources. For example, a liquid coolant manifold may include a larger line, conduit, pipe, or chamber that is flow connected to a plurality of smaller liquid coolant lines. For example, a liquid coolant manifold may permit distributing liquid coolant from a reservoir of a condenser to a plurality of two-phase evaporators by channeling a flow of liquid coolant from the reservoir to a larger (e.g., main) liquid coolant line and splitting the flow to each of a plurality of smaller liquid coolant inlet lines. Alternatively, the liquid manifold may directly distribute liquid coolant to each liquid coolant inlet lines.

By way of a non-limiting example, in Fig. 7, condenser 702 may include a condenser outlet 1136 for flow connection to plurality of liquid coolant inlet lines 1120.

By way of another non-limiting example, in Fig. 10D, liquid coolant manifold 1018 may be included in liquid coolant portion 1114 of secondary two-phase loop 1112. Liquid coolant manifold 1018 may deliver the condensed liquid coolant to plurality of liquid coolant inlet lines 1120.

In some disclosed embodiments a condenser is configured for thermally coupling a secondary two-phase loop to a primary water loop to transfer heat conveyed from the plurality of heat-generating electronic components by the vaporized coolant to water flowing in the output water line. Thermally coupling refers to positioning two or more bodies to enable heat transfer therebetween. To transfer refers to displace and/or move. Convey refers to transport, communicate, and/or carry, e.g., from one location to another. For example, a fluid may absorb heat at a first location and flow to a second location, to thereby convey the heat from the first location to the second location. Conveying heat thus may result in relative cooling at the first location and relative heating at the second location. Heat conveyed from a plurality of heat-generating electronic components by vaporized coolant refers to heat transported away from a plurality of heat-generating components by a flow of coolant. For example, liquid coolant in thermal contact with a plurality of heat-generating electronic components (e.g., via heat conducting walls of a plurality of associated two-phase evaporators) may absorb sufficient heat to reach boiling, whereby forces between coolant molecules may be overcome. This may cause the coolant to transition from a liquid phase to a gaseous phase, e.g., as vaporized coolant. The vaporized coolant may exit the plurality of two-phase evaporators (e.g., due to a pressure differential) and flow to the condenser carrying the heat therewith, resulting in cooling of the plurality of heat-generating clectronic components. Liquid coolant may be circulated continually through the two-phase evaporators to enable continual cooling of the plurality of heat-generating electronic components. Thermally coupling a secondary two-phase loop to a primary water loop refers to arranging the two-phase (e.g., coolant) loop and the water loop to enable heat transfer therebetween. For example, a condenser may enclose a portion of a primary water loop and a portion of a secondary two-phase loop in a manner to enable thermal contact therebetween. In some embodiments, the portion of the primary water loop may be in physical contact with the portion of the two-phase loop. In some embodiments, the portion of the primary water loop may be thermally coupled to the portion of the two-phase loop by indirect contact, e.g., using a heat conducting interface, such as air, or a solid material.

In some embodiments, a two-phase loop may include a plurality of first heat transfer locations for absorbing heat and a second (e.g., single) heat transfer location for releasing heat. A plurality of two-phase evaporators may be located at the plurality of first heat transfer locations, and a condenser may be located at the second heat transfer location. Liquid coolant may flow through the two-phase loop to the plurality of two-phase evaporators thermally coupled to the plurality of heat-generating electronic components in the first heat transfer locations. The liquid coolant may remain stagnant at the plurality of first locations to enable absorption of heat, causing pool boiling and transitioning of the liquid coolant to a gaseous phase, as vaporized coolant. The vaporized coolant may exit each of the plurality of two-phase evaporators, carrying the heat therewith, and flow to condenser at the second heat transfer location via a condenser inlet. At the second heat transfer location, water flowing in a water output line may absorb heat from the vaporized coolant, causing the vaporized coolant to transition to a liquid phase as liquid coolant. The liquid coolant may be pumped back through the two-phase loop to the plurality of two-phase evaporators for continual cooling.

By way of a non-limiting example, in Fig. 11A, condenser 702 may thermally couple secondary two-phase loop 1112 to primary water loop 712 to transfer heat conveyed from plurality of heat-generating electronic components 110 by the vaporized coolant to water flowing in output water line 706 (see Fig. 7). For example, heat transferred from each heat-generating electronic component 110 to coolant flowing in secondary two-phase loop 1112 at each of a plurality of first heat transfer locations 1140 may convert liquid coolant to vaporized coolant. In some embodiments, a region (e.g., a transition region) between vapor coolant portion 1116 and liquid coolant portion 1114 of secondary two-phase loop 1112 may be located at a second heat transfer location 1128 in an area where secondary two-phase loop 1112 may be thermally coupled to primary water loop 712. For instance, the removal of heat from vaporized coolant flowing in vapor coolant portion 1116 and the transfer of the heat to water flowing in water loop 712 at second heat transfer location 1128 may cause condensation of the vaporized coolant and produce liquid coolant.

In some disclosed embodiments, the output water line is configured to convey at least some of the heat transferred from the plurality of heat-generating electronic components to a heat exchanger. A heat exchanger refers to a structure configured to transfer of heat from a hot fluid to a cold fluid through one or more solid surfaces in a manner preventing mixing of the fluids. An output water line configured to convey at least some of the heat to a heat exchanger refers to an output water line fluidly coupled to the heat exchanger to permit heat to transfer from a flow of hot water to another substance (e.g., facility water). Continuing from the example above, the output water line and heat exchanger may be included in the primary water loop. The output water line may supply water heated at the condenser to the heat exchanger, where at least some of the heat may be transferred, causing the water to cool. The cooled water may circulate back to the condenser through the primary water loop. In this manner, a relatively fixed volume of coolant coupled to a relatively fixed volume of water may continually cool a plurality of heat-generating electronic components.

In some disclosed embodiments, the primary water loop is configured to convey at least some of the heat transferred to the water in the output water line to a heat exchanger in a first flow direction and return cooled water from the heat exchanger to the condenser in a second flow direction. A flow direction refers to a trajectory and/or path of a fluid moving from one location to another. In some embodiments a flow direction may be relative to a frame of reference. For instance, a first flow direction and second flow direction of a primary water loop may be relative to a condenser configured to deliver hot water in the first flow direction and receive cooled water in the second flow direction. As an example, a water loop may include a first section for delivering relatively hot water from a condenser to a heat exchanger in a first flow direction, and a second section for returning relatively cool water (after some heat has been expelled from the water via the heat exchanger) to the condenser in a second direction opposite the first direction. The relatively cool water may absorb heat at the condenser and become hot water, which may flow back to the heat exchanger in the first direction via the first section of the water loop in a circular process.

In some disclosed embodiments, the heat exchanger is a source of heat for the facility. A facility may refer to a plant, building, site, and/or location. For example, a facility may include infrastructure for housing and/or operating a plurality of heat-generating electronic components. A facility may be associated with a need for heating, e.g., for offices and/or assembly areas. A source of heat for a facility may refer to a supply and/or reserve of heat for the facility. For example, heat from the plurality of heat-generating electronic components may be channeled via the primary water loop and secondary two-phase loop away from the electronic components to the heat exchanger, where the heat may be distributed for use by the facility. For instance, the heat may be used to heat a facility water supply.

By way of another non-limiting example, in Figs. 7 and 11A, output water line 706 may convey at least some of the heat transferred from plurality of heat-generating electronic components 110 to a heat exchanger (e.g., facility water system 700). In some embodiments, primary water loop 712 may convey at least some of the heat transferred to the water in output water line 706 to a heat exchanger (e.g., facility water system 700) in a first flow direction 1130 relative to condenser 702 and return cooled water from the heat exchanger to condenser 700 in a second flow direction 1132 relative to condenser 702. For example, facility water system 700 may include a third heat transfer location 1134 whereby heat carried by relatively hot water supplied from condenser 702 in first flow direction 1130 via output water line 706 may transfer to a facility heat sink causing cooling of the water. The relatively cool water may circulate back to condenser 702 in second flow direction 1132. In some embodiments, the heat exchanger may be a source of heat for a facility (e.g., housing and/or monitoring a server farm).

Some disclosed embodiments involve a water line inlet and a water line outlet for connection to the output water line and for enabling water to pass through the condenser and to receive heat generated by the plurality of electronic components. A water line inlet (e.g., for enabling water to pass through a condenser) refers to an opening sized to permit a flow of water to enter a condenser. A water line outlet for connection to the output water line (e.g., and for enabling water to pass through a condenser) refers to an opening for receiving a flow water from a condenser and permitting the flow of water to enter a water output line. Enabling water to pass through a condenser refers to an opening or port in a condenser that enables water received in the condenser to exit the condenser. Receiving heat generated by a plurality of electronic components refers to absorbing heat conveyed by coolant heated by the plurality of electronic components. For example, a condenser may contain an output water line of a primary water loop thermally coupled to a portion of a secondary two-phase loop, as described earlier. Relatively cool water may enter the output water line inside the condenser via the water line inlet. The relatively cool water may come into thermal contact with relatively hot vaporized coolant flowing in the portion of the secondary two-phase loop and absorb at least some heat, and exit the condenser via the water line outlet.

By way of a non-limiting example, in Figs. 7 and 11A, condenser 702 may include a water line inlet 708 and a water line outlet 710 for connection to output water line 706 and for enabling water to pass through condenser 702 and receive heat generated by the plurality of electronic components 110. For example, relatively cool water may enter condenser 702 via water line inlet 708, where the relatively cool water may absorb heat generated by electronic components 110 and conveyed by the vaporized coolant to become relatively hot water (e.g., at second heat transfer location 1128). The relatively hot water may exit condenser 702 via water line outlet 710 and flow to facility water system 700 via output water line 706.

Some disclosed embodiments involve at least one processor configured to receive at least one signal indicative of at least one of a pressure in the plurality of vapor coolant outlet lines or a temperature in the output water line. Receive refers to obtain, acquire, and/or otherwise gain access to. Temperature (as described and exemplified elsewhere herein) in an output water line refers to a measure of hotness and/or coldness of a flow of water through an output water line. In some embodiments, an output water line may be associated with a temperature sensor configured to transmit a signal indicating water temperature in the output water to at least one processor. A temperature sensor may include a thermometer, a thermostat, a thermocouple, a thermopile, an infrared thermometer, a bimetallic strip thermometer, and/or any other type of temperature measurement device. A temperature sensor may include a transmitter allowing to transmit a signal indicative of temperature to at least one processor. Pressure refers to forces exerted by particles inside a closed volume and may be measured relative to ambient pressure, in units of bars, Pascals, and/or Psi. Pressure in a plurality of vapor coolant outlet lines refers to pressure exerted by vaporized coolant particles contained inside each of a plurality of vapor coolant outlet lines. In some embodiments, each vapor coolant outlet line may be associated with a pressure sensor configured to transmit a signal indicative of vapor pressure to at least one processor. A pressure sensor may include a strain gauge, a piezoelectric pressure sensor, a capacitive pressure sensor, a manometer, a vacuum pressure sensor, a bourdon tube, and/or an aneroid barometer. A pressure sensor may include a transmitter allowing to transmit a signal indicative of pressure to at least one processor. In some embodiments, the at least one processor may aggregate and/or combine pressure measurements for a plurality of vapor coolant outlet lines, e.g., as an average, a maximum, a minimum, and/or any other aggregated pressure value. At least one signal indicative of at least one of a pressure in the plurality of vapor coolant outlet lines or a temperature in the output water line refers to one or more signals (as described and exemplified elsewhere herein) including information associated with vapor pressure in the plurality of vapor coolant outlet lines and/or water temperature in an output water line. For example, at least one processor (as described an exemplified elsewhere herein) may receive a plurality of vapor pressure signals from a plurality of pressure sensors associated with a plurality of vapor coolant outlet lines and/or a temperature sensor associated with an output water line, (e.g., after water flowing therein has absorbed heat from relatively hot vaporized coolant).

In some disclosed embodiments, the at least one processor is configured to control boiling temperatures of liquid coolant within each of the plurality of two-phase evaporators. A boiling temperature refers to a temperature at which a substance in a liquid phase may absorb sufficient heat to overcome forces between the molecules, causing the substance to transition to a gaseous phase. The at least one processor may control one or more fluid dynamic characteristics in the primary water loop and/or the secondary dual-phase loop to cause a corresponding adjustment to the boiling temperature of the coolant. For instance, each vapor coolant outlet line may be fluidly coupled to a chamber of a dual-phase evaporator. The at least one processor may transmit one or more signals to release/constrict a valve (e.g., a solenoid valve) associated with each vapor coolant outlet line to increase/decrease a vapor flow rate inside each vapor coolant outlet line. Releasing a valve to increase the vapor flow rate in the associated vapor coolant outlet line may cause vapor to evacuate more quickly from the associated chamber, resulting in a decrease in vapor pressure inside the chamber. Constricting the valve to decrease the vapor flow rate in the associated vapor coolant outlet line by may cause vapor to evacuate more slowly from the chamber, resulting in an increase in vapor pressure inside the chamber. As the pool of liquid coolant in the chamber boils, vaporized coolant may rise and coolant in an upper portion of each chamber. Since pressure and temperature within a volume may be interdependent, changing (e.g., increasing or decreasing) the pressure of a vaporized coolant collecting above a pool of liquid coolant, may cause a corresponding change (e.g., increase or decrease) in a boiling temperature at which the liquid will transition to gas. Thus, by transmitting a signal to restrict a valve associated with a vapor coolant outlet line of a two-phase evaporator, the at least one processor may increase the pressure of vaporized coolant inside the chamber, causing the boiling temperature of the coolant inside the chamber to increase, raising the temperature of the vaporized coolant. By transmitting a signal to release a valve associated with a vapor coolant outlet line of a two-phase evaporator, the at least one processor may decrease the pressure of vaporized coolant inside the chamber, causing the boiling temperature of the coolant inside the chamber to decrease, decreasing the temperature of the vaporized coolant. Since at least some of the heat absorbed by the vaporized coolant in the chamber may be subsequently transferred to water flowing in a water loop thermally coupled thereto, increasing/decreasing the pressure in the vapor lines may increase/decrease the temperature of water exiting the condenser, respectively. In this manner, regulating the pressure inside the plurality of vapor coolant outlet lines may allow regulating water temperature of a flow of water exiting the condenser to a heat exchange associated with a facility. Additionally or alternatively, the at least one processor may regulate the flow of water in the primary water loop (e.g., by controlling one or more associated pumps and/or valves) to thereby control the boiling temperature, as described in greater detail herein below.

By way of a non-limiting example, in Fig. 1A and 11A, at least one processor 152 may receive at least one signal indicative of at least one of a pressure in plurality of vapor coolant outlet lines 1122 or a temperature in output water line 706. In some embodiments, output water line 706 may be associated with a temperature sensor configured to transmit a water temperature signal to at least one processor 152, and/or each of vapor coolant outlet lines 1122 may be associated with a pressure sensor configured to transmit a vapor pressure signal to at least one processor. For example, each of flow control valves 1138 may include a pressure sensor and water line outlet 710 may include a temperature sensor.

In some embodiments, at least one processor 152 may control boiling temperatures of liquid coolant within each of the plurality of two-phase evaporators (e.g., inside each of ENEs 100). For example, at least one processor 152 may use a relationship between pressure and temperature inside a closed chamber to control a boiling point of liquid coolant inside each chamber 116 of each ENE 100 (e.g., see Fig. 1B). At least one processor 152 may transmit a signal to restrict one or more of flow control valves 1138 associated with vapor coolant outlet lines 1122 of ENEs 100 to thereby increase the pressure of vaporized coolant inside one or more of chambers 116, causing the boiling temperature of the coolant inside chamber 116 to increase. Similarly, at least one processor 152 may transmit a signal to release one or more of flow control valves 1138 associated with vapor coolant outlet lines 1122 to thereby decrease the pressure of vaporized coolant inside one or more of chambers 116, causing the boiling temperature of the coolant inside chamber 116 to decrease.

Some disclosed embodiments involve at least one processor configured to regulate vapor pressure in the plurality of vapor coolant outlet lines as a function of the signal to thereby control a temperature of the water in the output water line. Regulate refers to control, adjust, modify, manage, and/or coordinate. As a function of a signal refers to based on, dependent on, and/or using the signal. Regulate vapor pressure in a plurality of vapor coolant outlet lines as a function of a signal refers to controlling and/or coordinating pressure within a plurality of vapor coolant outlet lines in a manner dependent on information encoded in a signal. For example, at least one processor may receive an indication of temperature in an output water line of a water loop and use the indication to release/constrict one or more control valves to regulate vapor pressure in a plurality of vapor coolant outlet lines of a two-phase loop thermally coupled to the water loop. If the water temperature is too low, the at least one processor may transmit a signal to restrict the associated valve, causing vapor pressure in the vapor outlet line and chamber fluidly coupled thereto to increase. This may cause the boiling temperature of the coolant inside the chamber to increase, raising the temperature of the vaporized coolant flowing to the condenser. The higher temperature of the vaporized coolant may raise the temperature of the water flowing in the primary water loop thermally coupled thereto. If the water temperature is too high, the at least one processor may transmit a signal to release the associated valve, causing vapor pressure in the vapor outlet line and chamber fluidly coupled thereto to decrease. This may cause the boiling temperature of the coolant inside the chamber to drop, lowering the temperature of the vaporized coolant flowing to the condenser. The lower temperature of the vaporized coolant may lower the temperature of the water flowing in the primary water loop thermally coupled thereto. In this manner, regulating vapor pressure in a plurality of vapor coolant outlet lines of a two-phase loop may permit at least one processor to regulate water temperature in an output water line of a water loop coupled thereto.

In some disclosed embodiments, the at least one processor is configured to regulate the control valve to achieve a target water temperature of at least 60 degrees C. **In** some disclosed embodiments, the at least one processor is configured to regulate the control valve to achieve a target water temperature of 65 degrees C. For example, the at least one processor may at least partially close the control valve to decrease a flow rate of water through the condenser allowing the relatively cool water in the output water line to come in thermal contact with relatively hot vaporized coolant for a longer time period. This may cause the relatively cool water to absorb a greater amount of heat, causing the water to achieve at least 60 degrees C or at least 65 degrees C.

By way of a non-limiting example, in Figs. 1A, 7, and 11A, at least one processor 152 may regulate vapor pressure in plurality of vapor coolant outlet lines 1122 as a function of the signal to thereby control a temperature of the water in output water line 706. For instance, by controlling vapor pressure in vapor coolant outlet lines 1122, at least one processor 152 may thereby control a vapor pressure inside each chamber 116 of each ENE 100 (see Fig. 1B). This may influence the boiling temperature of the coolant, which may affect the temperature of the vaporized coolant exiting each ENE 100, and determine how much heat may be transferred to water flowing in output water line 706 (e.g., to reach at least 60°C or at least 65°C). In some embodiments, at least one processor 152 may regulate control valve 704 to achieve a target water temperature of at least 60°C, or at least 65°C. For instance, regulating control valve 704 may affect a flow velocity of water passing through condenser 702, which may affect how much heat the water may absorb.

Some disclosed embodiments involve a pump for conveying liquid coolant from the condenser to the plurality oftwo-phase evaporators via the plurality of liquid coolant inlet lines. A pump refers to a mechanical device configured to move a fluid by generating a pressure differential. For example, a pump may repeatedly create a partial vacuum in a cyclical process, causing ambient pressure to push a fluid in a desired direction. For instance, a condenser may deliver condensed liquid coolant to a reservoir for storage. The reservoir may be fluidly coupled to a plurality of two-phase evaporators via a plurality of liquid coolant inlet lines. One or more pumps associated with the reservoir may propel the liquid coolant from the reservoir through the plurality of liquid coolant inlet lines to thereby supply liquid coolant to each two-phase evaporator. In some embodiments, the pump includes a plurality of pumps. In some disclosed embodiments, the at least one processor is further configured to control an RPM of the pump to regulate a flow of liquid coolant from the condenser to the plurality of two-phase evaporators via the plurality of liquid coolant lines. An RPM (e.g., rotations per minute) of a pump refers to a speed at which a pump may operate. Each cycle of a pump may produce a particular pressure differential, such that a pump RPM may indicate an amount of power produced to move a fluid. For example, increasing/decreasing the pump RPM may increase/decrease a rate of supply of the liquid coolant to a plurality of two-phase evaporators, which may affect a rate of heat transfer from the plurality of heat-generating electronic components to the liquid coolant. By controlling an RPM of a pump, the at least one processor may control the supply of liquid coolant from the condenser to the plurality of two-phase evaporators, thereby controlling a heat transfer rate from a plurality of heat-generating electronic components to the liquid coolant.

By way of a non-limiting example, in Fig. 11A, a pump 146 may convey liquid coolant from condenser 702 to the plurality of two-phase evaporators (e.g., ENEs 100) via plurality of liquid coolant inlet lines 1120. At least one processor 152 *(see* Fig. 1A) may control an RPM of pump 146 to regulate a flow of liquid coolant from condenser 702 to the plurality of two-phase evaporators via the plurality of liquid coolant lines 1120.

In some disclosed embodiments, the at least one processor is further configured to regulate inlet water flow into the condenser in order to regulate pressure in the plurality of vaporized coolant outlet lines. Regulating inlet water flow into a condenser may refer to controlling (e.g., by increasing/decreasing and/or starting/stopping) a flow of water into the condenser. The flow rate of water into the condenser may affect a rate at which heat is transferred from the relatively hot coolant flowing in the secondary two-phase loop to the relatively cool water flowing in the primary water loop. This may affect a rate of condensation of the vaporized coolant to liquid coolant and influence (e.g., upstream) vapor pressure in the secondary two-phase loop. For example, at least one processor may transmit one or more signals to cause a control valve to constrict a flow of relatively cool water to a condenser. This may cause a flow rate of cool water to the condenser to decrease, which may cause a heat transfer rate from vaporized coolant to the water in the primary water loop to decrease (e.g., due to less water carrying away heat from vaporized coolant). The decreased heat transfer rate may cause a condensation rate of vaporized coolant to liquid coolant to decrease as well, which may increase vapor pressure in the vapor output lines. The increased pressure in the vapor output lines may cause a corresponding increase in pressure inside the chambers of the two-phase evaporators, increasing the boiling temperature of the coolant inside the chambers. Similarly, the at least one processor may transmit one or more signals causing the control valve to release a flow of cool water to the condenser, thereby increasing the flow rate of cool water which may increase a heat transfer rate from vaporized coolant in the two-phase loop to water in the primary water loop (e.g., due to more water carrying away heat from vaporized coolant). This may cause a condensation rate to increase, which may lower vapor pressure in the vapor output lines and the chambers of the two-phase evaporators, causing the boiling temperature of the coolant inside the chambers to decrease.

By way of a non-limiting example, in Figs. 1A, 7, and 11A, at least one processor 152 may regulate inlet water flow into condenser 702 in order to regulate pressure in plurality of vaporized coolant outlet lines 1122. For instance, at least one processor 152 may transmit one or more signals to release/constrict control valve 704, causing a flow rate of water into condenser 702 via water line inlet 708 to increase/decrease, respectively. Increasing/decreasing the flow rate by releasing/constricting control valve 704 may increase/decrease the heat transfer rate from vaporized coolant flowing in two-phase loop 1114 to water flowing in water loop 712 at second heat transfer location 1128, respectively. This may increase/decrease the condensation rate of vaporized coolant to liquid coolant, which may decrease/increase the vapor pressure in vapor coolant outlet lines 1122 and chambers 116 of ENEs 100, respectively. Decreasing/increasing the vapor pressure in chambers 116 may decrease/increase the boiling temperature of coolant inside each chamber 116, which may decrease/increase the temperature of the vaporized coolant and the temperature of the water flowing in primary water loop 712 thermally coupled thereto.

Some disclosed embodiments involve a plurality of flow control valves, each flow control valve being associated with a differing outlet line. A flow control valve refers to a device for regulating movement of a fluid in a pipe, tube, and/or another flow conduit. For example, a flow control valve may include an element that may partially or fully block a flow in a conduit to thereby adjust a flow rate. In some embodiments, a flow control valve may include a solenoid valve controllable via one or more electronic signals. At least one processor may transmit one or more signals to one or more solenoid valves to regulate a flow therethrough. In some embodiments, each vapor coolant outlet line may be provided with a distinct flow control valve, allowing to control a flow of vaporized coolant therethrough. This may permit controlling vapor pressure within each chamber of each two-phase evaporator (e.g., as described earlier). In some disclosed embodiments, the at least one processor is further configured to control each flow control valve to regulate a flow of vaporized coolant from each of the plurality of two-phase evaporators to the condenser via the plurality of outline lines, thereby controlling the water temperature in the output water line. For example, at least one processor may transmit one or more electronic signals to at least partially open and/or close control one or more flow control valves (e.g., solenoid valves). In this manner, the at least one processor may start, stop, increase, and/or decrease a flow of vaporized coolant exiting each two-phase evaporator, thereby increasing/decreasing the vapor pressure inside each associated chamber. This may cause a corresponding increase/decrease in the boiling temperature of liquid coolant inside each chamber, which may affect the amount of heat transferred by the vaporized coolant to the water flowing in the primary water loop, as described earlier. Additionally or alternatively, by regulating one or more control valves to increasc/decreasc a vapor flow rate to the condenser via the vapor coolant output lines, the at least one processor may increase/decrease a heat transfer rate from vaporized coolant in the secondary two-phase loop to water in the primary water loop, which may increase/decrease the temperature of the water in the primary water line.

By way of a non-limiting example, in Figs. 1A and 11A, system 1100 may include a plurality of flow control valves 1138. Each flow control valve 1138 may be associated with a differing outlet line 1122. At least one processor 152 may control each flow control valve 1138 to regulate a flow of vaporized coolant from each two-phase evaporator (e.g., ENE 100) to condenser 702 via plurality of vapor outline lines 1122, thereby controlling the water temperature in output water line 706.

In some disclosed embodiments, regulating flow in the secondary two-phase loop includes controlling the plurality of flow control valves to regulate flow of vaporized coolant from each of the plurality of two-phase evaporators to the condenser to thereby achieve the substantially constant water temperature in the primary water loop. For example, at least one processor may transmit one or more electronic signals to at least partially open and/or close control one or more flow control valves to thereby control the boiling temperature of the coolant inside each two-phase evaporator. This may affect the amount of heat conveyed by the vaporized coolant exiting each two-phase evaporator, and how much heat may be transferred to the water flowing in the primary water loop. Additionally or alternatively, releasing/constricting the flow control valves may increase/decrease the vapor flow rate to the condenser, which may increase/decrease the heat transfer rate to the water in the primary water loop, causing the water temperature to increase/decrease.

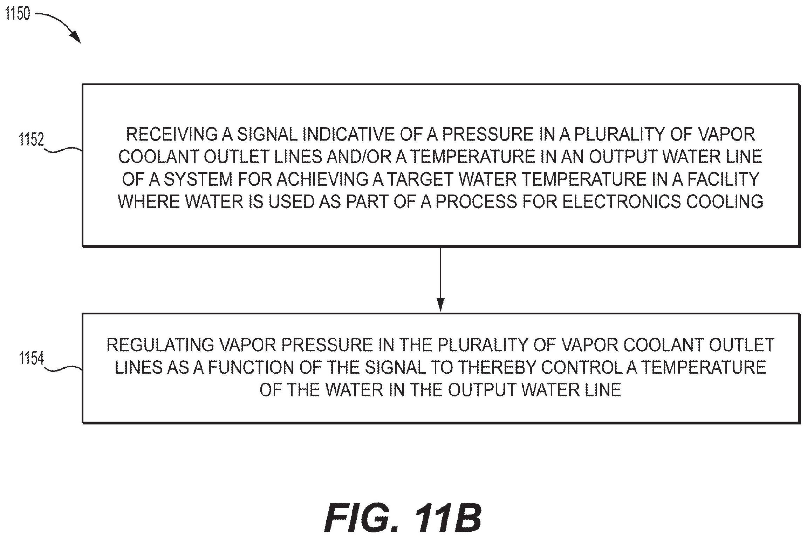

By way of a non-limiting example, in Figs. 1A, and 11B, regulating flow in secondary two-phase loop 1112 may include controlling the plurality of flow control valves 1138 to regulate flow of vaporized coolant from each of the plurality of two-phase evaporators 100 to condenser 702 to thereby achieve the substantially constant water temperature in primary water loop 712.

In some disclosed embodiments, the at least one processor is further configured to control operating frequencies for the plurality of heat-generating electronic components, thereby controlling the water temperature in the output water line. An operating frequency for a plurality of heat-generating electronic components may be understood as described elsewhere herein. The operating frequency may affect an amount of heat generated by the plurality of heat-generating electronic components. For example, increasing/decreasing the operating frequency may increase/decrease the amount of heat generated. By controlling the operating frequencies for the plurality of heat-generating electronic components, at least one processor may control the amount of heat transferred from the electronic components to coolant flowing in the secondary two-phase loop. This may affect the amount of heat transferred from relatively hot coolant flowing in the secondary two-phase loop to the relatively cool water flowing in the primary water loop, and which may affect the temperature of the water. For example, if the water temperature is higher than a target water temperature, the at least one processor may cause the plurality of heat-generating electronic components to operate at a lower operating frequency and generate less heat, causing the water temperature to drop. If the water temperature is less than a target water temperature, the at least one processor may cause the plurality of heat-generating electronic components to operate at a higher operating frequency and generate more heat, causing the water temperature to rise.

By way of a non-limiting example, in Figs. 1A and 11A, at least one processor 152 *(see* Fig. 1A) may control operating frequencies for the plurality of heat-generating electronic components 110, thereby controlling the water temperature in output water line 706.

In some disclosed embodiments, the at least one processor is further configured to regulate inlet water flow into the condenser by controlling the associated control valve. Regulating inlet water flow into a condenser refers to stopping, starting, increasing, and/or decreasing a rate of water flowing into (or out of) the condenser. For example, water may flow in the primary water loop due to a temperature gradient between heated water at the condenser and cooled water at the heat exchange (e.g., heat sink of a facility). Controlling a control valve refers to manipulating a control valve to thereby regulate an associated flow. For example, a control valve may be a solenoid valve controllable by one or more electronic signals, as described and exemplified earlier.

By way of a non-limiting example, in Figs. 1A and 7, at least one processor 152 may regulate inlet water flow into condenser 702 by controlling control valve 704.

In some disclosed embodiments, each two-phase evaporator includes a float valve configured to regulate an inflow of liquid coolant to each two-phase evaporator and to prevent liquid coolant from entering an associated vapor coolant outlet line. A float valve may be understood as described and exemplified elsewhere herein. For example, when a level of liquid coolant in a chamber of a two-phase evaporator exceeds a threshold level (e.g., if a liquid coolant inflow rate exceeds a vapor coolant outflow rate), a float valve may rise (e.g., by floating on a surface of the liquid coolant) to obstruct a liquid coolant inlet. This may block a flow of liquid coolant into the chamber of the two-phase evaporator, preventing the level of liquid coolant from exceeding the threshold level. Maintaining the level of liquid coolant in the chamber below the threshold level may prevent liquid coolant from reaching a vapor outlet of the two-phase evaporator, thereby preventing liquid coolant from entering the vapor coolant outlet line.

By way of a non-limiting example, in Figs. 1A and 2A, each two-phase evaporator 100 may include a float valve 200 configured to regulate an inflow of liquid coolant to each two-phase evaporator 100 and to prevent liquid coolant from entering an associated vapor coolant outlet line 1122 (see Fig. 11A).

Some disclosed embodiments involve at least one processor configured to regulate the control valve associated with the output water line as a function of the signal to thereby control a temperature of the water in the output water line. For example, the at least one processor may transmit one or more signals to manipulate a control valve, and thereby regulate a flow of water in a primary water loop entering a condenser, as described and exemplified earlier. In some embodiments, the at least one processor may use the at least one signal to control the temperature of the water in the output water line by performing one or more of: regulating the control valve associated with the output water line, regulating an RPM of a pump for conveying liquid coolant from the condenser to the plurality of two-phase evaporators, controlling each flow control valve to regulate a flow of vaporized coolant through each vapor outline lines, and/or controlling operating frequencies for the plurality of heat-generating electronic components.

By way of a non-limiting example, in Figs. 1A and 11A, at least one processor 152 may regulate control valve 704 associated with output water line 706 as a function of the signal to thereby control a temperature of the water in the output water linc 706.

Fig. 11B is a flowchart of an exemplary process 1150 for controlling a temperature of the water in the output water line, consistent with embodiments of the present disclosure. In some embodiments, process 1150 may be performed by at least one processing device (e.g., at least one processor 152) to perform operations or functions described herein. In some embodiments, some aspects of process 1150 may be implemented as software (e.g., program codes or instructions) that arc stored in a memory or a non-transitory computer readable medium. In some embodiments, some aspects of process 1150 may be implemented as hardware (e.g., a specific-purpose circuit). In some embodiments, process 1150 may be implemented as a combination of software and hardware.

Referring to Fig. 11B, process 1150 may include a step 1152 of receiving at least one signal indicative of at least one of a pressure in a plurality of vapor coolant outlet lines or a temperature in an output water line of a system for achieving a target water temperature in a facility where water is used as part of a process for electronics cooling. The system may include a primary water loop including the output water line and an associated control valve. The system may include a secondary two-phase loop including a plurality of two-phase evaporators, each two-phase evaporator configured for thermal contact with an associated one of a plurality of heat-generating electronic components, a plurality of liquid coolant inlet lines for delivering liquid coolant to the plurality of two-phase evaporators, and a plurality of vapor coolant outlet lines for evacuating vaporized coolant from the plurality of two-phase evaporators. The system may include a condenser having a condenser inlet for flow connection to the plurality of vapor coolant outlet lines and being configured to convert the vaporized coolant into the liquid coolant. The condenser may include a condenser outlet for flow connection to the plurality of liquid coolant inlet lines. The condenser may be configured for thermally coupling the secondary two-phase loop to the primary water loop to transfer heat conveyed from the plurality of heat-generating electronic components by the vaporized coolant to water flowing in the output water line.

Process 1150 may include a step 1154 of regulating vapor pressure in the plurality of vapor coolant outlet lines as a function of the signal to thereby control a temperature of the water in the output water line.

By way of a non-limiting example, in Figs. 1A and 11A, at least one processor 152 may receive at least one signal indicative of at least one of a pressure in plurality of vapor coolant outlet lines 1122 or a temperature in output water line 706 of system 700 for achieving a target water temperature in a facility where water is used as part of a process for electronics cooling. The system may include a primary water loop 712 including the output water line and an associated control valve 704. The system may include a secondary two-phase loop 1112 including plurality of two-phase evaporators 100. Each two-phase evaporator 100 may be in thermal contact with an associated heat-generating electronic component 110. Plurality of liquid coolant inlet lines 1120 may deliver liquid coolant to plurality of two-phase evaporators 100. Plurality of vapor coolant outlet lines 1122 may evacuate vaporized coolant from plurality of two-phase evaporators 100. System 700 may include condenser 702 having a condenser inlet 1124 for flow connection to plurality of vapor coolant outlet lines 1122. Condenser 702 may convert the vaporized coolant into the liquid coolant. Condenser 702 may include condenser outlet 1136 for flow connection to plurality of liquid coolant inlet lines 1120. Condenser 702 may thermally couple secondary two-phase loop 1112 to primary water loop 712 to transfer heat conveyed from plurality of heat-generating electronic components 100 by the vaporized coolant to water flowing in output water line 706. Processor 152 may regulate vapor pressure in plurality of vapor coolant outlet lines 1122 as a function of the signal to thereby control a temperature of the water in output water line 706. For example, processor 152 may receive a temperature signal from a temperature sensor associated with output water line 706 and/or a pressure signal from at least one pressure sensor associated with vapor coolant outlet lines 1122. In some embodiments, output water line 706 may be associated with a thermometer configured to transmit a water temperature signal to at least one processor 152, and/or each of vapor coolant outlet lines 1122 may be associated with a pressure sensor configured to transmit a vapor pressure signal to at least one processor. For example, each of flow control valves 1138 may include a pressure sensor and water line outlet 710 may include a temperature sensor.

Servers may include different types of electronic components (e.g., chips), each with varying thermal design power (TDP) levels. Higher TDP components may be more suited to certain cooling technologies and lower TDP components may be better suited to other cooling technologies. For instance, a two-phase cold plate (e.g., direct on chip) cooling system may be suitable for cooling high TDP components but may be less suitable for low TDP components, and air (e.g., in a single-phase loop) may be better suited for cooling low TDP components but may be less suitable for high TDP components. Consequently, applying any one of these technologies to cool a computing device having both high and low TDP components may result in sub-optimal heat capture. For example, of the total heat generated by a server, 70% of the heat may be produced by high TDP components, and 30% of the heat may be generated by low TDP components. Installing only a two-phase cold plate cooling system to a computing device having both high and low TDP components may effectively capture heat by the high TDP components (e.g., 70%) but may be ineffective in capturing heat generated by the low TDP components, (e.g., leaving as much as 30% of the heat output uncaptured). Similarly, installing only an air-based cooling system may effectively capture heat generated by the low TDP components (e.g., 30%) but may be ineffective (e.g., or less effective) in capturing heat generated by the high TDP components (e.g., 70%), thereby limiting heat capture to as little as 30%.

To allow capturing heat generated a by a server including both high TDP and low TDP components, a hybrid cooling system is disclosed herein including three fluidly isolated but thermally coupled loops. The first loop may be a two-phase coolant loop based on cold-plate technology to cool high TDP components. The second loop may be a single-phase air loop to cool low TDP components. The third loop may be a dual-purpose single-phase water loop to draw heat from both the first loop and the second loop, thereby allowing to capture up to 100% of generated heat.

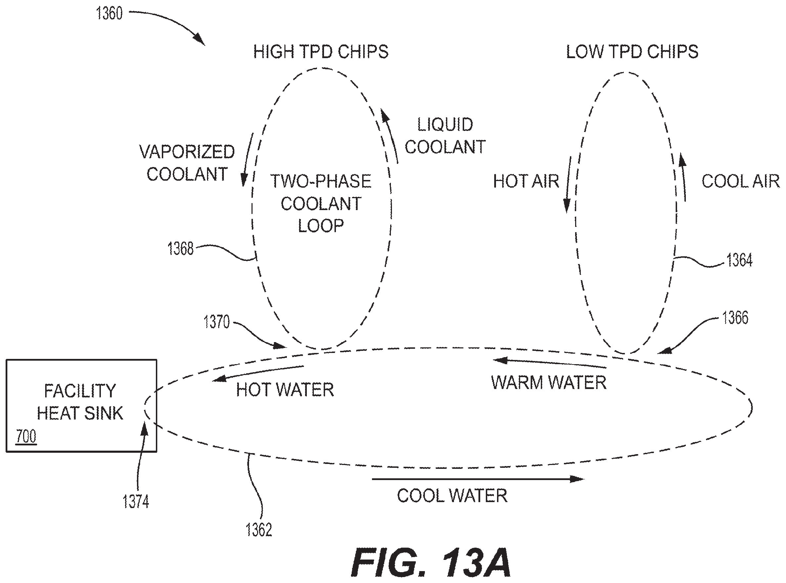

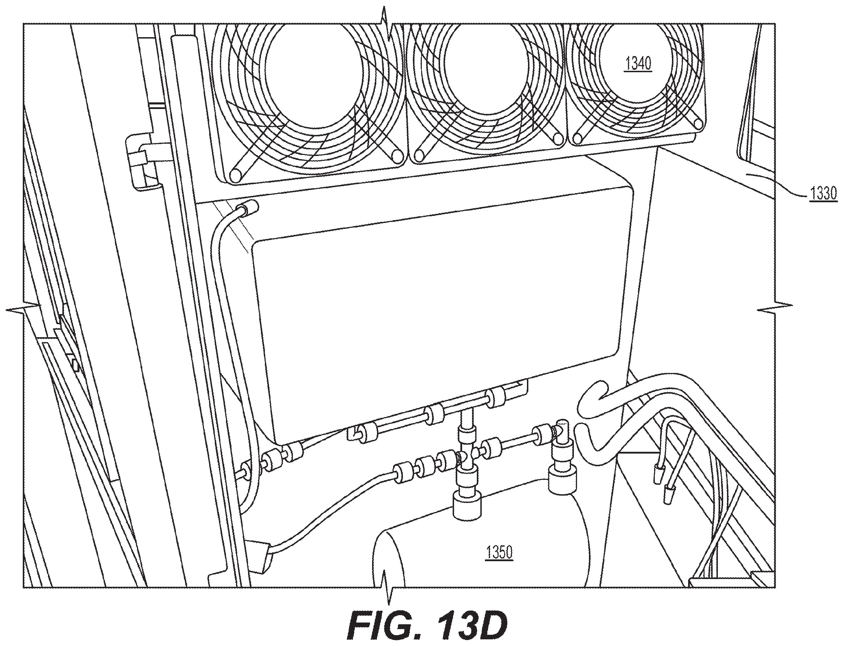

Referring to Fig. 13A, a hybrid cooling system 1360 may include a dual-purpose single phase water loop 1362 thermally coupled to a single-phase air loop 1364 at a first heat transfer location 1366, and to a two-phase coolant loop 1368 at a second heat transfer location 1370. First heat transfer location 1376 may allow transferring heat from low TDP components via air loop 1364 to water loop 1362, thereby converting cold facility water to warm water. Second heat transfer location 1370 may transfer heat from high TDP components via two-phase coolant loop 1368 to water loop 1362, thereby converting relatively warm facility water to relatively hot water. The hot water may flow to a facility heat sink 1372 associated with a third heat transfer location 1374 which may use the heat, thereby converting the hot water to cold facility water. The cold facility water may be pumped back to water loop 1362 in a cyclical manner for continued cooling.

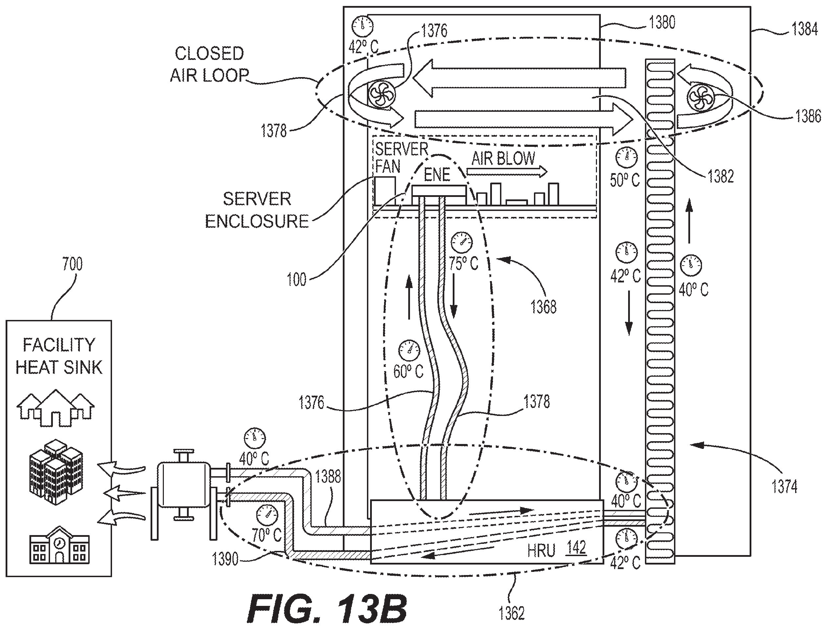

Reference is now made to Fig. 13B, showing a more detailed view of the hybrid cooling system of Fig. 13A. The two-phase coolant loop 1368 (liquid & gas) may include one or more ENEs 100, HRU 142, at least one pump (e.g., pump 146 of Fig. 1A), at least one processor 152 (see Fig. 1A), and optionally one or more valves (e.g., control valve 704 of Fig. 7 and/or flow control valves 1138 of Fig. 11A). Two-phase coolant loop 1368 may be suitable for high TDP components. Each ENE 100 may be thermally coupled to a different high TDP chip 110. Liquid coolant (e.g., at 60°C flowing in channel 1376 in Fig. 13B) may be pumped from HRU 142 to multiple ENEs 100 thermally coupled to heat-generating components 110 in the servers. Latent heat absorbed from high TDP components 110 may be transferred to the coolant, boiling the liquid coolant (e.g., via pool boiling) to produce vaporized coolant, which may heat the vaporized coolant (e.g., to 75°C). Heated vaporized coolant (e.g., flowing in channel 1378) may be collected (e.g., via the one or more valves) and may flow to condenser 702 of HRU 142. Condenser 702 may convert the vaporized coolant to liquid coolant using water in water loop 1362 at the same temperature, or cooler than the condensation point of the coolant (e.g., 60°C). The liquid coolant may be collected in a reservoir. Pump 146 of HRU 142 may pump the liquefied coolant to ENEs 100 on the servers in a cyclical manner for continued cooling. At least one processor 152 may monitor two-phase cooling loop 1368 and adjust the RPM of pump 146 and/or control valve 704 and/or flow control valves 1138 as necessary, e.g., to regulate water temperature flowing from HRU 142 to facility water system 700.

An ENE (Enhanced Nucleation Evaporator as described herein) 100 may be thermally coupled directly onto each high heat generating components 110 (e.g., CPU, GPU, FPGA) using cold plate technology. Liquid dielectric coolant may flow into each ENE via liquid coolant lines 120 (see Fig. 1C). An on-demand valve (e.g., float 200 in Fig. 2A) inside each ENE 100 may regulate inflow of liquid coolant. Latent heat emitted from component 110 may convert the liquid to vapor (e.g., pool boiling). The vapor may flow out of each ENE 100 via vapor line 122 and may be collected and delivered to condenser 702.

HRU 142 may include condenser 702, a reservoir 802 (see Fig. 8B), at least one processor 152, and at least one pump 142. Condenser 702 may collect vaporized coolant from ENEs 100. Condenser 702 may be thermally coupled to cool facility water. The cool facility water may cause the vaporized coolant introduced to condenser inlet 1124 to liquify to liquid coolant. The liquid coolant may be channeled to reservoir 802. The at least one pump 146 may pump the liquid coolant to the ENEs 100. At least one processor 152 may regulate the pump RPM to ensure reliable cooling.

Single-phase air loop 1364 may include one or more fans 1376 and a radiator 1374. This cooling technique may be suitable for low TDP components. Relatively cool air (e.g., at 42°C) may be introduced to a first side 1378 of a server rack 1380 (e.g., the front side) and may flow across the top of the servers in the server rack to a second side 1382 of server rack 1380 (e.g., the back side). The cool air may absorb heat from the server (e.g., including heat generated by low TDP components 110, thermally decoupled from the two-phase coolant loop), thereby cooling the low TDP components and heating the air (e.g., to 50°C). The heated air may be drawn to radiator 1374 located at second side 1382 of server rack 1380. Radiator 1374 may contain water at a cooler temperature (e.g., 40°C) than the air heated air (e.g., 50°C). The cool water in radiator 1374 may absorb heat from the heated air, thereby cooling the heated air (e.g., to 42°C) and heating the facility water to produce warm water (e.g., 42°C) in a first heat transfer. The cooled air may be pushed back to first side 1378 of server rack 1380 in a cyclical manner for continued cooling. In some embodiments, one or more server racks may be housed in a cabinet to isolate the air of the single-phase air loop from the ambient air. In some embodiments the single-phase air loop encompasses the volume (e.g., including all the shelves) of server rack 1380.

In some disclosed embodiments, server rack 1380 may be enclosed inside a cabinet 1384 containing the air of single-phase air loop 1364 as a closed loop. Cabinet 1384 may allow recapturing of waste heat, which may prevent heating the room (e.g., approaching 100% heat capture), saving costs for installing an air conditioner, and may allow transferring the heat to water flowing in water loop 1362 instead to produce relatively hotter water for facility 700. In addition, cabinet 1384 may allow maintaining a higher air temperature (e.g., 42°C) in air loop 1364 than the room temperature (e.g., 25°C), allowing to transfer additional heat to the water in water loop 1362. Consequently, water reaching facility heat sink may reach a sufficiently high temperature (e.g., 70°C) to provide additional utility.

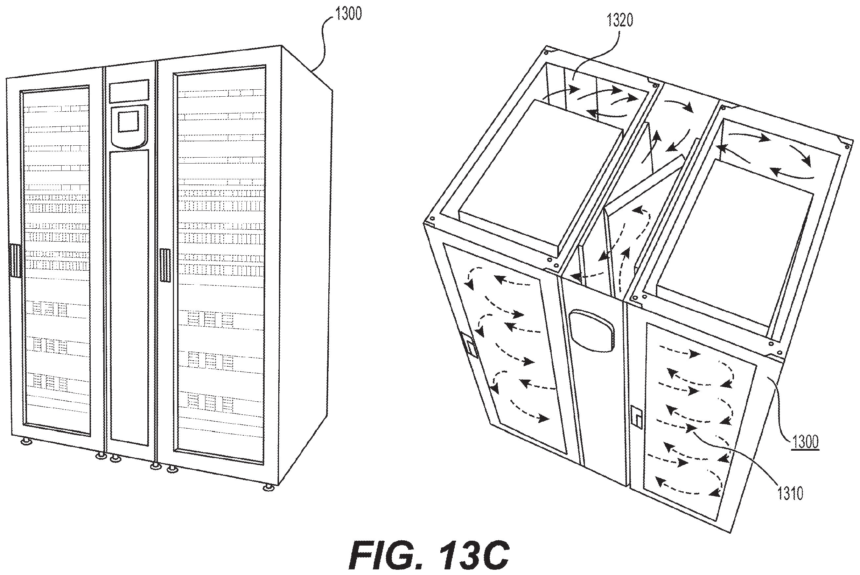

In some embodiments, fan 1376 (e.g., a first fan) is positioned at the first side 1378 of the server rack to push cool air across the server towards radiator 1374. In some embodiments, fan 1376 may be a server fan, such that there may be a first fan on each shelf of the server rack. In some embodiments, at least one second fan 1386 may be configured with radiator 1374 (e.g., opposite fan 1376), e.g., to draw heated air towards radiator 1374 and/or to push cooled air to first side 1378 in a cyclical manner. In some embodiments, radiator 1374 may be opposite the first side 1378. For example, first side 1378 may be the front of the server rack 1380 and radiator 1374 may be integrated in the rear door of the server rack). In some embodiments, two server racks may be positioned side-by-side, and the radiator may be positioned in the space between the side-by-side server racks (e.g., see Fig. 13C).

Dual-purpose single-phase water loop 1362 may include a cold-water channel 1388, a hot water channel 1390, facility heat sink 700, at least one pump 146, and radiator 1374. Water loop 1362 may collect heat from two-phase coolant loop 1368 and from single-phase air loop 1364 for delivery to facility heat sink 700. Relatively cold water (e.g., 40°C) may be pumped from the facility heat sink 700 to the base of radiator 1374 via cold-water channel 1388. At least one pump 146 may push the cold water up the length of radiator 1374. In some embodiments, radiator 1374 may extend to multiple shelves (e.g., every shelf) of server rack 1380. The relatively cold water (e.g., at 40°C) may absorb heat from the heated air (e.g., at 50°C) in single-phase air loop 1364 (e.g., drawing heat from low TDP components), heating the facility water to relatively warm water (e.g., to 42°C) in the first heat transfer location 1366 *(see* Fig. 13A). The relatively warm water may be at or below the condensation temperature (e.g., 60°C) for the coolant in the two-phase coolant loop 1368. The relatively warm water may flow to condenser 702 *(see* Fig. 13A) of the two-phase coolant loop 1368 where it may be thermally coupled to the vaporized coolant (e.g., at 75°C). The relatively warm water may absorb heat from the vaporized coolant (e.g., from the high TDP components), thereby liquefying the vaporized coolant (e.g., at 60°C) and heating the relatively warm water to produce relatively hot water (e.g., at 70°C). The relatively hot water may exit to the facility heat sink 700 (e.g., a building, greenhouse, manufacturing plant) where the heat may be used, thereby cooling the water. A pump may push the cooled water back to radiator 1374 in a cyclical manner for continued cooling.

For example, this may permit capturing heat from high and low TDP components and increase heat reuse efficiency by allowing less heat to be wasted by dissipating into the room, saving cost of air conditioning. Consequently, such a server cabinet configured with the hybrid cooling system may be suitable for installing in an office, hospital, or data center. In addition, capturing heat from high and low TDP components may produce hotter water for a facility. Furthermore, cooling high TDP components using ENEs may allow using warmer air (e.g., 42°C) than room temperature (e.g., 25°C) to cool lower TDP components, and may provide sufficient cooling.

Some disclosed embodiments involve a hybrid cooling system for cooling a server rack, the system comprising: a single-phase air loop including at least one fan and configured to draw heat from a plurality of low TDP components in the server rack; a two-phase coolant loop including a plurality of ENEs and an HRU, configured to draw heat from a plurality of high TDP components in the server rack; and a dual-purpose water loop configured to draw heat from the single-phase air loop during a first heat transfer stage, and draw heat from the two-phase coolant loop during a second heat transfer stage, thereby drawing heat from low TDP components and high TDP components in the server rack to produce hot water for facility heat sink.

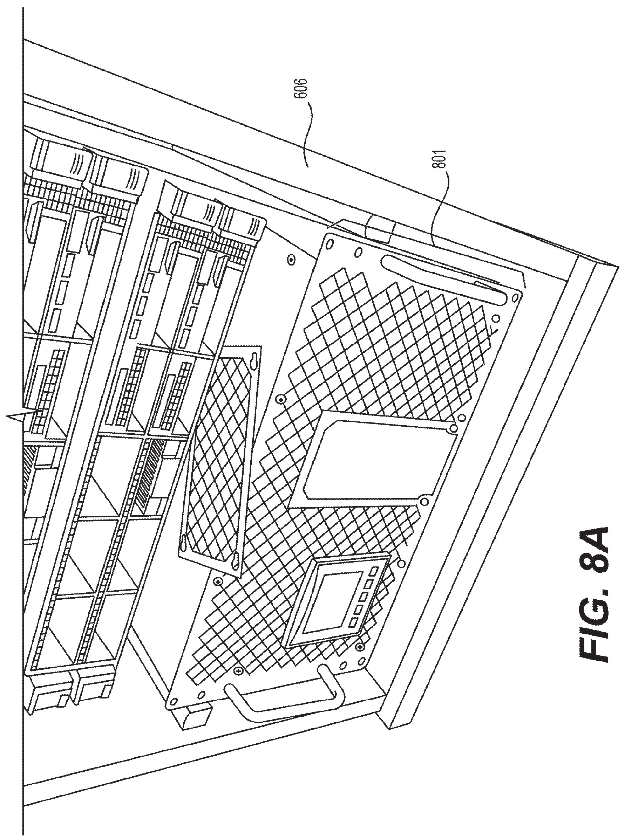

Some traditional system configurations involve a condenser positioned above a coolant reservoir to enable gravitational flow of coolant from the condenser to the reservoir. This configuration may require the use of several slots in a server rack, limiting the number of servers that may be accommodated in the rack. By way of example, Fig. 8A illustrates a server rack 606 having a condenser and reservoir in a gravitational-flow arrangement, requiring six slots (denoted by 801) of server rack 606. To save space in the server rack, an improved configuration may collocate the reservoir and the condenser at the same level on the rack using a one-way valve between the condenser and the reservoir.

Some disclosed embodiments involve an electronic component cooling system configured for mounting in a server rack having a plurality of slots with openings of predefined dimensions. A component refers to a single, individual unit and/or element. An electronic component refers to a device through which electricity may flow, as described and exemplified herein. A cooling system refers to an arrangement or apparatus of one or multiple cooling devices configured to expel heat. For example, a cooling system may draw heat away from a heat-generating device. Non-limiting examples of a cooling system may incorporate a fan, an air conditioner, a refrigerator, a heat pump, a coolant bath, or pool. A server rack refers to a frame or enclosure used to mount multiple electronic components. In some embodiments, the electronic components work together to form a computing system such as a computer server or a network of servers. Mounting refers to placing, setting, fixing, installing, attaching, securing, or otherwise situating a component. Mounting in a server rack thus refers to placing, fixing, installing, attaching, or otherwise situating in a frame or enclosure used to mount multiple electronic components. A plurality of slots with openings refers to a plurality of slits, notches, recesses, channels, or other openings in a server rack, the openings defining a plurality of server slots. A dimension refers to a measurable extent of something. Examples of dimensions include length, breadth, width, depth, or height. A predefined dimension refers to a dimension that is fixed in advance. Predefined dimensions are generally established in advance within a system, framework, or context, depending on the needs of the system design.

For instance, an electronic component cooling system may be configured to mount in a single or a plurality of positions or locations in a server rack. In some embodiments, an electronic cooling system is configured specifically for mounting in a fixed location or position in a server rack. In other embodiments, an electronic component cooling system may be mounted in various locations, positions, or openings in a server rack. This may allow the cooling system to removed, replaced, or otherwise repositioned. For example, an electronic component cooling system may be removed so it can be repaired or may be relocated to a plurality of other positions or locations in either the same or a different server rack.

Some disclosed embodiments involve a condenser sized for mounting at a particular level in the server rack. A condenser refers to a heat exchanger that transforms a substance in a gaseous state to a liquid state, thereby releasing latent heat stored therein. For example, a condenser may compress a vapor until the vapor transforms to liquid form. In another non-limiting example, a condenser may absorb heat from a vaporized coolant, causing the vapor to transform to liquid form. A level in the server rack refers to a vertical height within a server rack, typically defined by the bounds of a particular chamber, rack, shelf, or other opening within the server rack. A particular level in a server rack refers to a specific apposition within a server rack, as defined by the vertical height within the server rack or as defined by an individual or a plurality of server slots. Sized for mounting refers to the shape, height, or size of a condenser being adapted to fit with a server rack. For example, a condenser may be sized to enable the condenser to be mounted at a predetermined location or position in the server rack. In some embodiments, the condenser may be sized to be mounted in a particular level, defined by a specific server slot, within a server rack.

By way of a non-limiting example, Fig. 8B shows a condenser 800 sized for mounting at within the server rack 606. In other words, the size of condenser 800 is such that it fits within the server rack, in this instance at particular level 804. A condenser 800 mounted at a particular level 804 may save space in the server rack by facilitating collocation of the condenser and other components used in the electronic cooling system. The condenser may be sized to allow a plurality of other components to be mounted at the same particular level within the server rack.

Some embodiments involve a liquid coolant buffer sized for mounting at the particular level in the server rack, such that the buffer is mounted at least at the same elevation as the condenser. A liquid coolant refers to a cooling substance, as described and exemplified elsewhere herein, while in a liquid state. For example, vaporized coolant may undergo condensation to transform to liquid coolant. In an alternative example, a vaporized coolant may be compressed such that it transforms into liquid form. A buffer refers to reservoir or storage area for holding a fluid. A buffer may be used to store an item or material temporarily. Examples of a liquid coolant buffer include a reservoir, pool, basin, or other container that holds liquid coolant for the purposes of absorbing heat. An Elevation refers to the vertical position or location of the condenser in the server rack. The elevation of the condenser refers to the vertical elevation of the condenser within the server rack. The elevation of the liquid coolant buffer refers to the vertical position of the buffer within the server rack. In some embodiments, a liquid coolant buffer may be mounted at an elevation equal to or above the elevation of the condenser.

By way of a non-limiting example, Fig. 8B shows an example of a liquid coolant buffer as reservoir 802 mounted at the same level 804 as the condenser 800. This configuration positions the condenser at or below the position of the liquid coolant reservoir, resulting in a non-gravitational condenser-liquid coolant buffer arrangement.

Some embodiments involve a plurality of two-phase evaporators each for association with a plurality of differing electronic components distributed throughout the server rack at levels other than the particular level. A two-phase evaporator refers to a heat exchanging device that operates using two phases of matter. The two phases refer to liquid and gas such as vapor. More particularly, a two-phase evaporator enables evaporation of liquid in both a liquid and gaseous state. A two-phase evaporator may include, but it not limited to, an enhanced nucleation evaporator (ENE), as described and exemplified elsewhere herein. Association refers to a connection, coupling, junction, fastening, or other form of attachment or relationship. Association may involve a flow-based connection or coupling, such that a liquid or vapor flows between two associated components. Association to a plurality of differing electronic components refers to the association of a plurality of two-phase evaporators to a plurality of electronic component in such a way that allows heat exchange between the two-phase evaporators and the electronic components. Levels other than the particular level refers to elevations within the server rack other than the elevation of the liquid coolant buffer. For example, the liquid coolant buffer may be mounted at the lowest level of the server rack while a plurality of two-phase evaporators are associated with a plurality of heat-producing electronic components on a plurality of levels within the server rack. In such an arrangement, the liquid coolant buffer does not use the force of gravity to supply the two-phase evaporators with liquid coolant.

For instance, a plurality of two-phase evaporators may be associated with several liquid coolant lines within the electronic cooling system so the two-phase evaporators may absorb heat from electronic components within the server rack.

By way of a non-limiting example, Figs. 1A-1C show a two-phase evaporator such as ENE 100 associated with an electronic component 110 positioned within the server rack 154.

Some embodiments involve a vaporized coolant conduit for fluid coupling outlets of the plurality of two-phase evaporators with a vapor inlet of the condenser. A vaporized cooling conduit refers to a channel, pipe, tube, line, hose, or other means of facilitating the flow of gas for the purposes of refrigerating, chilling, or otherwise absorbing heat. Fluid coupling refers to connecting, linking, attaching, or otherwise joining to permit a flow. Coupling may involve connecting a plurality of openings, holes, gateways, ports, or other passageways. Coupling fluid outlets refers to connecting openings or passageways from which fluid flows so that said fluids may flow through the combined system. A vapor inlet refers to an inlet configured for introducing vapor, similar to a liquid inlet described and exemplified elsewhere herein. Fluid coupling an outlet with an inlet refers to connecting an outlet, passageway, or other type of opening through which fluid flows out to an inlet, passageway, or other type of opening through which fluid flows in. For example, the outlet of a two-phase evaporator may be coupled to the inlet of a condenser so that vaporized coolant may circulate through the vaporized cooling conduit, transporting coolant between a plurality of two-phase evaporators and the condenser.

By way of a non-limiting example, Figs. 6-7 show a vaporized coolant conduit 122 that fluidly couples the outlets of the two-phase evaporators such as ENEs 100 to the vapor inlet of condenser 702. Fluidly coupling the outlets of a plurality of two-phase evaporators enables heat to flow from a plurality of evaporators to the liquid coolant buffer and the condenser, forming a complete cooling cycle.

Some embodiments involve a liquid coolant conduit for fluid coupling an outlet of the liquid coolant buffer with inlets of the plurality of two-phase evaporators. A liquid coolant conduit refers to a channel, pipe, tube, line, hose, or other means of facilitating the flow of liquid for the purposes conveying a coolant. Fluid coupling refers to connecting, linking, attaching, or otherwise joining to permit flow. Inlets refer to openings or passages to which an inlet conduit can be connected for introducing coolant, in this context to two-phase evaporators. An outlet refers to an opening or passage through which something exits, in this context, an opening or passage in the buffer. Fluid coupling an outlet with an inlet refers to flow-connecting the outlet with the inlet. This can be accomplished through the interconnection of one or more tubes, pipes, lines, hoses or other conduits between the subject outlet and inlets.

By means of a non-limiting example, Fig. 1A shows a plurality of two-phase evaporators 100 fluidly connected to a liquid coolant buffer of HRU 142 (such as reservoir 802 shown in Figs. 8B and 8C) by liquid coolant conduits such as main liquid coolant line 120 and/or 148.

Some embodiments involve a plurality of pumps sized for mounting at the particular level in the server rack, such that the plurality of pumps are mounted at the same level as the condenser and the buffer, and wherein the plurality of pumps are configured for conveying liquid coolant to the plurality of two-phase evaporators for transferring heat to the condenser. A pump refers to a mechanical device or machine that moves fluids from one place to another. Pumps may move fluid including liquid and/or gas. In some embodiments, a pump moves fluid using pressure or suction. For example, a pump may compress fluids into a chambers, vessel, or other means for containing said gas or liquid. Alternatively, a pump may suction fluid from one vessel and provide hydraulic pressure to transport the suctioned fluid to a higher elevation. A pump may include a rotating propeller, helical rotor, screw, moving piston, or other type of moving component that displaces fluid and moves the fluid from one location to another. A pump sized for mounting refers to adapting the shape, height, or size of a pump to fit into a particular location, such as a particular level of a server rack. Mounting refers to placing, setting, fixing, installing, attaching, securing, or otherwise situating a component. A level of a server rack refers to a vertical height within a server rack, typically defined by the bounds of a particular chamber, rack, shelf, or other opening within the server rack. Mounting a plurality of pumps at the same level as the condenser and the buffer refers to mounting a plurality of pumps in same slot or group of slots in a server rack as the slot or slots where the condenser and buffer are located. For example, at least a portion, such as bases, of the condenser, the buffer, and the plurality of pumps may be mounted at the same elevation within the server rack. This may be accomplished, for example, by mounting the condenser, buffer, and the plurality of pumps in a single server slot of a server rack. Conveying refers to transporting or transmitting something from one place to another. An item or material, such as liquid coolant, may be transported through a mechanism through one or more conduits or pipelines. Pumps configured for conveying liquid coolant refers to pumps that are capable of and purposed for transporting liquid coolant to various levels within a server rack. For example, a plurality of pumps may be associated with the buffer so that liquid coolant may be pumped from the buffer to a plurality of two-phase evaporators. In such an arrangement, the plurality of pumps must be capable of creating sufficient pressure or suction to transport the liquid coolant. Such pumps may be designed to move liquid coolant to a higher or lower elevation of the server rack, depending on the design needs of the system.

By means of a non-limiting example, Fig. 8B shows a reservoir 802 of a HRU 142 (shown in Fig. 1A), a condenser 800, and a plurality of pumps 146 all mounted at the same level 804 within the server rack 806. In this non-limiting example, the reservoir 802, condenser 800, and the plurality of pumps 146 are all mounted in the same horizontal plane within the server rack 806. As shown in Fig. 1A, at least one pump 146 of HRU 142 may be configured to convey liquid coolant to one or more two-phase evaporators such as ENE 100, via one or more conduits such as liquid coolant lines 120 and 148.

Some embodiments involve a one-way valve fluidly coupling a liquid coolant outlet of the condenser to a liquid coolant inlet of the buffer, the one-way valve configured to prevent liquid coolant backflow from the buffer to the condenser. A one-way valve refers to a component, outlet, opening, spout, mouth, or other form of passageway or conduit that enables only the monodirectional flow of liquids or gasses, preventing backflow in an opposite direction. Fluidly coupling refers to connecting, linking, attaching, or otherwise joining a plurality of openings, holes, gateways, ports, or other passageways from which fluid flows so that said fluids may flow through the combined system. Fluidly coupling an outlet with an inlet may be interpreted as previously described. (e.g., connecting the outlet, passageway, or other type of opening through which fluid flows to an inlet, passageway, or other type of opening through which fluid flows. This may be accomplished through the interconnection of one or more tubes, pipes, lines, hoses or other conduits between the subject outlet and inlet. Backflow refers to a reverse flow of fluid. Backflow involves movement of fluid in a system in an opposite direction than the intended direction. Backflow can occur when pressure in a system drops or changes, causing a flow of fluids to reverse. An example of backflow is back-siphonage, in which system pressure drops creating a vacuum that sucks fluid backward. Another example of backflow is backpressure, in which the fluid pressure at the destination side of a fluid path exceeds the pressure at the fluid source, causing the fluid to reverse direction. Configured to prevent liquid coolant backflow refers to having one or more mechanisms that avoid or stop reverse flow of liquid coolant. In some embodiments, backflow is prevented using a one-way valve. A one-way valve is sometimes referred to as a check valve or a non-return valve. Examples of configurations of one-way valves include swing check valves, spring-loaded check valves, diaphragm check valves, and ball check valves. Backflow from the buffer to the condenser refers to the movement of fluid from the buffer reservoir to the condenser, in the opposite direction as during normal operation. A one-way valve may prevent the backflow of fluid from the buffer reservoir by closing in response to a pressure change within the system. For example, if gravitational forces promote backflow to the condenser, a one-way valve may prevent such an unintended result by stopping flow from occurring in the direction of the gravitational force. Further, a one-way valve may prevent backflow without requiring a repositioning of the buffer (such as reservoir 802) at a level lower than the condenser.

Some embodiments involve a plurality of pumps that arc swappable while the condenser is operating. Swappable refers interchangeable, exchangeable, or otherwise capable of being substituted. A pump that is swappable while the condenser is operating refers to a pump that may be removed, replaced, or otherwise substituted while the condenser is actively functioning. Swapping during operation is sometimes referred to as hot-swapping. For example, one or more pumps may be disconnected and removed from the condenser while the electronic cooling system continues to function. Another pump may be installed in place of the removed pumps, without ceasing operation. Thus, a pump that ceases to operate may be removed and replaced with a similar or identical pump while the condenser continues to function, to maximize system performance while minimizing or eliminating operational downtime.

By way of a non-limiting example, Figs. 8B and 8C show a plurality of pumps 146 arranged in an electronic cooling system and connected to a condenser 800. For example, a pump 146 could be removed from the system and replaced with a different pump, without disrupting the operation of the condenser 800.

Further referring to Figs. 8B-8C, HRU 142 may include a condenser 800 collocated with a reservoir 802 (e.g., a liquid coolant buffer) and a plurality of pumps 146 at a same level 804 of a server rack 806. A one-way valve may be provided with a tube connecting condenser 800 and reservoir 802 to prevent backflow of liquid coolant to condenser 800. For example, reservoir 802 of HRU 142 may be flow connected to multiple ENEs 100 via pumps 146 (as shown in Fig. 1AA) and liquid coolant lines 120 and 148 (e.g., delivering liquid coolant from reservoir 802 to ENEs 100). Similarly, condenser 800 of HRU 142 may be flow connected to multiple ENEs 100 via vapor coolant lines 122 and 150 (e.g., delivering vapor coolant from ENEs 100 to condenser 800). In some embodiments, pumps 146 may be "hot swappable", e.g., switchable while condenser 800 is operating. In some implementations, condenser 800, reservoir 802 and pumps 146 may be located on a base (c.g., a pedestal base) mounted on a particular shelf (e.g., the bottom shelf) of a server rack.

In some disclosed embodiments, at least one of the plurality of pumps is a positive displacement pump. A positive displacement pump refers to a pump (as previously defined) that uses of pressure to force the motion of fluid through a system. A positive displacement pump may use a piston, plunger, gear, diaphragm, or other mechanical means of increasing pressure in the pump system to move liquid or gas through the system. For example, a positive displacement pump may include a rotary pump or a reciprocating pump. A positive displacement pump may be used to move a fluid between vessels at various elevations or pressures. For example, a positive displacement pump may be used to transfer a fluid between a vessel at a lower elevation to a vessel at a higher elevation. A positive displacement pump can further be used to increase the potential energy of the displaced fluid. In an alternative arrangement, a positive displacement pump may be used to transfer fluid from a chamber of lower pressure to one of higher pressure.

By way of a non-limiting example, Figs. 8B-8C show a pump 146 which may be a positive displacement pump. In such a configuration, a plurality of pumps (e.g., positive displacement pumps) enable the non-gravitational transfer of fluid form the condenser 800 to the reservoir 802. By way of another non-limiting example, Fig. 1A shows a pump 146 used to transport coolant through the main liquid line 148 from the reservoir 802 (e.g., reservoir) to the two-phase evaporators 100.

In some disclosed embodiments, at least one processor is configured to operate the plurality of pumps. A processor refers to an electrical device as described and exemplified elsewhere herein. Operate refers to use or control a device in a manner that allows it to perform its intended function. Operating a pump may involve one or more steps including providing electrical power to the pump and controlling a speed or volume displacement rate of the pump. A processor may be programmed, designed, or otherwise configured to control a plurality of pumps in response to some data input. For example, the plurality of pumps may be manipulated in response to a human input or to an external data source. In another non-limiting embodiment, a processor may automatically manipulate the operation of a plurality of pumps according to predetermined operating instructions or operating parameters. For example, a processor may increase or decrease the volume of pumped fluid in response to operating data generated by the cooling system.

By way of a non-limiting example, Fig. 1A shows a processor 152 that is used to control at least one pump 146.

In some disclosed embodiments at least one of the condenser, the buffer, and the plurality of pumps includes a pedestal base, and wherein the bottom of the pedestal base is mounted at the particular level. A pedestal base refers to a stand, foundation, platform, or other structure that provides physical, mechanical support. A pedestal base may include a freestanding structure or a plurality of independent structures or mechanisms. For example, a pedestal base may be connected to a component in the electronic cooling system by way of a single or a plurality of connection points. The bottom of the pedestal base refers to the lowest part or the lowest-lying part or surface of the pedestal base. In some embodiments, a pedestal base may be adjustable or moveable. For example, a pedestal base may be adjustable, enabling the pedestal base to move components to various vertical heights.

In some disclosed embodiments, the particular level encompasses two server slots in the server rack. The particular level refers to a specified location, position, elevation, or other vertical height. Within a server rack, the particular level refers to a specified slot or a plurality of specified slots such that the particular level includes all of the physical space existing in a horizontal plane between physically separated vertical chambers or openings within the server rack. A server slot refers to a particular chamber, rack, shelf, or other opening within the server rack. The particular level that encompasses two server slots refers to the entirety of space occupied by two adjacent server slots within a server rack. For example, the particular level encompassing two server slots could be the two most lower server slots within a server rack. However, the particular level need not be the bottommost position within the server rack.

By way of a non-limiting example, Fig. 1A shows a HRU 142 placed at the lowermost server slot of the server rack 154. By way of another non-limiting example, Fig. 8A shows a HRU occupying multiple slots of a server rack, consistent with some disclosed embodiments.

In some disclosed embodiments, the particular level encompasses a single server slot in the server rack. The particular level refers to a specified location, position, elevation, or other vertical height as disclosed and exemplified herein. A server slot refers to a particular chamber, rack, shelf, or other opening within the server rack as previously disclosed and exemplified herein. A single server slot in the server rack refers to an individual chamber or area within the server rack, having a physical separation from other server slots in the server rack.

By way of a non-limiting example, Fig. 8B shows a cooling system mounted in a single server slot in the server rack 606. A condenser 800, a reservoir 802, and a plurality of pumps 146 are mounted and located at level 804 in the server rack, occupying a single server slot.

In some disclosed embodiments, the two server slots are the lowermost slots in the server rack. In some disclosed embodiments, the single server slot is the lowermost slot in the server rack. Lowermost slots refer to server slots that are located at the bottom or base of the server rack, such that there are no other server slots at a lower elevation. The lowest slot refers the slot that is closest to the bottom of the server rack, such as at ground level. The two lowermost slots include the lowest individual server slot and the server slot directly above said lowermost server slot. For example, the lowermost two server slots may include the lowest slot and the second to lowest slot in a server rack.

By way of a non-limiting example, Fig. 8B shows a cooling system mounted in a single server slot at level 804 in the server rack 806. A condenser 800, a reservoir 802, and a plurality of pumps 146 may be mounted and may be located at level 804 in the server rack, occupying only a single server slot.

In some disclosed embodiments, a level of the vapor inlet of the condenser is lower than a level of the liquid outlet of the condenser. A vapor inlet refers to a vent, opening, hole, gap, or other entryway through which a gas can pass. A vapor inlet of the condenser refers to the entryway or opening through which vaporized coolant enters the condenser. A level lower than that of the liquid outlet of the condenser refers to a position or location that is below, or at a lower elevation, than the condenser outlet. For example, the vapor inlet of the condenser may be closer to the base of the server rack than the vapor outlet of said condenser.

In some disclosed embodiments, a level of a center of the vapor inlet of the condenser is below a level of a center of the liquid outlet of the condenser. A center of the vapor inlet refers to the point of the vapor inlet that most equalizes the distance between said center point and the edges, exterior, or walls of the vapor inlet. For example, the center of a circular vapor inlet would be the central axis of the circle. Similarly, the center of a rectangular vapor inlet would be equidistant from all sides of the square that defines the exterior of the vapor inlet. A center of the liquid outlet refers to the point of the vapor outlet that most equalizes the distance between said center point and the edges, exterior, or walls of the liquid outlet. Below a level of center of the liquid outlet refers to a position that is closer to the bottom of the server rack than the center of the liquid outlet. For example, the vapor inlet may be positioned entirely below the liquid outlet of the condenser. In an alternative, non-limiting example, the top of the vapor inlet may be positioned at a higher elevation than the bottom of the liquid outlet. In such an embodiment, the center of the liquid outlet is positioned at a higher elevation than the center of the vapor inlet.

By way of a non-limiting example, Fig. 1A shows a liquid coolant line 146 connected to a liquid coolant outlet of HRU 142 near the bottom of the HRU 142. A vapor line 150 is connected to HRU 142 at a vapor inlet above the liquid coolant outlet. Fig. 7 shows internal components of HRU 142, including condenser 702. A vapor inlet of condenser 702 may be at a lower level than a level of the liquid coolant outlet of condenser 702. By positioning the liquid coolant outlet above the vaporized coolant inlet, the buffer can be collocated with the condenser, and the condenser does not need to occupy a separate server slot in the server rack. Fig. 8B illustrates another example of a buffer (reservoir 802) collocated with a condenser 800.

In some disclosed embodiments, a cross-sectional area of the vapor inlet is greater than a cross-sectional area of the liquid coolant outlet. A cross-section refers to a two-dimensional shape, in this context, a two-dimensional shape of an opening. A cross-section is usually viewed in a plane perpendicular to a main axis of the object. For example, a cross section of a round tube is a circle, whereas a cross section of a cube is a square. A cross-sectional area refers to an area of the two-dimensional shape resulting from a plane intersecting the object. An area is calculated using one or more dimensions of the cross-section, such as a diameter, a radius, a length, a width, a height, a diagonal, an angle, the value pi, or any other measurable dimension of the cross-section. A cross-sectional area of the vapor inlet refers to an area of a plane is normal to the direction of the flow of fluid. Similarly, a cross-sectional area of the liquid coolant outlet refers to the resulting two-dimensional figure when a plan intersects the liquid outlet such that the plane is normal to the direction of the flow of fluid. For example, the cross-sectional area of a circular vapor inlet would be circular. A vapor inlet cross-sectional area greater than that of the liquid coolant cross-sectional area refers to a cross-sectional area of the vapor inlet that having a larger value than that of the liquid outlet.

With reference to Figs. 1A, 8B, and 8C, in some embodiments, due to a larger volume for an amount of vaporized coolant vs the same amount of liquid coolant, a diameter or circumference of vapor line 150 may be larger than a diameter of circumference of a tube delivering liquid coolant from condenser 800 to reservoir 802. Consequently, a level (e.g., of a center) of a vapor inlet on condenser 800 coupled to vapor line 150 may be lower than a level of a liquid outlet of condenser 800 for conveying liquefied coolant to reservoir 802. The one-way valve on the tube connecting condenser 800 to reservoir 802 may prevent liquefied coolant from flowing away from reservoir 802 towards condenser 800 (c.g., to prevent backflow of liquefied coolant from reservoir 802 to condenser 800).

Some disclosed embodiments involve a water line thermally coupled to the condenser to enable water flowing in the water line to receive heat conveyed by vaporized coolant flowing from the plurality of two-phase evaporators. A water line refers to a tube, hose, cylinder, pipe, conduit, channel, or other means of carrying or allowing the flow of water. Thermally coupled refers to enabling the exchange of heat between two or more bodies or fluids. A water line thermally coupled to the condenser refers to a water line as previously described that is configured such that heat may be exchanged between the water or liquid flowing through the water line and the vaporized coolant. To receive heat refers to gaining or absorbing thermal energy from a heat source, such as a surrounding environment that is of a higher temperature. Heat can be transferred from one object to another due to, for example, temperature differences. Receiving heat typically involves an increase in temperature or a change in internal thermal energy. For example, the water line may have a thermally conductive coating or may be made from a thermally conductive material, which may allow the water or liquid in the line to absorb heat generated from the electronic components in the system. Or, in an alternative configuration, the water line may be positioned or located near, outside of, or within the condenser to enable heat to pass from the vaporized coolant to the liquid within the water line.

By means of a non-limiting example, Fig. 7 shows a condenser 702 with a valve 704 that may be thermally coupled to a facility water system 700. This non-limiting embodiment may allow heat absorbed by the vaporized coolant to be transferred to the facility water system 700 through a thermally coupled water line.

In some disclosed embodiments, the water line is associated with a facility where water is used as part of a process for electronics cooling. A facility refers to a building, place, equipment, or other installation. A facility where water is used for electronics cooling refers to a facility that uses water as a heat sink to absorb heat generated from electronic components.

By way of a non-limiting example, Fig. 7 shows a condenser that is connected to a facility where water is used as part of a process for cooling electronic components. In some embodiments, the water from the facility may enter the condenser and exchange heat with the vaporized coolant. In further alternative embodiments, the water from the facility may convert the vaporized coolant to liquid form, heating the facility water.

In some disclosed embodiments, the water line is included in a water loop configured to convey heated water to the facility and return cooled water to the condenser. A water loop refers to an arrangement of one or more components configured for water circulation therethrough. A water loop may be a closed-loop system involving one or more pipes, tubes, and other components. A water loop configured to convey heated water refers to a circulation of water that has absorbed heat from one or more heat sources. For example, a water loop may involve water cycling between hot and cold reservoirs. In an alternative arrangement, a water loop may be thermally coupled to various components in a system (such as, but not limited to, a condenser), allowing heat to be exchanged in a closed loop such that the water in the water loop does not exit the system. In another alternative example, a water loop may be replenished or the quantity of water in the loop may be modified. A water loop that can be replenished may allow the water facility to serve as a heat sink, providing cooled water to the condenser.

In some disclosed embodiments, a vapor coolant manifold is distributed over a plurality of levels in the server rack, wherein the vaporized coolant conduit is integrated with the vapor coolant manifold. A manifold may be understood as described elsewhere herein. For example, a manifold may refer to a structure or device that serves a hub or distribution point for the flow of something. A manifold may be a pipe, housing, channel, chamber, reservoir, or other opening that is fed by smaller pipes, channels, or openings. For example, a manifold may control or manipulate the supply of several channels of fluid to a single outlet. Alternatively, a manifold may supply a plurality of outlets. A vapor coolant manifold refers to a manifold which is configured to contain gaseous coolant, as previously described and exemplified herein. For example, a vapor coolant manifold may enable a single inlet or a plurality of inlets of vaporized coolant to combine into a single or a plurality of vapor coolant outlets. Distributed over a plurality of levels in the server rack refers to a vapor coolant manifold that transports vaporized coolant to a plurality of two-phase evaporators at a plurality of heights within the electronic component cooling system. For example, a vapor coolant manifold may provide several outlets for vaporized coolant. In some disclosed embodiments, a vapor coolant manifold may connect a single outlet of vaporized coolant to a plurality of vaporized coolant inlets. As another non-limiting example, a vapor coolant manifold may connect a plurality of vaporized coolant outlets to a single vaporized coolant inlet of the condenser.

By way of a non-limiting example, Fig. 1A shows RDU 144 which houses a vapor coolant inlet that is supplied by a vaporized coolant line 122, leading to a unified vaporized coolant inlet through vapor coolant line 150. In another non-limiting example, Fig. 10D shows a vapor manifold 1008 mounted along a side of the server rack having multiple vapor ports distributed along the length of the server rack. Vaporized coolant may flow via vapor manifold 1008 from two-phase evaporators thermally coupled to electronic components 110 on shelves 1004.

Some disclosed embodiments involve a liquid coolant manifold that is distributed over a plurality of levels in the server rack, wherein the liquid coolant conduit is integrated with the liquid coolant manifold. Distributed over a plurality of levels in the server rack refers to a liquid coolant manifold that transports vaporized coolant to a plurality of two-phase evaporators in a plurality of elevations within the electronic component cooling system.

By way of a non-limiting example, Fig. 1A shows RDU 144 which houses a liquid coolant inlet that is supplied by a liquid coolant line 120, leading to a unified liquid coolant inlet through liquid coolant line 148. In another non-limiting example, Fig. 10D shows a liquid manifold 1018 mounted along a side of the server rack having multiple liquid coolant ports distributed along the length of the server rack. Liquid coolant may flow via vapor manifold 1018 from a condenser that is thermally coupled to electronic components 110 on shelves 1004.

Some disclosed embodiments involve a plurality of controllable valves that arc each associated with a different outlet of a different one of the plurality of two-phase evaporators. A valve refers to a device that regulates or manipulates the flow of fluid. A controllable valve refers to a valve which regulates or manipulates the flow of fluid in response to an instruction from a controller. For example, a controllable valve may be operated through electronic components, and my respond to instructions or operations sent from a digital device. In another non-limiting example, a controllable valve may respond to manual input. Each associated with a different outlet refers to each controllable valve being installed to manipulate or control a specific outlet from a two-phase evaporator such as ENE 100.

Some disclosed embodiments involve at least one processor configured to control the plurality of controllable valves, thereby controlling vapor pressure in the vaporized coolant conduit. A processor refers to any physical device or group of devices having electric circuity that performs a logic operation on an input or inputs as described and exemplified elsewhere herein. A processor configured to control the plurality of controllable valves refers to a processor which is electrically (e.g., digitally) connected to a controllable valve in such a way that digital instructions from the processor manipulate the state of the valve, thereby manipulating the flow of liquid through the valve. For example, a processor may respond to a data feed from sensors within the system and adjust the state of the valves to modify the level of heat reduction in the system. In another alternative embodiment, a processor may respond to a human input, allowing the controllable valves to be manipulated. In another non-limiting example, the controllable valves may be automatically controlled by instructions send from a processor accordingly to predefined instructions or operating parameters.

Some disclosed embodiments involve a float valve associated with each of the plurality of two-phase evaporators and configured to control an inflow of liquid coolant to each of the plurality of two-phase evaporators from the condenser. A float valve may be understood as described and exemplified elsewhere herein. A float valve may serve as a valve that uses a floating device to manipulate the operation of the valve. For example, a float valve may be configured to maintain water in a chamber at a specific level. In an alternative embodiment, a float valve may be used to prevent a chamber from overflowing or from over-pressurization. A float valve associated with each of the plurality of two-phase evaporators refers to a plurality of float valves, each configured to regulate or manipulate the quantity of liquid coolant entering the two-phase evaporators. Configured to control an inflow of liquid coolant refers to a float valve that is capable of increasing and reducing introduction of liquid coolant in response to the operating parameters of the cooling system.

By way of non-limiting example, Figs. 1B, and 2A-2C illustrate a two-phase evaporator such as ENE 100 that may include a float value 200, as described and exemplified elsewhere herein.

To save space in a server rack, a condenser unit of an HRU may be mounted on the door of the server rack. A reservoir of the HRU may be located elsewhere, e.g., at the bottom of the server rack.

Some disclosed embodiments involve a system for cooling servers mounted in a server rack having opposing sides, a door opening, and a plurality of distributed slots for holding the server. A system refers to a set of interconnected components working together to achieve a specific function, as described and exemplified elsewhere herein. For example, a system may include only hardware. Some systems may include software, and/or firmware components. Cooling refers to the process of removing or reducing heat, as described and exemplified elsewhere herein. For example, cooling may involve the use of fans, heat sinks, or liquid cooling systems. Servers refer to computer hardware and/or computer software that provide services to other programs or devices. Cooling servers refers to the process of absorbing heat generated by servers, computers, or other heat-generating electronics components. For example, cooling servers may involve transferring heat from a server to a medium capable of absorbing thermal energy. In some instances, cooling servers may involve convection, conduction, diffusion, radiation, and/or advection. A server rack refers to a structure designed to house servers and related equipment, as described and exemplified elsewhere herein. A server rack may have a plurality of shelves, slots, bays, or other openings for holding servers and related equipment. Mounted refers to being installed or fixed in position. For example, something may be mounted using screws, brackets, or other hardware to secure a component. A system mounted in a server rack thus refers to components placed, fixed, installed, attached, or otherwise situating in a frame or enclosure used to mount multiple electronic components. Opposing sides refer to two or more sides of an object or structure that face each other. For example, opposing sides may include the left and right sides of a server rack. A door opening refers to a gap or space that allows access to an interior space via a door. For example, a door opening may be exposed upon opening a door, which refers to a panel or physical barrier that can be removed or opened. A plurality of distributed slots refers to openings that are configured to hold servers. For example, a server rack may have a plurality of distributed slots, sometimes known as server slots.

For instance, a system for cooling servers may be mounted in a single server slot inside of a server rack. Or, in an alternative embodiment, a system for cooling servers may be mounted on or within the structure and/or surfaces of the server rack. In another non-limiting example, a system for cooling servers may have individual components distributed across a plurality of server slots and/or mounted on a plurality of server slots.

By way of a non-limiting example, Fig. 1A illustrates an exemplary two-phase cooling system 140 including multiple Enhanced Nucleation Evaporators (ENEs) 100, each thermally coupled to a heat-generating electronic component, a heat rejection unit (HRU) 142, and a Refrigerant Distribution Unit (RDU) 144, consistent with disclosed embodiments. As illustrated in Fig. 1A, HRU 142 is mounted in server rack 141, having an opening and two opposing sides. In some instances, coolant is distributed from HRU 142 through RDU 144 to one or more server rack shelves 154 in server rack 140.

Some disclosed embodiments involve a door configured to be mounted at the door opening and to pivot on a hinged side between an open and closed position. A door refers to a physical barrier that serves as an entrance or access point into a structure. To pivot refers to the action of turning or rotating around a point. For example, to pivot may involve a door moving around a vertical axis running along one side of the door. A hinge refers to a jointed or flexible device that allows an object to pivot. A hinged side refers to the side of an object to which one or more jointed or flexible devices are attached. For example, a hinged side may include the side of a door that is attached to a door frame by one or more hinges. An open position refers to the state of a movable object when it is not in its closed or resting position. For example, an open position may include a door that is positioned to allow access to the interior of a structure. A closed position refers to the state of the door when it is not open, providing a barrier between the inside and outside of a structure. For example, a closed position may include a door positioned to restrict access to a structure.

For instance, a door may be configured to pivot on a hinged side of a server rack, enabling the door to restrict access to a server rack and/or the components within a server rack. The door may be operated manually or automatically and may incorporate other components such as locks, latches, handles, springs, pistons, struts, or other hardware that enables the door to pivot between an open and closed position.

By way of non-limiting example, Fig. 10D shows a door 1002 mounted to the hinged side of a server rack. Door 1002 is shown in an open position such that the interior of the server rack slots 1004 are exposed and/or accessible. Door 1002 may be pivotable such the opening to the server rack is restricted while allowing the vapor manifold 1008 to stay fluidly connected to door 1002 in a plurality of positions and/or while pivoting.

Some disclosed embodiments involve at least one condenser mounted on the door and having a condenser vapor inlet port, the at least one condenser being pivotable with the door when the door is moved between the open position and the closed position. A condenser is described and exemplified elsewhere herein. A condenser mounted on the door refers to the location of a condenser on a door, such that the condenser moves with the door and does not impair the typical function of the door. For example, the condenser may be mounted within the structure of the door. In some instances, a condenser may be mounted on the inside plane or exterior plane of the door. A vapor inlet port refers to a vent, opening, hole, gap, or other entryway through which a gas can pass. A condenser vapor inlet port refers to the entryway or opening through which vaporized coolant enters the condenser. Pivotable refers to the ability of an object to pivot, as described and exemplified elsewhere herein. A condenser being pivotable refers to a condenser which is configured such that it is capable of pivoting, as previously described and exemplified herein. A condenser being pivotable with the door refers to configuring the condenser such that the condenser pivots in unison, and to the same degree, as the door to which the condenser is mounted. A condenser pivotable when the door is moved refers to a condenser that pivots as the door pivots, enabling the condenser to stay associated with the door in a plurality of positions. Moved between the open position and the closed position refers to pivoting such that the door opening is enlarged, reduced, or otherwise changed.

For instance, a door may begin in an open position, having a condenser mounted to the door. The door may be pivoted, causing the condenser associated to the door to pivot with the door. As the door pivots from an open position to a closed position, the condenser may pivot to the identical position as the door. In some instances, the pivoting of the door between open and closed positions may occur while the cooling system is operating or while the condenser and the vapor manifold remain fluidly connected.

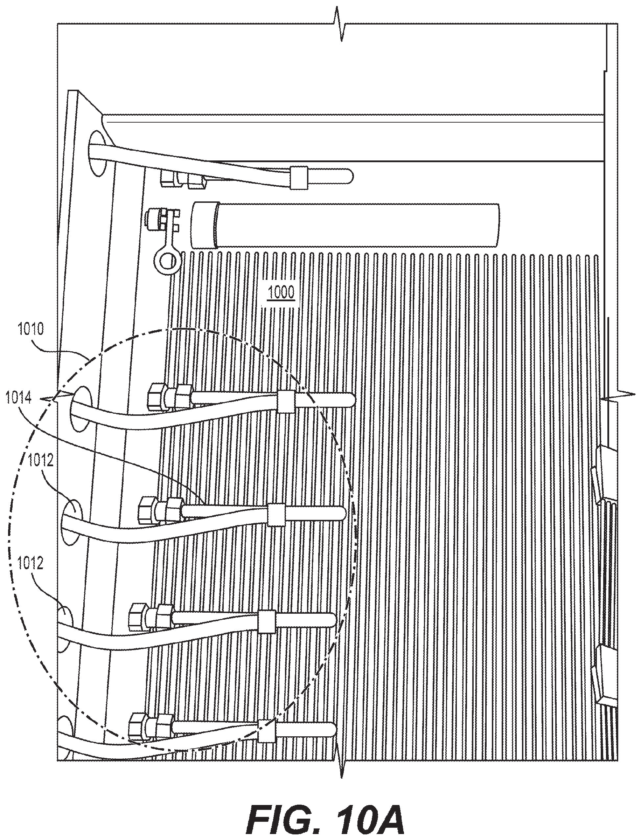

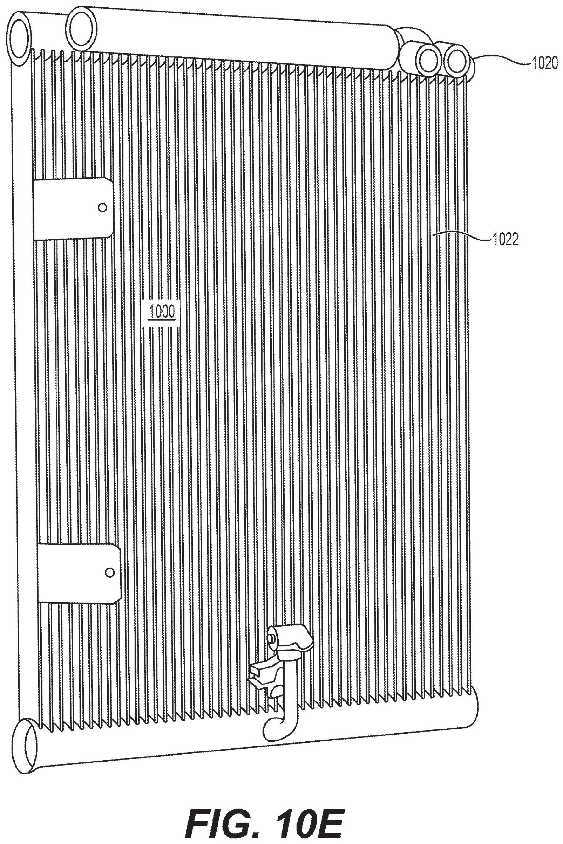

By way of non-limiting example, Figs. 10A-10C and 10E show a condenser 1000 that may be mounted on a door, such as door 1002 of Fig. 10D. The condenser may have a vapor inlet port. Fig. 10D shows a door 1002 that may be pivotable, allowing to open and close door while the servers and condenser 1000 are operating, e.g., condenser 1000 may be pivotable with door 1002. A rack vapor manifold 1008 (e.g., white tubes) may be mounted along a side of the server rack having multiple vapor ports distributed along the length of the server rack, each port may be associated with a different one of slots or shelves 1004. Vaporized coolant may flow via rack vapor manifold 1008 from ENEs 100 thermally coupled to electronic components 110 on shelves 1004 to condenser 1000 fitted inside door 1002. In some embodiments, a rack liquid manifold 1018 (e.g., shaded tubes) may be mounted along the side of the server rack with multiple liquid ports distributed along the length, each liquid port configured to convey liquid coolant from the reservoir to the ENEs 100.

Some disclosed embodiments involve at least one rack vapor manifold configured for mounting along a side of the rack, and having a plurality of rack vapor inlet ports distributed along a length of the rack for association with the plurality of distributed slots, the rack vapor inlet ports being arranged to receive coolant vaporized by heat of electronic components associated with the servers, the at least one vapor manifold further including a plurality of rack vapor outlet ports. A manifold may be understood as described and exemplified elsewhere herein. For example, a manifold may serve as a distribution hub. A rack vapor manifold refers to a manifold designed to facilitate collection and transportation of vapor. In some instances, a rack vapor manifold may collect vapor from multiple sources, channeling the comingled vapor to a singular or plurality of outlets. In some embodiments, a rack vapor manifold provides structural support to the server rack and/or serves as a structure component in the server rack. For example, a rack vapor manifold may support a ceiling of a server rack and/or one or more walls of the server rack. In some instances, a rack vapor manifold may form one or more of the walls, sides, or supports in a server rack. A side of the rack refers to a position adjacent to one of the opposing sides of a server rack. In some embodiments, a side may be adjacent to the door opening. Mounting along a side of the rack refers to installing or fixing a component in a position close to, associated with, or adjacent to one of the sides of a server rack. Rack vapor inlet ports refer to the entry points where vapor enters the rack vapor manifold. For example, the rack vapor inlet ports may include a series of valves, pipes, or other components that allow the vapor to enter the rack vapor manifold. Distributed refers to being dispersed, spread out, or allocated over a given area. A length of rack refers to a dimension of a rack sometimes referred to as a rack height. Ports distributed along a length of rack refers to positioning a plurality of rack vapor inlet ports in a plurality of positions along a length of rack. The ports may be distributed over a majority of the length or a portion of the length. An electronic component is described and exemplified elsewhere herein. Association with refers to a connection and/or relationship. In some embodiments, one or more vapor inlet ports may have a connection or relationship to one or more server rack slots, such as a proximity between the two components, a flow-based connection or coupling such that a liquid or vapor flows between two associated components, or another relationship. An association with the plurality of distributed slots refers to a spatial relationship with the slots in the sense that ports arranged higher along a length may more conveniently serve higher slots, and ports arranged lower along the length may more conveniently serve lower slots. For example, a particular server slot may have a dedicated rack vapor inlet port, or a plurality of rack vapor inlet ports, associated with a one or more vapor lines. Arranged to receive coolant means configured to, constructed to, or designed to receive coolant. For example, the rack vapor inlet ports may be positioned to be connected, either directly or indirectly, to the vapor coolant lines that transport vaporized coolant from condenser or buffer to the vapor rack manifold. Coolant is described and exemplified elsewhere herein. Heat refers to thermal energy, as described and exemplified elsewhere herein. Coolant vaporized by heat refers to liquid coolant that has transformed from to a gas due to the transfer and/or absorption of heat by the coolant. Electronic components refer to devices that use electricity to operate, as described and exemplified elsewhere herein. Heat of electronic components refers to heat, as described and exemplified elsewhere herein, generated by electronic components used in a server rack, including but not limited to heat generated by computers, servers, and microprocessors. Electronic components associated with the servers refers to the specific electronic components used within a server rack, for operation of the server itself or any other supporting components, including but not limited to electronic components used within computer hardware and the cooling system itself. Rack vapor outlet ports refer to exits, openings, pipes, valves, or other channels that enable vapor to flow out of the rack vapor manifold.

In some instances, a rack vapor manifold may be mounted on the side of a server rack, pivotable in unison with a door. In another non-limiting example, a rack vapor manifold may transport vaporized coolant from a plurality of rack vapor inlet ports to a rack vapor outlet port. A rack vapor outlet port may supply the condenser with vaporized coolant to be condensed to liquid. In some instances, a rack vapor inlet port may be positioned so that a server slot may be associated with a rack vapor inlet port. By way of another example, a rack vapor manifold may provide structural support to the server rack. In another non-limiting embodiment, a rack vapor manifold may be integrally formed with a rack liquid manifold, as described and exemplified elsewhere herein. A rack vapor manifold may be integrally formed into the structure and/body of the server rack, providing support to the ceiling, walls, and/or server slots and saving space for components in the server rack.

By way of non-limiting example, Fig. 10D shows a rack vapor manifold 1008 mounted on the hinged side of the server rack door 1002, allowing the for the door vapor inlet ports 1007 to connect to a plurality of rack vapor outlet ports 1008. In another example, vaporized coolant may be transported through the door vapor manifold to the condenser by passing through a door vapor inlet port, traveling through the door vapor manifold, and exiting at the door vapor outlet port. In some embodiments, a plurality of rack vapor inlet ports 1007 may be associate with a server rack slots 1004 such that each server slot has one or more dedicated rack vapor inlet ports connected to the vapor line of the cooling system. By way of another non-limiting example, the rack vapor manifold 1008 may be mounted on the side of the hinged side of the server rack, as shown in Fig. 10D. For instance, mounting the rack vapor manifold 1008 adjacent to the hinged side of the server rack door 1002 may facilitate the transport of vaporized coolant from the rack vapor manifold 1008, having one or more rack vapor outlet ports, into the door vapor manifold.

Some embodiments involve at least one door vapor manifold mounted on the hinged side of the door and having a plurality of door vapor inlet ports, and at least one door vapor outlet port for connection to the at least one condenser vapor inlet port. A manifold refers to a structure or device that serves a hub or distribution component for the flow of something, as described and exemplified clsewhere herein. A door vapor manifold refers to a component mounted on the door, having a plurality of vapor inlet ports, and at least one vapor outlet port for connection to the condenser vapor inlet port. For example, the door vapor manifold may be used to facilitate the flow of vaporized coolant from the servers to the condenser. The hinged side of the door refers to the edge of the door where the hinges connecting the door to the structure of the server rack is located. A door vapor manifold mounted on the hinged side of the door refers to installing or attaching a door vapor manifold to the door of a server rack, such that the door vapor manifold is positioned closes to the edge of the door connected to the server rack. A door vapor outlet port refers to the exit point in the door vapor manifold that connects to the condenser vapor inlet port. For example, the door vapor outlet port may be a single, larger opening design to allow the passage of vapor to the condenser. In some instances, a door vapor outlet port may be the same size as the door vapor inlet port. A connection in this context refers to an attachment, mating, integration, or other association between two components such that fluid may flow between the components. For example, a vapor inlet port may be physically connected via a coupling, a pipe, or a tube that allows the passage of vapor between the outlet port and the inlet port. A connection to the at least one condenser vapor inlet port refers to a similar connection for conveying vaporized coolant to at least one condenser. In some embodiments condenser may be located within the door that contains the door vapor manifold.

In some instances, a door manifold may facilitate the transport of vaporized coolant from the two-phase evaporators to the condenser, passing through one or more door vapor inlet ports and one or more door vapor outlet ports.

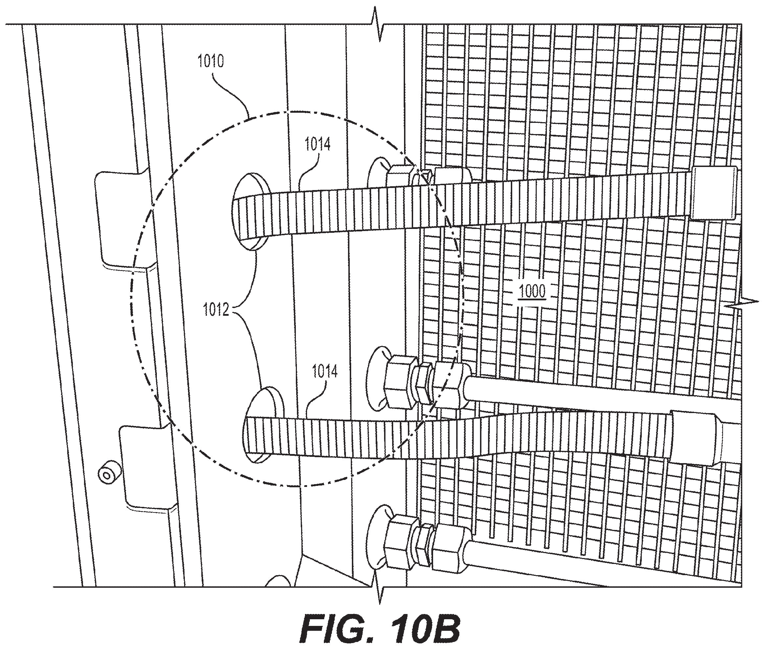

By way of non-limiting example, Fig. 10B shows a door vapor manifold 1010 having multiple door vapor inlets 1012 may be mounted on a hinged side of door 1002. Door vapor manifold 1010 may be flow connected to condenser 1000 via one or more flexible tubes 1014 and at least vapor outlet ports, e.g., to convey vaporized coolant from ENEs 100 on racks 1004 to condenser 1000. Flexible tubes 1014 may allow opening and closing door 1002 while condenser 1000 is operating. By way of another example, Fig. 10B shows a door vapor manifold 1010 that may facilitate the connection of vapor inlet ports 1012 through flexible tubes 1014 to condenser 1000. In some embodiments, condenser 1000 is mounted in door 1002 enabling vaporized coolant to be condensed to liquid and transported to the reservoir.

Some disclosed embodiments involve flexible tubes for interconnecting the rack vapor outlet ports to the door vapor inlet ports along the hinged side, to enable maintained flow-connections between the at least one rack vapor manifold and the at least one door vapor manifold while the door is pivoted between the open and closed positions. Flexible tubes refer to bendable conduits for interconnecting the rack vapor outlet ports to the door vapor inlet ports along the hinged side. For example, flexible tubes may be constructed of materials like rubber or polymers that can bend without breaking, allowing the door to pivot between open and closed positions while maintaining the flow-connections. Interconnecting refers to a linking or connecting of two or more components. Interconnecting ports refers to of the enablement of fluid to flow between those ports through the use of tubing, hoses, conduits, or other channels. Flexible tubes may thus interconnect the rack vapor outlet ports to the door vapor inlet ports. Such connections may involve, for example, the use of connectors, clamps, or other fastening devices to secure the tubes in place. Maintaining flow-connections refers to the continuous and uninterrupted passage of vapor or ability of vapor to pass between components. For example, a flow-connection may be made from the rack vapor outlet ports to the door vapor inlet ports, even as the door pivots between open and closed positions. In some instances, maintained flow-connections may be achieved through the use of flexible tubes and a hinged door design. Maintained flow-connections between the at least one rack vapor manifold and the at least one door vapor manifold refers to connecting or associating the rack vapor manifold and the door vapor manifold in an uninterrupted manner so that fluid may flow between the manifolds regardless of the open or closed position of the door. For example, flexible tubes may be used connect the rack vapor manifold and the door vapor manifold. Maintained flow-connections while the door is pivoted between the open and closed positions refers to enabling the uninterrupted movement of fluid through the rack vapor manifold and the door vapor manifold without regard to the position or state of the server rack door.

In some instances, vaporized coolant may be transported from the evaporators through the rack vapor inlet to the rack vapor outlet. In some instances, vaporized coolant may be transported from the rack vapor outlet through flexible tubing to the door vapor manifold inlet to the condenser. For example, vaporized coolant may pass through the rack vapor inlet port, the rack vapor outlet port, the door manifold inlet port, and the door manifold outlet port in order to reach the condenser. In some instances, the connections between the rack vapor manifold and the door vapor manifold may be maintained during operation (e.g., opening or closing) of the door, enabling for the cooling system to operate while the door of the server rack is opened, closed, moving, or stationary.

By way of a non-limiting example, referring to Figs. 10A-10E, one or more condensers 1000 of an HRU (e.g., HRU 142) may be located in a door 1002 (Fig. 10D) of a server rack. Condenser 1000 may be flow connected to multiple two-phase evaporators coupled to heat-generating electronic components of servers located on one or more slots 1004 of the server rack via a vapor line configured to convey vaporized coolant from one or more two-phase evaporators to a condenser 1000. Condenser 1000 may additionally be flow connected to a reservoir 1006 via a liquid line configured to convey liquefied coolant from condenser 1000 to reservoir 1006. One or more pumps (e.g., pumps 146) may push the liquid coolant from reservoir 1006 to one or more evaporators, as described carlicr. Reservoir 1006 may be located in door 1002, or elsewhere, e.g., in a bottom slot of the server rack.

By way of another example, Fig.10D shows rack vapor manifold 1008 and a door vapor manifold 1011. The connection between the rack vapor manifold and the door vapor manifold may allow vaporized coolant to be transported from the evaporators associated with a plurality of heat generating electronic components to the condenser, mounted to the door of the server rack. For example, in Fig. 10B, rack vapor manifold 1010 is connected to the door vapor manifold through flexible tubing 1014. This arrangement may save space in the server rack by removing the need to mount cooling system components on multiple server slots within the server rack.

In some embodiments, the at least one condenser includes a plurality of condensers mounted on the door. Mounted on the door refers locating one or more components on the door to move with the door as the door pivots. For example, a component may be mounted to the inside physical barrier of a door or the outside physical barrier of a door. In some instances, a component may be mounted to the edges or internal structural components of the door. A plurality of condensers mounted on the door refers to attaching or affixing more than one condenser to the door of the server rack such that plurality of condensers are supported by the door and are enabled to move in unison with the server rack door.

For example, a plurality of condensers mounted on the door may transform vaporized coolant to liquid form. The vaporized coolant may enter the plurality of condensers through a door vapor manifold. A door vapor manifold may have a plurality of door manifold vapor outlets that are each associated with one or more of a plurality of condensers that are mounted to the door of the server rack.

In some embodiments, the at least one rack vapor manifold is a single rack vapor manifold. A single rack vapor manifold refers to a rack vapor manifold, as previously described and exemplified herein, through which all of the vaporized coolant from the two-phase evaporators flows. In some instances, one rack vapor manifold collects the entirety of vaporized coolant outflow from the vapor coolant lines connected to the two-phase evaporators.

In some embodiments, the at least one door vapor manifold is a single door vapor manifold. A single door vapor manifold refers to a door vapor manifold, as previously described and exemplified herein, through which all of the vaporized coolant from the rack vapor manifold flows. In some instances, one door vapor manifold collects the entirety of vaporized coolant outflow from the rack vapor manifold.

Some embodiments involve at least one rack liquid coolant manifold having at least one manifold coolant inlet port and a plurality of manifold coolant outlet ports distributed along a length of the at least one rack coolant liquid manifold for association with the plurality of distributed slots, the manifold coolant outlet ports being arranged to supply liquid coolant to the electronic components associated with the servers. A rack liquid coolant manifold refers to a pipe or chamber having several openings, enabling liquid to be transported between one or more inlet ports and one or more outlet ports. For example, the rack liquid coolant manifold may include a manifold coolant inlet port and manifold coolant outlet ports. A manifold coolant inlet port refers to the entry point in the rack liquid coolant manifold that receives the liquid coolant. By way of example, the manifold coolant inlet port may include a valve or other control mechanism to regulate the flow of coolant into the manifold. A manifold coolant outlet port refers to the exit point in the rack liquid coolant manifold that distributes or transports the liquid coolant. Distributed along a length of at least one rack coolant liquid manifold refers to positioning one or more rack liquid inlet and outlet ports in a plurality of positions along a length of rack, as previously described and exemplified herein. Association with the plurality of distributed slots refers to the association of individual server slots to individual manifold coolant outlet ports, as previously described and exemplified herein. A liquid coolant refers to a coolant, as described and exemplified elsewhere herein, while in a liquid state. For example, vaporized coolant may undergo condensation to transform to liquid coolant. In an alternative example, a vaporized coolant may be compressed such that it transforms into liquid form. Arranged to supply liquid coolant to the electronic components refers to arranging a component to enable liquid coolant to flow between a component and the electronic components in the cooling system. The manifold coolant outlet ports being arranged to supply liquid coolant to the electronic components associated with the servers refers to enabling coolant to flow from the manifold coolant outlet ports to the two-phase evaporators.

For instance, liquid coolant may be supplied to the two-phases evaporators through a liquid coolant supply line connected to a manifold coolant outlet port. For example, liquid coolant may flow from the reservoir, through a manifold liquid coolant inlet port, through a manifold liquid coolant outlet port, through a rack liquid coolant manifold outlet port, and through the two-phase evaporators associated with the heat-generating electronic devices in the server rack.

In some embodiments, the rack vapor manifold and the rack liquid coolant manifold are integrally formed. An integrally formed component refers to a part that is made as a single piece or unit. For example, an integrally formed component may serve the functions of two typically separate parts, while being manufactured in one single piece or material. An integrally formed rack vapor and liquid coolant manifold refers to a manifold which both performs the functions of the rack vapor manifold and the rack liquid coolant manifold, both as previously described and exemplified herein.

Some embodiments involve at least one additional flexible tube for forming at least a portion of a flow-connection between the condenser with the rack liquid coolant manifold. An additional flexible tube as previously described and exemplified herein may be used to facilitate the flow of coolant. For example, the additional flexible tube may connect the rack vapor outlet ports to the door vapor inlet ports along the hinged side.

By way of a non-limiting example, Fig. 10B shows door vapor manifold 1010 flow connected to condenser 1000 via one or more flexible tubes 1014 and at least vapor outlet ports, e.g., to convey vaporized coolant from ENEs 100 on racks 1004 to condenser 1000.

Some embodiments involve a liquid coolant buffer for location in a flow path between the condenser and the rack liquid coolant manifold. A buffer refers to device or structure for holding something, as previously described and exemplified herein. A liquid coolant buffer refers to a reservoir, pool, basin, or other container that holds liquid coolant. A flow path refers to the route taken by a fluid as it moves through a system. A location in a flow path refers to the relative position or order in which system fluid flows through a specified component as it relates to the entire system. A location in a flow path between the condenser and the rack liquid coolant manifold refers to any place fluid flows after exiting the condenser and before entering the rack liquid coolant manifold.

In some cmbodiments, the buffer is configured for mounting on the door. Mounting on the door refers to installing or fixing a component such that it moves with and is affixed to the server rack door. A buffer configured for mounting on the door refers to a reservoir having dimensions such that the reservoir may be mounted on the door in a way which does not impede the motion or function of the door. For example, the buffer may be made to be a thickness that is less than that of the door, allowing the buffer to be mounted in a recessed opening on the door or mounted inside of the outer structure of the door.

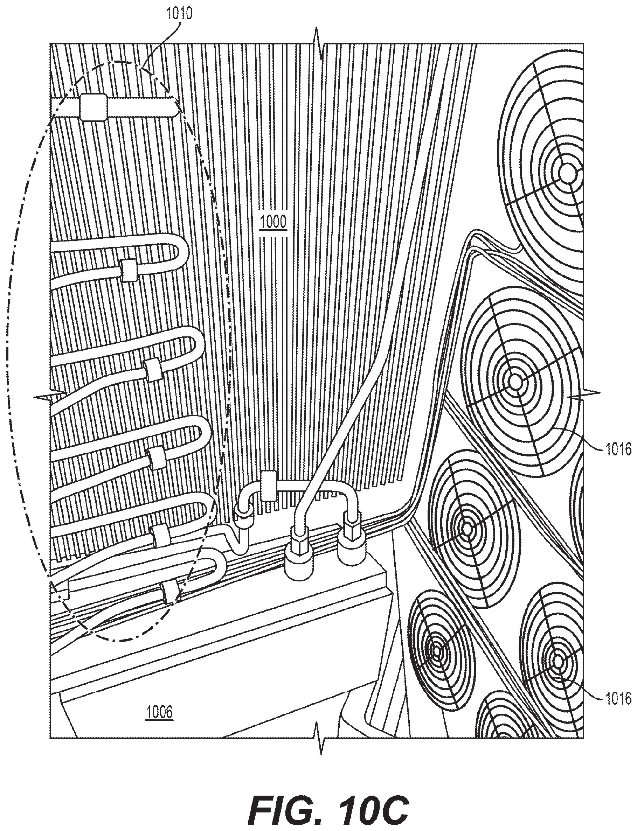

By way of a non-limiting example, Fig. 10C shows a reservoir 1006, acting as a buffer, mounted on the door of the server rack. The reservoir 1006 may be mounted such that it does not occupy space in a server slot or space in between the opposing sides of the server rack, as previously described and exemplified herein.

In some embodiments, the buffer is configured for mounting in the rack. Mounting in a server rack refers to placing, fixing, installing, attaching, or otherwise situating in a frame or enclosure used to mount multiple electronic components. In some instances, the buffer may occupy all of a server slot; in other embodiments, the buffer occupies only a portion of a server slot.

By way of a non-limiting example, Fig. 1 A shows a HRU 142, which includes a buffer, mounted in server rack 141. By way of another example, Fig. 8B shows a reservoir (e.g., a buffer) 802 mounted at level 804 in the server rack.

In some embodiments, the buffer is configured for mounting in a bottom slot of the rack. A bottom slot of the rack refers to the lowest level or clevation within the server rack. For example, a bottom slot may be closest to the base of the server rack. A buffer configured for mounting in a bottom slot may minimize the amount of server slot space occupied by components of the cooling system.

By way of a non-limiting example, Figs. 8B-8C illustrate an exemplary HRU including a condenser collocated with a reservoir and a plurality of pumps at a same level of a server rack, thereby occupying fewer slots than the HRU of Fig. 8A, consistent with some disclosed embodiments. For example, Fig. 8B shows a reservoir (e.g., a buffer) 802 mounted at the bottom slot 804 of the server rack. In some instances, the bottom slot may include other components of the cooling system in addition to a reservoir.

Some embodiments involve at least one pump for location in the flow path, wherein the at least one pump is configured for mounting on the door. A pump refers to a mechanical device or machine that moves fluids from one place to another. Pumps may move fluid including liquid and/or gas. In some embodiments, a pump moves fluid using pressure or suction. For example, a pump may compress fluids into a chambers, vessel, or other means for containing said gas or liquid. A pump configured for mounting on the door refers to a pump that is design, arranged, or otherwise constructed to be installed or attached to the door of the server rack.

For example, the at least one pump may be located within the outer structure of the door. In some instances, the at least one pump may be mounted to the exterior edges or surfaces of the door.

Some embodiments involve at least one pump for location in the flow path, wherein the at least one pump is configured for mounting in the rack. Mounting in a server rack is used as previously described and exemplified herein. A pump configured for mounting in the rack refers to a pump (as previously described) that is design, arranged, or otherwise constructed to be installed or attached to the server rack.

By way of a non-limiting example, Fig. 8B shows at least one pump 146 configured for mounting at level 804 in the server rack. In some instances, the at least one pump may be configured to be mounted in the same rack as the reservoir, condenser, or other components in the cooling system. The location of the at least one pump in the server rack may allow the cooling system to occupy less server slot space.

Some embodiments involve a plurality of fans mounted in the door for propelling air through the at least one condenser. A fan is an electrical/mechanical device for moving gas. For example, a fan may push air to provide convective cooling. In some instances, a fan may move air to provide convective cooling to heat-generating electronic component. A plurality of fans mounted in the door refers more than one fan attached to (either to a surface or within a cavity of) the server rack door. For example, a plurality of fans may be mounted to the interior or exterior surface of the server rack door. In some instances, a plurality of fans may be mounted inside the outer structure of the server door. Propelling refers to pushing, driving, or otherwise moving. Propelling air refers to moving air in a specific direction using mechanical force. Propelling air through the at least one condenser refers to mechanically driving or moving air into and out of the condenser such that the air absorbs heat generated or released by the condenser.

For instance, a plurality of fans may provide convective cooling to the condenser. Said condenser may be mounted in the server rack or in a specific server slot of the server rack. A plurality of fans may expel air that has absorbed heat from the condenser throughout the operation of the cooling system. Mounting the plurality of fans in the door may provide additional space in the server rack for mounting other components such as the condenser and the reservoir.

In some embodiments, a plurality of fans are mounted in the rack for propelling air through the at least one condenser. Propelling air through the at least one condenser refers to mechanically driving or moving air into and out of the condenser such that the air absorbs heat generated or released by the condenser.

For instance, a plurality of fans may provide convective cooling to the condenser. Said condenser may be mounted in the server rack or in a specific server slot of the server rack. A plurality of fans may expel air that has absorbed heat from the condenser throughout the operation of the cooling system. Mounting the plurality of fans in the server rack may provide additional space in the server door for mounting other components such as the condenser and the reservoir.

By way of a non-limiting example, Fig. 1A shows a plurality of fans integrated within the HRU 142. The plurality of fans in Fig. 1A may be mounted in the rack in one or more specific server slots. By way of another example, Fig. 10C shows one or more fans 1016 mounted in door 1002 (and/or with one or more servers) for propelling air through condenser 1000 and facilitate cooling.

In some embodiments, the at least one condenser covers a majority of a length of a door. Covering refers to occupying a space. The length a condenser covers refers to the distance between two opposing sides of the condenser. A majority refers to more than half or the largest of a given group or collection. A majority of a length of a door refers to more than half of the longest distance measurable between two opposing edges of the door. A condenser covering a majority of a length of a door refers to a condenser whose longest dimension is more than half of the longest dimension of the server door. For example, a condenser may cover a majority of the length of a door if the condenser is at least half of the height of the door.

In some embodiments, the server rack is preexisting and the door and the at least one rack vapor manifold are configured for retrofitting to the preexisting server rack. Preexisting refers to existing before in time. A preexisting server rack refers to a server rack that was not designed or manufactured to accommodate the cooling system disclosed and exemplified elsewhere herein. Retrofitting refers to modifying, adding, overhauling, or otherwise adding new parts or components to some device or structure. Retrofitting the door refers to replacing or modifying the server door described and exemplified elsewhere herein to accommodate the components necessary to operate the cooling systems disclosed, described, and exemplified elsewhere herein. Retrofitting the at least one rack vapor manifold refers to modifying the at least one rack vapor manifold so it may be mounted in the preexisting server rack or the server slots of said preexisting server rack.

In some instances, retrofitting may involve modifying, adding, adjusting, or otherwise changing the shape, structure, components, or other design details of the door or the at least one rack vapor manifold to enable both components to be mounted in a preexisting server rack. For example, the door may be cut, extended, or fitted with different mounting mechanisms to enable mounting in a preexisting server rack. By way of another non-limiting example, the at least one rack vapor manifold may be reshaped, reformed, or otherwise modified to fit within the preexisting server rack or specific server slots.

In some embodiments, the at least one condenser includes a plurality of microchannels on a surface thereof for facilitating cooling. Microchannels refers to narrow conduits, grooves, slots, or other recesses that allow fluid to flow between individual microchannels. A microchannel may have dimensions, for example, on the micrometer scale (typically less than a millimeter). A surface refers to a plane or an outermost layer. Microchannels on a surface refer to microchannels that are recessed into or extrude out from said surface. Microchannels for facilitating cooling refer to microchannels that have a physical structure enabling fluid to flow through the channels, absorbing heat generated or absorbed by the condenser.

By way of a non-limiting example, Fig. 10E shows a condenser 1000 with a plurality of microchannels 1022 for facilitating cooling. In some instances, the microchannels may facilitate cooling by allowing fluid flowing through the channels to convectively cool the condenser. In another example, microchannels 1022 may facilitate cooling and/or condensation of vaporized coolant.

In some embodiments, the at least one condenser is associated with at least one sensor configured to detect at least one of a temperature indication or a pressure indication associated with the coolant. The at least one condenser refers to a device used to condense a substance from its gaseous state to its liquid state, typically by cooling it or compressing it, as previously described and exemplified elsewhere herein. A sensor refers to a device that detects external stimuli. For example, a sensor may detect a change in a measured variable, and a sensor may further respond to that change by sending a signal to another component in a system. A sensor may include, but is not limited to, a thermometer or a pressure gauge. A temperature indication refers to the thermal energy, as expressed in a degree of temperature, within a body or a system. A pressure indication refers to the pressure of the coolant within the cooling system. A temperature indication or a pressure indication associated with the coolant refers to a temperature measurement of the coolant or a measurement of the fluid pressure of the coolant within the system.

By way of a non-limiting example, Fig. 10E shows condenser 1000 configured with server rack door 1002, and additionally, multiple sensors 1020 (e.g., temperature and/or pressure sensors) configured to measure coolant (e.g., liquid and/or vapor) temperature and/or pressure. Sensors 1020 may transmit the measurements to processor 152, which may use the measurements to monitor and regulate two-phase cooling system 140, as described earlier. In some embodiments, condenser 1000 may additionally include multiple micro-channels 1022 to facilitate cooling. In some embodiments, condenser 1000 may extend the full length of door 1002. In some embodiments, multiple condensers 1000 may collectively extend the full length of door 1002 (e.g., each condenser 1000 may be flow connected to a subset of server slots in the server rack).

Some embodiments involve at least one processor configured to use the at least one temperature indication or the pressure indication to control a flow of coolant in at least one rack liquid manifold, or the at least one door liquid manifold. A processor refers to an electronic component, as previously described and exemplified elsewhere herein. A processor configured to use the at least one temperature indication or the pressure indication refers to a processor that uses a temperature indication and/or a pressure indication as an input signal during operation of the cooling system.

For example, the at least one processor may adjust the power of the pumps in response to a detected temperature or pressure of coolant within the cooling system. In some instances, the processor may send an output signal to at least one of a plurality of electronic components in the cooling system.

By way of a non-limiting example, Fig. 1A shows a processor 152 mounted to HRU 142. In some instances, processor 152 is capable of controlling the flow of liquid coolant from the HRU to the door liquid manifold or the rack liquid manifold. In other embodiments, the processor 152 is capable of adjusting the flow of coolant through the at least one rack liquid manifold or the at least one door liquid manifold by adjusting the operating parameters of, among other components, the fan, the pumps, and the flow rate of coolant through one or more liquid manifolds.

As heat transfer from a heat-generating clectronic component causes liquid coolant to boil inside a chamber of a two-phase evaporator, bubbles of hot vaporized coolant may begin to form. However, some bubbles in hot vaporized coolant may become trapped on and/or near the surface of the base plate. This may cause regions on the base plate that are non-conducive to heat transfer, and may prevent (e.g., cooler) liquid coolant from reaching the evaporator base plate at the location of the bubbles. Embodiments are disclosed to impede the formation of such bubbles causing pulses of pressure fluctuations inside the chamber of the two-phase evaporator. The pulses of pressure fluctuations may release trapped bubbles and/or prevent the formation of large bubbles that may tend to become trapped (e.g., between additional components inside the two-phase evaporator).

Some disclosed embodiments involve a two-phase pulse evaporator system for cooling electronic components when bubble formation inhibits cooling. A system refers to a set of interacting or interdependent components forming an integrated whole. For example, a system may include various hardware and software components working together to perform a specific function. Two-phase refers to a system or process that involves two distinct phases or states. For example, a two-phase system may include a liquid phase and a gas phase, such as in a two-phase cooling system where a liquid coolant evaporates into a gas to remove heat. Cooling refers to the process of removing or reducing heat from a system and/or component. For example, cooling may involve the use of a coolant, a heat sink, a fan, and/or any other heat dissipation mechanisms. Electronic components refer to any individual device or part in an electronic system used to affect electrons or their associated fields. For example, electronic components may include resistors, capacitors, inductors, diodes, transistors, and/or integrated circuits. A two-phase system for cooling electronic components may be understood, as described and exemplified elsewhere herein. A pulse refers to a brief, rapid change in a system's state or condition. For example, a pulse may include a sudden increase or decrease in pressure, temperature, and/or other physical properties. Bubble formation refers to the process where a gas forms bubbles in a liquid. For example, bubble formation may occur when a liquid is heated, causing the gas dissolved in the liquid to come out of solution and form bubbles. Heating a liquid to a boiling temperature may increase a pace of the formation of bubbles and/or the size of bubbles formed. Inhibits cooling refers to any process or condition that reduces the efficiency of cooling. For instance, entrapment of bubbles in a pool of boiling coolant may prevent vaporized coolant from escaping the pool. This may raise an average temperature of the pool of coolant and may prevent replacement of hot vaporized coolant with cooler liquid coolant, thereby impeding heat transfer via the coolant.

As an example, a two-phase cooling system may include at least one two-phase evaporator enclosure for cooling an associated heat-generating electronic component thermally coupled thereto via a base plate. The at least one two-phase evaporator may include a chamber containing a pool of liquid coolant for absorbing heat from the associated heat-generating electronic component via an inner surface of the base plate. The liquid coolant may boil and become vaporized coolant which may escape from the chamber, conveying the heat therewith. This may permit relatively cool liquid coolant to displace the relatively hot vaporized coolant that escaped from the chamber. However, in some instances, the boiling coolant may cause formation of bubbles of hot vaporized coolant, some of which may become trapped on and/or near the inner surface of the base plate. This may trap heat in regions on and/or near the surface of the base plate, which may inhibit cooling. In some instances, larger bubbles of vaporized coolant may have a greater tendency to become trapped than smaller bubbles. Thus, formation of larger bubbles of hot vaporized coolant inside the chamber may inhibit subsequent heat transfer and cooling of the associated heat-generating electronic component. To overcome this, a two-phase pulse evaporator system is disclosed that may prevent entrapment of bubbles within the chamber, as described in greater detail herein below.

By way of a non-limiting example, Figs. 1A-1C show a two-phase pulse evaporator system for cooling electronic components when bubble formation inhibits cooling. The two-phase pulse evaporator system may include at least one ENE 100 thermally coupled to an electronic component 110 (see Fig. 1C). At least one processor 152 (see Fig. 1A) may control an inflow of liquid coolant and/or an outflow of vaporized coolant from each ENE 100 to prevent bubble formation that may inhibit cooling.

Some disclosed embodiments involve a two-phase evaporator enclosure having an evaporator base plate configured to serve as a heat exchanger. An enclosure refers to a bounded compartment, cell and/or space. A two-phase evaporator enclosure refers to an enclosure configured to contain coolant in both liquid and gaseous states in a manner to promote pool boiling of liquid coolant and evacuation of vaporized coolant. An evaporator base plate (e.g., a heat conducting base plate) refers to a component that serves as a primary site for heat exchange. A base plate may include a foundational component of an evaporator system, designed to facilitate heat exchange. For example, an evaporator base plate may be made of a thermally conductive material, such as heat-conductive metal. By way of non-limiting examples, such heat conductive metal may include copper or aluminum. One side of a base plate may be designed to be in thermal contact with a heat-generating electronic component and the other side of the base plate may be designed to be in thermal contact with relatively cool liquid coolant, allowing heat to transfer from the heat-generating electronic component through the base plate to the liquid coolant. The transfer of heat may cool the heat-generating electronic component. A heat exchanger refers to a device designed to transfer or exchange heat from one matter to another. For example, a heat exchanger may include a network of pipes or tubes that carry a coolant, and/or a metal plate that conducts heat away from a heat-generating component.

For instance, an outer surface of a base plate of a two-phase evaporator enclosure may be thermally coupled to a heat-generating electronic component, e.g., using one or more screws and/or a thermally conductive adhesive, and an inner surface of the base plate may be exposed to a pool of relatively cool liquid coolant stored inside the enclosure. The base plate may conduct heat from the heat-generating electronic component to the pool of relatively cool liquid coolant enclosure to thereby cool the electronic component.

Some disclosed embodiments involve an evaporator base plate with an outer surface of the base plate for contacting a heat-generating electronic component and an inner surface of the base plate exposed to a coolant chamber within the enclosure. An outer surface refers to the external or outward-facing surface of a component and/or object. For example, the outer surface of an evaporator base plate may be the surface that contacts a heat-generating electronic component. Contacting refers to the process of physical interaction between two or more components. For example, contacting may include the process of a heat-generating electronic component coming into direct contact with the outer surface of the base plate of an evaporator system. A heat-generating electronic component refers to any electronic device or part that produces heat as a byproduct of its operation. For example, a heat-generating electronic component may include a microprocessor, a power supply unit, and/or a graphics processing unit. An inner surface refers to the internal or inner-facing surface of a component and/or object. For example, an inner surface of an object may be opposite to an outer surface of the object. Exposed refers to a state of being accessible or open to a specific environment and/or substance. For example, exposing an inner surface of a base plate to a pool of liquid coolant inside a chamber of a two-phase evaporator may permit heat transferred through the base plate to be absorbed by the pool of liquid coolant. A coolant chamber refers to a designated space within an enclosure where a coolant is stored and/or circulated. For example, a coolant chamber may be located within the enclosure of an evaporator system, and may be in direct contact with the inner surface of the base plate. Heat generated by an electronic component may be conducted from the outer surface of a base plate, through the base plate, to the inner surface where the heat may be absorbed by the liquid coolant.

By way of a non-limiting example, in Fig. 1B, two-phase evaporator enclosure (e.g., ENE 100) may include an evaporator base plate (e.g., heat conductive wall 104) configured to serve as a heat exchanger. An outer surface 108 of the base plate may contact heat-generating electronic component 110 (e.g., see Fig. 1C) and an inner surface 106 of the base plate may be exposed to coolant chamber 102 within the enclosure of ENE 100. For example, the outer surface 108 of heat conductive wall 104 may be fastened to heat-generating electronic component 110 using one or more screws and/or a thermally-conductive adhesive permitting heat, generated by electronic component 110, to flow through outer surface 108 and inner surface 106 of heat conductive wall 104 into the interior of chamber 102. Liquid coolant contained inside chamber 102 (e.g., in pool 116) may absorb at least some of the heat.

Some disclosed embodiments involve a liquid coolant port in a wall of the enclosure for delivering liquid coolant to the coolant chamber and to the inner surface of the base plate. Liquid coolant (as described and exemplified elsewhere herein) refers to a fluid substance used to absorb heat. For example, liquid coolant may be delivered to the coolant chamber through a liquid coolant port, where the liquid coolant may come in contact with the inner surface of the base plate. A liquid coolant port refers to an opening or passage in a system through which liquid coolant is introduced. For example, liquid coolant port may be an opening that allows the flow of liquid coolant. The opening may include, for example, a flange or other connector to enable flow connection of a conduit. A liquid coolant port may be understood in a manner similar to a liquid coolant inlet, as described elsewhere herein. A wall of an enclosure refers to a physical boundary, such as a side, top, bottom, or other outer enclosure surface. For example, a wall of an enclosure may include a liquid coolant port for delivering liquid coolant, and a vapor outlet port for evacuating vaporized coolant. In some embodiments, a wall of an enclosure for delivering liquid coolant into a chamber may be located on top of the enclosure, above a base plate of the enclosure. Delivering refers to the process of transporting or supplying a substance or component from one location to another. For example, delivering may involve the process of supplying liquid coolant from a source, through a liquid coolant port, to a coolant chamber and an inner surface of the base plate.

For instance, upon entering a chamber of a two-phase evaporator enclosure via a liquid coolant port, liquid coolant may collect on the inner surface of the base plate at the bottom of the chamber and form a pool. Heat generated by an electronic component thermally coupled to an outer surface of the base plate may flow through the base plate where the heat may be absorbed by the pool of liquid coolant, causing the liquid coolant in the pool to boil.

By way of a non-limiting example, in Figs. 1B-1C, a liquid coolant port (e.g., liquid coolant inlet 128 of Fig. 1C) in a wall of the enclosure (e.g., in outer surface 124 of ENE 100) may deliver liquid coolant to coolant chamber 102 and to the inner surface 106 of the base plate (e.g., heat conducting wall 104). Heat may flow from heat-generating electronic component 110 through outer surface 108 and inner surface 106 of heat conducting wall 104 (e.g., an evaporator base plate), where the heat may be absorbed by liquid coolant contained in pool 116 inside chamber 102.

By way of another non-limiting example, in Fig. 1A, HRU 142 may include a reservoir of liquid coolant for delivery to one or more ENE 100s via one or more liquid coolant lines 120. The liquid coolant may flow from HRU 142 through the one or more liquid coolant lines 120 and enter each ENE 100 via an associated liquid coolant inlet 128 (see Fig. 1C).

Some disclosed embodiments involve a vapor outlet port in the wall of the enclosure for evacuating vaporized coolant from the enclosure. Vaporized coolant refers to the gaseous form of a liquid coolant (as described elsewhere herein) that has undergone phase change due to heat absorption. A vapor outlet port refers to a designated exit point in the enclosure of an evaporator system for the evacuation of vaporized coolant. For example, a vapor outlet port may be located in the wall of the enclosure, and may be connected to a controllable valve for the controlled release of vaporized coolant. A vapor outlet port may be understood in a manner similar to a vapor outlet, as described elsewhere herein. Evacuating refers to the process of removing or extracting a substance from a particular location. For example, evacuating may involve the process of removing vaporized coolant from the enclosure of an evaporator system through a vapor outlet port. In some embodiments, a vapor outlet port may have a larger diameter than a liquid input port to accommodate a larger volume occupied by vaporized than occupied by liquid coolant. In some embodiments, at least part of a vapor outlet port may be located towards an upper region of a chamber of a two-phase evaporator system to permit evaporated coolant that has risen to the upper region to exit via the vapor outlet port. In some embodiments, a vapor outlet port may be located at least partially in an upper region of the chamber associated with an accumulation of vaporized coolant and at least partially in a lower region of the chamber associated with an accumulation of liquid coolant, for example using a snorkel mechanism, as described and exemplified elsewhere herein.

For instance, as heat penetrates through the heat conducting base plate of a two-phase evaporator enclosure, a pool of liquid coolant contained therein may absorb at least some of the heat and may begin to boil. The boiling coolant may transform to vaporized coolant which may accumulate inside the chamber. The accumulation of vaporized coolant inside the chamber may increase the vapor pressure in the chamber relative to vapor pressure in a vapor return line fluidly coupled to the chamber by the vapor outlet port. The difference in pressure may cause at least some of the vaporized coolant to exit the enclosure via the vapor outlet port, permitting evacuation of vaporized coolant from the enclosure via the vapor outlet port.

By way of non-limiting example, in Figs. 1B-1C, a vapor outlet port (e.g., vapor outlet 130) in the wall of the enclosure (e.g., in outer surface 124 of ENE 100) may permit evacuation of vaporized coolant from the enclosure (e.g., from chamber 102 of ENE 100). For example, as liquid coolant in pool 116 absorbs heat generated by heat-generating electronic component 110, and boils, the liquid coolant may be converted to vaporized coolant, which may exit chamber 102 via vapor outlet 130.

Some disclosed embodiments involve at least one controllable valve flow connected to at least one of the liquid coolant port and the vapor outlet port. At least one refers to, for example, a single unit of a component, or multiple units. A controllable valve refers to a device configured to regulate, and/or control a flow, as described and exemplified elsewhere herein. For example, a control valve may open, close, and/or partially obstruct a passageway, to thereby control a fluid flow therein. In some embodiments, a controllable valve may be controllable by at least one processor. This may occur, for example, when a processor sends a control signal to the valve in order to operate the valve (i.e., open, close, partially open, or partially close the valve). In some disclosed embodiments, the at least one controllable valve is a solenoid valve. A solenoid valve refers to an electromechanically operated valve controlled by an electric current through a solenoid. By way of example, solenoid valve may include a coil, a plunger, and a valve body. A solenoid valve may be associated with a system through electrical connections. For example, at least one controller may transmit one or more electronic signals, causing a solenoid valve to open, close, and/or partially obstruct a passageway. Connected refers to the state of being linked or joined together. For example, connected may refer to physical connections using an adhesive, one or more threaded nuts and/or bolts, a sealant (e.g., silicone), and/or any other type of mechanical fastener. Flow connected refers to refers any form of direct or indirect connection that enables a substance to be conveyed between two locations, as described elsewhere herein. For example, a controllable valve may be located in a conduit fluidly coupled to a port, such that manipulating the controllable valve may permit stopping, starting, increasing, and/or decreasing a fluid flow through the port. For instance, at least one processor may transmit one or more signals to controllable valve flow connected to a liquid coolant port and/or a vapor outlet port, causing the at least one controllable valve to open, close, and/or partially obstruct a flow of coolant therethrough. In this manner, the at least one processor may regulate an inflow of liquid coolant and/or an outflow of vaporized coolant to/from the two-phase evaporator enclosure, respectively. For example, the at least one processor may regulate a flow rate to/from each two-phase evaporator enclosure, and/or regulate a timing and/or a frequency for increasing/decreasing and/or starting/stopping a flow of coolant to/from each two-phase evaporator enclosure. This may enable the at least one processor to regulate one or more of a rate of heat transfer from the heat generating electronic components to the coolant, a rate of heat transfer from the coolant to water flowing in a water line, vapor pressure inside the enclosure, a boiling temperature of the coolant, and/or any other system parameter affected by a flow of liquid and/or vaporized coolant.

In some disclosed embodiments, the at least one controllable valve regulates liquid coolant flow into the enclosure. Regulating liquid coolant flow into an enclosure refers to controlling, administering and/or overseeing a volume of liquid coolant moving from a first location to an enclosure. For example, at least one controller may transmit one or more signals to a controllable valve located on a liquid coolant inlet line supplying liquid coolant to a two-phase pulse evaporator enclosure causing the controllable valve to open, close, and/or partially obstruct, thereby regulating liquid coolant flow into the enclosure and to the inner surface of the base plate therein. As another example, at least one controller may transmit one or more signals to a controllable valve located on a vapor outlet line of a two-phase pulse evaporator enclosure causing the controllable valve to open, close, and/or partially obstruct, thereby regulating a vapor outflow from the two-phase pulse evaporator enclosure. This may affect vapor pressure and/or temperature inside the two-phase pulse evaporator enclosure, which may affect a heat transfer rate and the level of coolant in a pool therein, thereby regulating a float valve controlling an inflow of liquid coolant into the chamber.

In some disclosed embodiments, the at least one controllable valve regulates vapor flow out of the enclosure. Regulating vapor flow refers to controlling, administering and/or overseeing a volume of vaporized coolant moving from an enclosure to a first location. For example, at least one controller may transmit one or more signals to a controllable valve located on a vapor line of a two-phase pulse evaporator enclosure causing the controllable valve to open, close, and/or partially obstruct, thereby regulating a vapor flow exiting the two-phase pulse evaporator enclosure. As another example, at least one controller may transmit one or more signals to a controllable valve located on a liquid line coolant inlet line supplying liquid coolant to a two-phase pulse evaporator enclosure causing the controllable valve to open, close, and/or partially obstruct, thereby regulating liquid coolant flow into the enclosure and to the inner surface of the base plate therein. This may affect a heat transfer rate inside the chamber, which may affect vapor pressure inside the chamber, thereby affecting a flow rate of vaporized coolant exiting the enclosure.

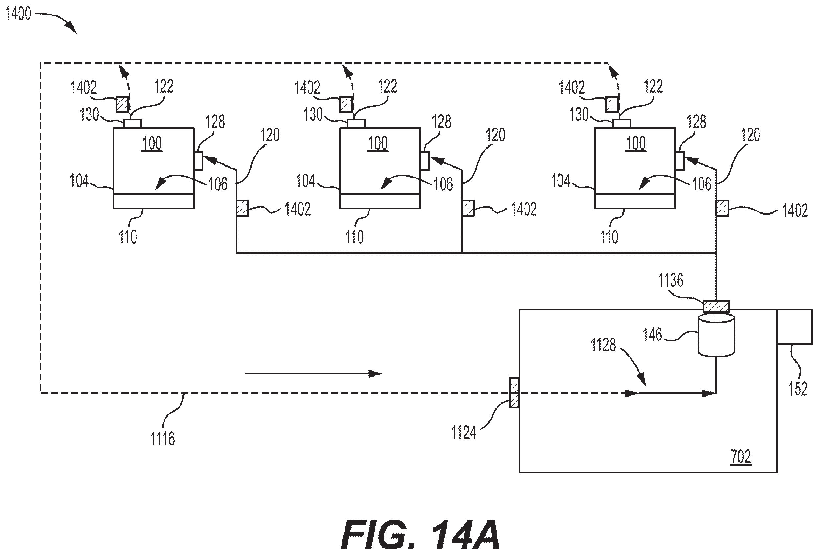

By way of a non-limiting example, reference is made to Fig. 14A, which is a schematic block diagram of a system 1400 for cooling electronic components when bubble formation inhibits cooling, consistent with some disclosed embodiments. System 1400 includes plurality of two-phase pulse evaporator enclosures (e.g., ENEs 100) fluidly coupled to condenser 702 via a plurality of liquid coolant inlet lines 120 and a plurality of vapor coolant outlet lines 122. Each liquid coolant inlet lines 120 may supply liquid coolant to each ENE 100 via an associated liquid coolant port (e.g., liquid coolant inlet 128) in a wall of ENE 100, and each vapor coolant outlet line may evacuate vaporized coolant from each ENE 100 via an associated vapor coolant port 130. A plurality of controllable valves 1402 may be flow connected to at least one of liquid coolant port 128 or vapor outlet port 130. For example, a controllable valve 1402 may be connected to each of vapor coolant outlet lines 122 flow connected to vapor coolant ports 130, and/or to each of liquid coolant inlet lines 120 flow connected to liquid coolant ports 128. In some embodiments, controllable valves 1402 may be solenoid valves configured to open, close, and/or partially obstruct a flow through any of vapor output lines 122 and/or liquid coolant lines 120 in response to one or more electronic signals. At least one controller 152 may transmit one or more electronic signals to controllable valves 1402 to thereby control a fluid flow through any of vapor output lines 122 liquid coolant lines 120, vapor outlet ports 130, and/or liquid coolant ports 128. By controlling controllable valves 1402, the at least one controller may regulate liquid coolant flow into the enclosures (ENEs 100) and/or regulate vapor flow out of the enclosures (ENEs 100). For example, controllable valves 1402 may be solenoid valves configured to respond to one or more control signals transmitted by at least one processor 152 by opening, closing, and/or at least partially obstructing a fluid flow therethrough.

Some disclosed embodiments involve at least one controller configured to pulse the controllable valve in succession thereby causing successive pressure fluctuations in the at least one two-phase evaporator enclosure to limit heat-transfer-impeding bubble formation on the inner surface of the evaporator base plate. A controller refers to a device or a system that manages or regulates the behavior of one or more other devices, components, or systems. For example, a controller may include a microprocessor, a microcontroller, or any other device capable of performing operations on data by executing programmed instructions. To pulse a controllable valve refers to causing a controllable valve to fully or partially open and close repeatedly. For example, a controller may transmit one or more electronic signals to a controllable valve, causing the controllable valve to pulse. This may cause an associated fluid flow to at least partially resume and halt repeatedly. In succession refers to in a series and/or sequence. For example, pulsing a controllable valve in succession may cause a fluid flow to repeatedly stop and resume. Successive pressure fluctuations refer to a series of changes in pressure that occur one after the other. For example, it might involve the rapid increase and decrease of pressure within a system. For instance, at least partially closing a controllable valve may cause fluid to accumulate, thereby increasing fluid pressure, and at least partially opening a controllable valve cause a fluid flow to exit a space, thereby decreasing fluid pressure. At least one controller may transmit a series of electronic signals to at least one controllable valve associated with a liquid coolant port and/or a vapor outlet port, causing the at least one controllable valve to repeatedly constrict and release in quick succession. This may cause pressure in a space fluidly coupled to the controllable valve to repeatedly increase and decrease accordingly. Heat-transfer-impeding bubble formation refers to a phenomenon where bubbles, formed during phase change of liquid coolant to vaporized coolant, limit heat transfer. For example, heat-transfer-impeding bubble formation may occur when bubbles formed on a surface serving as a heat exchanger become trapped on the surface, thereby reducing the amount of surface area of the heat exchanger in contact with liquid coolant. This may thwart further heat transfer, thereby reducing cooling efficiency of the heat exchanger. To limit refers to reduce, restrict, and/or maintain under a threshold. To limit heat-transfer-impeding bubble formation on the inner surface of the evaporator base plate refers to restricting and/or reducing the formation of bubbles of vaporized coolant that prevents the inner surface of the evaporator base plate from transferring heat.

For example, as liquid coolant absorbs heat generated by an associated electronic component via an evaporator base plate, bubbles of vaporized coolant may form on an inner surface thereof. Such bubbles may grow over time as additional heat is absorbed. After a time period, some bubbles may reach a size conducive to becoming trapped on the inner surface of the base plate. For instance, the bubbles may become trapped by components inside the chamber, e.g., due to surface tension from touching a surface inside the chamber. This may prevent the regions on and/or near the inner surface of the base plate where bubbles of vaporized coolant are trapped from coming into contact with liquid coolant, which may thwart heat transfer in those regions. Extricating and/or freeing such bubbles and/or preventing the formation of bubbles from reaching size conducive to becoming trapped may increase the surface area of the inner surface contacting liquid coolant, thereby promoting heat transfer. Successive pressure fluctuations inside a two-phase evaporator enclosure may introduce forces that may dislodge and/or extricate bubbles trapped on a surface thereof, and/or may agitate smaller bubbles, causing them to rise towards the upper region of the evaporator chamber before they reach a size where they may come into contact with a surface and become trapped. By pulsing one or more controllable valves, at least one controller may cause such successive pressure fluctuations. This may prevent heat-transfer-impeding bubble formation on and/or near the inner surface of the base plate, and increase the amount the area of the inner surface of the base plate that is in contact with liquid coolant, thereby promoting heat transfer.

In some embodiments, a time period associated with bubbles reaching a size conducive to becoming trapped may be dependent on an amount heat generated, which may depend on a workload of the electronic component. For instance, if it takes half a second for a bubble to reach a size that may cause it to become trapped (e.g., given a particular workload for an associated electronic component), the at least one controller may cause pressure fluctuations to dislodge bubbles in less than half a second. The at least one controller may determine a frequency for pulsing the controllable valve according to how much time it takes for bubbles to grow to a size where they may tend to get trapped, which may depend on the amount of heat generated by the electronic component, and/or the operating frequency thereof. Thus, the at least one controller may determine the frequency for pulsing the controllable valve based on a workload of the heat-generating electronic component, a flow-rate of liquid and/or vaporized coolant to/from the two-phase evaporator enclosure, a temperature of the vaporized coolant, and/or any other criterion that may contribute to preventing the formation of heat-transfer-impeding bubbles.

By way of a non-limiting example, in Figs. 1A-1B and 14A, at least one controller (e.g., at least one processor 152 of Fig. 1A) may pulse one or more of controllable valves 1402 (see Fig. 14A) in succession thereby causing successive pressure fluctuations in the at least one two-phase evaporator enclosure (e.g., one or more of ENEs 100). For example, pulsing controllable valves 1402 in succession may cause a rate of fluid flow through any of vapor output lines 122, liquid coolant lines 120, vapor outlet ports 130, and/or liquid coolant ports (e.g., liquid coolant inlets 128) to increase and decrease in succession. This may cause pressure inside chamber 102 of ENE 100 to decrease and increase in succession accordingly. Such pressure fluctuations inside chamber 102 of ENE may dislodge one more bubbles trapped on and/or near inner surface 106 of evaporator base plate (e.g., heat conductive wall 104), and/or prevent bubbles from reaching a size conducive to becoming trapped thereon. This may limit heat-transfer-impeding bubble formation on inner surface 106 of the evaporator base plate. For example, the at least one controller may cause controllable valves 1402 to pulse (e.g., open and close) at a rate of 5 pulses per second, 10 pulses per second, 40 pulses per second, and/or any other frequency that may inhibit formation of heat-transfer-impeding bubbles on inner surface 106 of evaporator base plate.

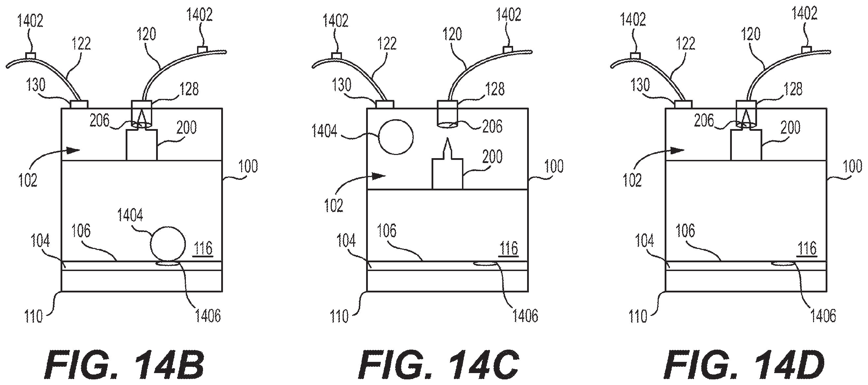

By way of another non-limiting example, reference is made to Figs. 14B to 14D which are additional schematic block diagrams of a two-phase pulse evaporator for cooling electronic components when bubble formation inhibits cooling, consistent with some disclosed embodiments. Referring to Fig. 14B, during a first time period, a bubble 1404 of (e.g., hot) vaporized coolant may form on inner surface 106 of base plate, as liquid coolant in pool 116 absorbs heat from electronic component 110, causing the liquid coolant to boil. Bubble 1404 may become trapped on inner surface 106 of the base plate (e.g., heat conductive wall 104) at region 1406. This may prevent (e.g., cooler) liquid coolant from coming in contact with region 1406 of inner surface 106 and/or decrease the amount of (e.g., cooler) liquid coolant in pool 116, thereby diminishing the heat transfer capability of ENE 100. Referring to Fig. 14C, during a second time period, at least one controller (e.g., at least one processor 152 of Fig. 14A) may transmit signals causing one or more of controllable valves 1402 to successively open and close, causing successive pressure fluctuations inside chamber 102 of ENE 100. The pressure fluctuations may dislodge bubble 1404 from inner surface 106, causing bubble 1404 to float upwards and exit pool 116 and chamber 102 via vapor outlet 130. In this manner, the at least one controller may limit heat-transfer-impeding bubble formation on the inner surface of the evaporator base plate. Referring to Fig. 14D, in a third time period, pool 116 may contain a substantially equivalent volume as in the first time period (e.g., shown in fig. 14B), however whereas the coolant in pool 116 during the third time period may be substantially liquid coolant (e.g., conducive to heat transfer), the coolant in pool 116 during the first time period may include a significant amount of vaporized coolant in bubble 1406, which may not be conducive to heat transfer.

In some disclosed embodiments, the at least one controller is configured to pulse the at least one controllable valve in a manner configured to promote a release of bubbles trapped on the inner surface of the base plate. Promoting refers to advancing, engendering, and/or triggering. Promoting a release of bubbles trapped on the inner surface of the base plate refers to triggering and/or enabling the escapement of bubbles caught and/or confined on the inner surface of the base plate. For example, successive pressure fluctuations inside the chamber of the two-phase evaporator may exert forces that may overcome other forces trapping bubbles on the inner surface of the base place (e.g., related to surface tension). The forces associated with the pressure fluctuations may dislodge the bubbles from the inner surface, permitting the bubbles to rise towards the upper region of the chamber and exit the two-phase evaporator, and allowing the displacement of the bubbles by liquid coolant.

By way of a non-limiting example, in Figs. 14B, at least one controller (e.g., at least one processor 152 in Fig. 14A) may transmit one or more electronic signals to pulse one or more of controllable valves 1402 in a manner that promotes a release of bubble 1404 trapped on inner surface 106 of the base plate (e.g., heat conductive wall 104). For example, in Fig. 14C, the pressure fluctuations inside chambers 102 of ENE 100 may exert forces that overcome other forces trapping bubble 1404 on and/or near inner surface 106 of the base plate, causing bubble 1404 to exit pool 116. This may expose region 1406 to liquid coolant in pool 116 and/or lower the average temperature of pool 116, thereby improving the heat transfer capability of ENE 100.

In some disclosed embodiments, the pulsing by the at least one controller is configured to induce a substantially equivalent volume of liquid coolant to contact the inner surface of the base plate as the equivalent volume of gas from trapped bubbles are released from the base plate. Induce refers to promote and/or initiate. A volume of liquid coolant and/or gas (e.g., coolant) may refer to an amount of space occupied by coolant in liquid and/or gas form, e.g., measured in cubic centimeters (cc) and/or milliliters (ml). Due to the lower density of coolant in gaseous phase than in liquid phase, boiling a quantity (e.g., in ounces or milligrams) of liquid coolant occupying a first volume (e.g., in cc) may produce a second, larger volume (e.g., in cc) of gaseous coolant. Thus, the amount of space (e.g., in cc) occupied by an amount (e.g., in grams) of coolant in liquid phase may be smaller than the amount of space (e.g., in cc) occupied by the same amount (e.g., in grams) of coolant in gaseous form. A volume of liquid coolant in contact the inner surface of the base plate refers to an amount of liquid coolant (e.g., in cc) adjacent to, and/or covering or coating the inner surface of the base plate. A volume of gas from trapped bubbles released from the base plate refers to an amount of vaporized coolant (e.g., in cc) contained in bubbles that are no longer confined to being adjacent to, covering, and/or coating the inner surface of the base plate. Substantially equivalent means that even if there are some differences, those differences are inconsequential from an operational standpoint.

For example, (e.g., cooler) liquid coolant may have a greater capacity for absorbing heat than (e.g., hot) vaporized coolant. Moreover, since the volume (in cc) occupied by an amount of gaseous coolant (in grams) is larger than the volume (in cc) of the same amount (in grams) of liquid coolant, the formation of bubbles of vaporized coolant in regions on and/or near the base plate may further block contact of those regions of the base plate with liquid coolant, inhibiting absorption of heat by liquid coolant. Accordingly, increasing the amount of surface area of the base plate exposed to liquid coolant by decreasing the amount of surface area of the base plate blocked from contact with liquid coolant by trapped bubbles of vaporized coolant may improve the heat transfer capability of the base plate, thereby improving the cooling efficiency of the two-phase pulse evaporator. By pulsing the at least one controllable valve to cause successive pressure fluctuations, the at least one controller may prevent formation of such bubbles and/or free one or more trapped bubbles. The at least one controller may determine a frequency and/or duration for pulsing, and/or a degree of opening and/or closing of the at least one controllable valve to thereby control pressure fluctuations inside the two-phase pulse evaporator chamber for preventing the formation of bubbles and/or releasing trapped bubbles of vaporized coolant from the inner surface of the base plate. The removal of such bubbles may permit a volume (e.g., in cc) of liquid coolant to displace regions (e.g., in cc) on and/or near the inner surface of the base plate previously occupied by a substantially equivalent volume of vaporized coolant, thereby increasing the amount of surface area of the base plate available for heat transfer. In addition, the replacement of a volume of vaporized coolant with a substantially equivalent volume of liquid coolant may prevent a chamber of the two-phase pulse evaporator enclosure from containing too little coolant or too much liquid coolant. In some embodiments, a float valve inside the chamber may facilitate replacement of a volume of vaporized coolant with a substantially equivalent volume of liquid coolant, as described and exemplified elsewhere herein.

By way of a non-limiting example, in Figs. 1A-1B and 14A, at least one controller (e.g., at least one processor 152 of Fig. 1A) may pulse one or more of controllable valves 1402 to induce a substantially equivalent volume of liquid coolant to contact inner surface 106 of the base plate (e.g., heat conductive wall 104) as the equivalent volume of gas from trapped bubbles are released from the base plate. For instance, the at least one controller may determine a frequency, duration, and/or intensity of pulsing for controllable valve 1402 to cause corresponding pressure fluctuations inside chamber 102 for releasing a particular volume (e.g., 0.5 cc) of vaporized coolant trapped in a bubble on inner surface 106 of the base plate, with a substantially equivalent volume (e.g., 0.5 cc) of liquid coolant. The pressure fluctuations may cause dislodgment of the bubble (e.g., containing 0.5 cc of vaporized coolant) trapped inside pool 116, causing the bubble to rise to the upper region of chamber 102 and exit via vapor outlet 130. This may reduce the volume of coolant contained in pool 116 by an equivalent amount (e.g., 0.5 cc), which may lower the level of coolant in pool 116 accordingly.

Referring to Fig. 2A, lowering of the level of coolant in pool 116 may cause float valve 200, resting on the surface of the liquid coolant in pool 116, to drop by an equivalent amount. This may cause portion 208 of float valve 200 to disengage from inlet orifice 206, permitting the introduction of cooler liquid coolant to enter chamber 102. The cooler liquid coolant may enter pool 116 until the level of coolant in pool 116 reaches the previous level, which may raise float valve to cause portion 208 of float valve 200 to block inlet orifice 206 and prevent additional liquid coolant from entering chamber 102. The amount of liquid coolant permitted to enter chamber 102 to replace the volume occupied by the released bubble may be substantially equivalent to 0.5 cc.

By way of another non-limiting example, in Figs. 14B to 14E, at least one controller (e.g., at least one processor 152 in Fig. 1A) may cause successive pulses of pressure fluctuations inside chamber 102 of ENE 100 causing bubble 1404 to exit from pool 116. This may displace an equivalent volume in pool 116, causing the level of pool 116 to drop (e.g., see Fig. 14B). This may cause float valve 200 to drop as well and disengage from inlet orifice 206 of chamber 102, permitting (e.g., cooler) liquid coolant to enter chamber 102 via liquid coolant inlet line 102 and liquid coolant port 120. Referring to Fig. 14D, liquid coolant may enter chamber 102 and accumulate in pool 116 until the level of pool 116 rises sufficiently to cause float valve 200 to engage once more with inlet orifice 206, thereby blocking additional inflow of liquid coolant. Thus, the volume occupied by pool 116 in Fig. 14B, including liquid coolant and bubble 1404, may be substantially equivalent to the volume occupied by pool 116 in Fig. 14D, containing only liquid coolant. The pulsing by the at least one controller may thus induce a substantially equivalent volume of liquid coolant to contact inner surface 106 of heat conductive wall 104 as the equivalent volume of gas from trapped bubble 1404 is released from heat conductive wall 104.

In some disclosed embodiments, the pulsing is configured to promote a formation of multiple small bubbles in place of one or more large bubbles. Promoting a formation of multiple small bubbles refers to facilitating and/or enabling the generation of a plurality of bubbles having a volume less than a threshold value. For example, bubbles having a volume larger than the threshold value may tend to become trapped on and/or near a heat-conducting base plate of a two-phase pulse evaporator. In place of one or more large bubbles refers to instead of, replacing, and/or displacing one or more bubbles having a volume exceeding a threshold value. For example, by pulsing one or more controllable valves to cause successive pressure fluctuations inside a two-phase pulse evaporator enclosure, at least one controller may cause multiple small bubbles to be formed instead of one or more larger bubbles. Small bubbles may be less conducive to becoming trapped (e.g., ensnared by one or more fins, wicks, a float valve, and/or any other component) on and/or near the base plate than large bubbles, and may more easily escape the chamber. Smaller bubbles may also be associated with a lesser surface tension force for overcoming than larger bubbles. Therefore, the formation of small bubbles in place of one or more larger bubbles may reduce the amount of surface area of the base plate blocked from contact with liquid coolant by trapped bubbles of vaporized coolant, which may improve the heat transfer capability of the base plate.

For instance, when bubbles are first formed on and/or near the base plate, they may be relatively small. However, over time as the vaporized coolant inside the bubbles absorbs additional heat, the bubbles may expand until their volume exceeds the threshold value. To prevent this, the at least one controller may time the pulsing of the controllable valve to cause successive pressure fluctuations inside the chamber capable of releasing newly formed bubbles. This may cause smaller bubbles to float to the upper part of the chamber, preventing those bubbles from absorbing additional heat and growing until their volume reaches a threshold size where they may become trapped on and/or near the base plate.

In some disclosed embodiments, a size of the small bubbles is smaller than a gap between adjacent fins of a plurality of fins extending from the inner surface of the base plate, and wherein a size of the one or more large bubbles is greater than the gap. A gap between adjacent fins of a plurality of fins extending from the inner surface of the base plate, as described elsewhere herein, refers to a space and/or opening separating neighboring fins located in proximity to each other, with no intervening fins separating them. A size of the small bubbles is smaller than a gap between adjacent fins refers to the small bubbles being sufficiently minute to permit the bubbles to fit inside a space between neighboring fins. For example, the size of the bubbles may be sufficiently small to allow the bubbles to fit between the adjacent fins without the shape of the bubble being deformed (e.g., to prevent the bubble from being squeezed and trapped between the fins), and/or with sufficient clearance to allow the bubble to reside between the fins without touching the fins (e.g., to prevent the bubble from sticking to a fin due to surface tension). This may prevent the bubble from becoming trapped in the gap between the adjacent fins. A size of the one or more large bubbles is greater than the gap refers to one or more bubbles having a sufficiently large volume such that a diameter of the one or more bubbles wider than the gap. When such bubbles are located between two adjacent fins, the shape of the bubbles may be deformed (e.g., causing the bubbles to be squeezed between the fins, which may trap them). Additionally or alternatively, larger bubbles located between adjacent fins may leave insufficient clearance to avoid contacting one or more or the fins, which may lead to surface tension trapping the bubbles in the gap.

For example, the at least one controller may transmit signals to pulse the controllable valve to cause pressure fluctuations inside the two-phase pulse evaporator enclosure that prevent formation of bubbles reaching a size where they may become trapped between adjacent fins, and promote formation of bubbles too small to become trapped. This may improve the heat transfer capability of the base plate, as described earlier. Such a size may be dependent on one or more of a time for absorbing heat, an amount of heat generated by an associated electronic component, an operating frequency of the associated electronic component, a heat transfer rate, a temperature of liquid coolant entering the chamber, and/or any other parameter affecting bubble formation inside the two-phase pulse evaporator.

By way of a non-limiting example, reference is made to Fig. 14E which is another schematic block diagrams of a two-phase pulse evaporator for cooling electronic components when bubble formation inhibits cooling, consistent with some disclosed embodiments The two-phase pulse evaporator (e.g., ENE 100) of Fig. 14E is substantially similar to the two-phase pulse evaporators for Figs. 14B to 14D with the addition of a plurality of fins 300 and wicks 302. At least one controller (e.g., processor 152 in Fig. 14A) may transmit signals to pulse one or more of controllable valves 1402 to promote a formation of multiple small bubbles 1408 in place of one or more large bubbles (e.g., see bubble 1404 in Fig. 14B). For example, the pulsing may release bubbles 1408 from becoming trapped on and/or near inner surface 106 of the base plate (e.g., heat conductive wall 104), causing bubbles 1408 to escape chamber 102 via vapor port 130 before bubbles 1408 can absorb sufficient heat to reach the size of bubble 1404 of Fig. 14B.

For example, the size of small bubbles 1408 may be smaller than a gap 1410 between adjacent fins of a plurality of fins 300 extending from inner surface 104 of base plate 106, and the size of large bubble 1404 may be greater than gap 1410. In some embodiments, the pulsing may cause the size of small bubbles 1408 to be smaller than a gap 1412 between any one of fins 300 and an adjacent wick 302.

In some disclosed embodiments, the pulsing includes opening and closing the at least one controllable valve multiple times a second. Opening and closing a valve refers to releasing and constricting a valve to permit and block a fluid flow therethrough at least partially. Multiple times a second refers to a frequency for operating a valve. For instance, at least one controller may transmit electronic signals to open and close a controllable valve (as described elsewhere herein) at least 2 times per second, at least 5 times per second, at least 10 times per second, and/or any at any other frequency. In some embodiments, the at least controller may determine a frequency for opening and closing the at least one controllable valve based on an operating frequency of an associated heat-generating electronic component. For example, above an operating frequency threshold, an electronic component may generate an amount of heat facilitating the formation of large bubbles after a time period. Upon detecting the electronic component operating at or near the operating frequency threshold, the at least one controller may cause successive pressure fluctuations inside the chamber at a frequency having a period less than the time period, to prevent bubbles in proximity to the base plate from absorbing heat for longer the time period, thereby preventing the formation of large bubbles that may become trapped. In some embodiments, the at least one controller may associate multiple operating frequency ranges for an electronic component, each operating frequency range corresponding to a different frequency for opening and closing the controllable valve, thereby causing pressure fluctuations at different frequencies inside the chamber. Each pressure fluctuation frequency may be configured to limit formation of large bubbles that may become trapped on and/or near the base plate, based on an amount of heat transferred from the electronic component to the coolant in the chamber.

In some disclosed cmbodiments, the at least one controller is configured to open and close the controllable valve in response to a vapor pressure reading associated with the two-phase evaporator enclosure. A vapor pressure reading associated with the two-phase evaporator enclosure refers to a collective measure of forces exerted by vaporized coolant molecules inside a chamber of a two-phase pulse evaporator. For example, a higher vapor pressure reading may be associated with a faster rate of heat exchange in the chamber and/or higher coolant boiling temperature and a lower vapor pressure reading may be associated with a slower rate of heat exchange in the chamber and/or lower coolant boiling temperature. At least one controller may receive a vapor pressure reading from a transmitter associated with a pressure sensor, as described elsewhere herein. Such a pressure sensor may be positioned at a location inside the chamber and/or fluidly coupled thereto. For instance, if the vapor pressure reading is too high, the at least one controller may transmit one or more signals to pulse (e.g., successively open and close) the controllable valve in a manner permitting a higher flow rate of vaporized coolant to exit the enclosure, thereby lowering the vapor pressure inside the enclosure. In some embodiments, this may cause the boiling temperature of the coolant in the enclosure to drop. If the vapor pressure reading is too low, the at least one controller may transmit one or more signals to pulse the controllable valve in a manner slowing a flow rate of vaporized coolant exiting the enclosure, thereby raising the vapor pressure inside the chamber. In some embodiments, this may cause the boiling temperature of the coolant in the enclosure to rise.

In some disclosed embodiments, the at least one controller is configured to open and close the controllable valve in response to a vapor pressure reading associated with the vapor return line. A vapor pressure reading, as described earlier, associated with a vapor return line refers to a collective measure of forces exerted by vaporized coolant molecules flowing in a conduit, in this instance in the vapor return line. A vapor return line, in this context, is a conduit or portion thereof for delivering vaporized coolant from a two-phase pulse evaporator to a condenser. At least one controller may receive a vapor pressure reading associated with a vapor return line from a transmitter associated with a pressure sensor, as described earlier. Such a pressure sensor may be positioned inside the vapor return line, on the vapor return line, and/or at a location fluidly coupled thereto. For example, if the vapor pressure reading is too high, the at least one controller may transmit one or more signals to pulse (e.g., successively open and close) the controllable valve in a manner permitting a higher flow rate of vaporized coolant through the vapor return line, permitting vaporized coolant to escape, thereby lower the vapor pressure therein. If the vapor pressure reading is too low, the at least one controller may transmit one or more signals to pulse the controllable valve in a manner to obstruct a flow rate of vaporized coolant in the vapor return line, causing vaporized coolant to accumulate, thereby increasing vapor pressure therein. In some embodiments, a vapor coolant outlet line may be fluidly coupled to a chamber of a two-phase pulse evaporator such that vapor pressure in the chamber may be substantially the same as vapor pressure in the vapor return line. In some embodiments, vapor pressure in a vapor coolant outlet line may be different than vapor pressure inside the chamber.

By way of a non-limiting example, in Fig. 14A, a controller (e.g., at least one processor 152) may transmit one or more signals causing one or more of controllable valves 1402 to (e.g., successively) open, close, and/or partially close in response to vapor pressure readings associated with one or more of two-phase evaporator enclosures (e.g., ENEs 100) and/or in response to vapor pressure readings associated with one or more vapor lines 122. For instance, one or more vapor pressure sensors (not shown) included inside ENEs 100 and/or with one or more of controllable valves 1402 located on vapor output lines 122 may transmit vapor pressure readings to at least one processor 152, e.g., periodically and/or in response to a prompt, e.g., by at least one processor 152.

In some disclosed embodiments, the at least one controller is configured to open and close the controllable valve in response to a vapor temperature reading. A vapor temperature reading may refer to a measure of temperature, as described elsewhere, of vaporized coolant. In some embodiments, a vapor temperature reading may be associated with a coolant boiling temperature inside a two-phase pulse evaporator enclosure. For example, a vapor temperature reading may be used to monitor the temperature of the vaporized coolant and adjust the rate of coolant delivery and/or the frequency of valve pulsing. At least one controller may receive a vapor temperature reading from a transmitter associated with a temperature sensor, as described elsewhere. For instance, if the vapor temperature reading is too high, the at least one controller may transmit one or more signals to pulse (e.g., successively open and close) the controllable valve in a manner permitting a higher flow rate of vaporized coolant to escape the enclosure, thereby lower the vapor pressure and temperature therein. If the vapor temperature reading is too low, the at least one controller may transmit one or more signals to regulate the controllable valve in a manner to obstruct a flow rate of vaporized coolant exiting the enclosure, causing vaporized coolant to accumulate and increase vapor pressure and temperature therein.

By way of a non-limiting example, in Fig. 14A, one or more vapor temperature sensors (not shown) included inside ENEs 100 and/or with one or more of controllable valves 1402 located on vapor output lines 122 may transmit vapor temperature readings to at least one processor 152 e.g., periodically and/or in response to a prompt, e.g., by at least one processor 152. At least one controller (e.g., at least one processor 152) may use the vapor temperature reading determine one or more signals for transmitting to one or more of controllable valves 1402 to cause one or more of controllable valves 1402 to (e.g., successively) open, close, and/or partially close in response.

In some disclosed embodiments, the at least one controller is configured to open and close the controllable valve in response to a vapor flow rate. A vapor flow rate sensor may be used to monitor the rate at which vaporized coolant is evacuated from the enclosure. A vapor flow rate refers to a rate of vaporized coolant flow, in this instance exiting a two-phase pulse evaporator enclosure, and/or a rate of vaporized coolant flowing through a vapor return line fluidly coupling a two-phase pulse evaporator enclosure to a condenser. This may be accomplished using a flow measuring device such as a flow meter (mass or volumetric; thermal mass, differential pressure, or ultrasonic), rotameter, or an orifice plate. At least one controller may use a vapor flow rate to adjust the rate of coolant delivery and/or the frequency of valve pulsing. For example, at least one controller may receive an indication of a vapor flow rate from a transmitter associated with a vapor flow rate sensor. Such sensors may include a flow meter configured to measure linear, non-linear, mass, and/or volumetric flow rates. For instance, if the vapor flow rate is too high, the at least one controller may transmit one or more signals to pulse (e.g., successively open and close) the controllable valve in a manner to obstruct a flow of vaporized coolant, thereby lowering the vapor flow rate. If the vapor flow rate is too low, the at least one controller may transmit one or more signals to pulse the controllable valve in a manner to permit a greater flow of vaporized coolant, thereby increasing the flow rate of vaporized coolant.

By way of a non-limiting example, in Fig. 14A, one or more vapor flow sensors (not shown) included with one or more of controllable valves 1402 located on vapor output lines 122 may transmit vapor temperature readings to at least one processor 152 e.g., periodically and/or in response to a prompt, e.g., by at least one processor 152. A controller (e.g., at least one processor 152) may user the vapor temperature readings to determine one or more signals for transmitting to one or more of controllable valves 1402 to cause the one or more controllable valves 1402 to (e.g., successively) open, close, and/or partially close in response to vapor flow rate readings, e.g., in vapor lines 122.

In some disclosed embodiments, a frequency of pulsing is predetermined. A frequency of pulsing refers to a number of times that a controllable valve may be opened and closed in in a period of time (e.g., one second, one minute, and/or any other time unit). Predetermined refers to computed and/or otherwise identified in advance. For example, a predetermined frequency of pulsing may be a preset number of pulses per time period. It may be associated with a temperature, pressure, and/or flow rate of vaporized coolant, liquid coolant, and/or water flowing in an associated water loop, and/or an operating frequency range for a heat-generating electronic component. At least one controller may receive one or more signals from a transmitter associated with one or more temperature, pressure, and/or flowrate sensors, and/or the heat-generating electronic component and use the one or more signals to retrieve a predetermined frequency of pulsing stored in memory. The at least one controller may user the predetermined frequency to transmit electronic signals to the at least one controllable valve causing the controllable valve to pulse according to the predetermined frequency. A frequency of pulsing may be used to regulate the pressure fluctuations in the two-phase evaporator enclosure. For example, the frequency of pulsing may be adjusted based on the vapor temperature reading and the vapor flow rate to optimize the cooling efficiency of the two-phase pulse evaporator. In some disclosed embodiments, at least one controller may use a predetermined frequency of pulsing may to set a default value for a parameter such as the frequency of pulsing and/or the rate of coolant delivery. For example, the predetermined value may be set based on the typical operating conditions of the electronic component being cooled.

By way of a non-limiting example, in Fig. 14A, at least one controller (e.g., at least one processor 152) may transmit signals to open and close (e.g., pulse) at least one controllable valve 1402 multiple time a second. For instance, at least one controllable valve 1402 may pulse at least 2 times per second, 5 times per second, or according to any other frequency. In some embodiments, a frequency of pulsing is predetermined. For instance, at least one controller (e.g., at least one processor) may retrieve a frequency from memory and transmit signals to open and close at least one controllable valve 1402 based on the retrieved frequency. As an example, one or more pulsing frequencies may be stored in memory in association with one or more operating frequency ranges for a heat-generating electronic component.

In some disclosed embodiments, the liquid coolant port is configured to receive the liquid coolant from a condenser flow-connected to a plurality of additional two-phase pulse evaporators. Additional two-phase pulse evaporators refers to a plurality of two-phase pulse evaporators, each associated with one or more other heat-generating electronic components. Such an arrangement may allow concurrent cooling of the plurality of heat-generating electronic components. A condenser flow-connected to a plurality of additional two-phase pulse evaporators refers to a condenser, as previously described, connected via one or more conduits for distributing liquid coolant to multiple two-phase pulse evaporators, concurrently. Thus, a particular two-phase pulse evaporator may receive liquid coolant from a condenser concurrently with a plurality of additional two-phase pulse evaporator receiving liquid coolant from the condenser. For example, a liquid coolant manifold may fluidly couple a condenser output to a plurality of liquid inlets of a plurality of two-phase pulse evaporators via a plurality of liquid coolant inlet lines. This may permit a flow of liquid coolant to exit the condenser and branch out via the plurality of liquid coolant inlet lines to concurrently deliver liquid coolant to each chamber of each two-phase pulse evaporator. Upon entering a chamber of a particular two-phase pulse evaporator, the liquid coolant may enter a pool of liquid coolant in contact with a base plate to cool an associated heat-generating electronic component.

In some disclosed embodiments, the vapor outlet port is configured to evacuate the vaporized coolant to the condenser, and wherein the condenser is configured to convert the vaporized coolant to liquid coolant. A condenser configured to convert vaporized coolant to liquid coolant refers to a condenser, as described previously, configured to transform and/or change coolant in a gaseous phase to a liquid phase. For example, a pool of liquid coolant inside each two-phase pulse evaporator may absorb heat from an associated heat-generating electronic component via the base plate, causing liquid coolant to convert to vaporized coolant. The vaporized coolant may exit each two-phase pulse evaporator, where the vaporized coolant may be combined and aggregated, and delivered to condenser. For example, a vapor manifold may fluidly couple a plurality of vapor outlets of a plurality of two-phase pulse evaporators to a condenser input via a plurality of liquid coolant inlet lines. This may permit combining vaporized coolant exiting a plurality of two-phase pulse evaporators for delivery to the condenser inlet. The condenser may include a heat exchange for dissipating heat (e.g., including latent heat) from the vaporized coolant combined from the plurality of two-phase pulse evaporators, and may convert the coolant to liquid phase. The condenser may include a reservoir for storing the liquified coolant for subsequent supply to the plurality of two-phase pulse evaporators. In some embodiments, the heat exchange may include a portion of a water loop thermally coupled to a two-phase loop conveying vaporized and liquid coolant, as described elsewhere herein. In some embodiments, the water loop may be a source of heat for a facility.

In some disclosed embodiments, the at least one controller is further configured to control a pump associated with a condenser for simultaneous delivery of liquid coolant to the two-phase pulse evaporator and to a plurality of additional two-phase pulse evaporators. Simultaneous delivery of liquid coolant to the two-phase pulse evaporator and to a plurality of additional two-phase pulse evaporators refers to concurrent supply of liquid coolant to each of multiple two-phase pulse evaporators. For example, one or more pumps may be fluidly coupled to a condenser output, flow connected to a liquid coolant manifold configured to deliver liquid coolant to each of a plurality of two-phase pulse evaporators, as described earlier. A pump associated with a condenser, as described elsewhere herein, may be used to facilitate the movement of liquid coolant. For example, a pump may force liquid coolant stored in a reservoir of a condenser through a network of liquid coolant lines delivering liquid coolant to a plurality of two-phase pulse evaporators. Control refers to the ability to manage and/or direct the operations of a system and/or component. For example, at least one controller may control a two-phase pulse evaporator system by executing a set of instructions to regulate the functioning thereof. To control a pump refers to causing a pump to operate according to one or more determined and/or selected operating parameters, such as a frequency (e.g., RPM), timing, duration, and/or any other operating parameter. For example, at least one controller may transmit one or more signals causing one or more pumps to force a flow of liquid coolant to a plurality of two-phase pulse evaporators according to a specific flow rate, timing, frequency, and/or duration. The at least one controller may determine and/or select the specific flow rate, timing, frequency, and/or duration based on signals received from one or more sensors. Such signals may include one or more temperature signals (e.g., a vaporized coolant temperature, a coolant boiling temperature, and/or a water temperature in an output water line), one or more vapor pressure signals (e.g., inside a two-phase pulse evaporator enclosure and/or inside one or more vapor coolant output lines), an operating frequency of one or more heat-generating electronic components, and/or any other type of signal indicative of one or more parameters of a two-phase pulse evaporator cooling system.

By way of a non-limiting example, Fig. 14A, liquid coolant port (e.g., liquid coolant inlet 128) may receive liquid coolant from condenser 702 flow-connected to a plurality of additional two-phase pulse evaporators 100. For example, condenser output 1136 may be flow connected to a plurality of liquid coolant ports (e.g., a plurality of liquid coolant inlets 128) of a plurality of ENEs 100 via a liquid coolant manifold. In some embodiments, the at least one controller (e.g., at least one processor 152) may control one or more pumps 146 associated with condenser 702 for simultaneous delivery of liquid coolant to each of a plurality of two-phase pulse evaporators (e.g., ENEs 100).

Some disclosed embodiments involve a system for cooling electronic components when bubble formation inhibits cooling. Such a system may include at least one processor configured to: determine at least one signal configured to cause successive pressure fluctuations in at least one two-phase evaporator enclosure, wherein the at least one two-phase pulse evaporator enclosure includes: an evaporator base plate configured to serve as a heat exchanger, with an outer surface of the base plate configured for contacting a heat-generating electronic component and an inner surface of the base plate exposed to a coolant chamber within the enclosure, a liquid coolant port in a wall of the enclosure for delivering liquid coolant to the coolant chamber and to the inner surface of the base plate, a vapor outlet port in the wall of the enclosure for evacuating vaporized coolant from the enclosure, and at least one controllable valve flow connected to at least one of the liquid coolant port and the vapor outlet port; and transmit the at least one signal to the at least one controllable valve thereby limiting heat-transfer-impeding bubble formation on the inner surface of the evaporator base plate.

In some embodiments, the at least one two-phase pulse evaporator enclosure includes a plurality of two-phase pulse evaporator enclosures, and wherein each liquid coolant port and each vapor outlet port of each of the plurality of two-phase pulse evaporator enclosures is flow connected to a common condenser configured to receive vaporized coolant from each of the plurality of two-phase pulse evaporator enclosures via a condenser inlet, convert the vaporized coolant to liquid coolant, and deliver the liquid coolant to each of the plurality of two-phase pulse evaporators via each liquid coolant port, and wherein the at least one processor is configured to transmit the at least one signal to the at least one controllable valve, thereby limiting heat-transfer-impeding bubble formation on the inner surface of each evaporator base plate of each of the plurality of two-phase pulse evaporator enclosures.

In some embodiments, the at least one processor is further configured to control a pump associated with the condenser for simultaneous delivery of liquid coolant to the plurality of two-phase pulse evaporator enclosures.

By way of a non-limiting example, in Fig. 14A, a system 1400 for cooling electronic components when bubble formation inhibits cooling is disclosed. System 1400 may include at least one processor 152 configured to determine at least one signal for causing successive pressure fluctuations in at least one two-phase evaporator enclosure (e.g., at least one of ENEs 100). The at least one two-phase pulse evaporator enclosure may include an evaporator base plate (e.g., heat conductive wall 104) configured to serve as a heat exchanger. An outer surface 108 (see Fig. 1B) of the base plate may contact heat-generating electronic component 110 and inner surface 106 of the base plate may be exposed to coolant chamber 102 within the enclosure of ENE 100. Liquid coolant port (e.g., liquid coolant inlet 128) in a wall of the enclosure for ENE 100 may deliver liquid coolant to coolant chamber 102 and to inner surface 106 of the base plate. Vapor outlet port 130 in the wall of the enclosure of ENE 100 may evacuate vaporized coolant from the enclosure of ENE 100. At least one controllable valve 1402 may be flow connected to at least one of liquid coolant port 128 and vapor outlet port 130. At least one processor 152 may transmit at least one signal to at least one controllable valve 1402 thereby limiting heat-transfer-impeding bubble formation (e.g., see bubble 1404 in Fig. 14B) on inner surface 106 of the evaporator base plate.

In some embodiments, the two-phase pulse evaporator enclosure (e.g., ENE 100) may include a plurality of two-phase pulse evaporator enclosures. Each liquid coolant port 128 and each vapor outlet port 130 of each of the plurality of two-phase pulse evaporator enclosures may be flow connected to common condenser 702 which may receive vaporized coolant from each of the plurality of two-phase pulse evaporator enclosures via condenser inlet 1124. Condenser 702 may convert the vaporized coolant to liquid coolant, and deliver the liquid coolant to each of the plurality of two-phase pulse evaporators (e.g., ENEs 100) via each liquid coolant port 128. At least one processor 152 may transmit the at least one signal to at least one controllable valve 1402, thereby limiting heat-transfer-impeding bubble formation on inner surface 106 of each evaporator base plate (e.g., heat conducting wall 104) of each of the plurality of two-phase pulse evaporator enclosures.

In some embodiments, at least one processor 152 may control at least one pump 146 associated with condenser 702 for simultaneous delivery of liquid coolant to the plurality of two-phase pulse evaporator enclosures (e.g., ENEs 100).

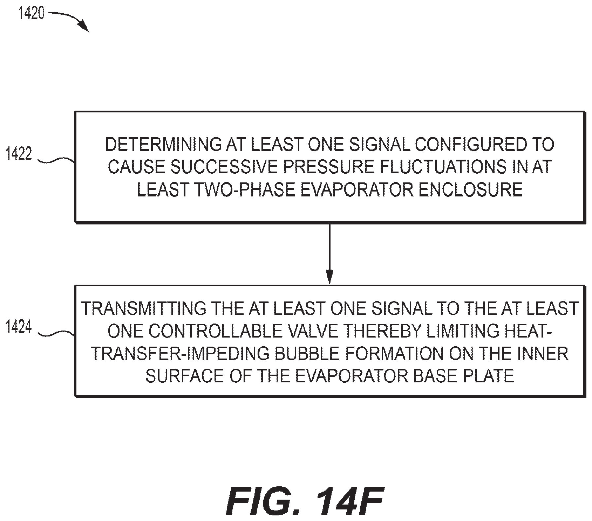

Fig. 14F is a flowchart of an exemplary process 1420 for cooling electronic components when bubble formation inhibits cooling, consistent with embodiments of the present disclosure. In some embodiments, process 1420 may be performed by at least one processing device (e.g., at least one processor 152) to perform operations or functions described herein. In some embodiments, some aspects of process 1420 may be implemented as software (e.g., program codes or instructions) that are stored in a memory or a non-transitory computer readable medium. In some embodiments, some aspects of process 1420 may be implemented as hardware (e.g., a specific-purpose circuit). In some embodiments, process 1420 may be implemented as a combination of software and hardware.

Referring to Fig. 14F, process 1420 may include a step 1422 of determining at least one signal configured to cause successive pressure fluctuations in at least one two-phase evaporator enclosure. The at least one two-phase pulse evaporator enclosure may include an evaporator base plate configured to serve as a heat exchanger, with an outer surface of the base plate configured for contacting a heat-generating electronic component and an inner surface of the base plate exposed to a coolant chamber within the enclosure, a liquid coolant port in a wall of the enclosure for delivering liquid coolant to the coolant chamber and to the inner surface of the base plate, a vapor outlet port in the wall of the enclosure for evacuating vaporized coolant from the enclosure, and at least one controllable valve flow connected to at least one of the liquid coolant port and the vapor outlet port. By way of a non-limiting example, in Fig. 14A, at least one processor 152 may determine at least one signal for causing successive pressure fluctuations in at least one two-phase evaporator enclosure (e.g., ENE 100). The at least one two-phase pulse evaporator enclosure may include an evaporator base plate (e.g., heat conducting wall 104) configured to serve as a heat exchanger, with outer surface 108 of the base plate configured for contacting heat-generating electronic component 110 and inner surface 106 of the base plate exposed to coolant chamber 102 within the enclosure of ENE 100. Liquid coolant port (e.g., liquid coolant inlet 128) in a wall of the enclosure of ENE 100 may deliver liquid coolant to coolant chamber 102 and to inner surface 106 of the base plate. Vapor outlet port 130 in the wall of the enclosure of ENE 100 may evacuate vaporized coolant from the enclosure of ENE 100. At least one controllable valve 1402 may be flow connected to at least one of liquid coolant port 128 and vapor outlet port 130.

Process 1420 may include a step 1424 of transmitting the at least one signal to the at least one controllable valve thereby limiting heat-transfer-impeding bubble formation on the inner surface of the evaporator base plate. By way of a non-limiting example, in Fig. 14A, at least one processor 152 may transmit at least one signal to at least one controllable valve 1402 thereby limiting heat-transfer-impeding bubble formation on inner surface 106 of the evaporator base plate (e.g., heat conducting wall 104). For instance, in Figs. 14B to 14E, pulsing of at least one controllable valve 1402 by at least one processor 152 (see Fig. 14A) may dislodge bubble 1404 preventing region 1406 of inner surface 106 of the base plate from coming in contact with liquid coolant in pool 116.

Examples of inventive concepts are contained in the following clauses which are an integral part of this disclosure.
Clause 1. A cooling device for a solid-state electronics component with a component surface that heats during operation, the cooling device comprising:
   a chamber having a first region defining a pool with a heat conducting wall, the heat conducting wall having an inner surface constituting a wall of the pool and an outer surface, opposite the inner surface for thermal contact with the component surface and for conducting heat therefrom into the pool;
   a liquid coolant inlet integrated with the chamber, the liquid coolant inlet for supplying liquid coolant to the pool to thereby enable pool boiling of the liquid coolant and conversion of the liquid coolant into vaporized coolant;
   a vapor outlet integrated with the chamber for evacuating vaporized coolant from the chamber; and
   a valve configured to restrict flow of the liquid coolant when the liquid coolant in the chamber surpasses a threshold.
Clause 2. The cooling device of clause 1, wherein the liquid coolant inlet includes an inlet orifice and wherein the valve includes a float with a portion for blocking the inlet orifice.
Clause 3. The cooling device of any of clauses 1 and 2, wherein the float has at least one opening therein for enabling the liquid coolant to pass therethrough.
Clause 4. The cooling device of any of clauses 1 to 3, wherein the blocking portion includes a pin and the inlet orifice is configured to receive the pin.
Clause 5. The cooling device of any of clauses 1 to 4, wherein the blocking portion is located in a central area of the float.
Clause 6. The cooling device of any of clauses 1 to 5, further comprising at least one spring for biasing the float toward the inlet orifice.
Clause 7. The cooling device of any of clauses 1 to 6, wherein the at least one spring is configured to counterbalance a weight of the float.
Clause 8. The cooling device of any of clauses 1 to 7, wherein the at least one spring includes a plurality of springs.
Clause 9. The cooling device of any of clauses 1 to 8, wherein an aggregate of the expansion forces of the plurality of springs are substantially equal to a weight of the float.
Clause 10. The cooling device of any of clauses 1 to 9, wherein the expansion forces of the plurality of springs are substantially equal.
Clause 11. The cooling device of any of clauses 1 to 10, wherein the float has a periphery area and wherein the plurality of springs are distributed in the periphery area.
Clause 12. The cooling device of any of clauses 1 to 11, wherein the float includes a central area in which the blocking portion is located, and wherein the blocking portion is substantially equidistant from each spring.
Clause 13. The cooling device of any of clauses 1 to 12, wherein the float has a generally rectangular periphery area and wherein each of the plurality of springs is located in a differing corner of the generally rectangular periphery area.
Clause 14. The cooling device of any of clauses 1 to 13, wherein the float is configured to block the inlet orifice in a manner promoting pool boiling.
Clause 15. The cooling device of any of clauses 1 to 14, wherein the heat conducting wall is a cooling plate having screw holes therein adapted for screw connection to a semiconductor board.
Clause 16. The cooling device of any of clauses 1 to 15, wherein the chamber includes a plurality of fins on an outer surface thereof.
Clause 17. The cooling device of any of clauses 1 to 16, wherein the chamber includes a plurality of fins therein.
Clause 18. The cooling device of any of clauses 1 to 17, wherein wicks are disposed between the plurality of fins.
Clause 19. The cooling device of any of clauses 1 to 18, wherein the liquid coolant is a non-electrically conductive material.
Clause 20. The cooling device of any of clauses 1to to 19, wherein the liquid coolant inlet and the vapor outlet are configured for flow-connection to a condenser configured to receive vaporized coolant evacuated from a plurality of cooling devices, convert the vaporized coolant to liquid coolant, and supply the liquid coolant to a plurality of cooling devices.
Clause 21. A cooling device of this clause and any of the preceding clauses, comprising:
   a chamber for containing a liquid coolant, the chamber having a heat transfer surface;
   an inlet for the liquid coolant;
   an outlet for vaporized liquid coolant;
   a plurality of fins within the chamber and extending from the heat transfer surface, the fins being arranged in the chamber for submersion in the liquid coolant; and a plurality of porous units disposed between the plurality of fins such that the fins and the porous units alternate, and wherein the porous units are configured to wick coolant along the fins.
Clause 22. The cooling device of any of clauses 1 to 21, wherein the porous units include a non-heat conductive fibrous material.
Clause 23. The cooling device of any of clauses 1 to 22, wherein the fibrous material is cellulose.
Clause 24. The cooling device of any of clauses 1 to 23, wherein at least some of the plurality of porous units have a rough surface.
Clause 25. The cooling device of any of clauses 1 to 24, wherein each rough surface is configured to prevent entrapment of boiling coolant bubbles in an associated gap between adjacent fins.
Clause 26. The cooling device of any of clauses 1 to 25, wherein each rough surface is configured to facilitate formation of boiling coolant bubbles smaller than would be formed in an absence of each rough surface.
Clause 27. The cooling device of any of clauses 1 to 26, wherein each rough surface is configured to facilitate formation of boiling coolant bubbles smaller than an associated gap between adjacent fins.
Clause 28. The cooling device of any of clauses 1 to 27, wherein the plurality of porous units are configured to enable the boiling coolant bubbles formed thereon to escape toward the outlet for vaporized liquid coolant.
Clause 29. The cooling device of any of clauses 1 to 28, wherein each of the plurality of porous units is in a form of a strip interleaved between adjacent fins.
Clause 30. The cooling device of any of clauses 1 to 29, wherein a width of each of the plurality of porous units is less than or equal to a size of an associated gap between adjacent fins.
Clause 31. The cooling device of any of clauses 1 to 30, wherein at least some of the plurality porous units extend past adjacent fins in at least one of length or height.
Clause 32. The cooling device of any of clauses 1 to 31, further comprising graphite layers sandwiching at least some of the porous units.
Clause 33. The cooling device of any of clauses 1 to 32, wherein the graphite layers contain a plurality of notches.
Clause 34. The cooling device of any of clauses 1 to 33, wherein the notches expose each of the plurality of porous units to an adjacent fin.
Clause 35. The cooling device of any of clauses 1 to 34, wherein the fins are made of heat-conductive metal.
Clause 36. The cooling device of any of clauses 1 to 35, wherein the heat conductive metal is chosen from a group consisting of copper, iron, steel, and aluminum.
Clause 37. The cooling device of any of clauses 1 to 36, wherein the fins are made of a non-metal.
Clause 38. The cooling device of any of clauses 1 to 37, wherein the non-metal is graphite.
Clause 39. The cooling device of any of clauses 1 to 38, further comprising at least one rib in the chamber for maintaining the porous units between the fins.
Clause 40. The cooling device of any of clauses 1 to 39, wherein the chamber is configured for location on a computer chip to thereby cool the computer chip.
Clause 41. A two-phase cooling device configured for parallel liquid coolant interconnection and serial vapor return interconnection of this clause and any of the preceding clauses, the two-phase cooling device comprising:
   a chamber having a liquid coolant region and vaporized coolant region;
   a liquid coolant port in the chamber for flow connection to a liquid coolant source;
   a first vapor port in the chamber for evacuating first vaporized coolant from the chamber;
   a second vapor port in the chamber for receiving second vaporized coolant from at least one other chamber of at least one other two-phased cooling device; and
   a vapor passthrough path flow-connecting the first vapor port to the second vapor port, to thereby enable the second vaporized coolant to mix with the first vaporized coolant.
Clause 42. The two-phase cooling device of any of clauses 1 to 41, wherein the first vapor port and the second vapor port are flow connected to the vaporized coolant region of the chamber thereby enabling the second vaporized coolant entering the vaporized coolant region to form a mixture with the first vaporized coolant, and enabling the mixture to exit the vaporized coolant region via the first vapor port.
Clause 43. The two-phase cooling device of any of clauses 1 to 42, wherein the vapor passthrough path is at least partially located in the vaporized coolant region.
Clause 44. The two-phase cooling device of any of clauses 1 to 43, further comprising a liquid coolant conduit for conveying liquid coolant from the liquid coolant port to a liquid coolant inlet in the liquid coolant chamber.
Clause 45. The two-phase cooling device of any of clauses 1 to 44, wherein the liquid coolant conduit at least partially passes through the vaporized coolant region of the chamber.
Clause 46. The two-phase cooling device of any of clauses 1 to 45, wherein the liquid coolant conduit is transverse to the vapor passthrough path.
Clause 47. The two-phase cooling device of any of clauses 1 to 46, further comprising at least one vaporized coolant conduit connected to at least one of the first vapor port and the second vapor port, wherein the at least one vaporized coolant conduit at least partially passes through the liquid coolant region.
Clause 48. The two-phase cooling device of any of clauses 1 to 47, further comprising a barrier in the chamber dividing the vaporized coolant region from the liquid coolant region.
Clause 49. The two-phase cooling device of any of clauses 1 to 48, wherein the barrier exposes at least one vent permitting the first vaporized coolant to escape from the liquid coolant region to the vaporized coolant region and mix with the second vaporized coolant in the vaporized coolant region.
Clause 50. The two-phase cooling device of any of clauses 1 to 49, wherein the first vapor port and the second vapor port are integrally formed with the barrier.
Clause 51. The two-phase cooling device of any of clauses 1 to 50, wherein the first vapor port and the second vapor part are at least partially located in the liquid coolant region.
Clause 52. The two-phase cooling device of any of clauses 1 to 51, further comprising a float valve in the liquid coolant region, wherein the float valve is configured to conditionally restrict inlet flow of liquid coolant into the liquid coolant region.
Clause 53. The two-phase cooling device of any of clauses 1 to 52, further comprising a liquid coolant conduit within the chamber, the liquid coolant conduit having a valve seat therein, and wherein the float valve includes a pin configured to engage the valve seat in order to restrict the inlet flow of liquid coolant through a liquid coolant inlet and into the liquid coolant region.
Clause 54. The two-phase cooling device of any of clauses 1 to 53, wherein the vapor passthrough path is configured for flow connection to a vapor conduit for receiving third vaporized coolant from at least one additional vapor passthrough path of at least one additional two-phased cooling device, to thereby enable the third vaporized coolant to mix with the first vaporized coolant and the second vaporized coolant.
Clause 55. The two-phase cooling device of any of clauses 1 to 54, wherein the first vapor port is associated with a first controllable valve and wherein the second vapor port is associated with a second controllable valve.
Clause 56. The two-phase cooling device of any of clauses 1 to 55, wherein the first controllable valve and the second controllable valve are regulated by at least one processor to modulate temperature within the chamber.
Clause 57. The two-phase cooling device of any of clauses 1 to 56, wherein the first controllable valve and the second first controllable valve are solenoid valves.
Clause 58. The two-phase cooling device of any of clauses 1 to 57, wherein cross-sectional areas of the first vapor port and the second vapor port are larger than a cross-sectional area of the liquid coolant port.
Clause 59. The two-phase cooling device of any of clauses 1 to 58, wherein the liquid coolant port is configured for flow connection to the liquid coolant source via a liquid coolant manifold configured for flow connecting a plurality of additional two-phase cooling devices to the liquid coolant source.
Clause 60. The two-phase cooling device of any of clauses 1 to 59, wherein the liquid coolant source is a condenser and wherein the first vapor port and the second vapor port are configured for flow connection to a vapor manifold configured to convey the first vaporized coolant, the second vaporized coolant, and additional vaporized coolant from the plurality of additional two-phase cooling devices to the condenser.
Clause 61. A cooling device configured to induce internal counterflow of this clause and any of the preceding clauses, the cooling device comprising:
   a chamber for containing a liquid coolant;
   a liquid coolant inlet in the chamber;
   a vapor outlet in a vapor collection region of the chamber for evacuating vaporized liquid coolant from the chamber;
   a heat conducting element in a boiling region of the chamber;
   a coolant pool region interposed between the vapor collection region and the boiling region; and
   at least one conduit extending from the boiling region toward the vapor collection region, the at least one conduit being configured to direct vapor in a first direction toward the vapor collection region thereby facilitating liquid coolant movement toward the boiling region in a second direction counter to the first direction.
Clause 62. The cooling device of any of clauses 1 to 61, configured for mounting on electronics for cooling the electronics.
Clause 63. The cooling device of any of clauses 1 to 62, wherein the heat conducting element includes a plurality of fins configured to cause a bubble field of vaporized coolant to be trapped therebetween, and wherein the at least one conduit is configured to facilitate an evacuation of the trapped bubble field.
Clause 64. The cooling device of any of clauses 1 to 63, wherein the heat conducting element includes a plurality of wicks interposed between adjacent fins.
Clause 65. The cooling device of any of clauses 1 to 64, wherein the fins are thermally coupled to the heat conducting element.
Clause 66. The cooling device of any of clauses 1 to 65, wherein the at least one conduit extends from a position adjacent the fins to a position in or adjacent the vapor collection region.
Clause 67. The cooling device of any of clauses 1 to 66, wherein the position adjacent to the fins is in the coolant pool region.
Clause 68. The cooling device of any of clauses 1 to 67, wherein the at least one conduit includes an inlet seated on at least one of the plurality of fins or the plurality of wicks interposed between the plurality of fins.
Clause 69. The cooling device of any of clauses 1 to 68, wherein the liquid coolant inlet is associated with a valve for conditionally restricting inflow of liquid coolant into the chamber. Clause 70. The cooling device of any of clauses 1 to 69, wherein the at least one conduit includes at least two conduits with a gap therebetween, and wherein the gap is configured to facilitate liquid coolant flow toward the boiling region in the second direction.
Clause 71. The cooling device of any of clauses 1 to 70, wherein the gap is configured to facilitate liquid coolant flow toward the boiling region in a cyclical manner for facilitating heat conduction.
Clause 72. The cooling device of any of clauses 1 to 71, wherein the gap is in flow communication with the liquid coolant inlet.
Clause 73. The cooling device of any of clauses 1 to 72, wherein the at least two conduits include two conduits joined in a unified structure, and wherein the two conduits converge in the boiling region and diverge as the two conduits approach the vapor collection region.
Clause 74. The cooling device of any of clauses 1 to 73, wherein the at least two conduits include inlets adjacent the boiling region, the inlets being configured to divide vapor flow into a plurality of spaced apart vapor pathways with a liquid coolant pathway in the gap therebetween.
Clause 75. The cooling device of any of clauses 1 to 74, wherein the gap includes a first opening at a location adjacent the boiling region, the first opening being narrower than openings of the inlets of the at least two conduits adjacent the boiling region.
Clause 76. The cooling device of any of clauses 1 to 75, wherein the gap includes a second opening at a location remote from the fins, the second opening being wider than openings of the at least two conduits adjacent the fins.
Clause 77. The cooling device of any of clauses 1 to 76, wherein the at least two conduits each include an elongated outlet with the gap between outlets of the at least two conduits at a location remote from the fins, and wherein a length of each of the elongated outlets is greater than a widest width of the gap.
Clause 78. The cooling device of any of clauses 1 to 77, wherein the at least two conduits define two channels, each channel having an inlet opening adjacent the fins and an outlet opening remote from the fins, and wherein the liquid coolant pathway includes the coolant pool region.
Clause 79. The cooling device of any of clauses 1 to 78, wherein the vapor outlet is configured to evacuate vaporized coolant from the chamber to a condenser.
Clause 80. The cooling device of any of clauses 1 to 79, wherein the liquid coolant inlet is configured for flow connection to the condenser to thereby enable deliver of the liquid coolant to the coolant pool region via the liquid coolant inlet.
Clause 81. A two-phase cooling device for enabling vapor outflow from a submerged liquid level location of this clause and any of the preceding clauses, the cooling device comprising:
   a chamber having a lower region for containing liquid coolant and an upper region for containing vaporized coolant;
   a liquid coolant port in the chamber;
   a heat conducting element in the lower region of the chamber;
   at least one vapor coolant port located at a level at least partially in the lower region, and at least partially beneath the upper region; and
   at least one snorkel pathway fluidly connecting the upper region for containing vaporized coolant with the at least one vapor coolant port, to thereby enable vaporized liquid coolant to exit the chamber from the submerged level at least partially beneath a level of liquid coolant in the lower region.
Clause 82. The two-phase cooling device of any of clauses 1 to 81, wherein the heat conducting element is configured for mounting on a heat-generating electrical component for cooling the heat-generating electrical component.
Clause 83. The two-phase cooling device of any of clauses 1 to 82, wherein the at least one vapor port includes two vapor ports and wherein the at least one snorkel pathway includes two snorkel pathways.
Clause 84. The two-phase cooling device of any of clauses 1 to 83, wherein each of the two snorkel pathways are in flow communication with the upper region thereby enabling vapor from one of the two vapor coolant ports to exit through the other of the two vapor coolant ports.
Clause 85. The two-phase cooling device of any of clauses 1 to 84, wherein the two snorkel pathways are symmetric.
Clause 86. The two-phase cooling device of any of clauses 1 to 85, further comprising a barrier between the lower region and the upper region.
Clause 87. The two-phase cooling device of any of clauses 1 to 86, wherein the barrier exposes at least one vent permitting vapor of boiling coolant in the lower region to escape to the upper region.
Clause 88. The two two-phase cooling device of any of clauses 1 to 87, wherein the upper region enables boiling coolant originating in the lower region to mix with coolant vapor entering through the at least one vapor port.
Clause 89. The two-phase cooling device of any of clauses 1 to 88, wherein the at least one vent includes a plurality of vents distributed around a perimeter of the barrier.
Clause 90. The two-phase cooling device of any of clauses 1 to 89, wherein the barrier is configured to obstruct entry of liquid coolant into the upper region.
Clause 91. The two-phase cooling device of any of clauses 1 to 90, wherein the barrier is plate shaped.
Clause 92. The two-phase cooling device of any of clauses 1 to 91, wherein the barrier has a liquid coolant inlet extending therethrough.
Clause 93. The two-phase cooling device of any of clause 1 to 92, further comprising a float valve in the lower region, the float valve being configured to conditionally obstruct the coolant inlet.
Clause 94. The two-phase cooling device of any of clauses 1 to 93, wherein the barrier includes a liquid coolant conduit for conveying liquid coolant through the upper region to the liquid coolant inlet.
Clause 95. The two-phase cooling device of any of clauses 1 to 94, wherein a cross-section of the liquid coolant conduit is smaller than a cross-section of the at least one snorkel pathway, and wherein a cross-section of an opening of the at least one vapor coolant port is larger than a cross-section of an opening of the liquid coolant port.
Clause 96. The two-phase cooling device of any of clauses 1 to 95, wherein the liquid coolant conduit is transverse to a direction of vapor coolant flow.
Clause 97. The two-phase cooling device of any of clauses 1 to 96, wherein lower region for containing liquid coolant has a volume substantially larger than a volume of the upper region.
Clause 98. The two-phase cooling device of any of clauses 1 to 97, wherein the at least one snorkel pathway is S-shaped.
Clause 99. The two-phase cooling device of any of clauses 1 to 98, wherein the snorkel pathway has a consistent gradient.
Clause 100. The two-phase cooling device of any of clauses 1 to 99, wherein the chamber is configured for pool boiling.
Clause 101. A system for controlling electronics operating frequencies for regulating heat generation of this clause and any of the preceding clauses, the system comprising:
   at least one processor configured to:
   monitor utilization of a plurality of heat-generating electronic components each having an associated operating frequency, and wherein heat generated by each electronic component is a function of the associated operating frequency;
   determine that the associated operating frequency of at least one of the plurality of heat-generating electronic components cooperating to accomplish a shared workload, is greater than necessary to accomplish the shared workload within a predefined timeframe, and therefore generating unnecessary heat;
   determine at least one operating frequency cap for the at least one of the plurality of heat-generating electronic components, wherein the at least one operating frequency cap is determined to enable the plurality of heat-generating electronic components to accomplish the workload while controlling aggregate heat output of the plurality of heat-generating electronic components; and
   output at least one cap signal to the at least one of the plurality of heat-generating electronic components, wherein the at least one cap signal is configured to limit the associated operating frequency of the at least one of the plurality of electronic components to the operating frequency cap.
Clause 102. The system of any of clauses 1 to 101, wherein determining that the associated operating frequency of the at least one of the plurality of heat-generating electronic components is greater than necessary includes identifying idle usage periods associated with the heat-generating electronic components, and wherein determining at least one operating frequency cap includes shifting workload from peak usage periods to the idle usage periods.
Clause 103. The system of any of clauses 1 to 102, wherein the at least one operating frequency cap is further based on an amount of time taken to shift from the peak usage periods to the idle usage periods.
Clause 104. The system of any of clauses 1 to 103, wherein the at least one operating frequency cap is a single common operating frequency cap applied to each of the plurality of heat-generating electronic components.
Clause 105. The system of any of clauses 1 to 104, wherein the at least one operating frequency cap includes a plurality of differing operating frequency caps for application to differing ones of the plurality of heat-generating electronic components.
Clause 106. The system of any of clauses 1 to 105, wherein values of the differing operating frequency caps depend on heat-generating electronic component type.
Clause 107. The system of any of clauses 1 to 106, wherein the at least one processor is further configured to change the plurality of operating frequency caps dynamically over time.
Clause 108. The system of any of clauses 1 to 107, further comprising a plurality of cooling devices associated with each of the plurality of heat-generating electronic components, and wherein the at least one processor is configured to simultaneously control the plurality of cooling devices.
Clause 109. The system of any of clauses 1 to 108, wherein the plurality of cooling devices are configured for two-phase cooling using a coolant.
Clause 110. The system of any of clauses 1 to 109, wherein the coolant is a dielectric coolant.
Clause 111. The system of any of clauses 1 to 110, wherein the at least one processor is further configured to control a pump delivering the coolant to the plurality of cooling devices.
Clause 112. The system of any of clauses 1 to 111, wherein each of the plurality of cooling devices includes a valve for controlling an output vapor flow, and wherein the at least one processor is further configured to control each valve, thereby controlling vaporized coolant exiting each of the plurality of cooling devices.
Clause 113. The system of any of clauses 1 to 112, wherein the at least one processor is further configured to control an inflow of water for cooling the vaporized coolant, thereby controlling a heat transfer rate between the vaporized coolant and the water.
Clause 114. The system of any of clauses 1 to 113, wherein the at least one operating frequency cap is determined based on heat-generating electronic component idle time and utilization.
Clause 115. The system of any of clauses 1 to 114, wherein the at least one operating frequency cap is based on an amount of idle time for a particular one of the plurality of heat-generating electronic components.
Clause 116. The system of any of clauses 1 to 115, wherein when the utilization exceeds a threshold, the at least one processor is configured to increase the at least one operating frequency cap.
Clause 117. The system of any of clauses 1 to 116, further comprising a load balancer configured to allocate the workload amongst the plurality of heat-generating electronic components.
Clause 118. The system of any of clauses 1 to 117, wherein for operating frequencies above which each electronic component experiences a heat-related degradation, the at least one processor is configured to impose an operational limit on an associated operating frequency.
Clause 119. The system of any of clauses 1 to 118, wherein the at least one operating frequency cap is associated with the operating limit.
Clause 120. The system of any of clauses 1 to 119, wherein the at least one operating frequency cap is less than the operational limit.
Clause 121. A system for achieving a target water temperature in a facility where water is used as part of a process for electronics cooling of this clause and any of the preceding clauses, the system comprising:
   a primary water loop including an output water line and an associated control valve;
   a secondary two-phase loop including:
      a plurality of two-phase evaporators, each two-phase evaporator configured for thermal contact with an associated one of a plurality of heat-generating electronic components,
      a plurality of liquid coolant inlet lines for delivering liquid coolant to the plurality of two-phase evaporators, and
      a plurality of vapor coolant outlet lines for evacuating vaporized coolant from the plurality of two-phase evaporators;
      a condenser having a condenser inlet for flow connection to the plurality of vapor coolant outlet lines and being configured to convert the vaporized coolant into the liquid coolant, the condenser further including a condenser outlet for flow connection to the plurality of liquid coolant inlet lines, the condenser being configured for thermally coupling the secondary two-phase loop to the primary water loop to transfer heat conveyed from the plurality of heat-generating electronic components by the vaporized coolant to water flowing in the output water line; and
      at least one processor configured to:
         receive at least one signal indicative of at least one of a pressure in the plurality of vapor coolant outlet lines or a temperature in the output water line; and
         regulate vapor pressure in the plurality of vapor coolant outlet lines as a function of the signal to thereby control a temperature of the water in the output water line.
Clause 122. The system of any of clauses 1 to 121, further comprising a pump for conveying liquid coolant from the condenser to the plurality of two-phase evaporators via the plurality of liquid coolant inlet lines, wherein the at least one processor is further configured to control an RPM of the pump to regulate a flow of liquid coolant from the condenser to the plurality of two-phase evaporators via the plurality of liquid coolant lines.
Clause 123. The system of any of clauses 1 to 122, wherein the at least one processor is further configured to regulate inlet water flow into the condenser in order to regulate pressure in the plurality of vaporized coolant outlet lines.
Clause 124. The system of any of clauses 1 to 123, further comprising a plurality of flow control valves, each flow control valve being associated with a differing outlet line, and wherein the at least one processor is further configured to control each flow control valve to regulate a flow of vaporized coolant from each of the plurality of two-phase evaporators to the condenser via the plurality of outline lines, thereby controlling the water temperature in the output water line.
Clause 125. The system of any of clauses 1 to 124, wherein the at least one processor is further configured to control operating frequencies for the plurality of heat-generating electronic components, thereby controlling the water temperature in the output water line.
Clause 126. The system of any of clause 1 to 125, wherein the at least one processor is further configured to regulate inlet water flow into the condenser by controlling the associated control valve.
Clause 127. The system of any of clauses 1 to 126, wherein the condenser further includes a water line inlet and a water line outlet for connection to the water line and for enabling water to pass through the condenser and to receive heat generated by the plurality of electronic components.
Clause 128. The system of any of clauses 1 to 127, further comprising a vapor manifold for collecting vapor from the plurality of outlet lines and for delivering the collected vapor to the condenser.
Clause 129. The system of any of clauses 1 to 128, further comprising a liquid coolant manifold for delivering the condensed liquid coolant to the plurality of liquid coolant inlet lines.
Clause 130. The system of any of clauses 1 to 129, wherein the at least one processor is configured to control boiling temperatures of liquid coolant within each of the plurality of two-phase evaporators.
Clause 131. The system of any of clauses 1 to 130, wherein the output water line is configured to convey at least some of the heat transferred from the plurality of heat-generating electronic components to a heat exchanger.
Clause 132. The system of any of clauses 1 to 131, wherein each two-phase evaporator includes a float valve configured to regulate an inflow of liquid coolant to each two-phase evaporator and to prevent liquid coolant from entering an associated vapor coolant outlet line.
Clause 133. A system for achieving a target water temperature in a facility where water is used as part of a process for electronics cooling of this clause and any of the preceding clauses, the system comprising:
   a primary water loop including an output water line and an associated control valve;
   a secondary two-phase loop including:
      a plurality of two-phase evaporators, each two-phase evaporator configured for thermal contact with an associated one of a plurality of heat generating electronic components;
      a plurality of liquid coolant inlet lines for delivering liquid coolant to the plurality of two-phase evaporators, and
      a plurality of vapor coolant outlet lines for evacuating vaporized coolant from the plurality of two-phase evaporators;
      a condenser having a condenser inlet for flow connection to the plurality of vaporized coolant outlet lines and being configured to convert the vaporized coolant into the liquid coolant, the condenser further including a condenser outlet for flow connection to the plurality of liquid
      coolant inlet lines, the condenser being configured for thermally coupling the secondary two-phase loop to the primary water loop to transfer heat conveyed from the plurality of heat-generating electronic components by the vaporized coolant to water in the output water line; and
      at least one processor configured to:
         receive a signal indicative of at least one of a pressure in the plurality of vapor coolant outlet lines or a temperature in the output water line; and
         regulate the control valve associated with the output water line as a function of the signal to thereby control a temperature of the water in the output water line.
Clause 134. The system of any of clauses 1 to 133, wherein the at least one processor is configured to regulate the control valve to achieve a target water temperature of at least 60 degrees C.
Clause 135. The system of any of clauses 1 to 134, wherein the at least one processor is configured to regulate the control valve to achieve a target water temperature of 65 degrees C.
Clause 136. The system of any of clauses 1 to 135, wherein regulating flow in the secondary two-phase loop includes controlling the plurality of flow control valves to regulate flow of vaporized coolant from each of the plurality of two-phase evaporators to the condenser to thereby achieve the substantially constant water temperature in the primary water loop.
Clause 137. The system of any of clauses 1 to 136, wherein the primary water loop is configured to convey at least some of the heat transferred to the water in the output water line to a heat exchanger in a first flow direction and return cooled water from the heat exchanger to the condenser in a second flow direction.
Clause 138. The system of any of clauses 1 to 137, wherein the condenser further includes a water line inlet and a water line outlet for connection to the output water line and for enabling cooled water from the heat exchanger to pass through the condenser and to receive at least some heat generated by the plurality of clcctronic components.
Clause 139. The system of any of clauses 1 to 138, wherein the heat exchanger is a source of heat for the facility.
Clause 140. An electronic component cooling system configured for mounting in a server rack having a plurality of slots with openings of predefined dimensions of this clause and any of the preceding clauses, the cooling system comprising:
   a condenser sized for mounting at a particular level in the server rack;
   a liquid coolant buffer sized for mounting at the particular level in the server rack, such that the buffer is mounted at least at the same elevation as the condenser;
   a plurality of two-phase evaporators each for association with a plurality of differing electronic components distributed throughout the server rack at levels other than the particular level;
   a vaporized coolant conduit for fluid coupling outlets of the plurality of two-phase evaporators with a vapor inlet of the condenser;
   a liquid coolant conduit for fluid coupling an outlet of the liquid coolant buffer with inlets of the plurality of two-phase evaporators;
   a plurality of pumps sized for mounting at the particular level in the server rack, such that the plurality of pumps are mounted at the same level as the condenser and the buffer, and wherein the plurality of pumps are configured for conveying liquid coolant to the plurality of two-phase evaporators for transferring heat to the condenser; and
   a one-way valve fluidly coupling a liquid coolant outlet of the condenser to a liquid coolant inlet of the buffer, the one-way valve configured to prevent liquid coolant backflow from the buffer to the condenser.
Clause 141. The electronic component cooling system of any of clauses 1 to 140, wherein the plurality of pumps are swappable while the condenser is operating.
Clause 142. The electronic component cooling system of any of clauses 1 to 141, wherein at least one of the condenser, the buffer, and the plurality of pumps includes a pedestal base, and wherein the bottom of the pedestal base is mounted at the particular level.
Clause 143. The electronic component cooling system of any of clauses 1 to 142, wherein at least one of the plurality of pumps is a positive displacement pump.
Clause 144. The electronic component cooling system of any of clauses 1 to 143, wherein the particular level encompasses two server slots in the server rack.
Clause 145. The electronic component cooling system of any of clauses 1 to 144, wherein the two server slots are lowermost slots in the server rack.
Clause 146. The electronic component cooling system of any of clauses 1 to 145, wherein the particular level encompasses a single server slot in the server rack.
Clause 147. The clectronic component cooling system of any of clauses 1 to 146, wherein the single server slot is a lowermost slot in the server rack.
Clause 148. The electronic component cooling system of any of clauses 1 to 147, wherein a level of the vapor inlet of the condenser is lower than a level of the liquid outlet of the condenser.
Clause 149. The electronic component cooling system of any of clauses 1 to 148, wherein a level of a center of the vapor inlet of the condenser is below a level of a center of the liquid outlet of the condenser.
Clause 150. The electronic component cooling system of any of clauses 1 to 149, wherein a cross-sectional area of the vapor inlet is greater than a cross-sectional area of the liquid coolant outlet.
Clause 151. The electronic component cooling system of any of clauses 1 to 150, further comprising a water line thermally coupled to the condenser to enable water flowing in the water line to receive heat conveyed by vaporized coolant flowing from the plurality of two-phase evaporators.
Clause 152. The electronic component cooling system of any of clauses 1 to 151, wherein the water line is associated with a facility where water is used as part of a process for electronics cooling.
Clause 153. The electronic component cooling system of any of clauses 1 to 152, wherein the water line is included in a water loop configured to convey heated water to the facility and return cooled water to the condenser.
Clause 154. The electronic component cooling system of any of clauses 1 to 153, further comprising at least one processor configured to operate the plurality of pumps.
Clause 155. The electronic component cooling system of any of clauses 1 to 154, further comprising a vapor coolant manifold distributed over a plurality of levels in the server rack, wherein the vaporized coolant conduit is integrated with the vapor coolant manifold.
Clause 156. The clectronic component cooling system of any of clauses 1 to 155, further comprising a liquid coolant manifold distributed over a plurality of levels in the server rack, wherein the liquid coolant conduit is integrated with the liquid coolant manifold.
Clause 157. The clectronic component cooling system of any of clauses 1 to 156, further comprising a plurality of controllable valves, each controllable valve associated with a different outlet of a different one of the plurality of two-phase evaporators.
Clause 158. The electronic component cooling system of any of clauses 1 to 157, further comprising at least one processor configured to control the plurality of controllable valves, thereby controlling vapor pressure in the vaporized coolant conduit.
Clause 159. The electronic component cooling system of any of clauses 1 to 158, further comprising a float valve associated with each of the plurality of two-phase evaporators and configured to control an inflow of liquid coolant to each of the plurality of two-phase evaporator from the condenser.
Clause 160. A system for cooling servers mounted in a server rack having opposing sides, a door opening, and a plurality of distributed slots for holding the servers of this clause and any of the preceding clauses, the system comprising:
   a door configured to be mounted at the door opening and to pivot on a hinged side between an open position and a closed position;
   at least one condenser mounted on the door and having a condenser vapor inlet port, the at least one condenser being pivotable with the door when the door is moved between the open position and the closed position;
   at least one rack vapor manifold configured for mounting along a side of the rack, and having a plurality of rack vapor inlet ports distributed along a length of the rack for association with the plurality of distributed slots, the rack vapor inlet ports being arranged to receive coolant vaporized by heat of electronic components associated with the servers, the at least one rack vapor manifold further including a plurality of rack vapor outlet ports;
   at least one door vapor manifold mounted on the hinged side of the door and having a plurality of door vapor inlet ports, and at least one door vapor outlet port for connection to the at least one condenser vapor inlet port; and
   a plurality of flexible tubes for interconnecting the rack vapor outlet ports to the door vapor inlet ports along the hinged side, to enable maintained flow-connections between the at least one rack vapor manifold and the at least one door vapor manifold while the door is pivoted between the open and closed positions.
Clause 161. The system of any of clauses 1 to 160, wherein the at least one condenser includes a plurality of condensers mounted on the door.
Clause 162. The system of any of clauses 1 to 161, wherein the at least one rack vapor manifold is a single rack vapor manifold.
Clause 163. The system of any of clauses 1 to 162, wherein the at least one door vapor manifold is a single door vapor manifold.
Clause 164. The system of any of clauses 1 to 163, further comprising at least one rack liquid coolant manifold having at least one manifold coolant inlet port and a plurality of manifold coolant outlet ports distributed along a length of the at least one rack coolant liquid manifold for association with the plurality of distributed slots, the manifold coolant outlet ports being arranged to supply liquid coolant to the electronic components associated with the servers.
Clause 165. The system of any of clauses 1 to 164, wherein the rack vapor manifold and the rack liquid coolant manifold are integrally formed.
Clause 166. The system of any of clauses 1 to 165, further comprising at least one additional flexible tube for forming at least a portion of a flow-connection between the condenser with the rack liquid coolant manifold.
Clause 167. The system of any of clauses 1 to 166, further comprising a liquid coolant buffer for location in a flow path between the condenser and the rack liquid coolant manifold.
Clause 168. The system of any of clauses 1 to 167, wherein the buffer is configured for mounting on the door.
Clause 169. The system of any of clauses 1 to 168, wherein the buffer is configured for mounting in the rack.
Clause 170. The system of any of clauses 1 to 160, wherein the buffer is configured for mounting in a bottom slot of the rack.
Clause 171. The system of any of clauses 1 to 170, further comprising at least one pump for location in the flow path, wherein the at least one pump is configured for mounting on the door.
Clause 172. The system of any of clauses 1 to 171, further comprising at least one pump for location in the flow path, wherein the at least one pump is configured for mounting in the rack.
Clause 173. The system of any of clauses 1 to 172, further comprising a plurality of fans mounted in the door for propelling air through the at least one condenser.
Clause 174. The system of any of clauses 1 to 173, further comprising a plurality of fans configured for mounting in the rack for propelling air through the at least one condenser.
Clause 175. The system of any of clauses 1 to 174, wherein the at least one condenser covers a majority of a length of the door.
Clause 176. The system of any of clauses 1 to 175, wherein the server rack is preexisting and the door and the at least one rack vapor manifold are configured for retrofitting to the preexisting server rack.
Clause 177. The system of any of clauses 1 to 176, wherein the at least one condenser includes a plurality of microchannels on a surface thereof for facilitating cooling.
Clause 178. The system of any of clauses 1 to 177, wherein the at least one condenser is associated with at least one sensor configured to detect at least one of a temperature indication or a pressure indication associated with the coolant.
Clause 179. The system of any of clauses 1 to 178, further comprising at least one processor configured to use the at least one temperature indication or the pressure indication to control a flow of coolant in at least one rack liquid manifold, or the at least one door liquid manifold.
Clause 180. A two-phase pulse evaporator system for cooling electronic components when bubble formation inhibits cooling of this clause and any of the preceding clauses, the system comprising:
   a two-phase evaporator enclosure having an evaporator base plate configured to serve as a heat exchanger, with an outer surface of the base plate for contacting a heat-generating electronic component and an inner surface of the base plate exposed to a coolant chamber within the enclosure;
   a liquid coolant port in a wall of the enclosure for delivering liquid coolant to the coolant chamber and to the inner surface of the base plate;
   a vapor outlet port in the wall of the enclosure for evacuating vaporized coolant from the enclosure;
   at least one controllable valve flow connected to at least one of the liquid coolant port and the vapor outlet port; and
   at least one controller configured to pulse the controllable valve in succession thereby causing successive pressure fluctuations in the at least one two-phase evaporator enclosure to limit heat-transfer-impeding bubble formation on the inner surface of the evaporator base plate.
Clause 181. The two-phase pulse evaporator of any of clauses 1 to 180, wherein the at least one controllable valve is a solenoid valve.
Clause 182. The two-phase pulse evaporator of any of clauses 1 to 181, wherein the at least one controller is configured to pulse the at least one controllable valve in a manner configured to promote a release of bubbles trapped on the inner surface of the base plate.
Clause 183. The two-phase pulse evaporator of any of clauses 1 to 182, wherein the pulsing by the at least one controller is configured to induce a substantially equivalent volume of liquid coolant to contact the inner surface of the base plate as the equivalent volume of gas from trapped bubbles are released from the base plate.
Clause 184. The two-phase pulse evaporator of any of clauses 1 to 183, wherein the pulsing is configured to promote a formation of multiple small bubbles in place of one or more large bubbles.
Clause 185. The two-phase pulse evaporator of any of clauses 1 to 184, wherein a size of the small bubbles is smaller than a gap between adjacent fins of a plurality of fins extending from the inner surface of the base plate, and wherein a size of the one or more large bubbles is greater than the gap.
Clause 186. The two-phase pulse evaporator of any of clauses 1 to 185, wherein the pulsing includes opening and closing the at least one controllable valve multiple times a second.
Clause 187. The two-phase pulse evaporator of any of clauses 1 to 186, wherein the at least one controllable valve regulates liquid coolant flow into the enclosure.
Clause 188. The two-phase pulse evaporator of any of clauses 1 to 187, wherein the at least one controllable valve regulates vapor flow out of the enclosure.
Clause 189. The two-phase pulse evaporator of any of clauses 1 to 188, wherein the at least one controller is configured to open and close the controllable valve in response to a vapor pressure reading associated with the two-phase evaporator enclosure.
Clause 190. The two-phase pulse evaporator of any of clauses 1 to 189, wherein the at least one controller is configured to open and close the controllable valve in response to a vapor pressure reading associated with the vapor return line.
Clause 191. The two-phase pulse evaporator of any of clauses 1 to 190, wherein the at least one controller is configured to open and close the controllable valve in response to a vapor temperature reading.
Clause 192. The two-phase pulse evaporator of any of clauses 1 to 191, wherein the at least one controller is configured to open and close the controllable valve in response to a vapor flow rate.
Clause 193. The two-phase pulse evaporator of any of clauses 1 to 192, wherein a frequency of pulsing is predetermined.
Clause 194. The two-phase pulse evaporator of any of clauses 1 to 193, wherein the liquid coolant port is configured to receive the liquid coolant from a condenser flow-connected to a plurality of additional two-phase pulse evaporators, wherein the vapor outlet port is configured to evacuate the vaporized coolant to the condenser, and wherein the condenser is configured to convert the vaporized coolant to liquid coolant.
Clause 195. The two-phase pulse evaporator of any of clauses 1 to 194, wherein the at least one controller is further configured to control a pump associated with a condenser for simultaneous delivery of liquid coolant to the two-phase pulse evaporator and to a plurality of additional two-phase pulse evaporators.
Clause 196. A system for cooling electronic components when bubble formation inhibits cooling of this clause and any of the preceding clauses, the system comprising:
   at least one processor configured to:
   determine at least one signal configured to cause successive pressure fluctuations in at least one two-phase evaporator enclosure, wherein the at least one two-phase pulse evaporator enclosure includes:
   an evaporator base plate configured to serve as a heat exchanger, with an outer surface of the base plate configured for contacting a heat-generating electronic component and an inner surface of the base plate exposed to a coolant chamber within the enclosure,
   a liquid coolant port in a wall of the enclosure for delivering liquid coolant to the coolant chamber and to the inner surface of the base plate,
   a vapor outlet port in the wall of the enclosure for evacuating vaporized coolant from the enclosure, and
   at least one controllable valve flow connected to at least one of the liquid coolant port and the vapor outlet port; and
   transmit the at least one signal to the at least one controllable valve thereby limiting heat-transfer-impeding bubble formation on the inner surface of the evaporator base plate.
Clause 197. The system of any of clauses 1 to 196, wherein the at least one two-phase pulse evaporator enclosure includes a plurality of two-phase pulse evaporator enclosures, and wherein each liquid coolant port and each vapor outlet port of each of the plurality of two-phase pulse evaporator enclosures is flow connected to a common condenser configured to receive vaporized coolant from each of the plurality of two-phase pulse evaporator enclosures via a condenser inlet, convert the vaporized coolant to liquid coolant, and deliver the liquid coolant to each of the plurality of two-phase pulse evaporators via each liquid coolant port, and wherein the at least one processor is configured to transmit the at least one signal to the at least one controllable valve, thereby limiting heat-transfer-impeding bubble formation on the inner surface of each evaporator base plate of each of the plurality of two-phase pulse evaporator enclosures.
Clause 198. The system of any of clauses 1 to 197, wherein the at least one processor is further configured to control a pump associated with the condenser for simultaneous delivery of liquid coolant to the plurality of two-phase pulse evaporator enclosures.
Clause 199. A method for cooling electronic components when bubble formation inhibits cooling of this clause and any of the preceding clauses, the method comprising:
   determining at least one signal configured to cause successive pressure fluctuations in at least one two-phase evaporator enclosure, wherein the at least one two-phase pulse evaporator enclosure includes:
   an evaporator base plate configured to serve as a heat exchanger, with an outer surface of the base plate configured for contacting a heat-generating electronic component and an inner surface of the base plate exposed to a coolant chamber within the enclosure,
   a liquid coolant port in a wall of the enclosure for delivering liquid coolant to the coolant chamber and to the inner surface of the base plate,
   a vapor outlet port in the wall of the enclosure for evacuating vaporized coolant from the enclosure, and
   at least one controllable valve flow connected to at least one of the liquid coolant port and the vapor outlet port; and
   transmitting the at least one signal to the at least one controllable valve thereby limiting heat-transfer-impeding bubble formation on the inner surface of the evaporator base plate.

Disclosed embodiments may include any one of the following bullet-pointed features alone or in combination with one or more other bullet-pointed features, whether implemented as a system and/or method, by one or more hardware components disclosed herein, as well as by at least one processor or circuitry, and/or stored as executable instructions on non-transitory computer readable media or computer readable media.
- A cooling device for a solid-state electronics component with a component surface that heats during operation.
- a chamber having a first region defining a pool with a heat conducting wall, the heat conducting wall having an inner surface constituting a wall of the pool and an outer surface, opposite the inner surface for thermal contact with the component surface and for conducting heat therefrom into the pool.
- a liquid coolant inlet integrated with the chamber, the liquid coolant inlet for supplying liquid coolant to the pool to thereby enable pool boiling of the liquid coolant and conversion of the liquid coolant into vaporized coolant.
- a vapor outlet integrated with the chamber for evacuating vaporized coolant from the chamber.
- a valve configured to restrict flow of the liquid coolant when the liquid coolant in the chamber surpasses a threshold.
- a liquid coolant inlet including an inlet orifice.
- a valve including a float with a portion for blocking an inlet orifice.
- a float having at least one opening therein for enabling the liquid coolant to pass therethrough.
- a blocking portion including a pin.
- an inlet orifice configured to receive a pin.
- a blocking portion located in a central area of a float.
- at least one spring for biasing a float toward an inlet orifice.
- at least one spring configured to counterbalance a weight of a float.
- at least one spring including a plurality of springs.
- an aggregate of expansion forces of a plurality of springs substantially equal to a weight of a float.
- expansion forces of a plurality of springs that are substantially equal.
- a float having a periphery area.
- a plurality of springs distributed in a periphery area.
- a float includes a central area in which a blocking portion is located, and wherein the blocking portion is substantially equidistant from each spring.
- a float having a generally rectangular periphery area and wherein each of the plurality of springs is located in a differing corner of the generally rectangular periphery area.
- a float configured to block an inlet orifice in a manner promoting pool boiling.
- a heat conducting wall that is a cooling plate having screw holes therein adapted for screw connection to a semiconductor board.
- a chamber including a plurality of fins on an outer surface thereof.
- a chamber including a plurality of fins therein.
- wicks disposed between a plurality of fins.
- the liquid coolant is a non-electrically conductive material.
- a liquid coolant inlet and a vapor outlet configured for flow-connection to a condenser configured to receive vaporized coolant evacuated from a plurality of cooling devices, convert the vaporized coolant to liquid coolant, and supply the liquid coolant to a plurality of cooling devices.
- a cooling device.
- a chamber for containing a liquid coolant.
- a chamber having a heat transfer surface.
- an inlet for a liquid coolant.
- an outlet for vaporized liquid coolant.
- a plurality of fins within a chamber and extending from a heat transfer surface.
- fins being arranged in a chamber for submersion in liquid coolant.
- a plurality of porous units disposed between a plurality of fins such that the fins and the porous units alternate, and wherein the porous units are configured to wick coolant along the fins.
- porous units including a non-heat conductive fibrous material.
- a fibrous material is cellulose.
- at least some of a plurality of porous units have a rough surface.
- each rough surface is configured to prevent entrapment of boiling coolant bubbles in an associated gap between adjacent fins.
- each rough surface is configured to facilitate formation of boiling coolant bubbles smaller than would be formed in an absence of each rough surface.
- each rough surface is configured to facilitate formation of boiling coolant bubbles smaller than an associated gap between adjacent fins.
- a plurality of porous units configured to enable boiling coolant bubbles formed thereon to escape toward an outlet for vaporized liquid coolant.
- each of a plurality of porous units is in a form of a strip interleaved between adjacent fins.
- a width of each of a plurality of porous units is less than or equal to a size of an associated gap between adjacent fins.
- at least some of a plurality porous units extend past adjacent fins in at least one of length or height.
- graphite layers sandwiching at least some of the porous units.
- graphite layers contain a plurality of notches.
- notches expose each of the plurality of porous units to an adjacent fin.
- fins are made of heat-conductive metal.
- heat conductive metal is chosen from a group consisting of copper, iron, steel, and aluminum.
- fins are made of a non-metal.
- non-metal is graphite.
- at least one rib in a chamber for maintaining porous units between fins.
- a chamber configured for location on a computer chip to thereby cool the computer chip.
- a two-phase cooling device configured for parallel liquid coolant interconnection and serial vapor return interconnection.
- a chamber having a liquid coolant region and vaporized coolant region.
- a liquid coolant port in the chamber for flow connection to a liquid coolant source.
- a first vapor port in the chamber for evacuating first vaporized coolant from the chamber.
- a second vapor port in the chamber for receiving second vaporized coolant from at least one other chamber of at least one other two-phased cooling device.
- a vapor passthrough path flow-connecting a first vapor port to a second vapor port, to thereby enable second vaporized coolant to mix with first vaporized coolant.
- a first vapor port and a second vapor port are flow connected to a vaporized coolant region of a chamber thereby enabling second vaporized coolant entering the vaporized coolant region to form a mixture with the first vaporized coolant, and enabling the mixture to exit the vaporized coolant region via the first vapor port.
- a vapor passthrough path is at least partially located in the vaporized coolant region.
- a liquid coolant conduit for conveying liquid coolant from the liquid coolant port to a liquid coolant inlet in the liquid coolant chamber.
- a liquid coolant conduit at least partially passes through a vaporized coolant region of a chamber.
- a liquid coolant conduit is transverse to a vapor passthrough path.
- at least one vaporized coolant conduit connected to at least one of a first vapor port and a second vapor port, wherein the at least one vaporized coolant conduit at least partially passes through a liquid coolant region.
- a barrier in a chamber dividing a vaporized coolant region from a liquid coolant region.
- a barrier exposes at least one vent permitting first vaporized coolant to escape from a liquid coolant region to a vaporized coolant region and mix with second vaporized coolant in the vaporized coolant region.
- a first vapor port and a second vapor port are integrally formed with a barrier.
- a first vapor port and a second vapor part are at least partially located in a liquid coolant region.
- a float valve in a liquid coolant region.
- a float valve is configured to conditionally restrict inlet flow of liquid coolant into a liquid coolant region.
- a liquid coolant conduit within a chamber.
- a liquid coolant conduit having a valve seat therein.
- a float valve includes a pin configured to engage a valve seat in order to restrict an inlet flow of liquid coolant through a liquid coolant inlet and into a liquid coolant region.
- a vapor passthrough path is configured for flow connection to a vapor conduit for receiving third vaporized coolant from at least one additional vapor passthrough path of at least one additional two-phased cooling device, to thereby enable the third vaporized coolant to mix with the first vaporized coolant and the second vaporized coolant.
- a first vapor port associated with a first controllable valve.
- a second vapor port associated with a second controllable valve.
- a first controllable valve and a second controllable valve regulated by at least one processor to modulate temperature within a chamber.
- a first controllable valve and a second first controllable valve are solenoid valves.
- cross-sectional areas of a first vapor port and a second vapor port are larger than a cross-sectional area of a liquid coolant port.
- a liquid coolant port configured for flow connection to a liquid coolant source via a liquid coolant manifold configured for flow connecting a plurality of additional two-phase cooling devices to the liquid coolant source.
- a liquid coolant source is a condenser.
- a first vapor port and a second vapor port configured for flow connection to a vapor manifold configured to convey first vaporized coolant, second vaporized coolant, and additional vaporized coolant from a plurality of additional two-phase cooling devices to a condenser.
- a cooling device configured to induce internal counterflow.
- a chamber for containing a liquid coolant.
- a liquid coolant inlet in the chamber.
- a vapor outlet in a vapor collection region of a chamber for evacuating vaporized liquid coolant from the chamber.
- a heat conducting element in a boiling region of a chamber.
- a coolant pool region interposed between a vapor collection region and a boiling region.
- at least one conduit extending from a boiling region toward a vapor collection region.
- at least one conduit being configured to direct vapor in a first direction toward a vapor collection region thereby facilitating liquid coolant movement toward a boiling region in a second direction counter to the first direction.
- a cooling device configured for mounting on electronics for cooling the electronics.
- a heat conducting element including a plurality of fins configured to cause a bubble field of vaporized coolant to be trapped therebetween.
- at least one conduit is configured to facilitate an evacuation of a trapped bubble field.
- a heat conducting element includes a plurality of wicks interposed between adjacent fins.
- fins are thermally coupled to a heat conducting element.
- at least one conduit extends from a position adjacent the fins to a position in or adjacent a vapor collection region.
- a position adjacent to the fins is in a coolant pool region.
- at least one conduit includes an inlet seated on at least one of a plurality of fins or a plurality of wicks interposed between a plurality of fins.
- a liquid coolant inlet is associated with a valve for conditionally restricting inflow of liquid coolant into a chamber.
- at least one conduit includes at least two conduits with a gap therebetween.
- a gap is configured to facilitate liquid coolant flow toward a boiling region in a second direction.
- a gap is configured to facilitate liquid coolant flow toward a boiling region in a cyclical manner for facilitating heat conduction.
- the gap is in flow communication with the liquid coolant inlet.
- at least two conduits include two conduits joined in a unified structure.
- two conduits converge in a boiling region and diverge as the two conduits approach a vapor collection region.
- at least two conduits include inlets adjacent the boiling region.
- inlets being configured to divide vapor flow into a plurality of spaced apart vapor pathways with a liquid coolant pathway in the gap therebetween.
- a gap includes a first opening at a location adjacent a boiling region, the first opening being narrower than openings of inlets of at least two conduits adjacent the boiling region.
- a gap includes a second opening at a location remote from fins.
- a second opening being wider than openings of at least two conduits adjacent fins.
- at least two conduits each include an elongated outlet with the gap between outlets of the at least two conduits at a location remote from the fins.
- a length of each of the elongated outlets is greater than a widest width of the gap.
- at least two conduits define two channels.
- each channel having an inlet opening adjacent the fins and an outlet opening remote from the fins.
- a liquid coolant pathway includes the coolant pool region.
- a vapor outlet is configured to evacuate vaporized coolant from the chamber to a condenser.
- a liquid coolant inlet is configured for flow connection to the condenser to thereby enable deliver of the liquid coolant to the coolant pool region via the liquid coolant inlet.
- a two-phase cooling device for enabling vapor outflow from a submerged liquid level location.
- a chamber having a lower region for containing liquid coolant and an upper region for containing vaporized coolant.
- a liquid coolant port in a chamber.
- a heat conducting element in a lower region of a chamber.
- at least one vapor coolant port located at a level at least partially in a lower region, and at least partially beneath an upper region.
- at least one snorkel pathway fluidly connecting an upper region for containing vaporized coolant with at least one vapor coolant port, to thereby enable vaporized liquid coolant to exit the chamber from the submerged level at least partially beneath a level of liquid coolant in the lower region.
- a heat conducting element is configured for mounting on a heat-generating electrical component for cooling the heat-generating electrical component.
- at least one vapor port includes two vapor ports.
- at least one snorkel pathway includes two snorkel pathways.
- each of two snorkel pathways are in flow communication with an upper region thereby enabling vapor from one of two vapor coolant ports to exit through the other of the two vapor coolant ports.
- the two snorkel pathways are symmetric.
- a barrier between a lower region and an upper region.
- a barrier exposes at least one vent permitting vapor of boiling coolant in a lower region to escape to an upper region.
- an upper region enables boiling coolant originating in a lower region to mix with coolant vapor entering through at least one vapor port.
- at least one vent includes a plurality of vents distributed around a perimeter of the barrier.
- a barrier is configured to obstruct entry of liquid coolant into an upper region.
- a barrier is plate shaped.
- a barrier has a liquid coolant inlet extending therethrough.
- a float valve in a lower region.
- a float valve being configured to conditionally obstruct a coolant inlet.
- a barrier includes a liquid coolant conduit for conveying liquid coolant through an upper region to a liquid coolant inlet.
- a cross-section of a liquid coolant conduit is smaller than a cross-section of at least one snorkel pathway.
- a cross-section of an opening of at least one vapor coolant port is larger than a cross-section of an opening of a liquid coolant port.
- a liquid coolant conduit is transverse to a direction of vapor coolant flow.
- a lower region for containing liquid coolant has a volume substantially larger than a volume of an upper region.
- at least one snorkel pathway is S-shaped.
- a snorkel pathway has a consistent gradient.
- a chamber is configured for pool boiling.
- a system for controlling electronics operating frequencies for regulating heat generation.
- at least one processor.
- monitor utilization of a plurality of heat-generating electronic components each having an associated operating frequency.
- heat generated by each electronic component is a function of an associated operating frequency.
- determine that an associated operating frequency of at least one of a plurality of heat-generating electronic components cooperating to accomplish a shared workload, is greater than necessary to accomplish the shared workload within a predefined timeframe, and therefore generating unnecessary heat.
- determine at least one operating frequency cap for at least one of the plurality of heat-generating electronic components.
- at least one operating frequency cap is determined to enable a plurality of heat-generating electronic components to accomplish a workload while controlling aggregate heat output of a plurality of heat-generating electronic components.
- output at least one cap signal to at least one of the plurality of heat-generating electronic components.
- at least one cap signal is configured to limit an associated operating frequency of at least one of a plurality of electronic components to an operating frequency cap.
- determining that an associated operating frequency of at least one of a plurality of heat-generating electronic components is greater than necessary includes identifying idle usage periods associated with the heat-generating electronic components.
- determining at least one operating frequency cap includes shifting workload from peak usage periods to idle usage periods.
- at least one operating frequency cap is based on an amount of time taken to shift from peak usage periods to idle usage periods.
- at least one operating frequency cap is a single common operating frequency cap applied to each of a plurality of heat-generating electronic components.
- at least one operating frequency cap includes a plurality of differing operating frequency caps for application to differing ones of a plurality of heat-generating electronic components.
- values of differing operating frequency caps depend on heat-generating electronic component type.
- at least one processor configured to change a plurality of operating frequency caps dynamically over time.
- a plurality of cooling devices associated with each of a plurality of heat-generating electronic components.
- at least one processor configured to simultaneously control a plurality of cooling devices.
- a plurality of cooling devices are configured for two-phase cooling using a coolant.
- a coolant is a dielectric coolant.
- at least one processor is configured to control a pump delivering coolant to a plurality of cooling devices.
- each of a plurality of cooling devices includes a valve for controlling an output vapor flow.
- at least one processor is configured to control each valve, thereby controlling vaporized coolant exiting each of a plurality of cooling devices.
- at least one processor is configured to control an inflow of water for cooling vaporized coolant, thereby controlling a heat transfer rate between the vaporized coolant and the water.
- at least one operating frequency cap is determined based on heat-generating electronic component idle time and utilization.
- at least one operating frequency cap is based on an amount of idle time for a particular one of a plurality of heat-generating electronic components.
- when utilization exceeds a threshold, at least one processor is configured to increase at least one operating frequency cap.
- a load balancer configured to allocate a workload amongst a plurality of heat-generating electronic components.
- for operating frequencies above which each electronic component experiences a heat-related degradation, at least one processor is configured to impose an operational limit on an associated operating frequency.
- at least one operating frequency cap is associated with an operating limit.
- at least one operating frequency cap is less than an operational limit.
- a system for achieving a target water temperature in a facility where water is used as part of a process for electronics cooling.
- a primary water loop including an output water line and an associated control valve.
- a secondary two-phase loop:
- a plurality of two-phase evaporators.
- each two-phase evaporator configured for thermal contact with an associated one of a plurality of heat-generating electronic components.
- a plurality of liquid coolant inlet lines for delivering liquid coolant to a plurality of two-phase evaporators.
- a plurality of vapor coolant outlet lines for evacuating vaporized coolant from a plurality of two-phase evaporators.
- a condenser having a condenser inlet for flow connection to a plurality of vapor coolant outlet lines and being configured to convert the vaporized coolant into the liquid coolant.
- a condenser including a condenser outlet for flow connection to a plurality of liquid coolant inlet lines.
- a condenser being configured for thermally coupling a secondary two-phase loop to a primary water loop to transfer heat conveyed from a plurality of heat-generating electronic components by vaporized coolant to water flowing in a output water line.
- receive at least one signal indicative of at least one of a pressure in a plurality of vapor coolant outlet lines or a temperature in an output water line.
- regulate vapor pressure in a plurality of vapor coolant outlet lines as a function of a signal to thereby control a temperature of water in an output water line.
- a pump for conveying liquid coolant from a condenser to a plurality of two-phase evaporators via a plurality of liquid coolant inlet lines.
- at least one processor is configured to control an RPM of a pump to regulate a flow of liquid coolant from a condenser to a plurality of two-phase evaporators via a plurality of liquid coolant lines.
- at least one processor is configured to regulate inlet water flow into a condenser in order to regulate pressure in a plurality of vaporized coolant outlet lines.
- a plurality of flow control valves, each flow control valve being associated with a differing outlet line.
- at least one processor configured to control each flow control valve to regulate a flow of vaporized coolant from each of a plurality of two-phase evaporators to a condenser via a plurality of outline lines, thereby controlling water temperature in an output water line.
- at least one processor configured to control operating frequencies for a plurality of heat-generating electronic components, thereby controlling water temperature in an output water line.
- at least one processor configured to regulate inlet water flow into a condenser by controlling an associated control valve.
- a condenser includes a water line inlet and a water line outlet for connection to a water line and for enabling water to pass through a condenser and to receive heat generated by a plurality of electronic components.
- a vapor manifold for collecting vapor from a plurality of outlet lines and for delivering the collected vapor to a condenser.
- a liquid coolant manifold for delivering condensed liquid coolant to a plurality of liquid coolant inlet lines.
- at least one processor configured to control boiling temperatures of liquid coolant within each of a plurality of two-phase evaporators.
- an output water line is configured to convey at least some heat transferred from a plurality of heat-generating electronic components to a heat exchanger.
- each two-phase evaporator includes a float valve configured to regulate an inflow of liquid coolant to each two-phase evaporator and to prevent liquid coolant from entering an associated vapor coolant outlet line.
- a system for achieving a target water temperature in a facility where water is used as part of a process for electronics cooling.
- a primary water loop including an output water line and an associated control valve.
- a secondary two-phase loop.
- a plurality of two-phase evaporators.
- each two-phase evaporator configured for thermal contact with an associated one of a plurality of heat generating electronic components.
- a plurality of liquid coolant inlet lines for delivering liquid coolant to a plurality of two-phase evaporators.
- a plurality of vapor coolant outlet lines for evacuating vaporized coolant from a plurality of two-phase evaporators.
- a condenser having a condenser inlet for flow connection to a plurality of vaporized coolant outlet lines and being configured to convert vaporized coolant into liquid coolant.
- a condenser including a condenser outlet for flow connection to a plurality of liquid coolant inlet lines.
- a condenser being configured for thermally coupling a secondary two-phase loop to a primary water loop to transfer heat conveyed from a plurality of heat-generating electronic components by vaporized coolant to water in an output water line.
- receive a signal indicative of at least one of a pressure in a plurality of vapor coolant outlet lines or a temperature in an output water line.
- regulate a control valve associated with an output water line as a function of a signal to thereby control a temperature of water in an output water line.
- at least one processor configured to regulate a control valve to achieve a target water temperature of at least 60 degrees C.
- at least one processor configured to regulate a control valve to achieve a target water temperature of 65 degrees C.
- regulating flow in a secondary two-phase loop includes controlling a plurality of flow control valves to regulate flow of vaporized coolant from each of a plurality of two-phase evaporators to a condenser to thereby achieve a substantially constant water temperature in a primary water loop.
- a primary water loop configured to convey at least some heat transferred to water in an output water line to a heat exchanger in a first flow direction and return cooled water from the heat exchanger to the condenser in a second flow direction.
- a condenser includes a water line inlet and a water line outlet for connection to an output water line and for enabling cooled water from a heat exchanger to pass through the condenser and to receive at least some heat generated at the plurality of electronic components.
- a heat exchanger is a source of heat for the facility.
- an electronic component cooling system configured for mounting in a server rack having a plurality of slots with openings of predefined dimensions.
- a condenser sized for mounting at a particular level in a server rack.
- a liquid coolant buffer sized for mounting at a particular level in a server rack, such that the buffer is mounted at least at the same elevation as a condenser.
- a plurality of two-phase evaporators each for association with a plurality of differing electronic components distributed throughout a server rack at levels other than a particular level.
- a vaporized coolant conduit for fluid coupling outlets of a plurality of two-phase evaporators with a vapor inlet of a condenser.
- a liquid coolant conduit for fluid coupling an outlet of a liquid coolant buffer with inlets of a plurality of two-phase evaporators.
- a plurality of pumps sized for mounting at a particular level in a server rack, such that the plurality of pumps are mounted at the same level as a condenser and a buffer.
- a plurality of pumps are configured for conveying liquid coolant to a plurality of two-phase evaporators for transferring heat to a condenser.
- a one-way valve fluidly coupling a liquid coolant outlet of a condenser to a liquid coolant inlet of a buffer.
- a one-way valve configured to prevent liquid coolant backflow from a buffer to a condenser.
- a plurality of pumps are swappable while a condenser is operating.
- at least one of a condenser, a buffer, and a plurality of pumps includes a pedestal base.
- a bottom of a pedestal base is mounted at a particular level.
- at least one of the plurality of pumps is a positive displacement pump.
- a particular level encompasses two server slots in a server rack.
- two server slots are lowermost slots in a server rack.
- a particular level encompasses a single server slot in a server rack.
- a single server slot is a lowermost slot in a server rack.
- a level of a vapor inlet of a condenser is lower than a level of a liquid outlet of the condenser.
- a level of a center of the vapor inlet of a condenser is below a level of a center of a liquid outlet of the condenser.
- a cross-sectional area of a vapor inlet is greater than a cross-sectional area of a liquid coolant outlet.
- a water line thermally coupled to a condenser to enable water flowing in a water line to receive heat conveyed by vaporized coolant flowing from a plurality of two-phase evaporators.
- a water line is associated with a facility where water is used as part of a process for electronics cooling.
- a water line is included in a water loop configured to convey heated water to a facility and return cooled water to a condenser.
- at least one processor configured to operate a plurality of pumps.
- a vapor coolant manifold distributed over a plurality of levels in a server rack.
- a vaporized coolant conduit is integrated with a vapor coolant manifold.
- a liquid coolant manifold distributed over a plurality of levels in a server rack.
- a liquid coolant conduit is integrated with a liquid coolant manifold.
- a plurality of controllable valves.
- each controllable valve associated with a different outlet of a different one of a plurality of two-phase evaporators.
- at least one processor configured to control the plurality of controllable valves, thereby controlling vapor pressure in a vaporized coolant conduit.
- a float valve associated with each of a plurality of two-phase evaporators and configured to control an inflow of liquid coolant to each of the plurality of two-phase evaporator from a condenser.
- a system for cooling servers mounted in a server rack having opposing sides, a door opening, and a plurality of distributed slots for holding the servers.
- a door configured to be mounted at a door opening and to pivot on a hinged side between an open position and a closed position.
- at least one condenser mounted on a door and having a condenser vapor inlet port.
- at least one condenser being pivotable with a door when the door is moved between an open position and a closed position.
- at least one rack vapor manifold configured for mounting along a side of the rack, and having a plurality of rack vapor inlet ports distributed along a length of the rack for association with a plurality of distributed slots.
- rack vapor inlet ports being arranged to receive coolant vaporized by heat of electronic components associated with servers.
- at least one rack vapor manifold including a plurality of rack vapor outlet ports.
- at least one door vapor manifold mounted on a hinged side of a door and having a plurality of door vapor inlet ports.
- at least one door vapor outlet port for connection to at least one condenser vapor inlet port.
- a plurality of flexible tubes for interconnecting rack vapor outlet ports to door vapor inlet ports along a hinged side, to enable maintained flow-connections between at least one rack vapor manifold and at least one door vapor manifold while the door is pivoted between the open and closed positions.
- at least one condenser includes a plurality of condensers mounted on a door.
- at least one rack vapor manifold is a single rack vapor manifold.
- at least one door vapor manifold is a single door vapor manifold.
- at least one rack liquid coolant manifold having at least one manifold coolant inlet port and a plurality of manifold coolant outlet ports distributed along a length of the at least one rack coolant liquid manifold for association with the plurality of distributed slots.
- manifold coolant outlet ports being arranged to supply liquid coolant to electronic components associated with servers.
- a rack vapor manifold and a rack liquid coolant manifold are integrally formed.
- at least one additional flexible tube for forming at least a portion of a flow-connection between a condenser with a rack liquid coolant manifold.
- a liquid coolant buffer for location in a flow path between a condenser and a rack liquid coolant manifold.
- a buffer is configured for mounting on a door.
- a buffer is configured for mounting in a rack.
- a buffer is configured for mounting in a bottom slot of a rack.
- at least one pump for location in a flow path.
- at least one pump is configured for mounting on a door.
- at least one pump is configured for mounting in the rack.
- a plurality of fans mounted in a door for propelling air through at least one condenser.
- a plurality of fans configured for mounting in a rack for propelling air through at least one condenser.
- at least one condenser covers a majority of a length of a door.
- a server rack is preexisting and a door and at least one rack vapor manifold are configured for retrofitting to the preexisting server rack.
- at least one condenser includes a plurality of microchannels on a surface thereof for facilitating cooling.
- at least one condenser is associated with at least one sensor configured to detect at least one of a temperature indication or a pressure indication associated with coolant.
- at least one processor configured to use at least one temperature indication or pressure indication to control a flow of coolant in at least one rack liquid manifold, or at least one door liquid manifold
- a two-phase pulse evaporator system for cooling electronic components when bubble formation inhibits cooling.
- a two-phase evaporator enclosure having an evaporator base plate configured to serve as a heat exchanger.
- an outer surface of a base plate for contacting a heat-generating electronic component and an inner surface of the base plate exposed to a coolant chamber within an enclosure.
- a liquid coolant port in a wall of an enclosure for delivering liquid coolant to a coolant chamber and to an inner surface of a base plate.
- a vapor outlet port in a wall of an enclosure for evacuating vaporized coolant from an enclosure.
- at least one controllable valve flow connected to at least one of a liquid coolant port and a vapor outlet port.
- at least one controller configured to pulse a controllable valve in succession thereby causing successive pressure fluctuations in at least one two-phase evaporator enclosure to limit heat-transfer-impeding bubble formation on an inner surface of an evaporator base plate.
- at least one controllable valve is a solenoid valve.
- at least one controller is configured to pulse at least one controllable valve in a manner configured to promote a release of bubbles trapped on an inner surface of a base plate.
- pulsing by the at least one controller is configured to induce a substantially equivalent volume of liquid coolant to contact an inner surface of a base plate as the equivalent volume of gas from trapped bubbles are released from the base plate.
- pulsing is configured to promote a formation of multiple small bubbles in place of one or more large bubbles.
- a size of small bubbles is smaller than a gap between adjacent fins of a plurality of fins extending from an inner surface of a base plate.
- a size of the one or more large bubbles is greater than a gap.
- pulsing includes opening and closing at least one controllable valve multiple times a second.
- at least one controllable valve regulates liquid coolant flow into an enclosure.
- at least one controllable valve regulates vapor flow out of an enclosure.
- at least one controller is configured to open and close a controllable valve in response to a vapor pressure reading associated with a two-phase evaporator enclosure.
- at least one controller is configured to open and close a controllable valve in response to a vapor pressure reading associated with a vapor return line.
- at least one controller is configured to open and close a controllable valve in response to a vapor temperature reading.
- at least one controller is configured to open and close a controllable valve in response to a vapor flow rate.
- a frequency of pulsing is predetermined.
- a liquid coolant port is configured to receive liquid coolant from a condenser flow-connected to a plurality of additional two-phase pulse evaporators.
- a vapor outlet port is configured to evacuate vaporized coolant to a condenser.
- a condenser is configured to convert vaporized coolant to liquid coolant.
- at least one controller is configured to control a pump associated with a condenser for simultaneous delivery of liquid coolant to a two-phase pulse evaporator and to a plurality of additional two-phase pulse evaporators.
- a system for cooling electronic components when bubble formation inhibits cooling.
- determine at least one signal configured to cause successive pressure fluctuations in at least one two-phase evaporator enclosure.
- an evaporator base plate configured to serve as a heat exchanger.
- an outer surface of a base plate configured for contacting a heat-generating electronic component and an inner surface of the base plate exposed to a coolant chamber within an enclosure.
- a liquid coolant port in a wall of an enclosure for delivering liquid coolant to a coolant chamber and to an inner surface of a base plate.
- a vapor outlet port in a wall of an enclosure for evacuating vaporized coolant from the enclosure.
- at least one controllable valve flow connected to at least one of a liquid coolant port and a vapor outlet port.
- transmit the at least one signal to at least one controllable valve thereby limiting heat-transfer-impeding bubble formation on an inner surface of an evaporator base plate.
- at least one two-phase pulse evaporator enclosure includes a plurality of two-phase pulse evaporator enclosures.
- each liquid coolant port and each vapor outlet port of each of a plurality of two-phase pulse evaporator enclosures is flow connected to a common condenser configured to receive vaporized coolant from each of the plurality of two-phase pulse evaporator enclosures via a condenser inlet, convert the vaporized coolant to liquid coolant, and deliver the liquid coolant to each of the plurality of two-phase pulse evaporators via each liquid coolant port.
- at least one processor is configured to transmit at least one signal to at least one controllable valve, thereby limiting heat-transfer-impeding bubble formation on an inner surface of each evaporator base plate of each of a plurality of two-phase pulse evaporator enclosures.
- at least one processor is configured to control a pump associated with a condenser for simultaneous delivery of liquid coolant to a plurality of two-phase pulse evaporator enclosures.
- a method for cooling electronic components when bubble formation inhibits cooling.
- determining at least one signal configured to cause successive pressure fluctuations in at least one two-phase evaporator enclosure.
- an evaporator base plate configured to serve as a heat exchanger.
- an outer surface of a base plate configured for contacting a heat-generating electronic component.
- an inner surface of a base plate exposed to a coolant chamber within an enclosure.
- a liquid coolant port in a wall of an enclosure for delivering liquid coolant to a coolant chamber and to an inner surface of the base plate.
- a vapor outlet port in a wall of an enclosure for evacuating vaporized coolant from the enclosure.
- at least one controllable valve flow connected to at least one of a liquid coolant port and a vapor outlet port.
- transmitting the at least one signal to at least one controllable valve thereby limiting heat-transfer-impeding bubble formation on ab inner surface of an evaporator base plate.

Some systems and methods disclosed herein involve unconventional improvements over conventional approaches. Descriptions of the disclosed embodiments are not exhaustive and are not limited to the precise forms or embodiments disclosed. Modifications and adaptations of the embodiments will be apparent from consideration of the specification and practice of the disclosed embodiments. Additionally, the disclosed embodiments are not limited to the examples discussed herein.

The foregoing description has been presented for purposes of illustration. It is not exhaustive and is not limited to the precise forms or embodiments disclosed. Modifications and adaptations of the embodiments will be apparent from consideration of the specification and practice of the disclosed embodiments. For example, the described implementations include hardware and software, but systems and methods consistent with the present disclosure may be implemented as hardware alone.

The features and advantages of the disclosure are apparent from the detailed specification, and thus, it is intended that the appended claims cover all systems and methods falling within the true spirit and scope of the disclosure. As used herein, the indefinite articles "a" and "an" mean "one or more." Similarly, the use of a plural term does not necessarily denote a plurality unless it is unambiguous in the given context. Words such as "and" or "or" mean "and/or" unless specifically directed otherwise. Further, since numerous modifications and variations will readily occur from studying the present disclosure, it is not desired to limit the disclosure to the exact construction and operation illustrated and described, and, accordingly, all suitable modifications and equivalents may be resorted to, falling within the scope of the disclosure.

Computer programs based on the written description and methods of this specification are within the skill of a software developer. The various functions, scripts, programs, or modules may be created using a variety of programming techniques. For example, programs, scripts, functions, program sections or program modules may be designed in or by means of languages, including JAVASCRIPT, C, C++, JAVA, PHP, PYTHON, RUBY, PERL, BASH, or other programming or scripting languages. One or more of such software sections or modules may be integrated into a computer system, non-transitory computer readable media, or existing communications software. The programs, modules, or code may also be implemented or replicated as firmware or circuit logic.

Moreover, while illustrative embodiments have been described herein, the scope may include any and all embodiments having equivalent elements, modifications, omissions, combinations (e.g., of aspects across various embodiments), adaptations or alterations based on the present disclosure. The elements in the claims are to be interpreted broadly based on the language employed in the claims and not limited to examples described in the present specification or during the prosecution of the application, which examples are to be construed as non-exclusive. Further, the steps of the disclosed methods may be modified in any manner, including by reordering steps or inserting or deleting steps. It is intended, therefore, that the specification and examples be considered as exemplary only, with a true scope and spirit being indicated by the following claims and their full scope of equivalents.

### Also included herein are the following Clauses.

1. A cooling device for a solid-state electronics component with a component surface that heats during operation, the cooling device comprising:
   a chamber having a first region defining a pool with a heat conducting wall, the heat conducting wall having an inner surface constituting a wall of the pool and an outer surface, opposite the inner surface for thermal contact with the component surface and for conducting heat therefrom into the pool;
   a liquid coolant inlet integrated with the chamber, the liquid coolant inlet for supplying liquid coolant to the pool to thereby enable pool boiling of the liquid coolant and conversion of the liquid coolant into vaporized coolant;
   a vapor outlet integrated with the chamber for evacuating vaporized coolant from the chamber; and
   a valve configured to restrict flow of the liquid coolant when the liquid coolant in the chamber surpasses a threshold.
2. The cooling device of clause 1, wherein the liquid coolant inlet includes an inlet orifice and wherein the valve includes a float with a portion for blocking the inlet orifice.
3. The cooling device of clause 2, wherein the float has at least one opening therein for enabling the liquid coolant to pass therethrough.
4. The cooling device of clause 2, wherein the blocking portion includes a pin and the inlet orifice is configured to receive the pin.
5. The cooling device of clause 2, wherein the blocking portion is located in a central area of the float.
6. The cooling device of clause 2, further comprising at least one spring for biasing the float toward the inlet orifice.
7. The cooling device of clause 6, wherein the at least one spring is configured to counterbalance a weight of the float.
8. The cooling device of clause 6, wherein the at least one spring includes a plurality of springs.
9. The cooling device of clause 8, wherein an aggregate of the expansion forces of the plurality of springs are substantially equal to a weight of the float.
10. The cooling device of clause 8, wherein the expansion forces of the plurality of springs are substantially equal.
11. The cooling device of clause 10, wherein the float has a periphery area and wherein the plurality of springs are distributed in the periphery area.
12. The cooling device of clause 11, wherein the float includes a central area in which the blocking portion is located, and wherein the blocking portion is substantially equidistant from each spring.
13. The cooling device of clause 10, wherein the float has a generally rectangular periphery area and wherein each of the plurality of springs is located in a differing corner of the generally rectangular periphery area.
14. The cooling device of clause 2, wherein the float is configured to block the inlet orifice in a manner promoting pool boiling.
15. The cooling device of clause 1, wherein the heat conducting wall is a cooling plate having screw holes therein adapted for screw connection to a semiconductor board.
16. The cooling device of clause 1, wherein the chamber includes a plurality of fins on an outer surface thereof.
17. The cooling device of clause 1, wherein the chamber includes a plurality of fins therein.
18. The cooling device of clause 17, wherein wicks are disposed between the plurality of fins.
19. The cooling device of clause 1, wherein the liquid coolant is a non-electrically conductive material.
20. The cooling device of clause 1, wherein the liquid coolant inlet and the vapor outlet are configured for flow-connection to a condenser configured to receive vaporized coolant evacuated from a plurality of cooling devices, convert the vaporized coolant to liquid coolant, and supply the liquid coolant to a plurality of cooling devices.

## Claims

1. A two-phase cooling device configured for parallel liquid coolant interconnection and serial vapor return interconnection, the two-phase cooling device comprising:
a chamber having a liquid coolant region and vaporized coolant region;
a liquid coolant port in the chamber for flow connection to a liquid coolant source;
a first vapor port in the chamber for evacuating first vaporized coolant from the chamber;
a second vapor port in the chamber for receiving second vaporized coolant from at least one other chamber of at least one other two-phased cooling device; and
a vapor passthrough path flow-connecting the first vapor port to the second vapor port, to thereby enable the second vaporized coolant to mix with the first vaporized coolant.

2. The two-phase cooling device of claim 1, wherein the first vapor port and the second vapor port are flow connected to the vaporized coolant region of the chamber thereby enabling the second vaporized coolant entering the vaporized coolant region to form a mixture with the first vaporized coolant, and enabling the mixture to exit the vaporized coolant region via the first vapor port.

3. The two-phase cooling device of claim 1 or claim 2, wherein the vapor passthrough path is at least partially located in the vaporized coolant region.

4. The two-phase cooling device of any preceding claim, further comprising a liquid coolant conduit for conveying liquid coolant from the liquid coolant port to a liquid coolant inlet in the liquid coolant source.

5. The two-phase cooling device of claim 4, wherein the liquid coolant conduit at least partially passes through the vaporized coolant region of the chamber.

6. The two-phase cooling device of claim 5, wherein the liquid coolant conduit is transverse to the vapor passthrough path.

7. The two-phase cooling device of any preceding claim, further comprising at least one vaporized coolant conduit connected to at least one of the first vapor port and the second vapor port, wherein the at least one vaporized coolant conduit at least partially passes through the liquid coolant region.

8. The two-phase cooling device of any preceding claim, further comprising a barrier in the chamber dividing the vaporized coolant region from the liquid coolant region.

9. The two-phase cooling device of claim 8, wherein the barrier exposes at least one vent permitting the first vaporized coolant to escape from the liquid coolant region to the vaporized coolant region and mix with the second vaporized coolant in the vaporized coolant region.

10. The two-phase cooling device of claim 8 or claim 9, wherein the first vapor port and the second vapor port are integrally formed with the barrier.

11. The two-phase cooling device of any one of claims 8 to 10, wherein the first vapor port and the second vapor port are at least partially located in the liquid coolant region.

12. The two-phase cooling device of any preceding claim, further comprising a float valve in the liquid coolant region, wherein the float valve is configured to conditionally restrict inlet flow of liquid coolant into the liquid coolant region.

13. The two-phase cooling device of claim 12, further comprising a liquid coolant conduit within the chamber, the liquid coolant conduit having a valve seat therein, and wherein the float valve includes a pin configured to engage the valve seat in order to restrict the inlet flow of liquid coolant through a liquid coolant inlet and into the liquid coolant region.

14. The two-phase cooling device of any preceding claim, wherein the vapor passthrough path is configured for flow connection to a vapor conduit for receiving third vaporized coolant from at least one additional vapor passthrough path of at least one additional two-phased cooling device, to thereby enable the third vaporized coolant to mix with the first vaporized coolant and the second vaporized coolant.

15. The two-phase cooling device of claim 14, wherein the first vapor port is associated with a first controllable valve and wherein the second vapor port is associated with a second controllable valve.

16. The two-phase cooling device of claim 15, wherein the first controllable valve and the second controllable valve are regulated by at least one processor to modulate temperature within the chamber.

17. The two-phase cooling device of claim 16, wherein the first controllable valve and the second controllable valve are solenoid valves.

18. The two-phase cooling device of any preceding claim, wherein cross-sectional areas of the first vapor port and the second vapor port are larger than a cross-sectional area of the liquid coolant port.

19. The two-phase cooling device of any preceding claim, wherein the liquid coolant port is configured for flow connection to the liquid coolant source via a liquid coolant manifold configured for flow connecting a plurality of additional two-phase cooling devices to the liquid coolant source.

20. The two-phase cooling device of claim 19, wherein the liquid coolant source is a condenser and wherein the first vapor port and the second vapor port are configured for flow connection to a vapor manifold configured to convey the first vaporized coolant, the second vaporized coolant, and additional vaporized coolant from the plurality of additional two-phase cooling devices to the condenser.
